(19) Europäisches Patentamt
European Patent Office
Office européen des brevets

(11) EP 3 502 117 B1

(12) **EUROPEAN PATENT SPECIFICATION**

(45) Date of publication and mention of the grant of the patent:
**16.09.2020 Bulletin 2020/38**

(51) Int Cl.:
***C07F 15/00*** *(2006.01)* ***C09K 11/06*** *(2006.01)*
***H01L 51/00*** *(2006.01)*

(21) Application number: **18212977.5**

(22) Date of filing: **17.12.2018**

(54) **ORGANOMETALLIC COMPOUND, ORGANIC LIGHT-EMITTING DEVICE INCLUDING THE ORGANOMETALLIC COMPOUND, AND DIAGNOSTIC COMPOSITION INCLUDING THE ORGANOMETALLIC COMPOUND**

ORGANOMETALLISCHE VERBINDUNG, ORGANISCHE LICHTEMITTIERENDE VORRICHTUNG MIT DER ORGANOMETALLISCHEN VERBINDUNG UND DIAGNOSTISCHE ZUSAMMENSETZUNG MIT DER ORGANOMETALLISCHEN VERBINDUNG

COMPOSÉ ORGANOMÉTALLIQUE, DISPOSITIF ÉLECTROLUMINESCENT ORGANIQUE LE COMPRENANT ET COMPOSITION DE DIAGNOSTIC COMPRENANT LE COMPOSÉ ORGANOMÉTALLIQUE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **22.12.2017 KR 20170178740**

(43) Date of publication of application:
**26.06.2019 Bulletin 2019/26**

(73) Proprietor: **Samsung Electronics Co., Ltd.**
**Suwon-si, Gyeonggi-do, 16677 (KR)**

(72) Inventors:
- **CHOI, Jongwon**
**16678 Gyeonggi-do (KR)**
- **CHO, Yongsuk**
**16678 Gyeonggi-do (KR)**
- **KOO, Hyun**
**16678 Gyeonggi-do (KR)**
- **PARK, Bumwoo**
**16678 Gyeonggi-do (KR)**
- **LEE, Sunghun**
**16678 Gyeonggi-do (KR)**
- **ISHIHARA, Shingo**
**16678 Gyeonggi-do (KR)**
- **KWAK, Yoonhyun**
**16678 Gyeonggi-do (KR)**
- **KWON, Ohyun**
**16678 Gyeonggi-do (KR)**

(74) Representative: **Elkington and Fife LLP**
**Prospect House**
**8 Pembroke Road**
**Sevenoaks, Kent TN13 1XR (GB)**

(56) References cited:
**US-A1- 2017 305 881**

- **ZHANG, ANYUN ET AL: "Separation and complexation of palladium(II) with a new soft N-donor ligand 6,6'-bis(5,6-dinonyl-1,2,4-triazin-3-yl)-2 ,2'-bipyridine (C9-BTBP) in nitric acid medium", NEW JOURNAL OF CHEMISTRY, vol. 40, no. 7, 10 May 2016 (2016-05-10), pages 6374-6383, XP002789934, ISSN: 1144-0546, DOI: 10.1039/C5NJ03082J 10.1039/C5NJ03082J**
- **LEWIS, FRANK W. ET AL: "Synthesis and evaluation of lipophilic BTBP ligands for An/Ln separation in nuclear waste treatment: The effect of alkyl substitution on extraction properties and implications for ligand design", EUROPEAN JOURNAL OF ORGANIC CHEMISTRY, vol. 8, 12 January 2012 (2012-01-12), pages 1509-1519, XP002789935, ISSN: 1099-0690, DOI: 10.1002/EJOC.201101576 10.1002/EJOC.201101576**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

EP 3 502 117 B1

## Description

FIELD OF THE INVENTION

One or more embodiments relate to an organometallic compound, an organic light-emitting device including the organometallic compound, and a diagnostic composition including the organometallic compound.

BACKGROUND OF THE INVENTION

Organic light-emitting devices (OLEDs) are self-emission devices, which have superior characteristics in terms of a viewing angle, a response time, a brightness, a driving voltage, and a response speed, and which produce full-color images.

In a typical example, an organic light-emitting device includes an anode, a cathode, and an organic layer disposed between the anode and the cathode, wherein the organic layer includes an emission layer. A hole transport region may be disposed between the anode and the emission layer, and an electron transport region may be disposed between the emission layer and the cathode. Holes provided from the anode may move toward the emission layer through the hole transport region, and electrons provided from the cathode may move toward the emission layer through the electron transport region. The holes and the electrons recombine in the emission layer to produce excitons. These excitons transit from an excited state to a ground state, thereby generating light.

Meanwhile, luminescent compounds may be used to monitor, sense, or detect a variety of biological materials including cells and proteins. An example of the luminescent compounds includes a phosphorescent luminescent compound. Non-platinum metal complexes for excimer based single dopant white organic light emitting diodes are disclosed in US 2017/0305881 A1.

Various types of organic light emitting devices are known. However, there still remains a need in OLEDs having low driving voltage, high efficiency, high brightness, and long lifespan.

SUMMARY OF THE INVENTION

Aspects of the present disclosure provide an organometallic compound, an organic light-emitting device including the organometallic compound, and a diagnostic composition including the organometallic compound.

Additional aspects will be set forth in part in the description which follows and, in part, will be apparent from the description, or may be learned by practice of the presented embodiments.

An aspect of the present disclosure provides an organometallic compound represented by Formula 1:

Formula 1

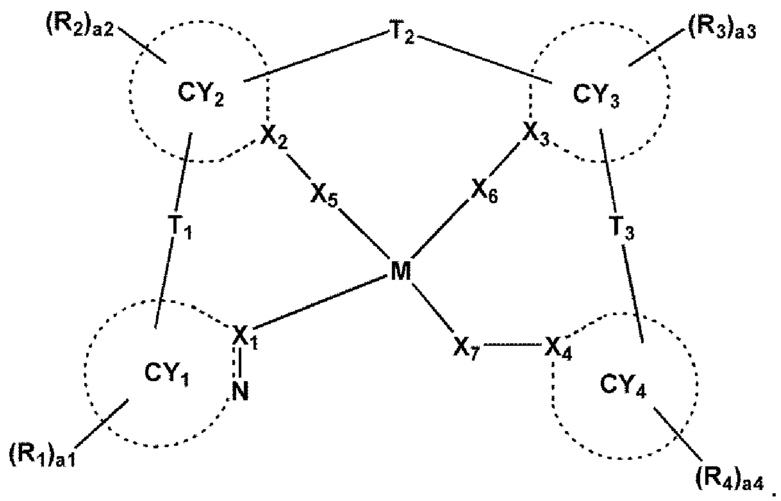

In Formula 1,

M may be beryllium (Be), magnesium (Mg), aluminum (Al), calcium (Ca), titanium (Ti), manganese (Mn), cobalt (Co), copper (Cu), zinc (Zn), gallium (Ga), germanium (Ge), ruthenium (Ru), rhodium (Rh), silver (Ag), rhenium (Re), platinum (Pt), or gold (Au),

$X_1$ may be N,

$X_2$ to $X_4$ may each independently be C or N,

$X_5$ to $X_7$ may each independently be a chemical bond, O, S, $B(R_7)$, $N(R_7)$, $P(R_7)$, $C(R_7)(R_8)$, $Si(R_7)(R_8)$, $Ge(R_7)(R_8)$, C(=O), $B(R_7)(R_8)$, $N(R_7)(R_8)$, or $P(R_7)(R_8)$, when $X_5$ is a chemical bond, $X_2$ and M may be directly linked to each other, when $X_6$ is a chemical bond, $X_3$ and M may be directly linked to each other, and when $X_7$ is a chemical bond, $X_4$ and M may be directly linked to each other,

a bond between $X_1$ and M may be a coordinate bond, one bond selected from a bond between $X_2$ or $X_5$ and M, a bond between $X_3$ or $X_6$ and M, and a bond between $X_4$ or $X_7$ and M may be a coordinate bond, and the others thereof may each be a covalent bond,

ring $CY_1$ may be a $C_1$-$C_{30}$ heterocyclic group having at least two N atoms as ring-forming atoms,

ring $CY_2$ to ring $CY_4$ may each independently be selected from a $C_5$-$C_{30}$ carbocyclic group and a $C_1$-$C_{30}$ heterocyclic group,

$T_1$ and $T_3$ may each independently be a single bond, a double bond, *-N(R')-*', *-B(R')-*', *-P(R')-*', *-C(R')(R")-*', *-Si(R')(R")-*', *-Ge(R')(R")-*', *-S-*', *-Se-*', *-O-*', *-C(=PO)-*', *-S(=O)-*', *-S(=O)$_2$-*', *-C(R')=*', *=C(R')-*', *-C(R')=C(R")-*', *-C(=S)-*', or *-C≡C-*',

$T_2$ may be a single bond, a double bond, *-N($R_5$)-*', *-B($R_5$)-*', *-P($R_5$)-*', *-C($R_5$)($R_6$)-*', *-Si($R_5$)($R_6$)-*', *-Ge($R_5$)($R_6$)-*', *-S-*', *-Se-*', *-O-*', *-C(=O)-*', *-S(=O)-*', *-S(=O)$_2$-*', *-C($R_5$)=*', *=C($R_5$)-*', *-C($R_5$)=C($R_6$)-*', *-C(=S)-*', or *-C=C-*',

$R_1$ to $R_8$, R', and R" may each independently be selected from hydrogen, deuterium, -F, -Cl, -Br, -I, -$SF_5$, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a substituted or unsubstituted $C_1$-$C_{60}$ alkyl group, a substituted or unsubstituted $C_2$-$C_{60}$ alkenyl group, a substituted or unsubstituted $C_2$-$C_{60}$ alkynyl group, a substituted or unsubstituted $C_1$-$C_{60}$ alkoxy group, a substituted or unsubstituted $C_3$-$C_{10}$ cycloalkyl group, a substituted or unsubstituted $C_1$-$C_{10}$ heterocycloalkyl group, a substituted or unsubstituted $C_3$-$C_{10}$ cycloalkenyl group, a substituted or unsubstituted $C_1$-$C_{10}$ heterocycloalkenyl group, a substituted or unsubstituted $C_6$-$C_{60}$ aryl group, a substituted or unsubstituted $C_7$-$C_{60}$ alkyl aryl group, a substituted or unsubstituted $C_6$-$C_{60}$ aryloxy group, a substituted or unsubstituted $C_6$-$C_{60}$ arylthio group, a substituted or unsubstituted $C_7$-$C_{60}$ aryl alkyl group, a substituted or unsubstituted $C_1$-$C_{60}$ heteroaryl group, a substituted or unsubstituted $C_1$-$C_{60}$ heteroaryloxy group, a substituted or unsubstituted $C_1$-$C_{60}$ heteroarylthio group, a substituted or unsubstituted $C_2$-$C_{60}$ heteroaryl alkyl group, a substituted or unsubstituted $C_2$-$C_{60}$ alkyl heteroaryl group, a substituted or unsubstituted monovalent non-aromatic condensed polycyclic group, a substituted or unsubstituted monovalent non-aromatic condensed heteropolycyclic group, -N($Q_1$)($Q_2$), -Si($Q_3$)($Q_4$)($Q_5$), - B($Q_6$)($Q_7$), and -P(=O)($Q_8$)($Q_9$),

a1 to a4 may each independently be an integer from 0 to 20,

two of a plurality of neighboring groups $R_1$ may optionally be linked to form a $C_5$-$C_{30}$ carbocyclic group which is unsubstituted or substituted with at least one $R_{10a}$ or a $C_1$-$C_{30}$ heterocyclic group which is unsubstituted or substituted with at least one $R_{10a}$,

two of a plurality of neighboring groups $R_2$ may optionally be linked to form a $C_5$-$C_{30}$ carbocyclic group which is unsubstituted or substituted with at least one $R_{10a}$ or a $C_1$-$C_{30}$ heterocyclic group which is unsubstituted or substituted with at least one $R_{10a}$,

two of a plurality of neighboring groups $R_3$ may optionally be linked to form a $C_5$-$C_{30}$ carbocyclic group which is unsubstituted or substituted with at least one $R_{10a}$ or a $C_1$-$C_{30}$ heterocyclic group which is unsubstituted or substituted with at least one $R_{10a}$,

two of a plurality of neighboring groups $R_4$ may optionally be linked to form a $C_5$-$C_{30}$ carbocyclic group which is unsubstituted or substituted with at least one $R_{10a}$ or a $C_1$-$C_{30}$ heterocyclic group which is unsubstituted or substituted with at least one $R_{10a}$,

two of $R_1$ to $R_8$, R', and R" may optionally be linked to form a $C_5$-$C_{30}$ carbocyclic group which is unsubstituted or substituted with at least one $R_{10a}$ or a $C_1$-$C_{30}$ heterocyclic group which is unsubstituted or substituted with at least one $R_{10a}$,

$R_{10a}$ is the same as described in connection with $R_1$,

* and *' each indicate a binding site to a neighboring atom,

at least one substituent of the substituted $C_1$-$C_{60}$ alkyl group, the substituted $C_2$-$C_{60}$ alkenyl group, the substituted $C_2$-$C_{60}$ alkynyl group, the substituted $C_1$-$C_{60}$ alkoxy group, the substituted $C_3$-$C_{10}$ cycloalkyl group, the substituted $C_1$-$C_{10}$ heterocycloalkyl group, the substituted $C_3$-$C_{10}$ cycloalkenyl group, the substituted $C_1$-$C_{10}$ heterocycloalkenyl group, the substituted $C_6$-$C_{60}$ aryl group, the substituted $C_7$-$C_{60}$ alkyl aryl group, the substituted $C_6$-$C_{60}$ aryloxy group, the substituted $C_6$-$C_{60}$ arylthio group, the substituted $C_7$-$C_{60}$ aryl alkyl group, the substituted $C_1$-$C_{60}$ heteroaryl group, the substituted $C_1$-$C_{60}$ heteroaryloxy group, the substituted $C_1$-$C_{60}$ heteroarylthio group, the substituted $C_2$-$C_{60}$ heteroaryl alkyl group, the substituted $C_2$-$C_{60}$ alkyl heteroaryl group, the substituted monovalent non-aromatic condensed polycyclic group, and the substituted monovalent non-aromatic condensed heteropolycyclic group may

be selected from:

deuterium, -F, -Cl, -Br, -I, $-CD_3$, $-CD_2H$, $-CDH_2$, $-CF_3$, $-CF_2H$, $-CFH_2$, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a C1-C60 alkyl group, a $C_2$-$C_{60}$ alkenyl group, a $C_2$-$C_{60}$ alkynyl group, and a $C_1$-$C_{60}$ alkoxy group;

a $C_1$-$C_{60}$ alkyl group, a $C_2$-$C_{60}$ alkenyl group, a $C_2$-$C_{60}$ alkynyl group, and a $C_1$-$C_{60}$ alkoxy group, each substituted with at least one selected from deuterium, -F, -Cl, -Br, -I, $-CD_3$, $-CD_2H$, $-CDH_2$, $-CF_3$, $-CF_2H$, $-CFH_2$, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_7$-$C_{60}$ alkyl aryl group, a $C_6$-$C_{60}$ aryloxy group, a $C_6$-$C_{60}$ arylthio group, a $C_7$-$C_{60}$ aryl alkyl group, a $C_1$-$C_{60}$ heteroaryl group, a $C_1$-$C_{60}$ heteroaryloxy group, a $C_1$-$C_{60}$ heteroarylthio group, a $C_2$-$C_{60}$ heteroaryl alkyl group, a $C_2$-$C_{60}$ alkyl heteroaryl group, a monovalent non-aromatic condensed polycyclic group, a monovalent non-aromatic condensed heteropolycyclic group, $-N(Q_{11})(Q_{12})$, $-Si(Q_{13})(Q_{14})(Q_{15})$, $-B(Q_{16})(Q_{17})$, and $-P(=O)(Q_{18})(Q_{19})$;

a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_7$-$C_{60}$ alkyl aryl group, a $C_6$-$C_{60}$ aryloxy group, a $C_6$-$C_{60}$ arylthio group, a $C_7$-C60 aryl alkyl group, a $C_1$-$C_{60}$ heteroaryl group, a $C_1$-$C_{60}$ heteroaryloxy group, a $C_1$-$C_{60}$ heteroarylthio group, a $C_2$-$C_{60}$ heteroaryl alkyl group, a $C_2$-$C_{60}$ alkyl heteroaryl group, a monovalent non-aromatic condensed polycyclic group, and a monovalent non-aromatic condensed heteropolycyclic group;

a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_7$-$C_{60}$ alkyl aryl group, a $C_6$-$C_{60}$ aryloxy group, a $C_6$-$C_{60}$ arylthio group, a $C_7$-$C_{60}$ aryl alkyl group, a $C_1$-$C_{60}$ heteroaryl group, a $C_1$-$C_{60}$ heteroaryloxy group, a $C_1$-$C_{60}$ heteroarylthio group, a $C_2$-$C_{60}$ heteroaryl alkyl group, a $C_2$-$C_{60}$ alkyl heteroaryl group, a monovalent non-aromatic condensed polycyclic group, and a monovalent non-aromatic condensed heteropolycyclic group, each substituted with at least one selected from deuterium, -F, -Cl, -Br, -I, $-CD_3$, $-CD_2H$, $-CDH_2$, $-CF_3$, $-CF_2H$, $-CFH_2$, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a $C_1$-$C_{60}$ alkyl group, a $C_2$-$C_{60}$ alkenyl group, a $C_2$-$C_{60}$ alkynyl group, a $C_1$-$C_{60}$ alkoxy group, a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_7$-$C_{60}$ alkyl aryl group, a $C_6$-$C_{60}$ aryloxy group, a $C_6$-$C_{60}$ arylthio group, a $C_7$-$C_{60}$ aryl alkyl group, a $C_1$-$C_{60}$ heteroaryl group, a $C_1$-$C_{60}$ heteroaryloxy group, a $C_1$-$C_{60}$ heteroarylthio group, a $C_2$-$C_{60}$ heteroaryl alkyl group, a $C_2$-$C_{60}$ alkyl heteroaryl group, a monovalent non-aromatic condensed polycyclic group, a monovalent non-aromatic condensed heteropolycyclic group, $-N(Q_{21})(Q_{22})$, $-Si(Q_{23})(Q_{24})(Q_{25})$, $-B(Q_{26})(Q_{27})$, and $-P(=O)(Q_{28})(Q_{29})$; and

$-N(Q_{31})(Q_{32})$, $-Si(Q_{33})(Q_{34})(Q_{35})$, $-B(Q_{36})(Q_{37})$, and $-P(=O)(Q_{38})(Q_{39})$, and

$Q_1$ to $Q_9$, $Q_{11}$ to $Q_{19}$, $Q_{21}$ to $Q_{29}$, and $Q_{31}$ to $Q_{39}$ may each independently be selected from hydrogen, deuterium, -F, -Cl, -Br, -I, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a $C_1$-$C_{60}$ alkyl group, a $C_2$-$C_{60}$ alkenyl group, a $C_2$-$C_{60}$ alkynyl group, a $C_1$-$C_{60}$ alkoxy group, a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_6$-$C_{60}$ aryl group substituted with at least one selected from a $C_7$-C60 alkylaryl group, a $C_1$-$C_{60}$ alkyl group, and a $C_6$-$C_{60}$ aryl group, a $C_6$-$C_{60}$ aryloxy group, a $C_6$-$C_{60}$ arylthio group, a $C_7$-$C_{60}$ aryl alkyl group, a $C_1$-$C_{60}$ heteroaryl group, a $C_1$-$C_{60}$ heteroaryloxy group, a $C_1$-$C_{60}$ heteroarylthio group, a $C_2$-$C_{60}$ heteroaryl alkyl group, a $C_2$-$C_{60}$ alkyl heteroaryl group, a monovalent non-aromatic condensed polycyclic group, and a monovalent non-aromatic condensed heteropolycyclic group.

Another aspect of the present disclosure provides an organic light-emitting device including:

a first electrode,
a second electrode, and
an organic layer disposed between the first electrode and the second electrode,
wherein the organic layer includes an emission layer, and
wherein the organic layer includes at least one organometallic compound.

In the organic layer, the organometallic compound may serve as a dopant.
Another aspect of the present disclosure provides a diagnostic composition including at least one organometallic

compound represented by Formula 1.

BRIEF DESCRIPTION OF THE DRAWING

These and/or other aspects will become apparent and more readily appreciated from the following description of the embodiments, taken in conjunction with FIGURE which is a schematic view of an organic light-emitting device according to an embodiment.

DETAILED DESCRIPTION OF THE EMBODIMENTS

Reference will now be made in detail to embodiments, examples of which are illustrated in the accompanying drawings, wherein like reference numerals refer to like elements throughout. In this regard, the present embodiments may have different forms and should not be construed as being limited to the descriptions set forth herein. Accordingly, the embodiments are merely described below, by referring to the figures, to explain aspects of the present description. As used herein, the term "and/or" includes any and all combinations of one or more of the associated listed items. Expressions such as "at least one of," when preceding a list of elements, modify the entire list of elements and do not modify the individual elements of the list.

It will be understood that when an element is referred to as being "on" another element, it can be directly in contact with the other element or intervening elements may be present therebetween. In contrast, when an element is referred to as being "directly on" another element, there are no intervening elements present.

It will be understood that, although the terms first, second, third etc. may be used herein to describe various elements, components, regions, layers, and/or sections, these elements, components, regions, layers, and/or sections should not be limited by these terms. These terms are only used to distinguish one element, component, region, layer, or section from another element, component, region, layer, or section. Thus, a first element, component, region, layer, or section discussed below could be termed a second element, component, region, layer, or section without departing from the teachings of the present embodiments.

The terminology used herein is for the purpose of describing particular embodiments only and is not intended to be limiting. As used herein, the singular forms "a," "an," and "the" are intended to include the plural forms as well, unless the context clearly indicates otherwise.

The term "or" means "and/or." It will be further understood that the terms "comprises" and/or "comprising," or "includes" and/or "including" when used in this specification, specify the presence of stated features, regions, integers, steps, operations, elements, and/or components, but do not preclude the presence or addition of one or more other features, regions, integers, steps, operations, elements, components, and/or groups thereof.

Unless otherwise defined, all terms (including technical and scientific terms) used herein have the same meaning as commonly understood by one of ordinary skill in the art to which this general inventive concept belongs. It will be further understood that terms, such as those defined in commonly used dictionaries, should be interpreted as having a meaning that is consistent with their meaning in the context of the relevant art and the present disclosure, and will not be interpreted in an idealized or overly formal sense unless expressly so defined herein.

Exemplary embodiments are described herein with reference to cross section illustrations that are schematic illustrations of idealized embodiments. As such, variations from the shapes of the illustrations as a result, for example, of manufacturing techniques and/or tolerances, are to be expected. Thus, embodiments described herein should not be construed as limited to the particular shapes of regions as illustrated herein but are to include deviations in shapes that result, for example, from manufacturing. For example, a region illustrated or described as flat may, typically, have rough and/or nonlinear features. Moreover, sharp angles that are illustrated may be rounded. Thus, the regions illustrated in the figures are schematic in nature and their shapes are not intended to illustrate the precise shape of a region and are not intended to limit the scope of the present claims.

"About" or "approximately" as used herein is inclusive of the stated value and means within an acceptable range of deviation for the particular value as determined by one of ordinary skill in the art, considering the measurement in question and the error associated with measurement of the particular quantity (i.e., the limitations of the measurement system). For example, "about" can mean within one or more standard deviations, or within $\pm$ 30%, 20%, 10%, 5% of the stated value.

In an embodiment, an organometallic compound represented by Formula 1 below is provided:

Formula 1

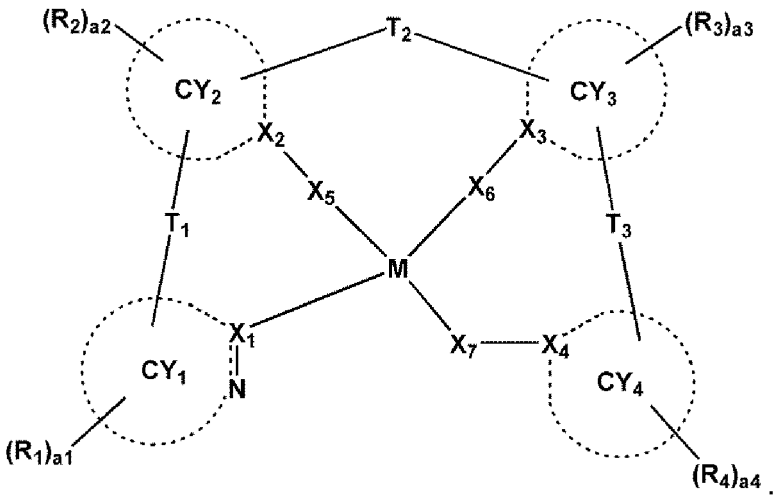

M in Formula 1 may be beryllium (Be), magnesium (Mg), aluminum (Al), calcium (Ca), titanium (Ti), manganese (Mn), cobalt (Co), copper (Cu), zinc (Zn), gallium (Ga), germanium (Ge), ruthenium (Ru), rhodium (Rh), silver (Ag), rhenium (Re), platinum (Pt), or gold (Au).

For example, M may be Pt, or Au, but embodiments of the present disclosure are not limited thereto.

In Formula 1, $X_1$ may be N, $X_2$ to $X_4$ may each independently be C or N, $X_5$ to $X_7$ may each independently be a chemical bond, O, S, $B(R_7)$, $N(R_7)$, $P(R_7)$, $C(R_7)(R_8)$, $Si(R_7)(R_8)$, $Ge(R_7)(R_8)$, C(=O), $B(R_7)(R_8)$, $N(R_7)(R_8)$, or $P(R_7)(R_8)$, when $X_5$ is the chemical bond, $X_2$ and M may be directly linked to each other, when $X_6$ is the chemical bond, $X_3$ and M may be directly linked to each other, and when $X_7$ is the chemical bond, $X_4$ and M may be directly linked to each other. $R_7$ and $R_8$ are the same as described herein.

In one or more embodiments, in Formula 1,

$X_2$ and $X_3$ may each be C, $X_4$ may be N, and $X_5$ to $X_7$ may each be a chemical bond; or
$X_2$ and $X_4$ may each be C, $X_3$ may be N, $X_5$ and $X_6$ may each be a chemical bond, and $X_7$ may be a chemical bond, O, or S, but embodiments of the present disclosure are not limited thereto.

In Formula 1, a bond between $X_1$ and M may be a coordinate bond, one bond selected from a bond between $X_2$ or $X_5$ and M, a bond between $X_3$ or $X_6$ and M, and a bond between $X_4$ or $X_7$ and M may be a coordinate bond, and the others thereof may each be a covalent bond. Therefore, the organometallic compound represented by Formula 1 may be electrically neutral.

In one or more embodiments, in Formula 1,

a bond between $X_2$ or $X_5$ and M and a bond between $X_3$ or $X_6$ and M may each be a covalent bond, $X_7$ may be a chemical bond, and a bond between $X_4$ and M may be a coordinate bond; or
a bond between $X_2$ or $X_5$ and M and a bond between $X_4$ or $X_7$ and M may each be a covalent bond, $X_6$ may be a chemical bond, and a bond between $X_3$ and M may be a coordinate bond, but embodiments of the present disclosure are not limited thereto.

In Formula 1, ring $CY_1$ may be a $C_1$-$C_{30}$ heterocyclic group having at least two N atoms as a ring-forming atom, and ring $CY_2$ to ring $CY_4$ may each independently be selected from a $C_5$-$C_{30}$ carbocyclic group and a $C_1$-$C_{30}$ heterocyclic group.

In one or more embodiments, in Formula 1,

ring $CY_1$ may be selected from i) a first ring, ii) a condensed ring in which at least two of the first ring is condensed, and iii) a condensed ring in which at least one of the first ring and at least one of a second ring are condensed to each other,
the first ring may be a pyridazine group, a triazine group, or a tetrazine group, and
the second ring may be selected from a cyclopentane group, a cyclopentadiene group, a furan group, a thiophene group, a pyrrole group, a silole group, an indene group, a benzofuran group, a benzothiophene group, an indole group, a benzosilole group, an oxazole group, an isoxazole group, an oxadiazole group, an isoxadiazole group, an

oxatriazole group, an isoxatriazole group, a thiazole group, an isothiazole group, a thiadiazole group, an isothiadiazole group, a thiatriazole group, an isothiatriazole group, a pyrazole group, an imidazole group, a triazole group, a tetrazole group, an azasilole group, a diazasilole group, a triazasilole group, an adamantane group, a norbornane group, a norbornene group, a cyclohexane group, a cyclohexene group, a benzene group, a pyridine group, a pyrimidine group, and a pyrazine group.

When ring $CY_1$ is a condensed ring in which at least one of the first ring and at least one of a second ring are condensed with each other, N in the first ring of the condensed ring may be coordinately bonded to M in Formula 1. That is, when ring $CY_1$ is a condensed ring in which at least one of the first ring and at least one of a second ring are condensed with each other, N in the first ring of the condensed ring may be $X_1$ coordinately bonded to M in Formula 1.

In one or more embodiments, in Formula 1,

ring $CY_2$ to ring $CY_4$ may each independently be selected from i) a third ring, ii) a fourth ring, iii) a condensed ring in which at least two of the third ring are condensed to each other, iv) a condensed ring in which at least two of the fourth ring are condensed to each other, and v) a condensed ring in which at least one of the third ring and at least one of the fourth ring are condensed to each other,

the third ring may be selected from a cyclopentane group, a cyclopentadiene group, a furan group, a thiophene group, a pyrrole group, a silole group, an indene group, a benzofuran group, a benzothiophene group, an indole group, a benzosilole group, an oxazole group, an isoxazole group, an oxadiazole group, an isoxadiazole group, an oxatriazole group, an isoxatriazole group, a thiazole group, an isothiazole group, a thiadiazole group, an isothiadiazole group, a thiatriazole group, an isothiatriazole group, a pyrazole group, an imidazole group, a triazole group, a tetrazole group, an azasilole group, a diazasilole group, and a triazasilole group, and

the fourth ring may be selected from an adamantane group, a norbornane group, a norbornene group, a cyclohexane group, a cyclohexene group, a benzene group, a pyridine group, a pyrimidine group, a pyrazine group, a pyridazine group, and a triazine group.

For example, ring $CY_2$ to ring $CY_4$ may each independently be selected from a benzene group, a naphthalene group, an anthracene group, a phenanthrene group, a triphenylene group, a pyrene group, a chrysene group, a cyclopentadiene group, a 1,2,3,4-tetrahydronaphthalene group, a thiophene group, a furan group, an indole group, a benzoborole group, a benzophosphole group, an indene group, a benzosilole group, a benzogermole group, a benzothiophene group, a benzoselenophene group, a benzofuran group, a carbazole group, a dibenzoborole group, a dibenzophosphole group, a fluorene group, a dibenzosilole group, a dibenzogermole group, a dibenzothiophene group, a dibenzoselenophene group, a dibenzofuran group, a dibenzothiophene 5-oxide group, a 9H-fluorene-9-one group, a dibenzothiophene 5,5-dioxide group, an azaindole group, an azabenzoborole group, an azabenzophosphole group, an azaindene group, an azabenzosilole group, an azabenzogermole group, an azabenzothiophene group, an azabenzoselenophene group, an azabenzofuran group, an azacarbazole group, an azadibenzoborole group, an azadibenzophosphole group, an azafluorene group, an azadibenzosilole group, an azadibenzogermole group, an azadibenzothiophene group, an azadibenzoselenophene group, an azadibenzofuran group, an azadibenzothiophene 5-oxide group, an aza-9H-fluorene-9-one group, an azadibenzothiophene 5,5-dioxide group, a pyridine group, a pyrimidine group, a pyrazine group, a pyridazine group, a triazine group, a quinoline group, an isoquinoline group, a quinoxaline group, a quinazoline group, a phenanthroline group, a pyrrole group, a pyrazole group, an imidazole group, a triazole group, an oxazole group, an isoxazole group, a thiazole group, an isothiazole group, an oxadiazole group, a thiadiazole group, a benzopyrazole group, a benzimidazole group, a benzoxazole group, a benzothiazole group, a benzoxadiazole group, a benzothiadiazole group, a 5,6,7,8-tetrahydroisoquinoline group, and a 5,6,7,8-tetrahydroquinoline group.

In Formula 1, $T_1$ and $T_3$ may each independently be a single bond, a double bond, *-N(R')-*', *-B(R')-*', *-P(R')-*', *-C(R')(R")-*', *-Si(R')(R")-*', *-Ge(R')(R")-*', *-S-*', *-Se-*', *-O-*', *-C(=O)-*', *-S(=O)-*', *-S(=O)$_2$-*', *-C(R')=*', *=C(R')-*', *-C(R')=C(R")-*', *-C(=S)-*', or *-C≡C-*', and $T_2$ may be a single bond, a double bond, *-N($R_5$)-*', *-B($R_5$)-*', *-P($R_5$)-*', *-C($R_5$)($R_6$)-*', *-Si($R_5$)($R_6$)-*', *-Ge($R_5$)($R_6$)-*', *-S-*', *-Se-*', *-O-*', *-C(=O)-*', *-S(=O)-*', *-S(=O)$_2$-*', *-C($R_5$)=*', *=C($R_5$)-*', *-C($R_5$)=C($R_6$)-*' *-C(=S)-*', or *-C≡C-*'. R', R", $R_5$, and $R_6$ may be understood by referring to the description provided herein.

In an embodiment, in Formula 1, $T_1$ and $T_3$ may each be a single bond, and $T_2$ may be *-N($R_5$)-*', *-C($R_5$)($R_6$)-*', *-Si($R_5$)($R_6$)-*', *-S-*', or *-O-*', but embodiments of the present disclosure are not limited thereto.

In Formula 1, $R_1$ to $R_8$, R', and R" may each independently be selected from hydrogen, deuterium, -F, -Cl, -Br, -I, -$SF_5$, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a substituted or unsubstituted $C_1$-$C_{60}$ alkyl group, a substituted or unsubstituted $C_2$-$C_{60}$ alkenyl group, a substituted or unsubstituted $C_2$-$C_{60}$ alkynyl group, a substituted or unsubstituted $C_1$-$C_{60}$ alkoxy group, a substituted or unsubstituted $C_3$-$C_{10}$ cycloalkyl group, a substituted or unsubstituted $C_1$-$C_{10}$ heterocycloalkyl group, a substituted or unsubstituted

$C_3$-$C_{10}$ cycloalkenyl group, a substituted or unsubstituted $C_1$-$C_{10}$ heterocycloalkenyl group, a substituted or unsubstituted $C_6$-$C_{60}$ aryl group, a substituted or unsubstituted $C_7$-$C_{60}$ alkyl aryl group, a substituted or unsubstituted $C_6$-$C_{60}$ aryloxy group, a substituted or unsubstituted $C_6$-$C_{60}$ arylthio group, a substituted or unsubstituted $C_7$-$C_{60}$ aryl alkyl group, a substituted or unsubstituted $C_1$-$C_{60}$ heteroaryl group, a substituted or unsubstituted $C_1$-$C_{60}$ heteroaryloxy group, a substituted or unsubstituted $C_1$-$C_{60}$ heteroarylthio group, a substituted or unsubstituted $C_2$-$C_{60}$ heteroaryl alkyl group, a substituted or unsubstituted $C_2$-$C_{60}$ alkyl heteroaryl group, a substituted or unsubstituted monovalent non-aromatic condensed polycyclic group, a substituted or unsubstituted monovalent non-aromatic condensed heteropolycyclic group, - $N(Q_1)(Q_2)$, $-Si(Q_3)(Q_4)(Q_5)$, $-B(Q_6)(Q_7)$, and $-P(=O)(Q_8)(Q_9)$. $Q_1$ to $Q_9$ are each independently the same as described above.

For example, $R_1$ to $R_8$, R', and R" may each independently be selected from:

hydrogen, deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, $-SF_5$, a $C_1$-C20 alkyl group, and a $C_1$-$C_{20}$ alkoxy group;
a $C_1$-$C_{20}$ alkyl group and a $C_1$-$C_{20}$ alkoxy group, each substituted with at least one selected from deuterium, -F, -Cl, -Br, -I, $-CD_3$, $-CD_2H$, $-CDH_2$, - $CF_3$, $-CF_2H$, $-CFH_2$, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{10}$ alkyl group, a cyclopentyl group, a cyclohexyl group, a cycloheptyl group, a cycloctyl group, an adamantanyl group, a norbornanyl group, a norbornenyl group, a cyclopentenyl group, a cyclohexenyl group, a cycloheptenyl group, a phenyl group, a biphenyl group, a naphthyl group, a pyridinyl group, and a pyrimidinyl group,
a cyclopentyl group, a cyclohexyl group, a cycloheptyl group, a cycloctyl group, an adamantanyl group, a norbornanyl group, a norbornenyl group, a cyclopentenyl group, a cyclohexenyl group, a cycloheptenyl group, a phenyl group, a biphenyl group, a $C_1$-$C_{20}$ alkyl phenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, and an imidazopyrimidinyl group;
a cyclopentyl group, a cyclohexyl group, a cycloheptyl group, a cycloctyl group, an adamantanyl group, a norbornanyl group, a norbornenyl group, a cyclopentenyl group, a cyclohexenyl group, a cycloheptenyl group, a phenyl group, a biphenyl group, a $C_1$-$C_{20}$ alkyl phenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, and an imidazopyrimidinyl group, each substituted with at least one selected from deuterium, -F, -Cl, -Br, -I, $-CD_3$, - $CD_2H$, $-CDH_2$, $-CF_3$, $-CF_2H$, $-CFH_2$, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{20}$ alkyl group, a $C_1$-$C_{20}$ alkoxy group, a cyclopentyl group, a cyclohexyl group, a cycloheptyl group, a cycloctyl group, an adamantanyl group, a norbornanyl group, a norbornenyl group, a cyclopentenyl group, a cyclohexenyl group, a cycloheptenyl group, a phenyl group, a biphenyl group, a $C_1$-$C_{20}$ alkyl phenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group,

an oxadiazolyl group, a triazinyl group, a dibenzofuranyl group, a dibenzothiophenyl group, a benzocarbazolyl group, a dibenzocarbazolyl group, an imidazopyridinyl group, and an imidazopyrimidinyl group; and
$-N(Q_1)(Q_2)$, $-Si(Q_3)(Q_4)(Q_5)$, $-B(Q_6)(Q_7)$, and $-P(=O)(Q_8)(Q_9)$, and
$Q_1$ to $Q_9$ may each independently be selected from:

$-CH_3$, $-CD_3$, $-CD_2H$, $-CDH_2$, $-CH_2CH_3$, $-CH_2CD_3$, $-CH_2CD_2H$, $- CH_2CDH_2$, $-CHDCH_3$, $-CHDCD_2H$, $-CHDCDH_2$, $-CHDCD_3$, $-CD_2CD_3$, $- CD_2CD_2H$, $-CD_2CH_3$, and $-CD_2CDH_2$;
an n-propyl group, an iso-propyl group, an n-butyl group, an iso-butyl group, a sec-butyl group, a tert-butyl group, an n-pentyl group, an isopentyl group, a sec-pentyl group, a tert-pentyl group, a phenyl group, and a naphthyl group; and
an n-propyl group, an iso-propyl group, an n-butyl group, an iso-butyl group, a sec-butyl group, a tert-butyl group, an n-pentyl group, an isopentyl group, a sec-pentyl group, a tert-pentyl group, a phenyl group, and a naphthyl group, each substituted with at least one selected from deuterium, a $C_1$-$C_{10}$ alkyl group, and a phenyl group.

In an embodiment, $R_1$ to $R_8$, R', and R" may each independently be selected from hydrogen, deuterium, -F, a cyano group, a nitro group, $-SF_5$, $-CH_3$, $-CD_3$, $-CD_2H$, $-CDH_2$, $-CF_3$, $-CF_2H$, $-CFH_2$, groups represented by Formulae 9-1 to 9-19, groups represented by Formulae 10-1 to 10-226, and $-Si(Q_1)(Q_2)(Q_3)$ (wherein $Q_1$ to $Q_3$ are the same as described above):

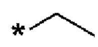
9-1
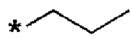
9-2
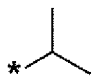
9-3
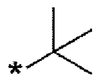
9-4
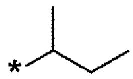
9-5
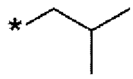
9-6
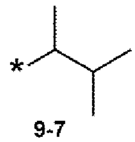
9-7
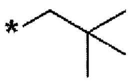
9-8
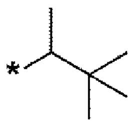
9-9
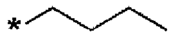
9-10
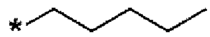
9-11
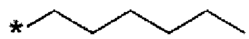
9-12
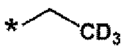
9-13
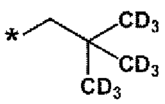
9-14
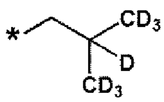
9-15
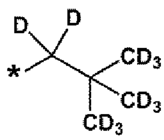
9-16
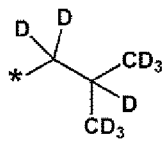
9-17
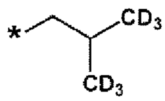
9-18
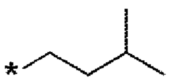
9-19
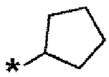
10-1
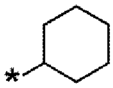
10-2
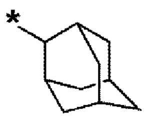
10-3
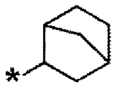
10-4
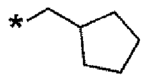
10-5
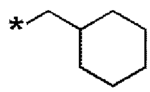
10-6
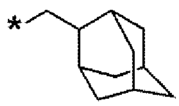
10-7

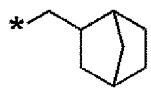
10-8

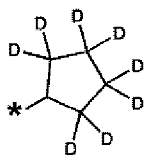
10-9

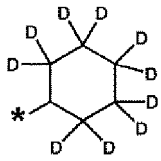
10-10

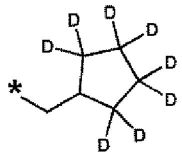
10-11

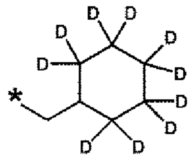
10-12

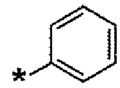
10-13

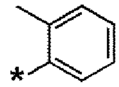
10-14

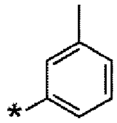
10-15

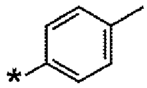
10-16

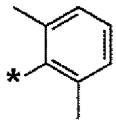
10-17

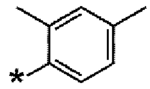
10-18

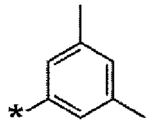
10-19

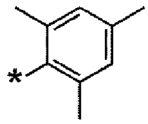
10-20

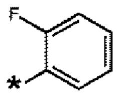
10-21

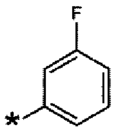
10-22

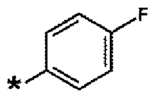
10-23

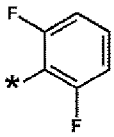
10-24

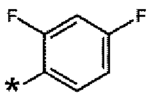
10-25

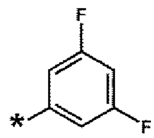
10-26

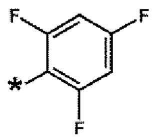
10-27

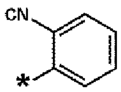
10-28

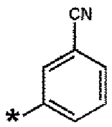
10-29

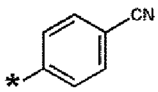
10-30

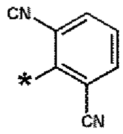
10-31

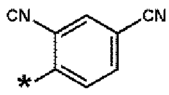
10-32

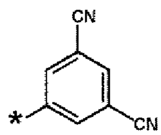
10-33

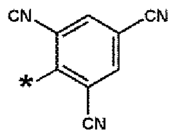
10-34

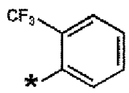
10-35

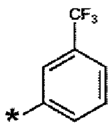
10-36

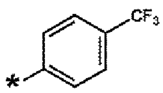
10-37

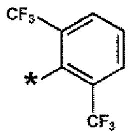
10-38

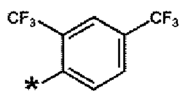
10-39

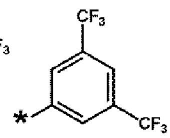
10-40

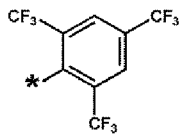
10-41

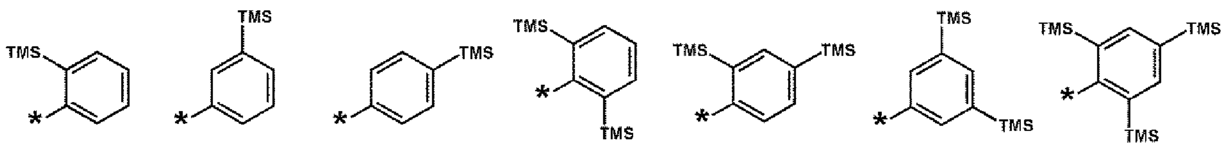
10-42 10-43 10-44 10-45 10-46 10-47 10-48

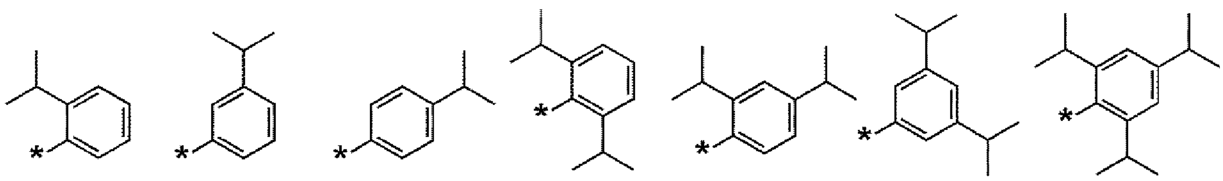
10-49 10-50 10-51 10-52 10-53 10-54 10-55

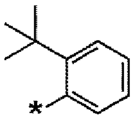
10-56
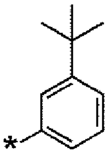
10-57
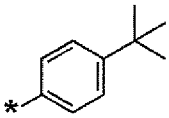
10-58
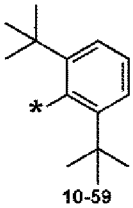
10-59
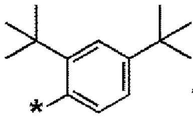
10-60
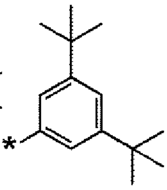
10-61
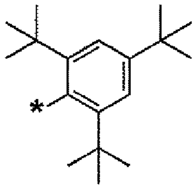
10-62

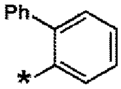
10-63
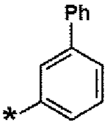
10-64
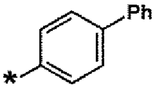
10-65
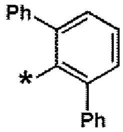
10-66
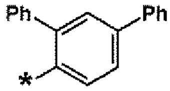
10-67
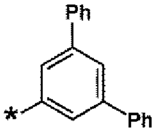
10-68
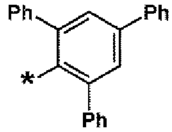
10-69

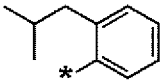
10-70
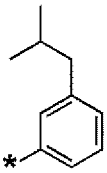
10-71
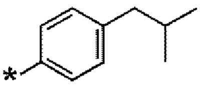
10-72
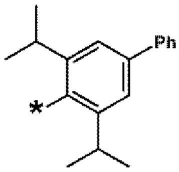
10-73
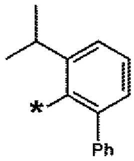
10-74
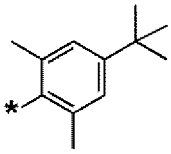
10-75

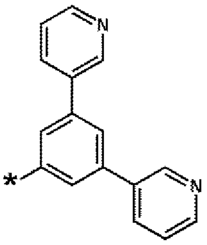
10-76
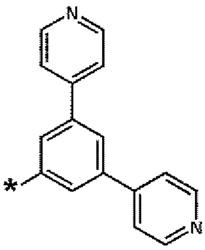
10-77
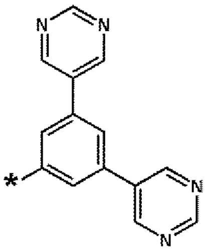
10-78
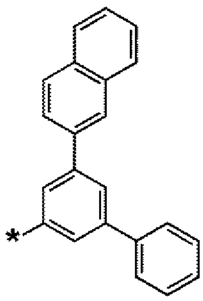
10-79
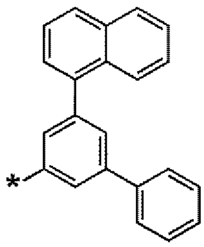
10-80

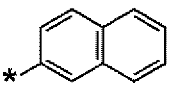
10-81
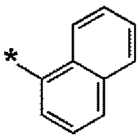
10-82
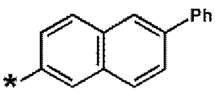
10-83
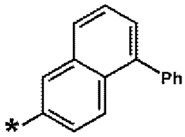
10-84
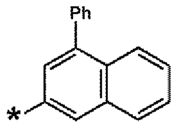
10-85

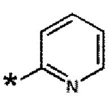
10-86
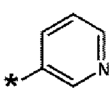
10-87
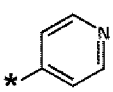
10-88
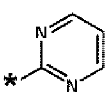
10-89
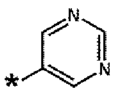
10-90
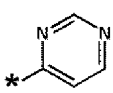
10-91
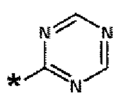
10-92

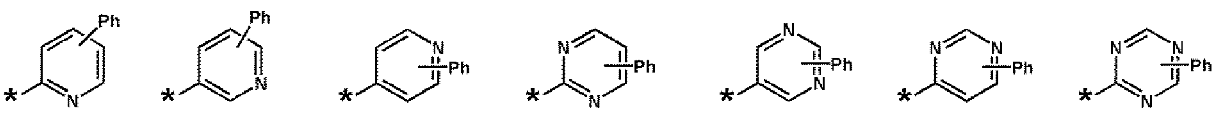
10-93 10-94 10-95 10-96 10-97 10-98 10-99

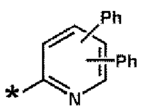 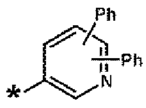 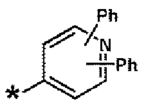 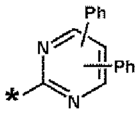 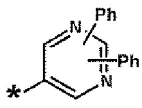 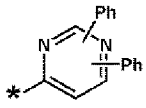 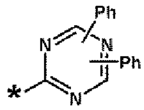

10-100 10-101 10-102 10-103 10-104 10-105 10-106

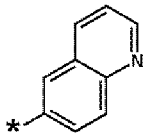 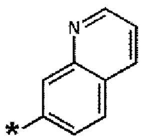 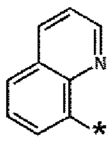 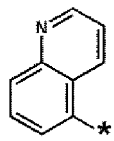 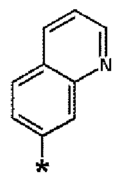 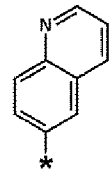

10-107 10-108 10-109 10-110 10-111 10-112

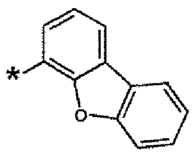 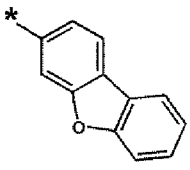 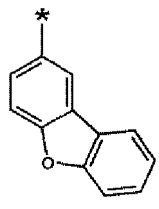 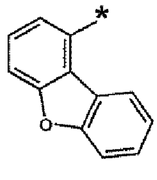 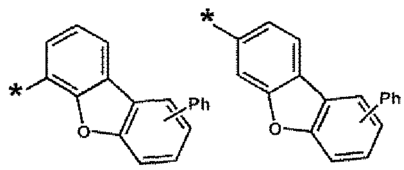

10-113 10-114 10-115 10-116 10-117 10-118

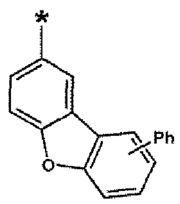 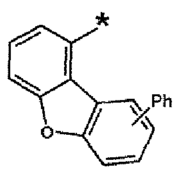 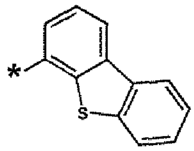 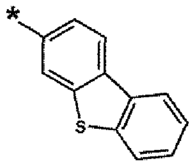 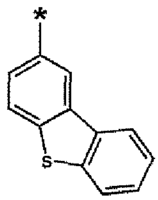 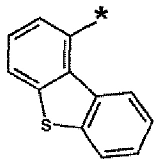

10-119 10-120 10-121 10-122 10-123 10-124

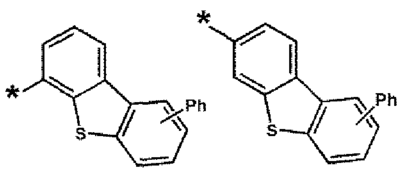 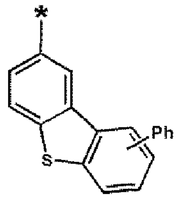 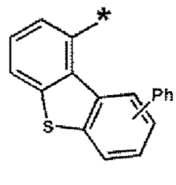 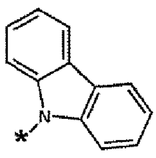 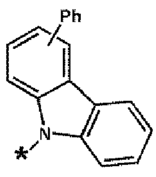

10-125 10-126 10-127 10-128 10-129 10-130

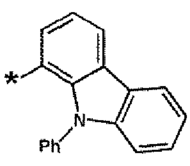 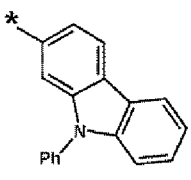 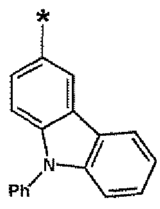 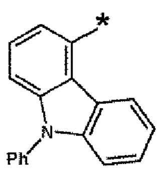 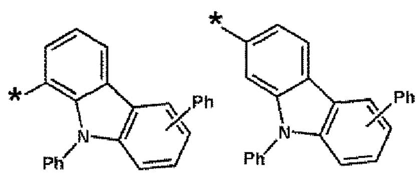

10-131 10-132 10-133 10-134 10-135 10-136

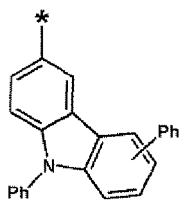 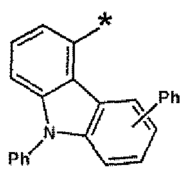 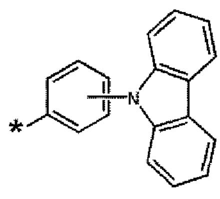 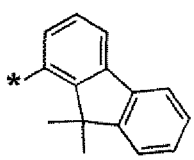 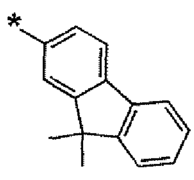 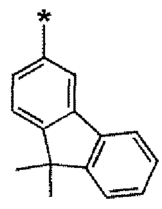

10-137 10-138 10-139 10-140 10-141 10-142

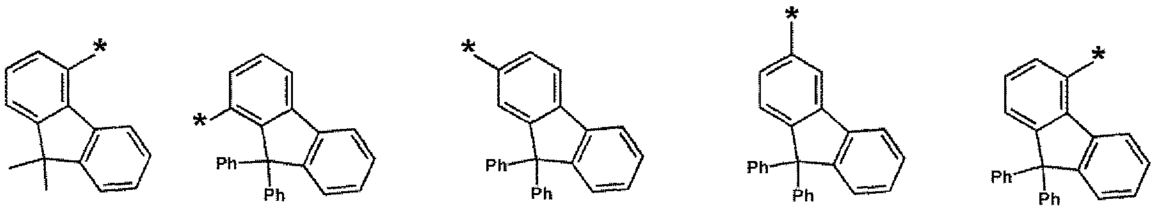
10-143 10-144 10-145 10-146 10-147

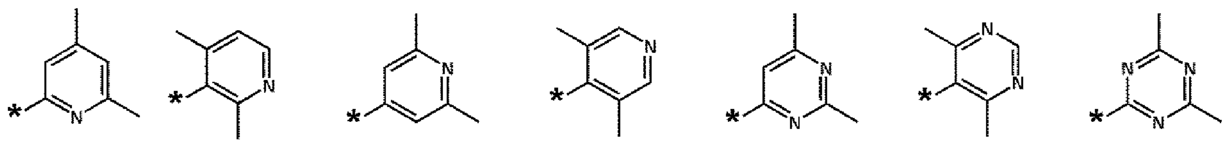
10-148 10-149 10-150 10-151 10-152 10-153 10-154

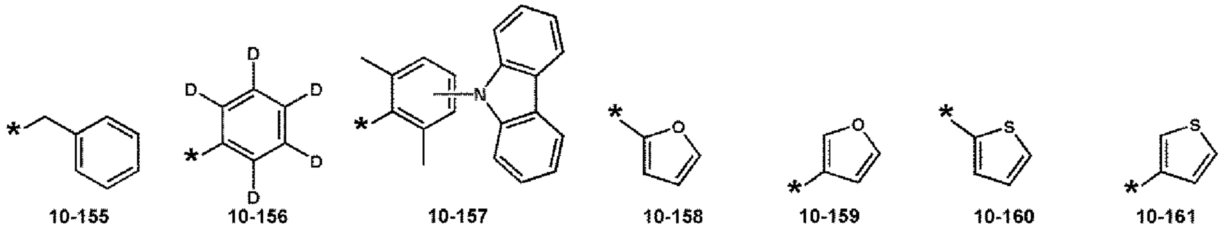
10-155 10-156 10-157 10-158 10-159 10-160 10-161

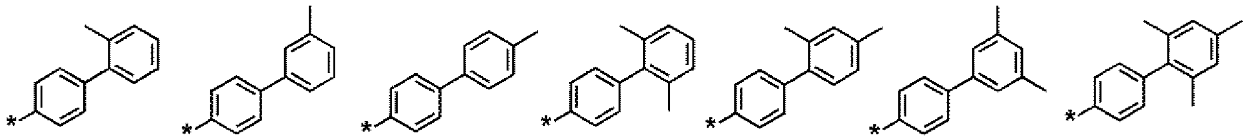
10-162 10-163 10-164 10-165 10-166 10-167 10-168

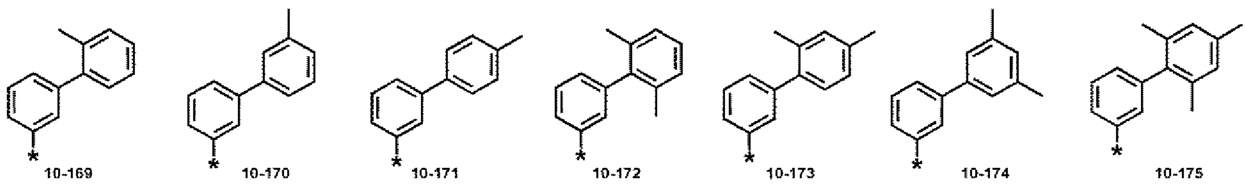
10-169 10-170 10-171 10-172 10-173 10-174 10-175

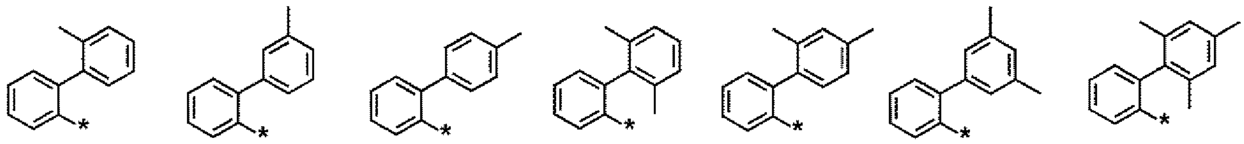
10-176 10-177 10-178 10-179 10-180 10-181 10-182

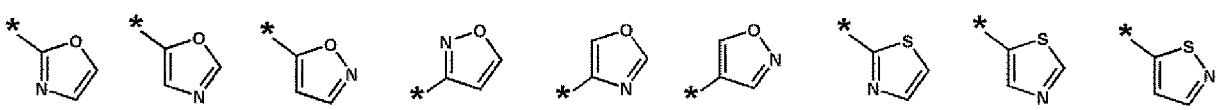
10-183 10-184 10-185 10-186 10-187 10-188 10-189 10-190 10-191

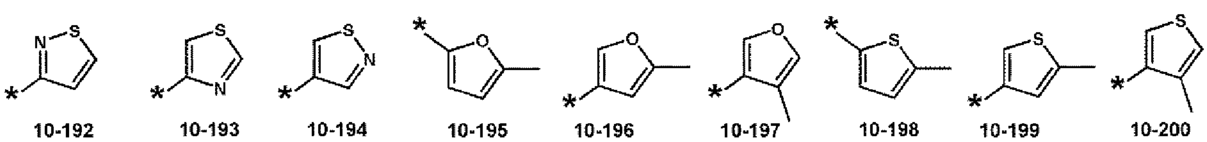
10-192 10-193 10-194 10-195 10-196 10-197 10-198 10-199 10-200

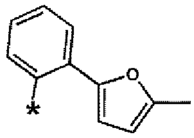
10-201

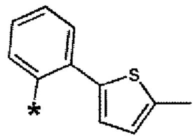
10-202

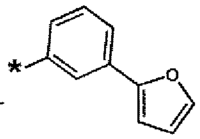
10-203

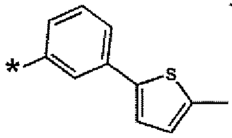
10-204

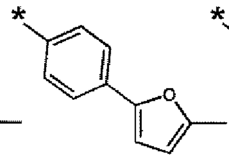
10-205

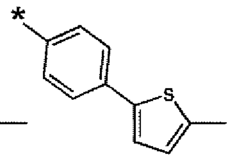
10-206

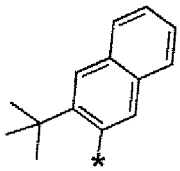
10-207

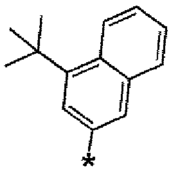
10-208

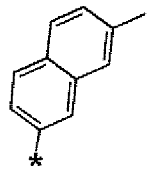
10-209

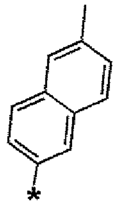
10-210

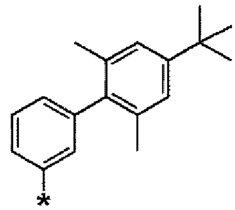
10-211

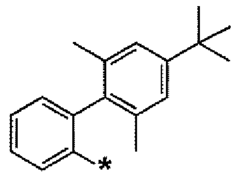
10-212

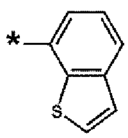
10-213

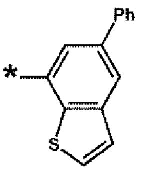
10-214

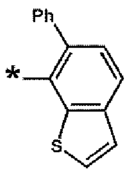
10-215

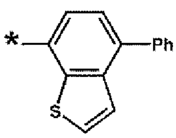
10-216

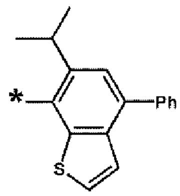
10-217

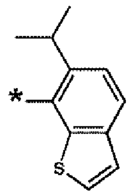
10-218

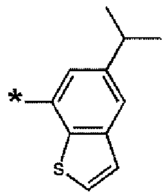
10-219

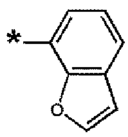
10-220

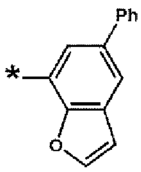
10-221

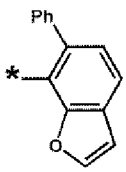
10-222

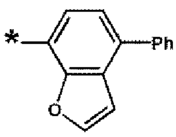
10-223

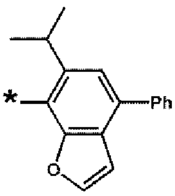
10-224

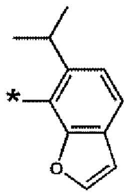
10-225

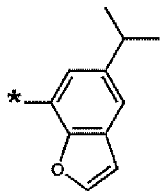
10-226

.

In Formulae 9-1 to 9-19 and 10-1 to 10-226, * indicates a binding site to a neighboring atom, Ph indicates a phenyl group, and TMS indicates a trimethylsilyl group.

a1 to a4 in Formula 1 indicate the number of groups $R_1$ to $R_4$, respectively, and may each independently be an integer from 0 to 20. When a1 is two or more, two or more groups $R_1$ may be identical to or different from each other, when a2 is two or more, two or more groups $R_2$ may be identical to or different from each other, when a3 is two or more, two or more groups $R_3$ may be identical to or different from each other, and when a4 is two or more, two or more groups $R_4$ may be identical to or different from each other. For example, a1 to a4 may each independently be an integer from 0 to 7.

In Formula 1, i) two of a plurality of neighboring groups $R_1$ may optionally be linked to form a $C_5$-$C_{30}$ carbocyclic group unsubstituted or substituted with at least one $R_{10a}$ or a $C_1$-$C_{30}$ heterocyclic group unsubstituted or substituted with at least one $R_{10a}$, ii) two of a plurality of neighboring groups $R_2$ may optionally be linked to form a $C_5$-$C_{30}$ carbocyclic group unsubstituted or substituted with at least one $R_{10a}$ or a $C_1$-$C_{30}$ heterocyclic group unsubstituted or substituted with at least one $R_{10a}$, iii) two of a plurality of neighboring groups $R_3$ may optionally be linked to form a $C_5$-$C_{30}$ carbocyclic group unsubstituted or substituted with at least one $R_{10a}$ or a $C_1$-$C_{30}$ heterocyclic group unsubstituted or substituted with at least one $R_{10a}$, iv) two of a plurality of neighboring groups $R_4$ may optionally be linked to form a $C_5$-$C_{30}$ carbocyclic group unsubstituted or substituted with at least one $R_{10a}$ or a $C_1$-$C_{30}$ heterocyclic group unsubstituted or substituted with at least one $R_{10a}$, v) two of $R_1$ to $R_8$, R', and R" may optionally be linked to form a $C_5$-$C_{30}$ carbocyclic group unsubstituted or substituted with at least one $R_{10a}$ or a $C_1$-$C_{30}$ heterocyclic group unsubstituted or substituted with at least one $R_{10a}$. The "$C_5$-$C_{30}$ carbocyclic group" and the "$C_1$-$C_{30}$ heterocyclic group" are the same as described in connection with ring $CY_1$, and $R_{10a}$ is the same as described in connection with $R_1$.

**[0041]** * and *' each indicate a binding site to a neighboring atom.

In an embodiment, the organometallic compound represented by Formula 1 may satisfy one of Condition 1 and Condition 2:

Condition 1

i) $X_5$ and $X_6$ are each a chemical bond,
ii) $T_2$ is not a single bond,
iii) a moiety represented by

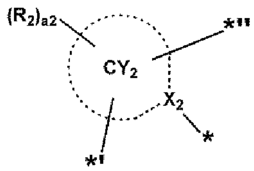

is represented by Formula A2-1, and
iv) a moiety represented by

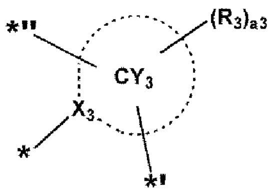

is represented by Formula A3-1; and

Condition 2

i) $X_5$ and $X_6$ are each a chemical bond,
ii) $T_2$ is a single bond,
iii) a moiety represented by

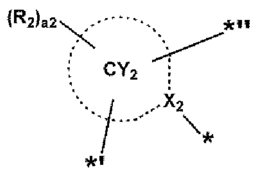

is represented by Formula A2-2, or a moiety represented by

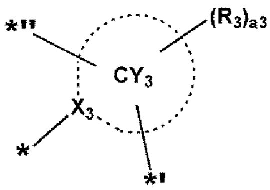

is represented by Formula A3-3:

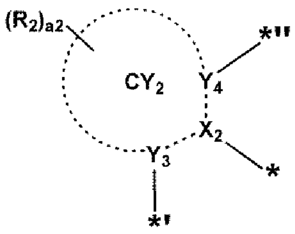
A2-1

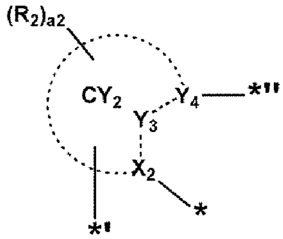
A2-2

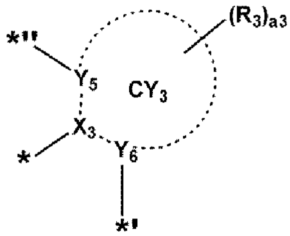
A3-1

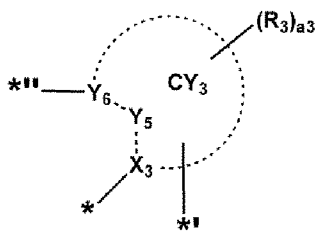
A3-3

.

In Formulae A2-1, A2-2, A3-1, and A3-3, $X_2$, $X_3$, $R_2$, $R_3$, a2, and a3 are the same as described herein, and $Y_3$ to $Y_6$ may each independently be N or C,
in Formulae A2-1 and A2-2, * indicates a binding site to $X_5$ or M in Formula 1, *' indicates a binding site to $T_1$ in Formula 1, and *" indicates a binding site to $T_2$ in Formula 1, and
in Formulae A3-1 and A3-3, * indicates a binding site to $X_6$ or M in Formula 1,
*" indicates a binding site to $T_2$ in Formula 1, and *' indicates a binding site to $T_3$ in Formula 1.

In one or more embodiments, a moiety represented by

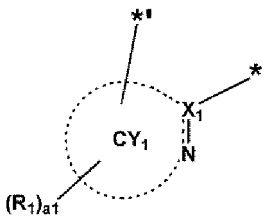

in Formula 1 may be represented by one of Formulae A1-1(1) to A1-1(28) and A1-2(1) to A1-2(9):

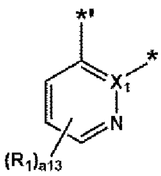
A1-1(1)

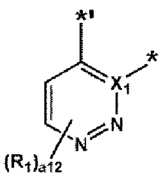
A1-1(2)

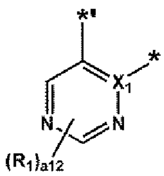
A1-1(3)

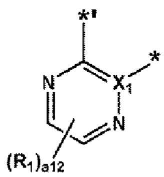
A1-1(4)

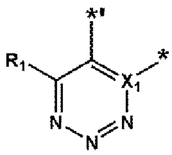
A1-1(5)

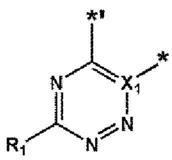
A1-1(6)

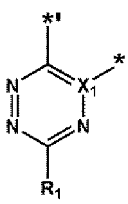
A1-1(7)

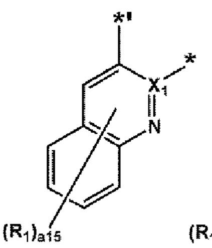
A1-1(8)

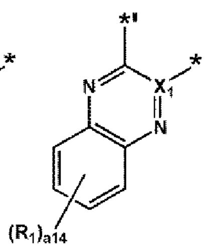
A1-1(9)

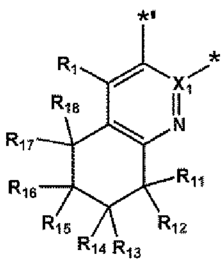
A1-1(10)

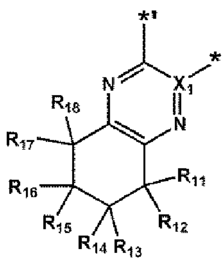
A1-1(11)

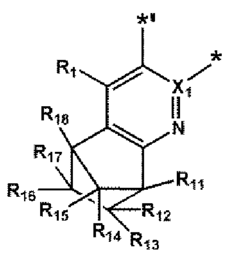
A1-1(12)

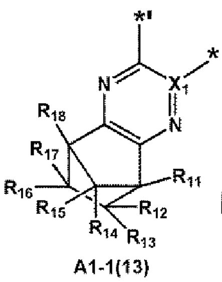
A1-1(13)

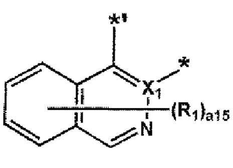
A1-1(14)

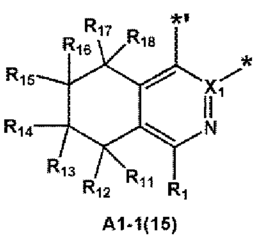
A1-1(15)

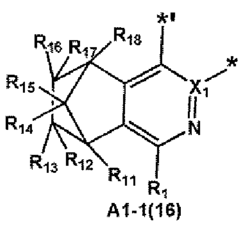
A1-1(16)

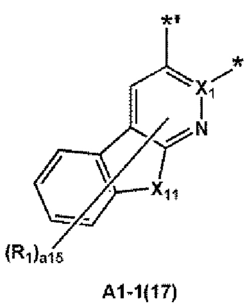
A1-1(17)

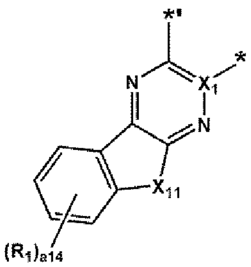
A1-1(18)

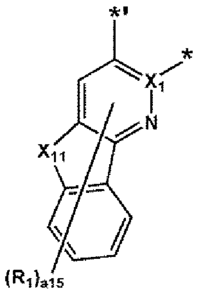
A1-1(19)

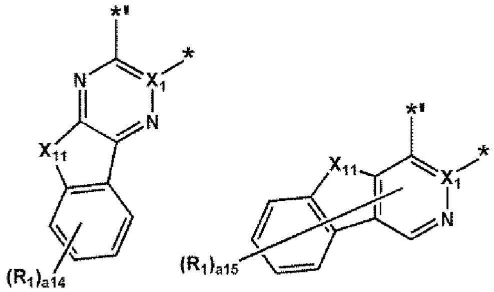
A1-1(20)

A1-1(21)

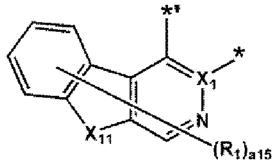
A1-1(22)

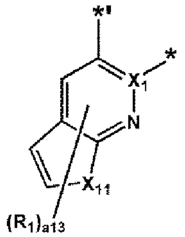
A1-1(23)

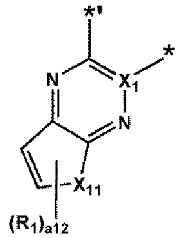
A1-1(24)

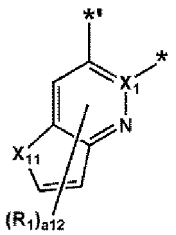
A1-1(25)

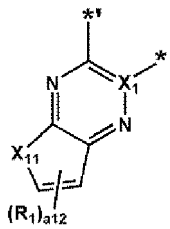
A1-1(26)

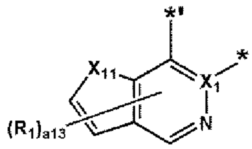
A1-1(27)

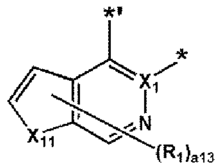
A1-1(28)

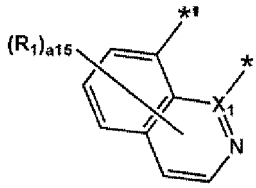
A1-2(1)

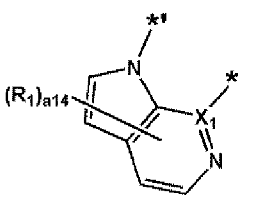
A1-2(2)

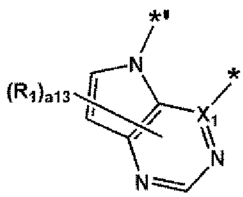
A1-2(3)

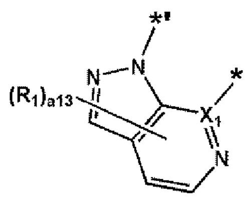
A1-2(4)

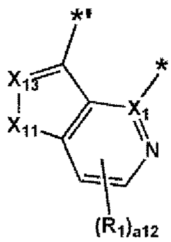
A1-2(5)

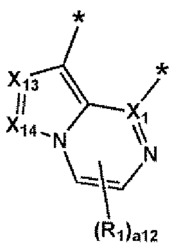
A1-2(6)

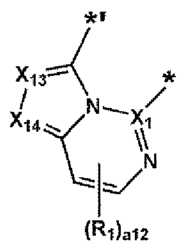
A1-2(7)

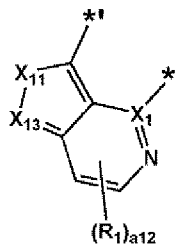
A1-2(8)

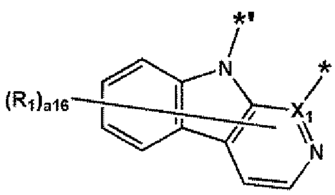
A1-2(9)

.

In Formulae A1-1(1) to A1-1(28) and A1-2(1) to A1-2(9),

$X_1$ and $R_1$ are the same as described herein,
X11 may be O, S, $N(R_{11})$, $C(R_{11})(R_{12})$, or $Si(R_{11})(R_{12})$,
$X_{13}$ may be N or $C(R_{13})$,
$X_{14}$ may be N or $C(R_{14})$,
$R_{11}$ to $R_{18}$ are the same as described in connection with $R_1$,

a15 may be an integer from 0 to 5,
a14 may be an integer from 0 to 4,
a13 may be an integer from 0 to 3,
a12 may be an integer from 0 to 2,
* indicates a binding site to M in Formula 1, and
*' indicates a binding site to $T_1$ in Formula 1.

In one or more embodiments, a moiety represented by

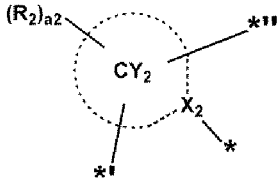

in Formula 1 may be represented by one of Formulae A2-1(1) to A2-1(21), A2-2(1) to A2-2(58), and A2-3(1) to A2-3(58):

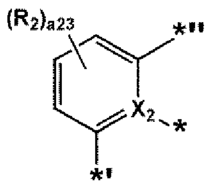

A2-1(1)

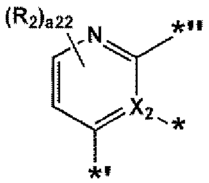

A2-1(2)

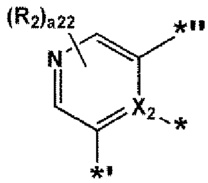

A2-1(3)

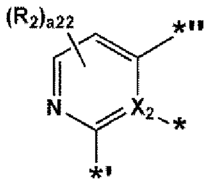

A2-1(4)

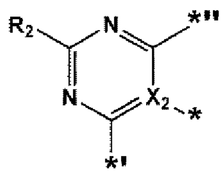

A2-1(5)

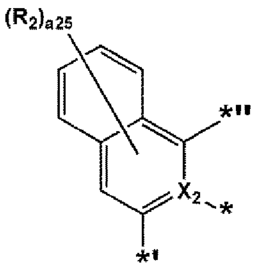

A2-1(6)

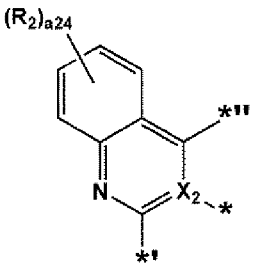

A2-1(7)

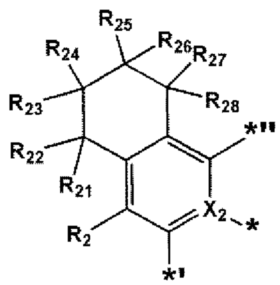

A2-1(8)

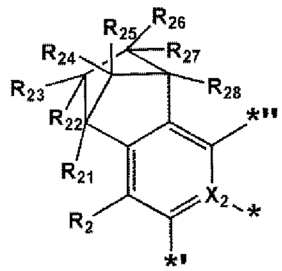

A2-1(9)

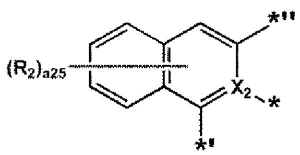

A2-1(10)

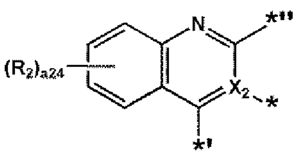

A2-1(11)

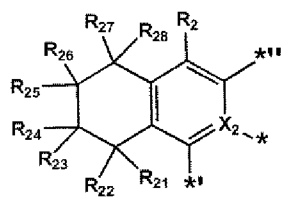

A2-1(12)

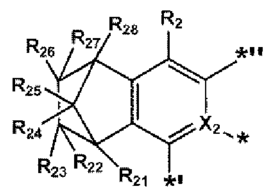

A2-1(13)

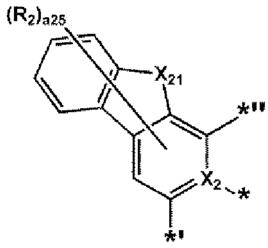
A2-1(14)

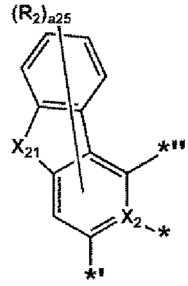
A2-1(15)

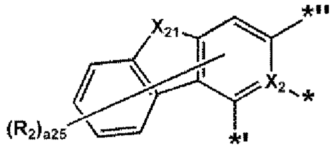
A2-1(16)

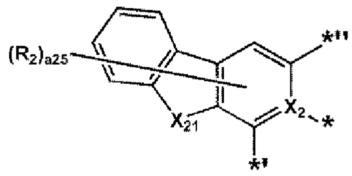
A2-1(17)

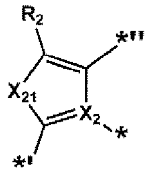
A2-1(18)

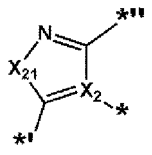
A2-1(19)

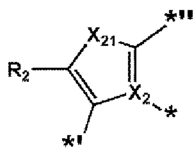
A2-1(20)

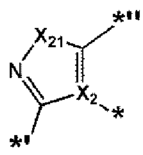
A2-1(21)

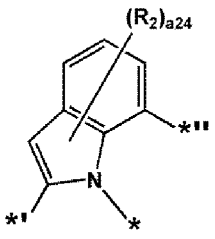
A2-2(1)

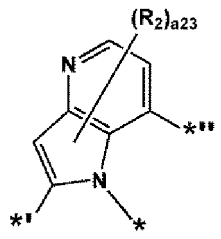
A2-2(2)

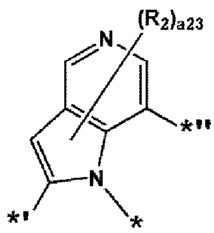
A2-2(3)

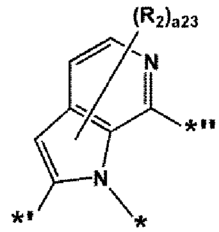
A2-2(4)

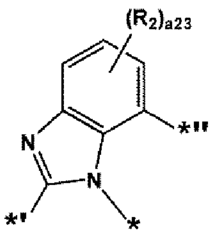
A2-2(5)

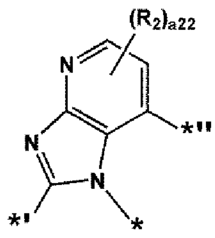
A2-2(6)

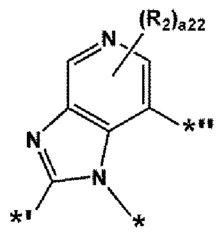
A2-2(7)

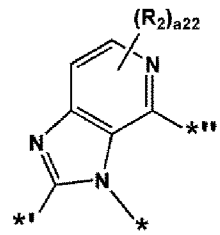
A2-2(8)

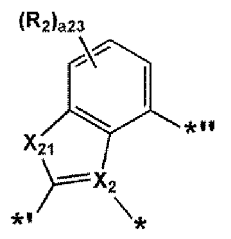
A2-2(9)

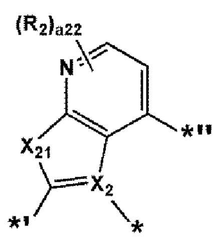
A2-2(10)

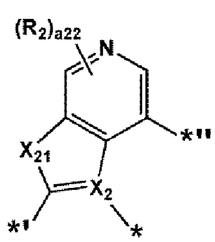
A2-2(11)

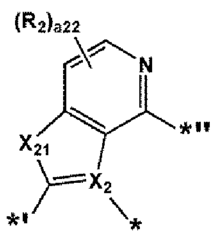
A2-2(12)

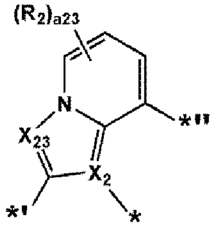
A2-2(13)

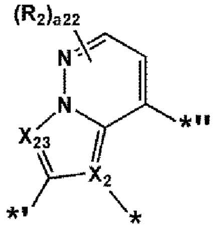
A2-2(14)

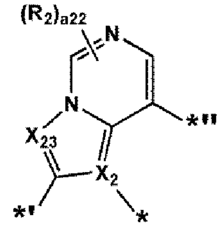
A2-2(15)

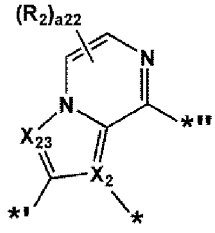
A2-2(16)

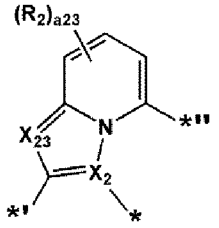
A2-2(17)

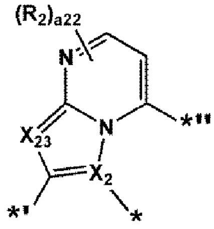
A2-2(18)

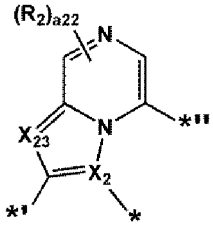
A2-2(19)

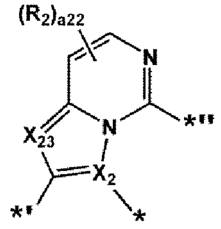
A2-2(20)

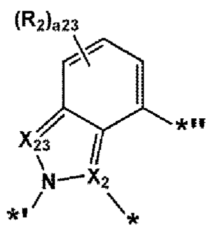
A2-2(21)

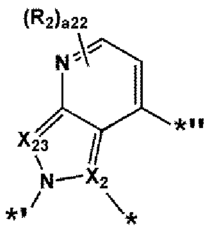
A2-2(22)

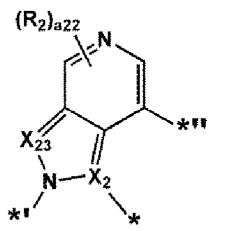
A2-2(23)

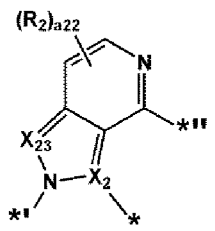
A2-2(24)

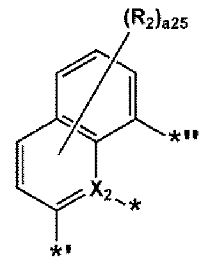
A2-2(25)

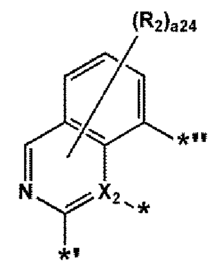
A2-2(26)

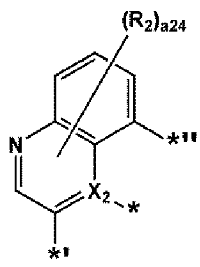
A2-2(27)

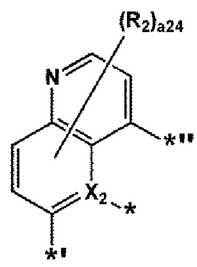
A2-2(28)

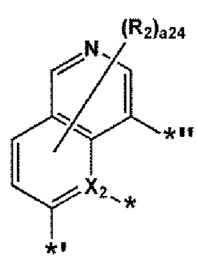
A2-2(29)

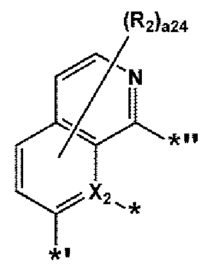
A2-2(30)

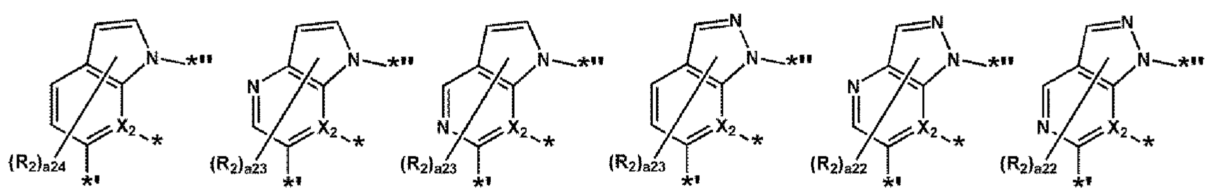
A2-2(31) A2-2(32) A2-2(33) A2-2(34) A2-2(35) A2-2(36)

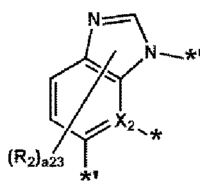
A2-2(37)

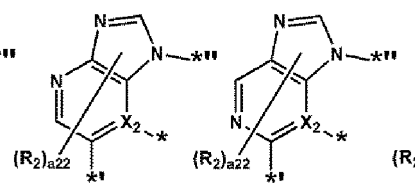
A2-2(38) A2-2(39)

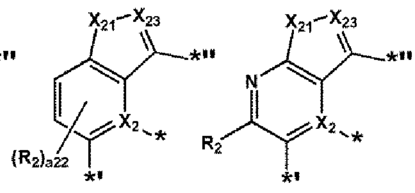
A2-2(40) A2-2(41)

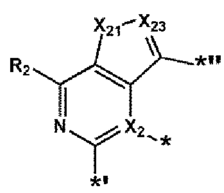
A2-2(42)

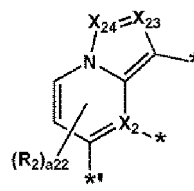
A2-2(43)

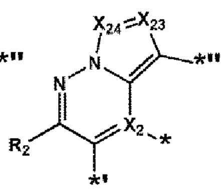
A2-2(44)

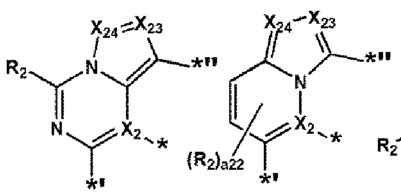
A2-2(45) A2-2(46)

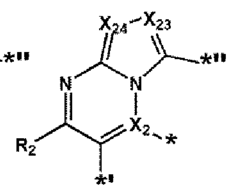
A2-2(47)

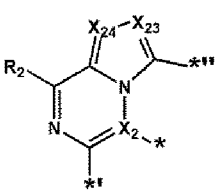
A2-2(48)

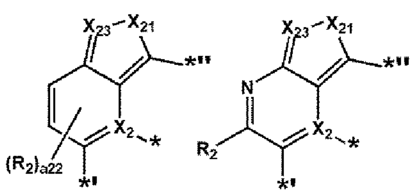
A2-2(49) A2-2(50)

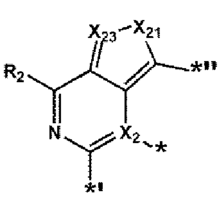
A2-2(51)

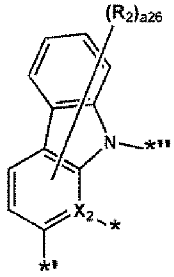
A2-2(52)

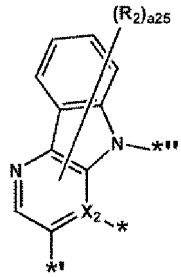
A2-2(53)

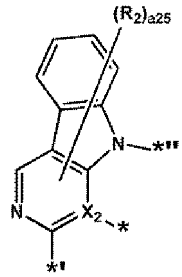
A2-2(54)

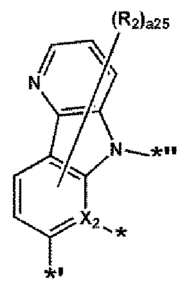
A2-2(55)

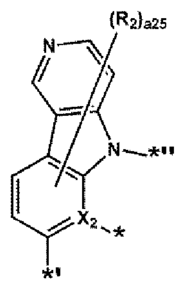
A2-2(56)

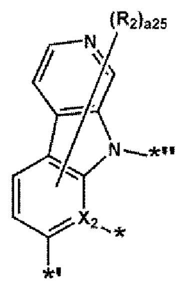
A2-2(57)

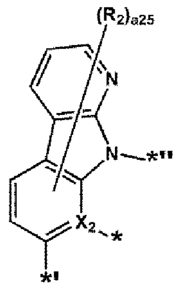
A2-2(58)

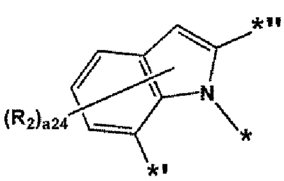
A2-3(1)

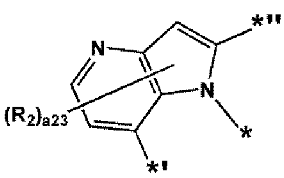
A2-3(2)

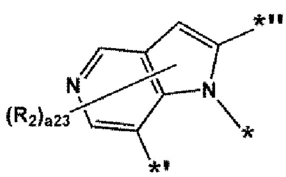
A2-3(3)

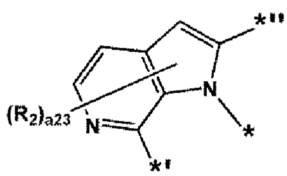
A2-3(4)

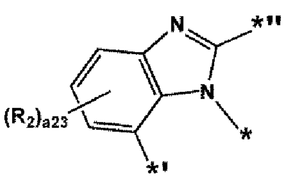
A2-3(5)

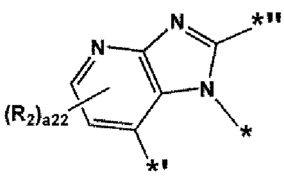
A2-3(6)

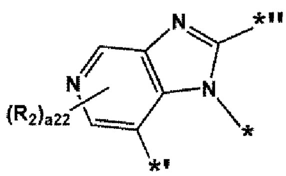
A2-3(7)

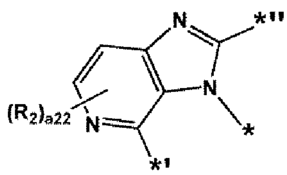
A2-3(8)

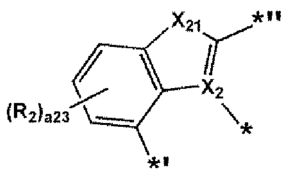
A2-3(9)

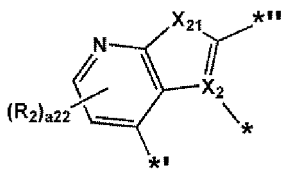
A2-3(10)

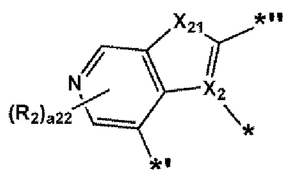
A2-3(11)

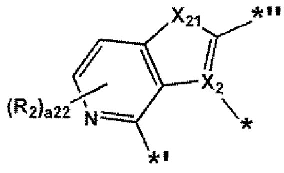
A2-3(12)

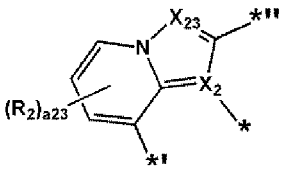
A2-3(13)

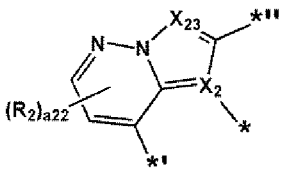
A2-3(14)

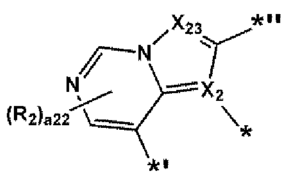
A2-3(15)

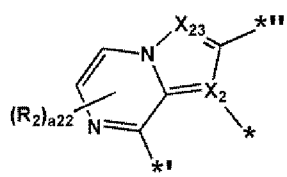
A2-3(16)

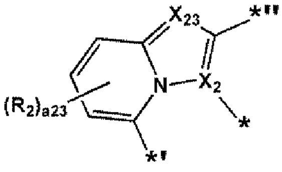
A2-3(17)

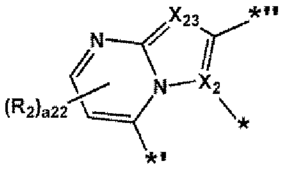
A2-3(18)

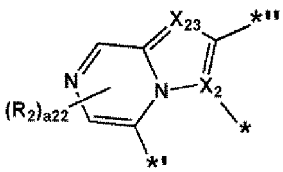
A2-3(19)

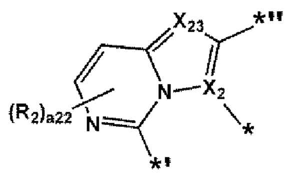
A2-3(20)

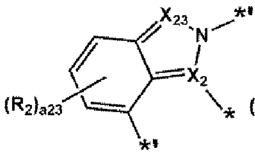
A2-3(21)

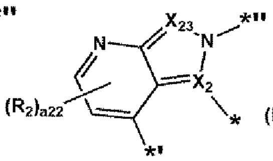
A2-3(22)

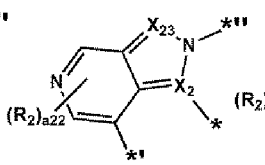
A2-3(23)

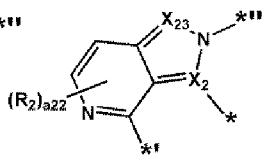
A2-3(24)

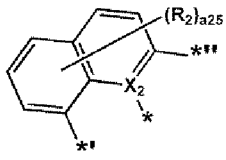
A2-3(25)

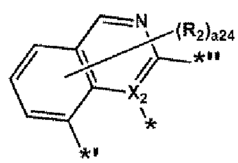
A2-3(26)

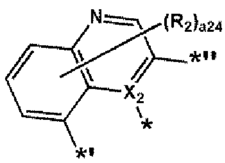
A2-3(27)

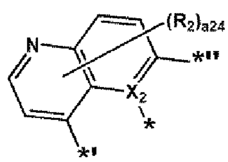
A2-3(28)

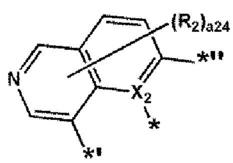
A2-3(29)

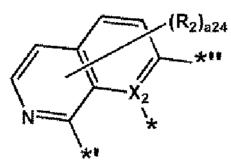
A2-3(30)

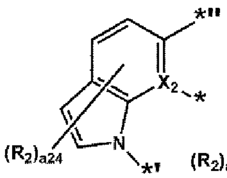
A2-3(31)

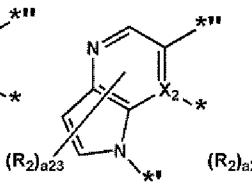
A2-3(32)

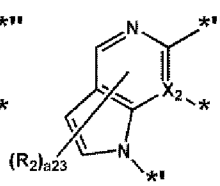
A2-3(33)

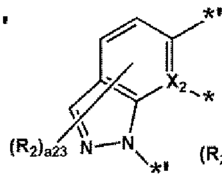
A2-3(34)

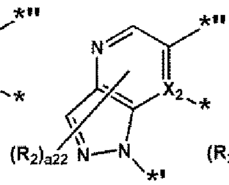
A2-3(35)

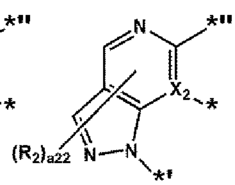
A2-3(36)

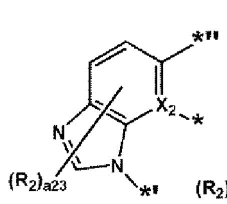
A2-3(37)

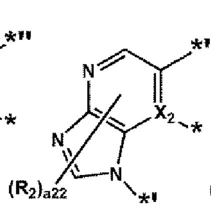
A2-3(38)

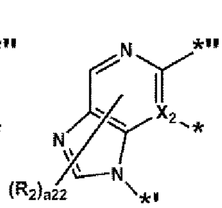
A2-3(39)

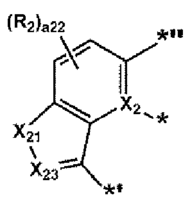
A2-3(40)

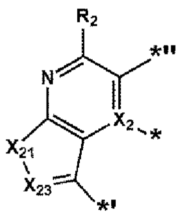
A2-3(41)

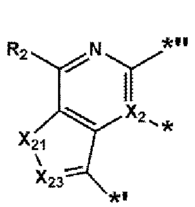
A2-3(42)

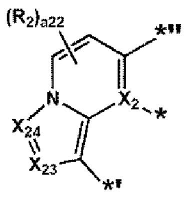 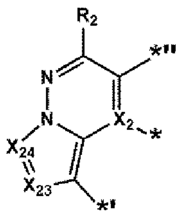 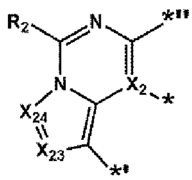 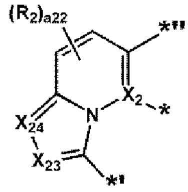 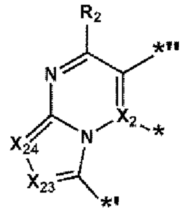 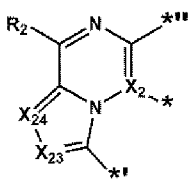

A2-3(43) A2-3(44) A2-3(45) A2-3(46) A2-3(47) A2-3(48)

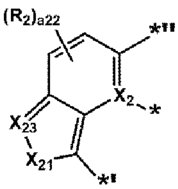 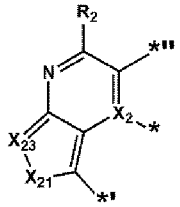 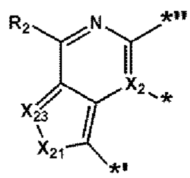 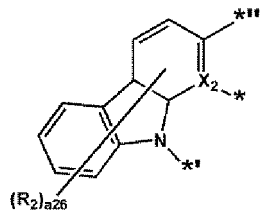 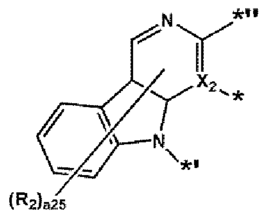

A2-3(49) A2-3(50) A2-3(51) A2-3(52) A2-3(53)

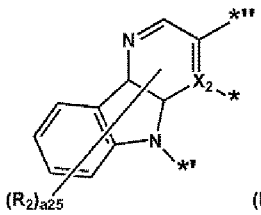 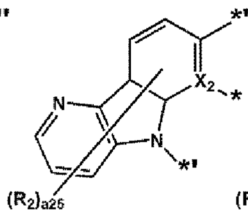 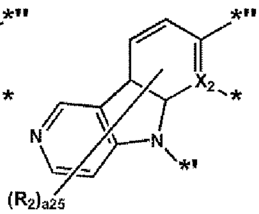 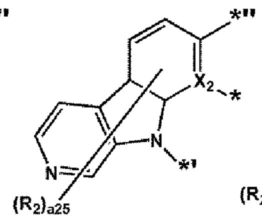 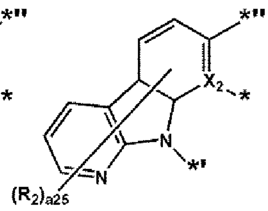

A2-3(54) A2-3(55) A2-3(56) A2-3(57) A2-3(58)

.

In Formulae A2-1(1) to A2-1(21), A2-2(1) to A2-2(58), and A2-3(1) to A2-3(58),

$X_2$ and $R_2$ are the same as described herein,
$X_{21}$ may be O, S, $N(R_{21})$, $C(R_{21})(R_{22})$, or $Si(R_{21})(R_{22})$,
$X_{23}$ may be N or $C(R_{23})$,
$X_{24}$ may be N or $C(R_{24})$,
$R_{21}$ to $R_{28}$ are the same as described in connection with $R_2$,
a26 may be an integer from 0 to 6,
a25 may be an integer from 0 to 5,
a24 may be an integer from 0 to 4,
a23 may be an integer from 0 to 3,
a22 may be an integer from 0 to 2,
* indicates a binding site to $X_5$ or M in Formula 1,
*' indicates a binding site to $T_1$ in Formula 1, and
*" indicates a binding site to $T_2$ in Formula 1.

In one or more embodiments, a moiety represented by

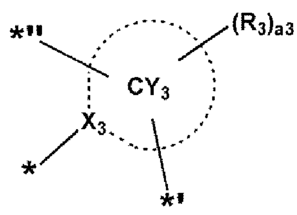

in Formula 1 may be selected from groups represented by Formulae A3-1(1) to A3-1(21), A3-2(1) to A3-2(58), and A3-3(1) to A3-3(58):

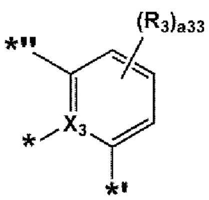
A3-1(1)

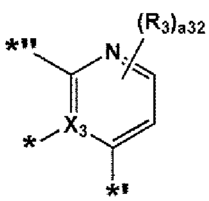
A3-1(2)

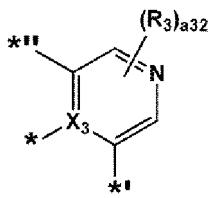
A3-1(3)

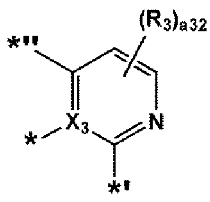
A3-1(4)

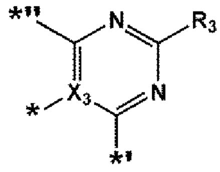
A3-1(5)

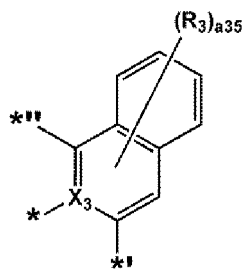
A3-1(6)

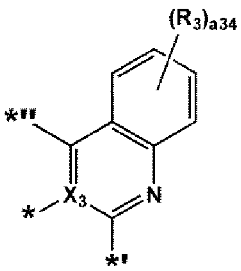
A3-1(7)

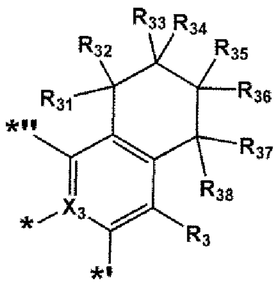
A3-1(8)

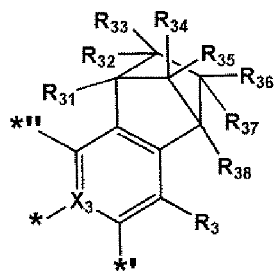
A3-1(9)

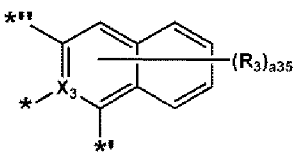
A3-1(10)

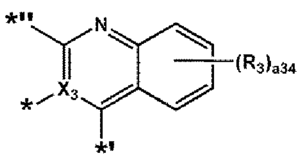
A3-1(11)

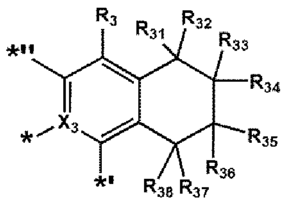
A3-1(12)

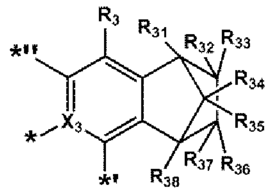
A3-1(13)

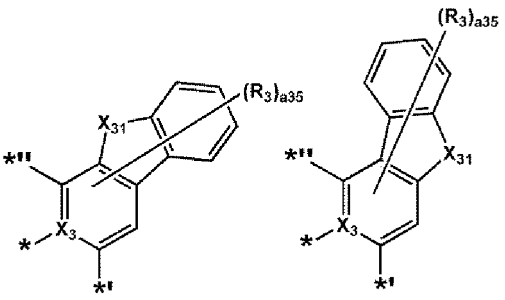
A3-1(14)

A3-1(15)

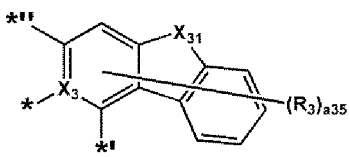
A3-1(16)

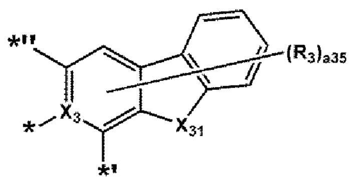
A3-1(17)

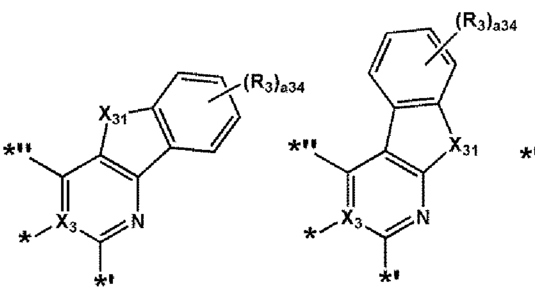
A3-1(18)

A3-1(19)

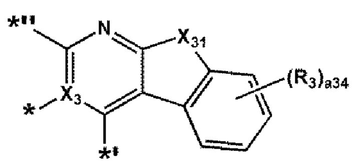
A3-1(20)

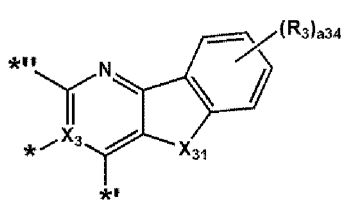
A3-1(21)

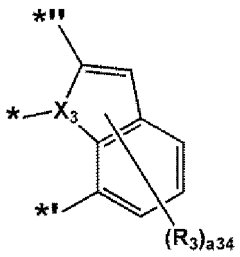
A3-2(1)

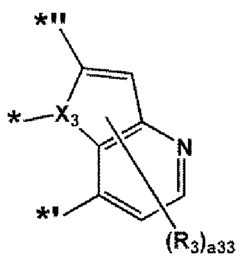
A3-2(2)

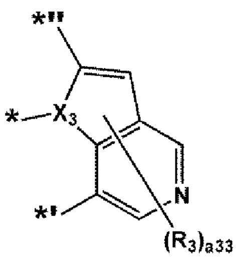
A3-2(3)

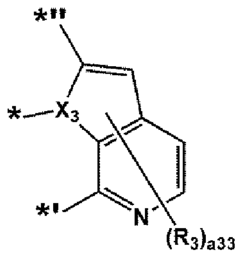
A3-2(4)

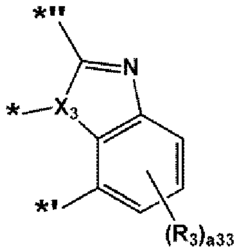
A3-2(5)

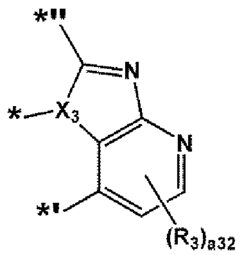
A3-2(6)

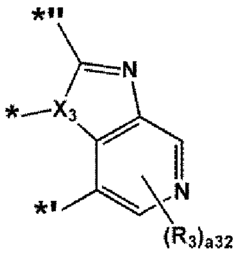
A3-2(7)

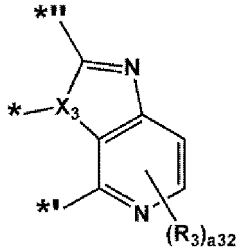
A3-2(8)

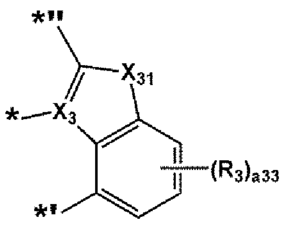
A3-2(9)

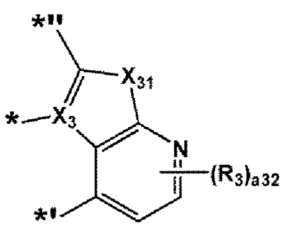
A3-2(10)

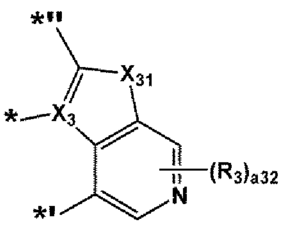
A3-2(11)

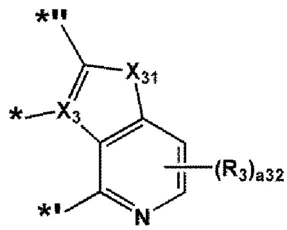
A3-2(12)

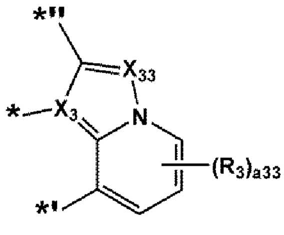
A3-2(13)

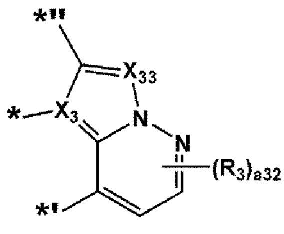
A3-2(14)

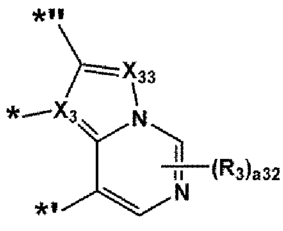
A3-2(15)

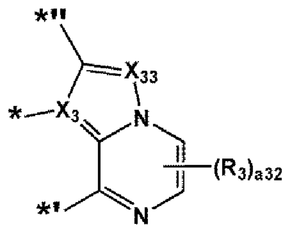
A3-2(16)

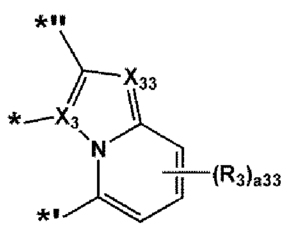
A3-2(17)

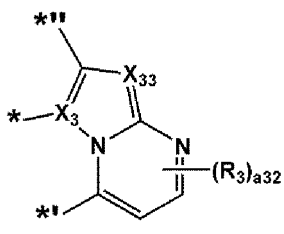
A3-2(18)

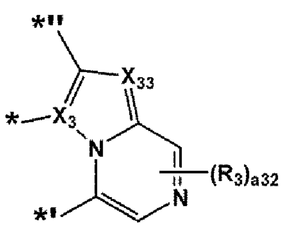
A3-2(19)

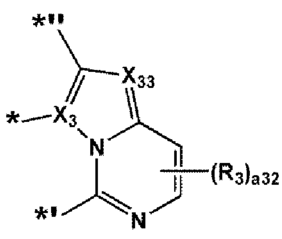
A3-2(20)

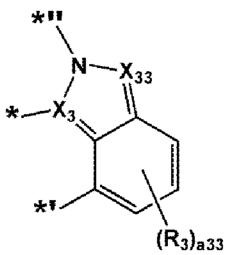

A3-2(21)

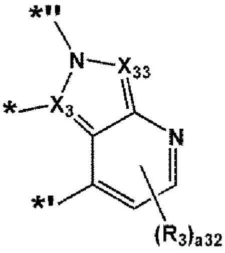

A3-2(22)

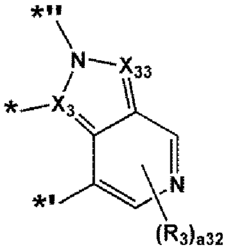

A3-2(23)

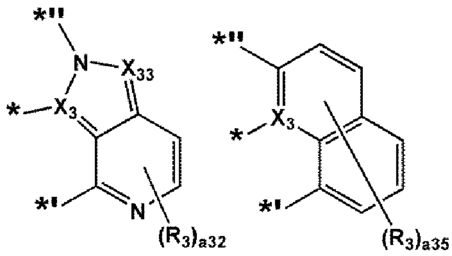

A3-2(24) A3-2(25)

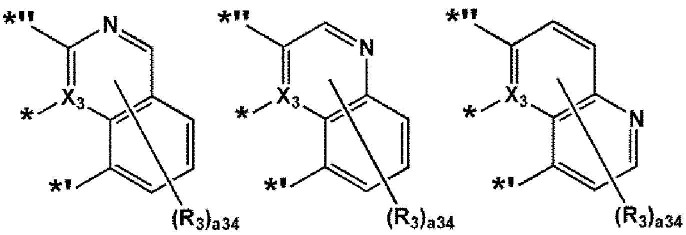

A3-2(26) A3-2(27) A3-2(28)

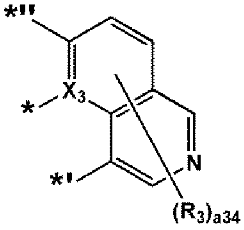

A3-2(29)

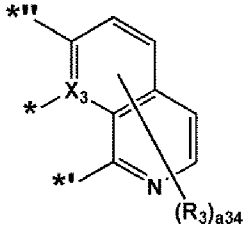

A3-2(30)

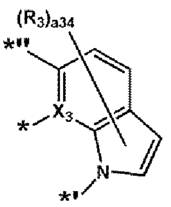

A3-2(31)

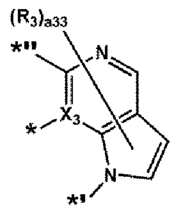

A3-2(32)

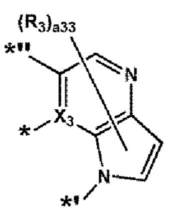

A3-2(33)

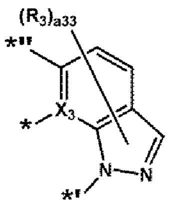

A3-2(34)

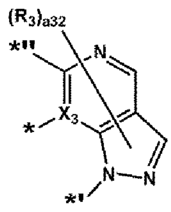

A3-2(35)

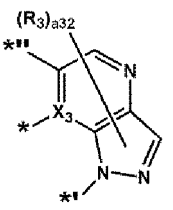

A3-2(36)

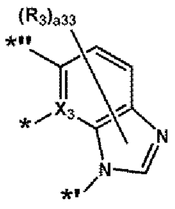

A3-2(37)

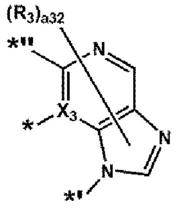

A3-2(38)

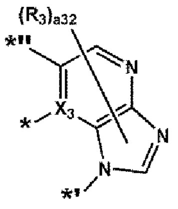

A3-2(39)

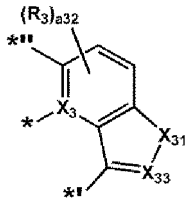

A3-2(40)

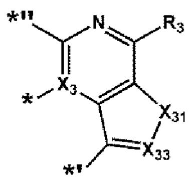

A3-2(41)

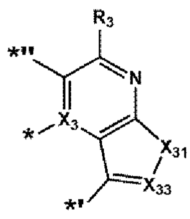

A3-2(42)

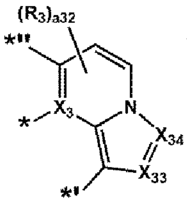

A3-2(43)

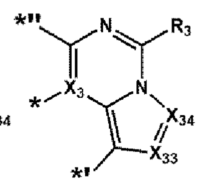

A3-2(44)

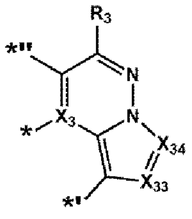

A3-2(45)

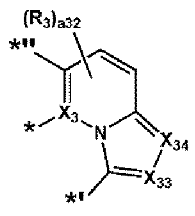

A3-2(46)

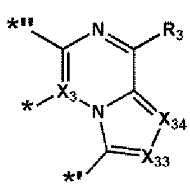

A3-2(47)

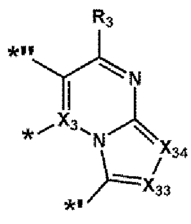

A3-2(48)

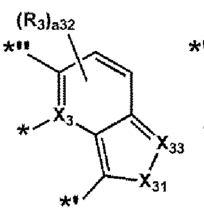

A3-2(49)

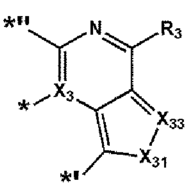

A3-2(50)

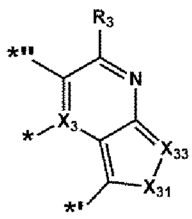

A3-2(51)

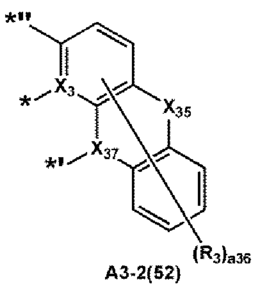

A3-2(52)

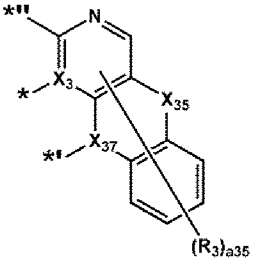

A3-2(53)

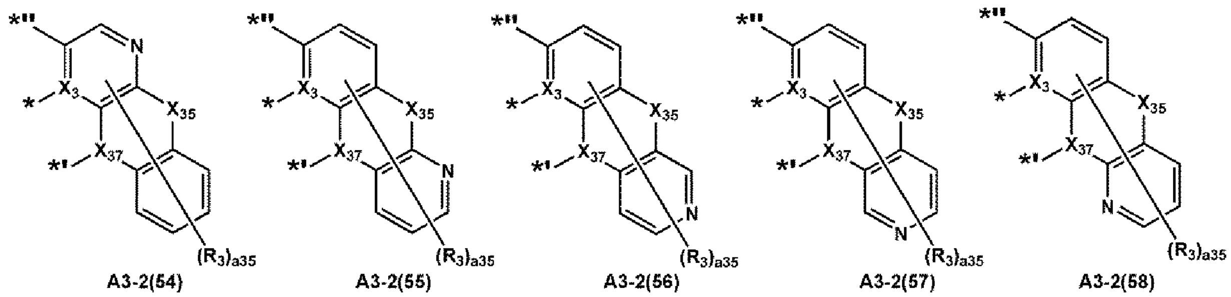

A3-2(54) A3-2(55) A3-2(56) A3-2(57) A3-2(58)

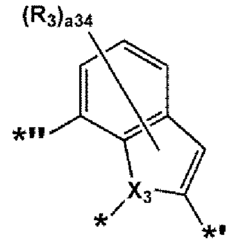

A3-3(1)

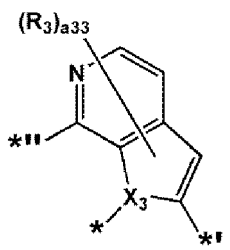

A3-3(2)

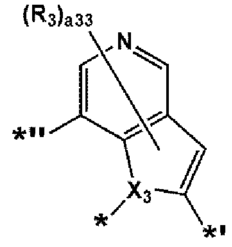

A3-3(3)

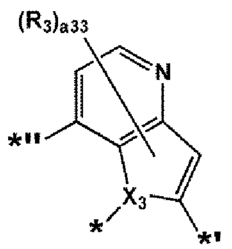

A3-3(4)

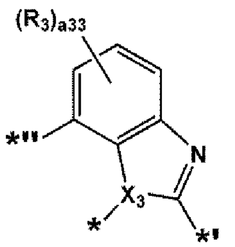

A3-3(5)

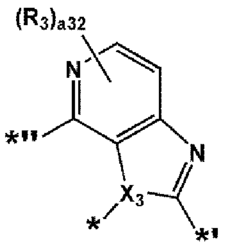

A3-3(6)

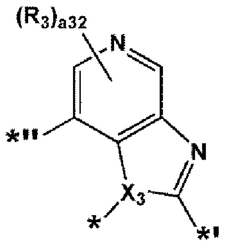

A3-3(7)

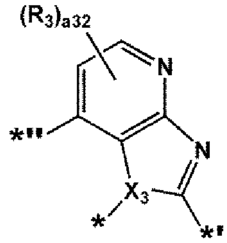

A3-3(8)

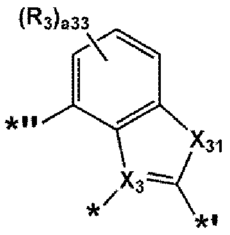

A3-3(9)

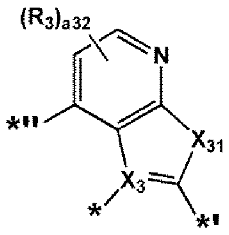

A3-3(10)

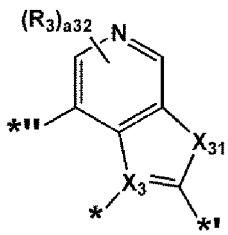

A3-3(11)

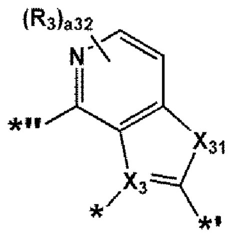

A3-3(12)

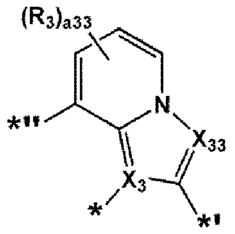

A3-3(13)

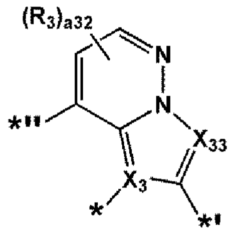

A3-3(14)

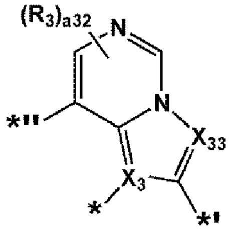

A3-3(15)

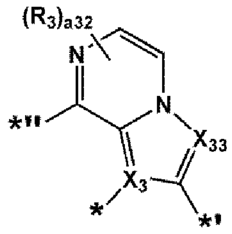

A3-3(16)

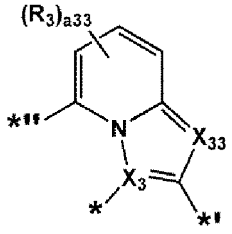
A3-3(17)

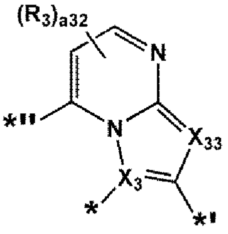
A3-3(18)

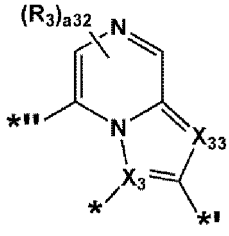
A3-3(19)

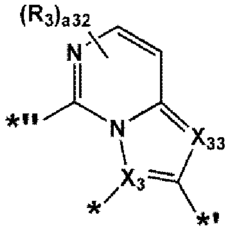
A3-3(20)

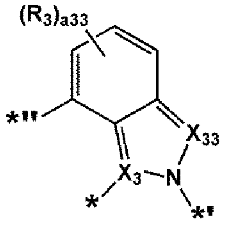
A3-3(21)

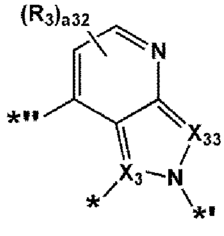
A3-3(22)

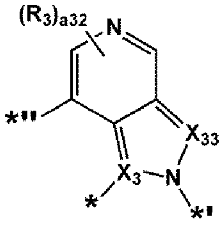
A3-3(23)

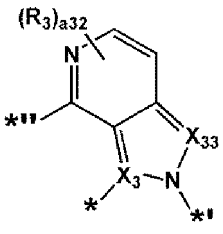
A3-3(24)

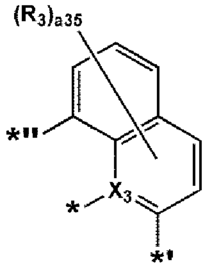
A3-3(25)

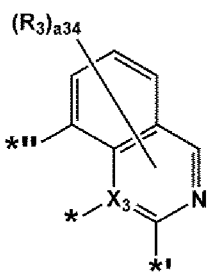
A3-3(26)

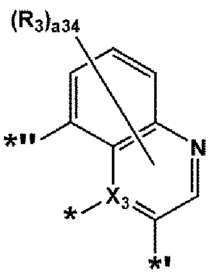
A3-3(27)

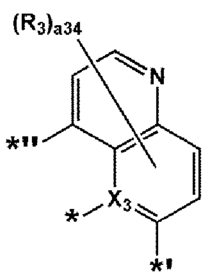
A3-3(28)

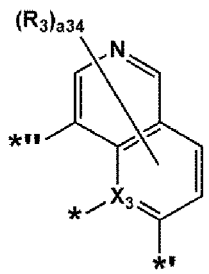
A3-3(29)

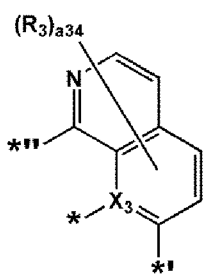
A3-3(30)

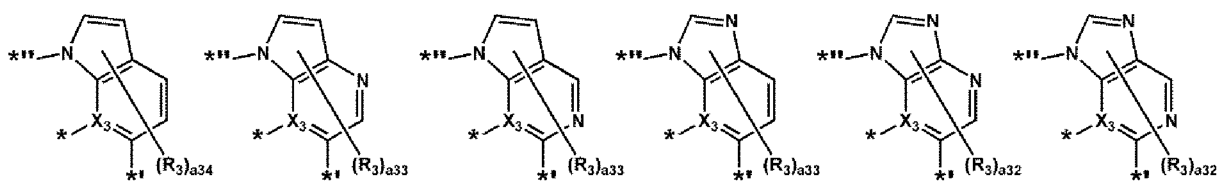
A3-3(31) A3-3(32) A3-3(33) A3-3(34) A3-3(35) A3-3(36)

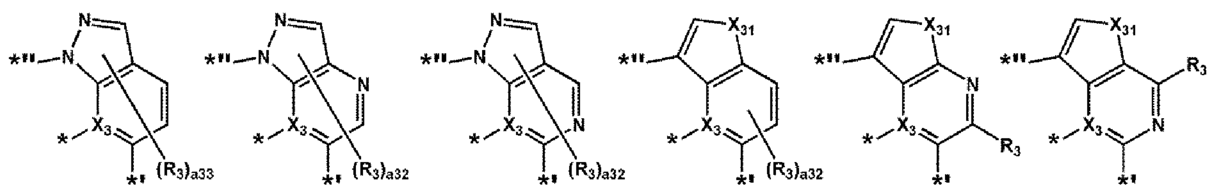
A3-3(37) A3-3(38) A3-3(39) A3-3(40) A3-3(41) A3-3(42)

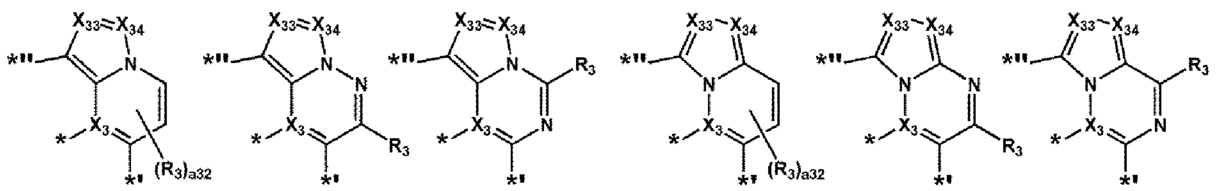
A3-3(43) A3-3(44) A3-3(45) A3-3(46) A3-3(47) A3-3(48)

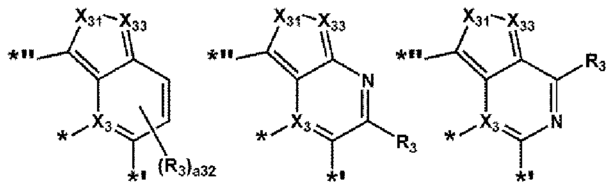
A3-3(49) A3-3(50) A3-3(51)

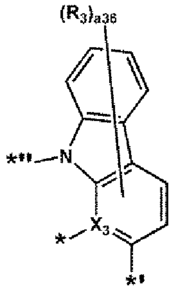
A3-3(52)

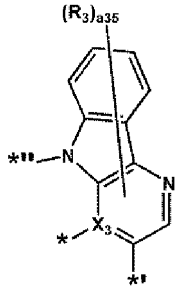
A3-3(53)

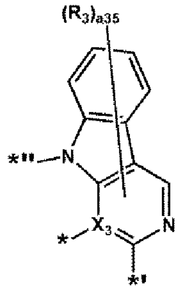
A3-3(54)

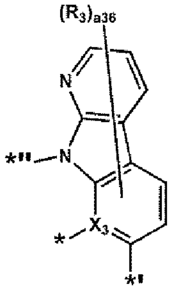
A3-3(55)

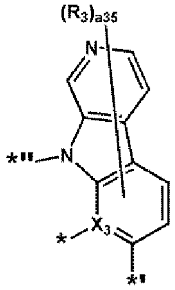
A3-3(56)

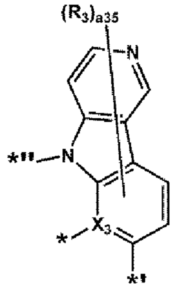
A3-3(57)

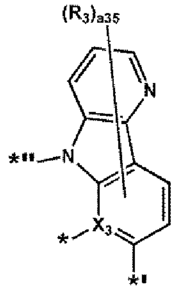
A3-3(58)

.

In Formulae A3-1(1) to A3-1(21), A3-2(1) to A3-2(58), and A3-3(1) to A3-3(58),

$X_3$ and $R_3$ are the same as described herein,
$X_{31}$ may be O, S, $N(R_{31})$, $C(R_{31})(R_{32})$, or $Si(R_{31})(R_{32})$,
$X_{33}$ may be N or $C(R_{33})$,
$X_{34}$ may be N or $C(R_{34})$,
$X_{35}$ is O, S, $N(R_{35})$, $C(R_{35})(R_{36})$, or $Si(R_{35})(R_{36})$,
$X_{37}$ is N or $C(R_{37})$,
$R_{31}$ to $R_{38}$ are the same as described in connection with $R_3$,
a36 may be an integer from 0 to 6,
a35 may be an integer from 0 to 5,
a34 may be an integer from 0 to 4,
a33 may be an integer from 0 to 3,
a32 may be an integer from 0 to 2,
*" indicates a binding site to $T_2$ in Formula 1,
* indicates a binding site to $X_6$ or M in Formula 1, and
*' indicates a binding site to $T_3$ in Formula 1.

In one or more embodiments, a moiety represented by

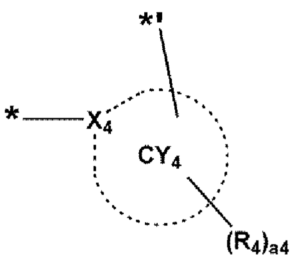

in Formula 1 may be represented by one of Formulae A4-1(1) to A4-1(51) and A4-2(1) to A4-2(71):

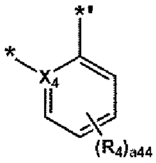
A4-1(1)

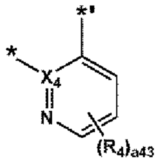
A4-1(2)

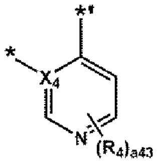
A4-1(3)

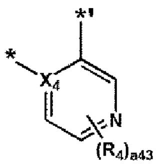
A4-1(4)

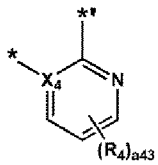
A4-1(5)

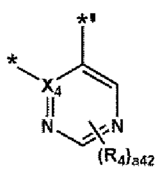
A4-1(6)

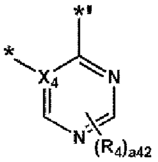
A4-1(7)

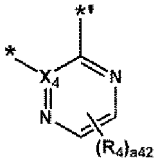
A4-1(8)

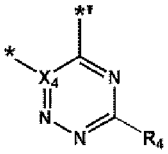
A4-1(9)

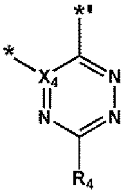
A4-1(10)

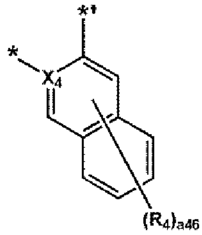
A4-1(11)

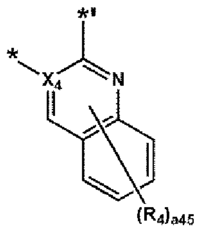
A4-1(12)

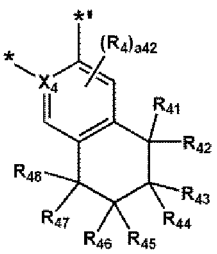
A4-1(13)

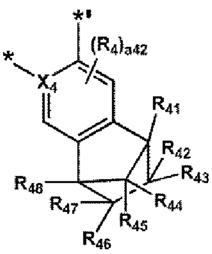
A4-1(14)

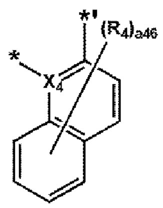
A4-1(15)

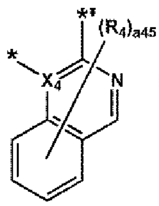
A4-1(16)

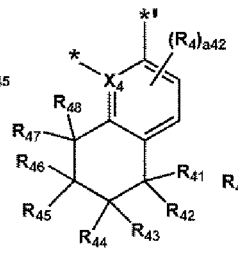
A4-1(17)

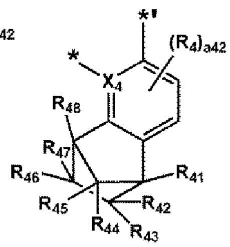
A4-1(18)

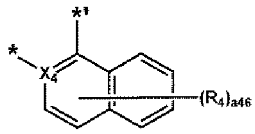
A4-1(19)

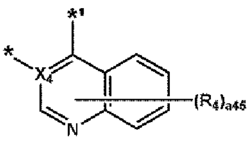
A4-1(20)

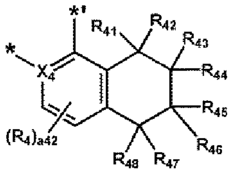
A4-1(21)

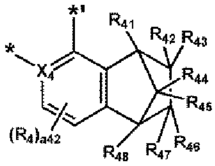
A4-1(22)

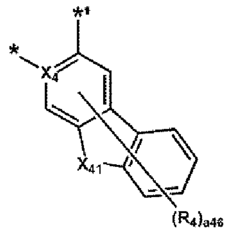
A4-1(23)

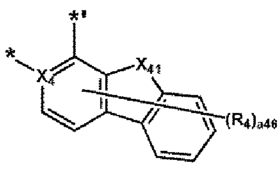
A4-1(24)

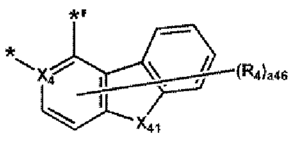
A4-1(25)

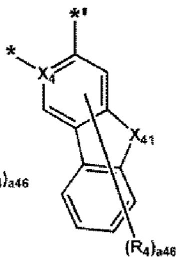
A4-1(26)

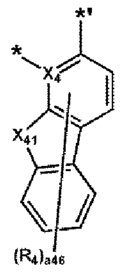
A4-1(27)

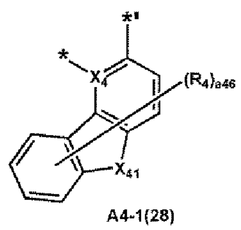
A4-1(28)

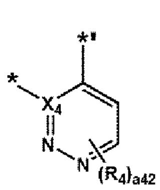
A4-1(29)

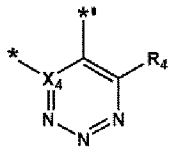
A4-1(30)

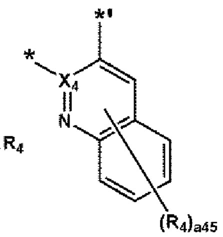
A4-1(31)

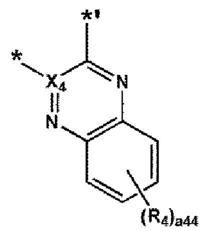
A4-1(32)

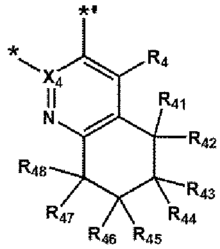
A4-1(33)

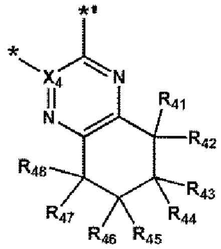
A4-1(34)

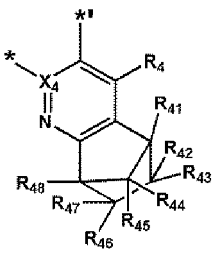
A4-1(35)

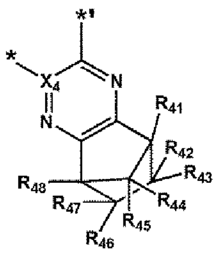
A4-1(36)

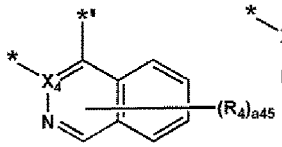
A4-1(37)

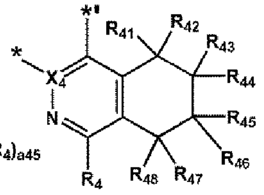
A4-1(38)

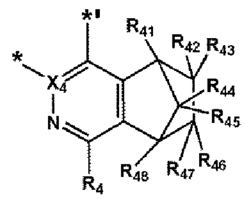
A4-1(39)

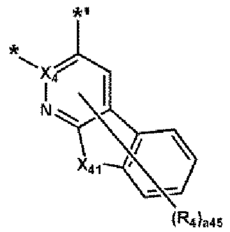
A4-1(40)

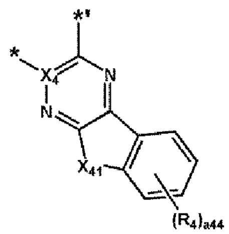
A4-1(41)

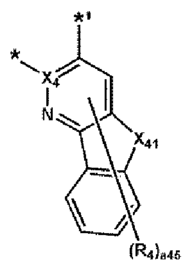
A4-1(42)

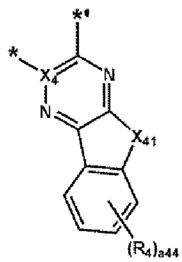
A4-1(43)

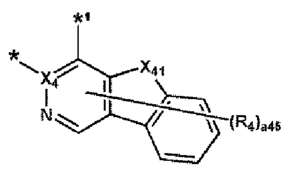
A4-1(44)

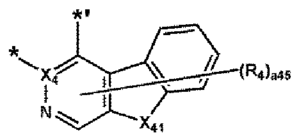
A4-1(45)

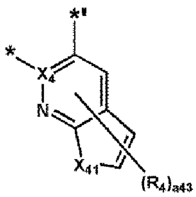
A4-1(46)

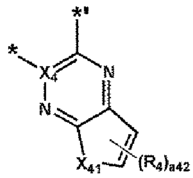
A4-1(47)

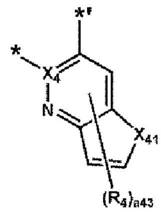
A4-1(48)

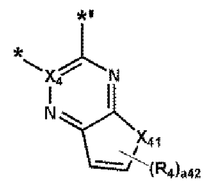
A4-1(49)

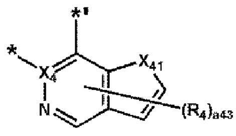
A4-1(50)

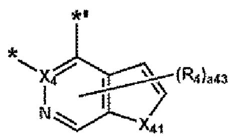
A4-1(51)

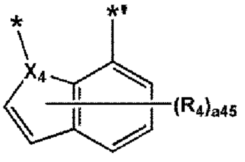
A4-2(1)

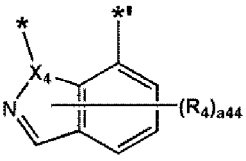
A4-2(2)

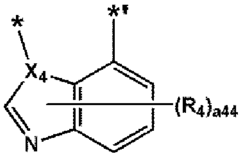
A4-2(3)

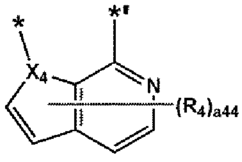
A4-2(4)

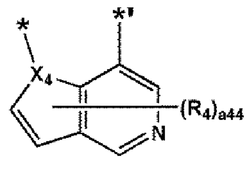
A4-2(5)

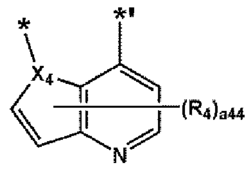
A4-2(6)

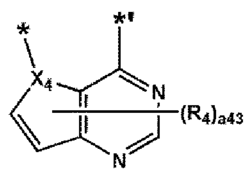
A4-2(7)

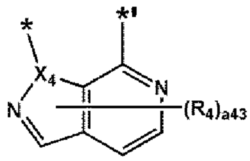
A4-2(8)

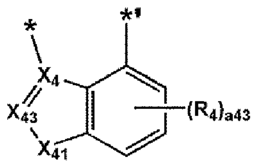
A4-2(9)

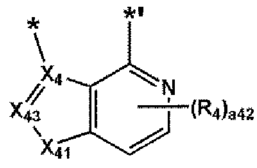
A4-2(10)

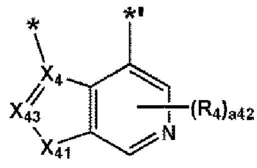
A4-2(11)

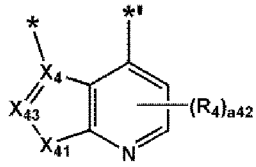
A4-2(12)

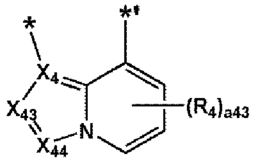
A4-2(13)

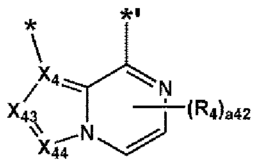
A4-2(14)

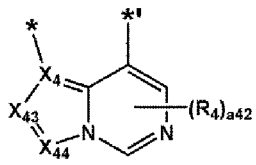
A4-2(15)

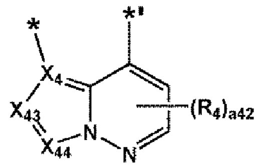
A4-2(16)

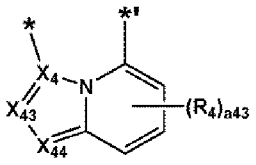
A4-2(17)

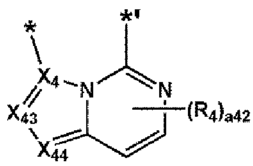
A4-2(18)

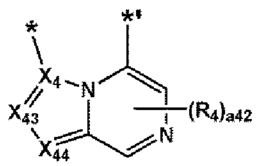
A4-2(19)

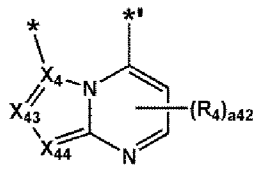
A4-2(20)

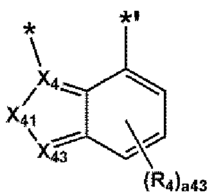
A4-2(21)

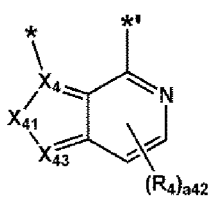
A4-2(22)

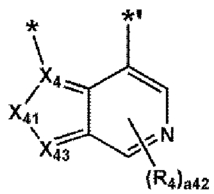
A4-2(23)

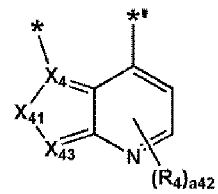
A4-2(24)

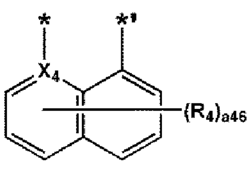
A4-2(25)

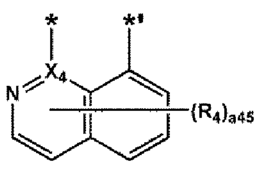
A4-2(26)

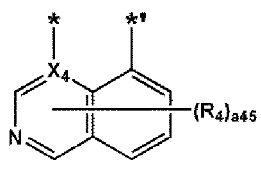
A4-2(27)

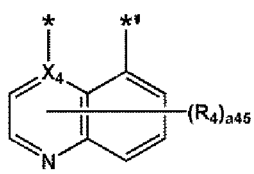
A4-2(28)

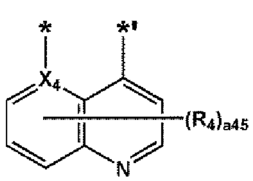
A4-2(29)

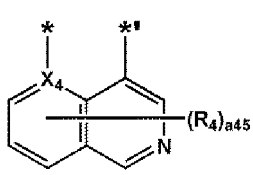
A4-2(30)

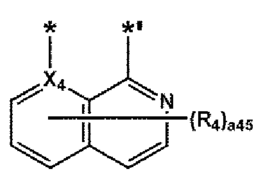
A4-2(31)

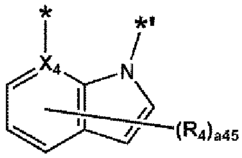
A4-2(32)

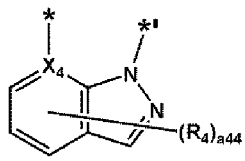
A4-2(33)

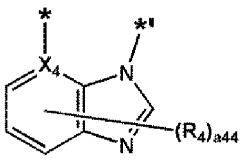
A4-2(34)

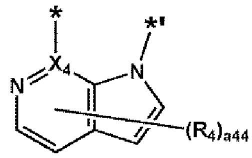
A4-2(35)

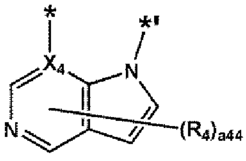
A4-2(36)

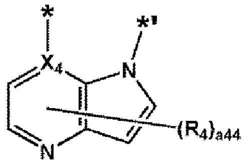
A4-2(37)

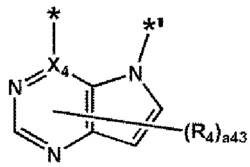
A4-2(38)

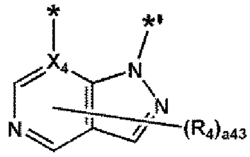
A4-2(39)

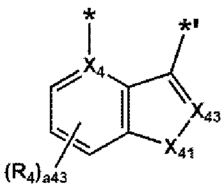
A4-2(40)

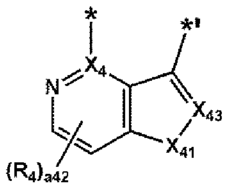
A4-2(41)

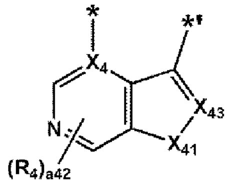
A4-2(42)

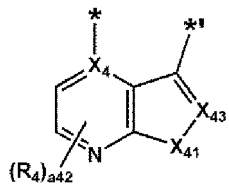
A4-2(43)

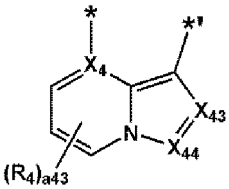
A4-2(44)

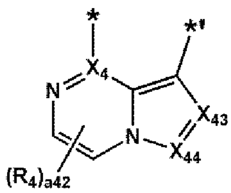
A4-2(45)

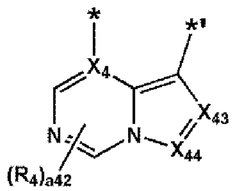
A4-2(46)

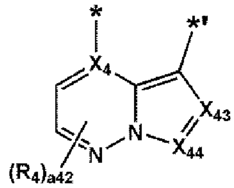
A4-2(47)

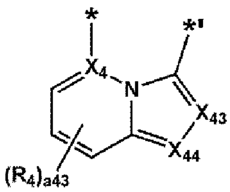
A4-2(48)

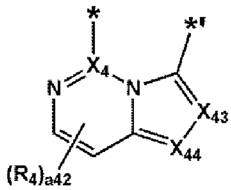
A4-2(49)

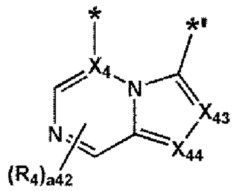
A4-2(50)

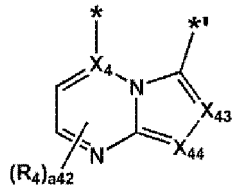
A4-2(51)

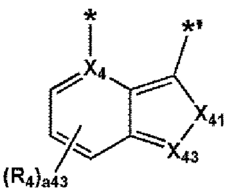
A4-2(52)

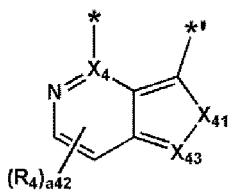
A4-2(53)

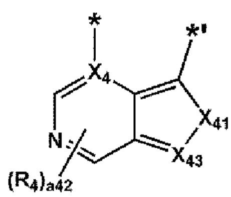
A4-2(54)

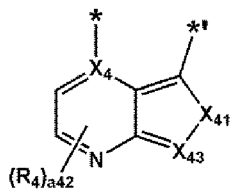
A4-2(55)

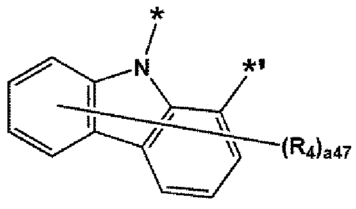
A4-2(56)

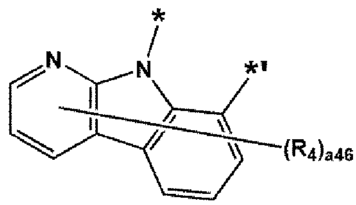
A4-2(57)

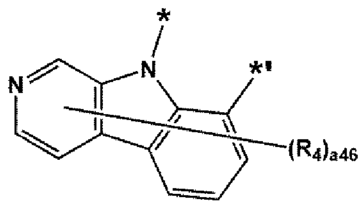
A4-2(58)

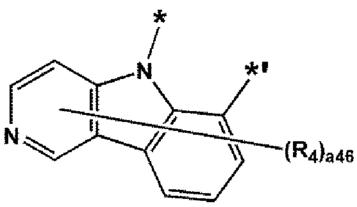
A4-2(59)

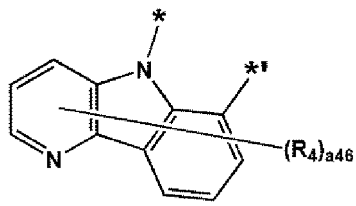
A4-2(60)

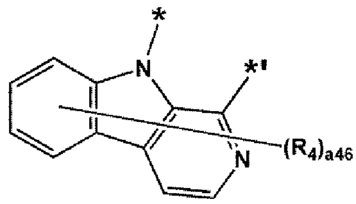
A4-2(61)

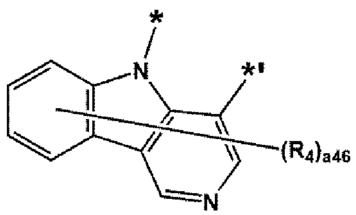
A4-2(62)

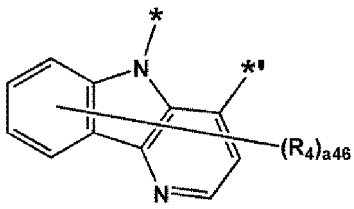
A4-2(63)

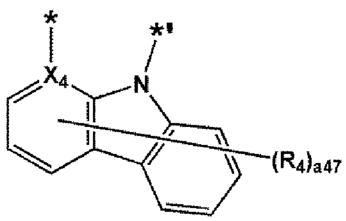
A4-2(64)

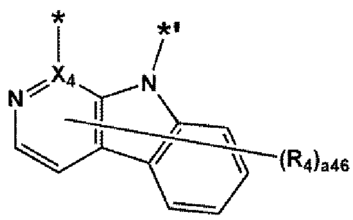
A4-2(65)

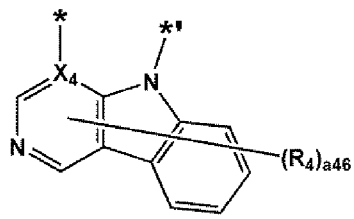
A4-2(66)

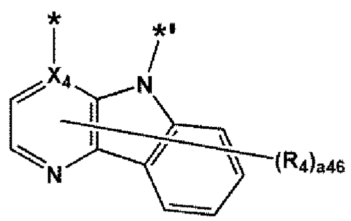
A4-2(67)

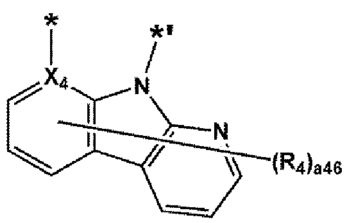
A4-2(68)

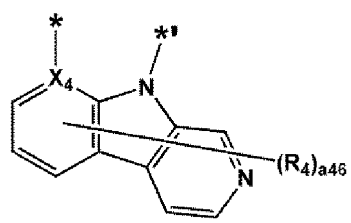
A4-2(69)

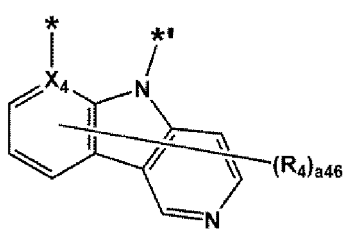
A4-2(70)

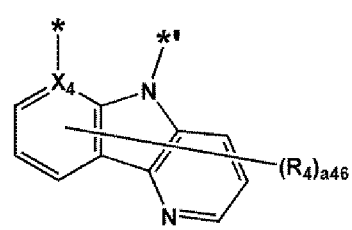
A4-2(71)

.

In Formulae A4-1(1) to A4-1(51) and A4-2(1) to A4-2(71),

$X_4$ and $R_4$ are the same as described herein,
$X_{41}$ may be O, S, $N(R_{41})$, $C(R_{41})(R_{42})$, or $Si(R_{41})(R_{42})$,
$X_{43}$ may be N or $C(R_{43})$,
$X_{44}$ may be N or $C(R_{44})$,
$R_{41}$ to $R_{48}$ are the same as described in connection with $R_4$,
a47 may be an integer from 0 to 7,
a46 may be an integer from 0 to 6,
a45 may be an integer from 0 to 5,
a44 may be an integer from 0 to 4,
a43 may be an integer from 0 to 3,
a42 may be an integer from 0 to 2,
* indicates a binding site to $X_7$ or M in Formula 1, and
*' indicates a binding site to $T_3$ in Formula 1.

In one or more embodiments, in Formula 1,
a moiety represented by

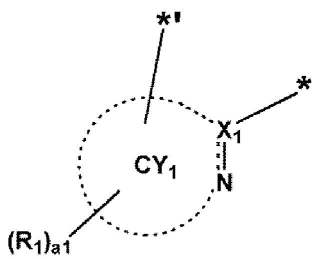

may be represented by one of Formulae CY1-1 to CY1-18, and/or
a moiety represented by

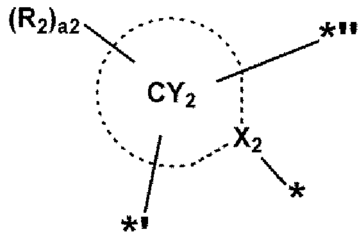

may be represented by one of Formulae CY2-1 to CY2-15, and/or
a moiety represented by

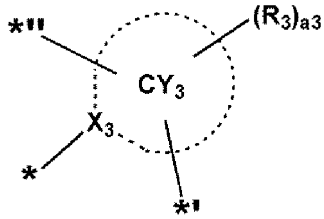

may be represented by one of Formulae CY3-1 to CY3-15, and/or
a moiety represented by

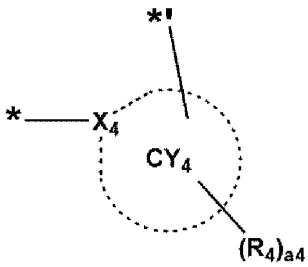

may be represented by one of Formulae CY4-1 to CY4-47, but embodiments of the present disclosure are not limited thereto:

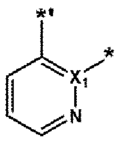
CY1-1

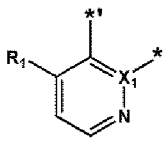
CY1-2

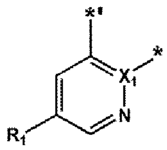
CY1-3

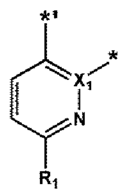
CY1-4

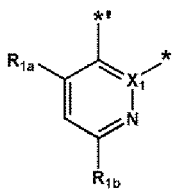
CY1-5

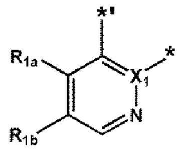
CY1-6

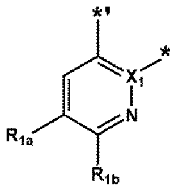
CY1-7

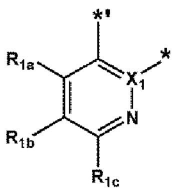
CY1-8

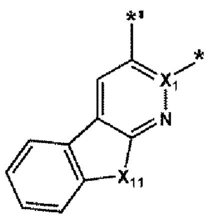
CY1-9

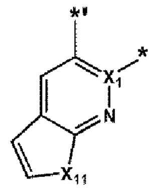
CY1-10

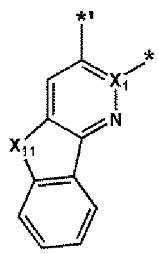
CY1-11

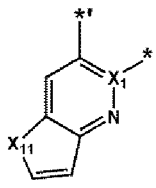
CY1-12

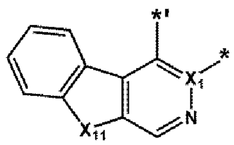
CY1-13

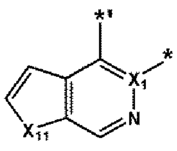
CY1-14

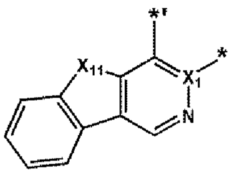
CY1-15

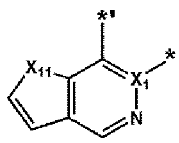
CY1-16

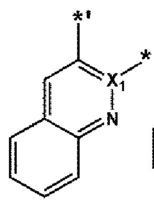
CY1-17

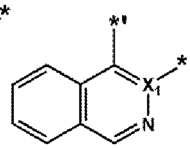
CY1-18

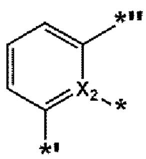
CY2-1

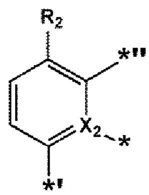
CY2-2

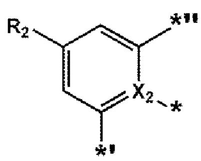
CY2-3

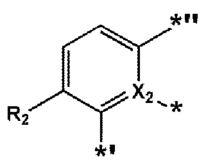
CY2-4

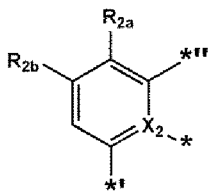
CY2-5

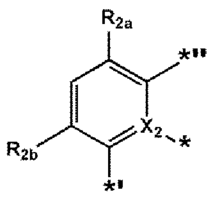
CY2-6

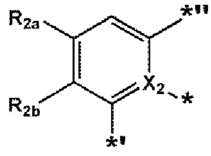
CY2-7

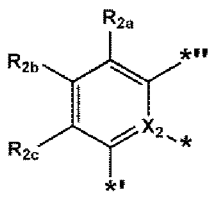
CY2-8

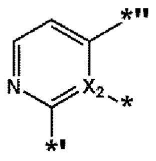
CY2-9

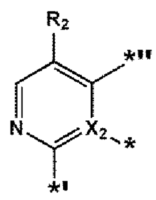
CY2-10

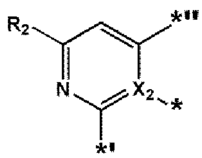
CY2-11

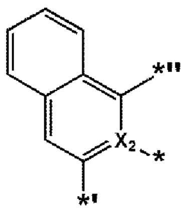
CY2-12

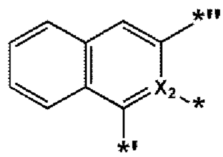
CY2-13

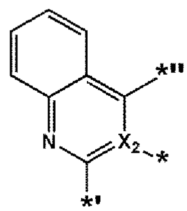
CY2-14

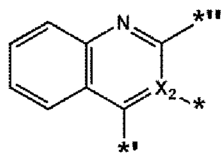
CY2-15

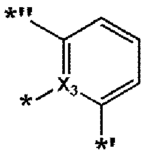
CY3-1

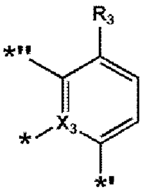
CY3-2

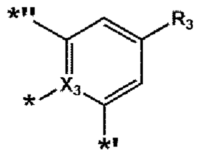
CY3-3

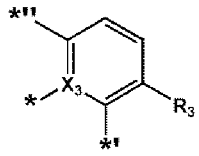
CY3-4

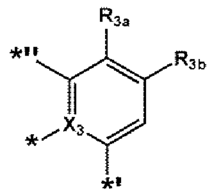
CY3-5

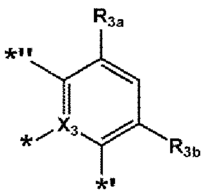
CY3-6

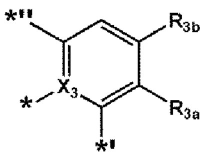
CY3-7

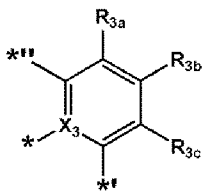
CY3-8

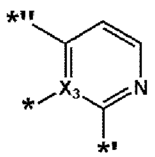
CY3-9

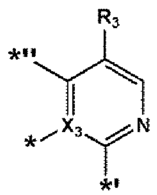
CY3-10

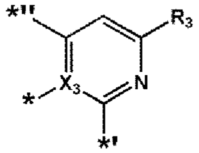
CY3-11

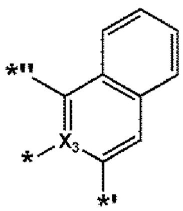
CY3-12

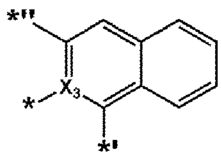
CY3-13

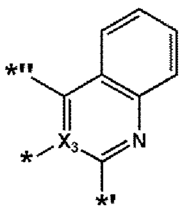
CY3-14

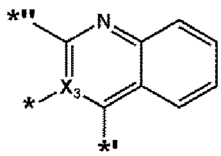
CY3-15

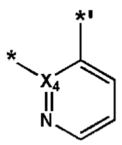
CY4-1

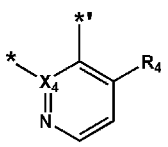
CY4-2

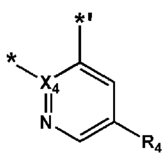
CY4-3

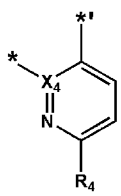
CY4-4

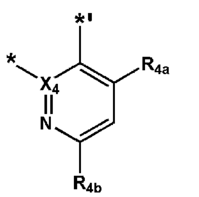
CY4-5

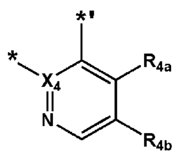
CY4-6

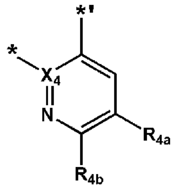
CY4-7

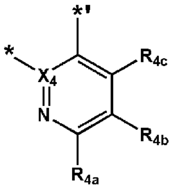
CY4-8

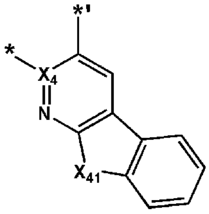
CY4-9

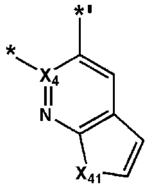
CY4-10

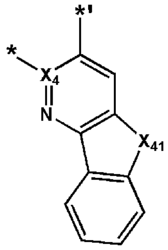
CY4-11

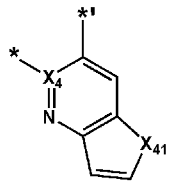
CY4-12

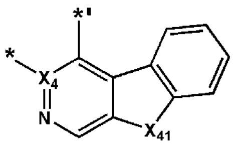
CY4-13

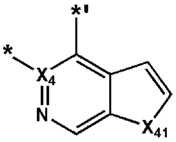
CY4-14

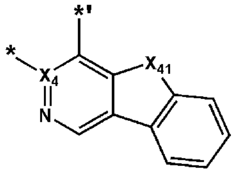
CY4-15

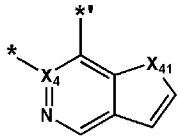
CY4-16

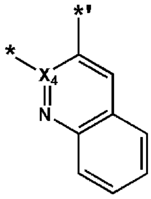
CY4-17

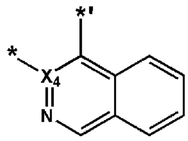
CY4-18

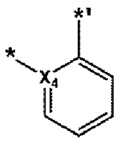
CY4-19

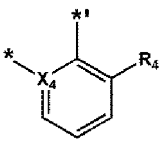
CY4-20

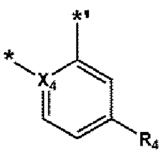
CY4-21

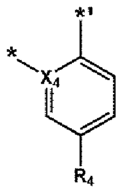
CY4-22

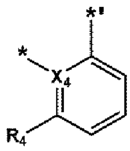
CY4-23

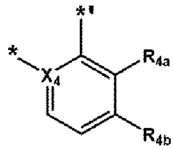
CY4-24

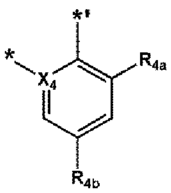
CY4-25

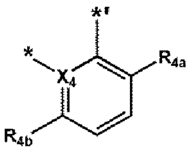
CY4-26

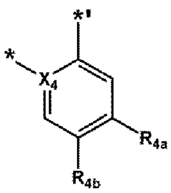
CY4-27

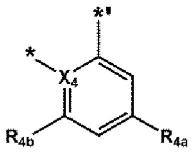
CY4-28

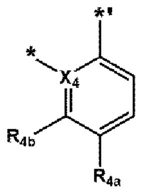
CY4-29

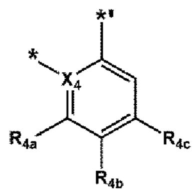
CY4-30

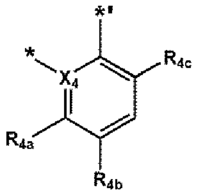
CY4-31

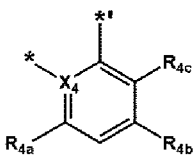
CY4-32

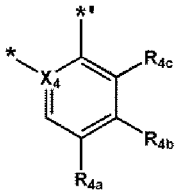
CY4-33

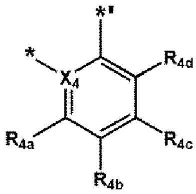
CY4-34

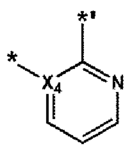
CY4-35

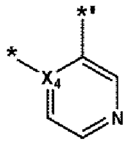
CY4-36

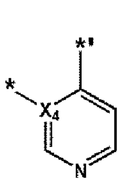
CY4-37

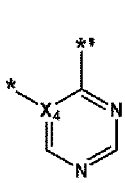
CY4-38

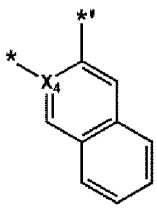
CY4-39

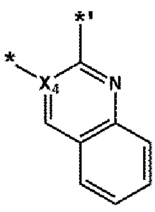
CY4-40

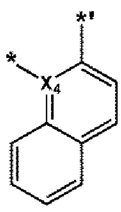
CY4-41

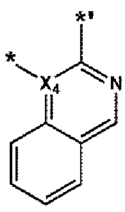
CY4-42

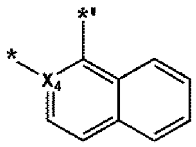
CY4-43

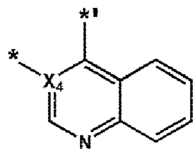
CY4-44

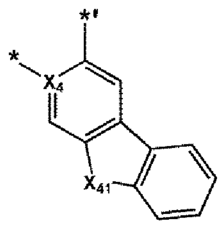
CY4-45

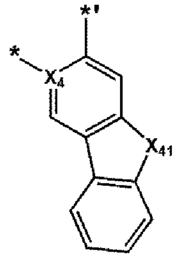
CY4-46

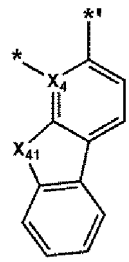
CY4-47 .

In Formulae CY1-1 to CY1-18, CY2-1 to CY2-15, CY3-1 to CY3-15, and CY4-1 to CY4-47,

$X_1$ to $X_4$ and $R_1$ to $R_4$ are the same as described herein,
$X_{11}$ may be O, S, $N(R_{11})$, $C(R_{11})(R_{12})$, or $Si(R_{11})(R_{12})$,
$X_{41}$ may be O, S, $N(R_{41})$, $C(R_{41})(R_{42})$, or $Si(R_{41})(R_{42})$,
$R_{1a}$ to $R_{1c}$, $R_{11}$, and $R_{12}$ are the same as described in connection with $R_1$,
$R_{2a}$ to $R_{2c}$ are the same as described in connection with $R_2$,
$R_{3a}$ to $R_{3c}$ are the same as described in connection with $R_3$,
$R_{4a}$ to $R_{4d}$, $R_{41}$, and $R_{42}$ are the same as described in connection with $R_4$,
$R_1$ to $R_4$, $R_{1a}$ to $R_{1c}$, $R_{2a}$ to $R_{2c}$, $R_{3a}$ to $R_{3c}$, and $R_{4a}$ to $R_{4d}$ are not hydrogen,
in Formulae CY1-1 to CY1-18, * indicates a binding site to M in Formula 1, and *' indicates a binding site to $T_1$ in Formula 1,
in Formulae CY2-1 to CY2-15, * indicates a binding site to $X_5$ or M in Formula 1, *' indicates a binding site to $T_1$ in Formula 1, and *" indicates a binding site to $T_2$ in Formula 1,
in Formulae CY3-1 to CY3-15, * indicates a binding site to $X_6$ or M in Formula 1, *" indicates a binding site to $T_2$ in Formula 1, and *' indicates a binding site to $T_3$ in Formula 1, and
in Formulae CY4-1 to CY4-47, * indicates a binding site to $X_7$ or M in Formula 1, and *' indicates a binding site to $T_3$ in Formula 1.

In one or more embodiments, in Formula 1,
a group represented by

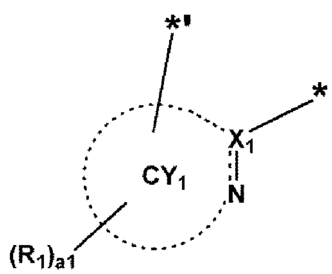

may be selected from groups represented by Formulae A1-1(1) to A1-1(28) (for example, Formulae CY1-1 to CY1-18), and a group represented by

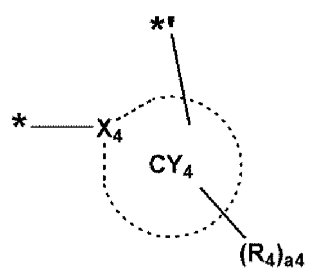

may be selected from groups represented by Formulae A4-1(2), A4-1(29), A4-1(6), A4-1(8), A4-1(30), A4-1(9), A4-1(10),

and A4-1(31) to A4-1(51) (for example, Formulae CY4-1 to CY4-18), but embodiments of the present disclosure are not limited thereto.

In one or more embodiments, the organometallic compound may be represented by Formula 1A:

Formula 1A

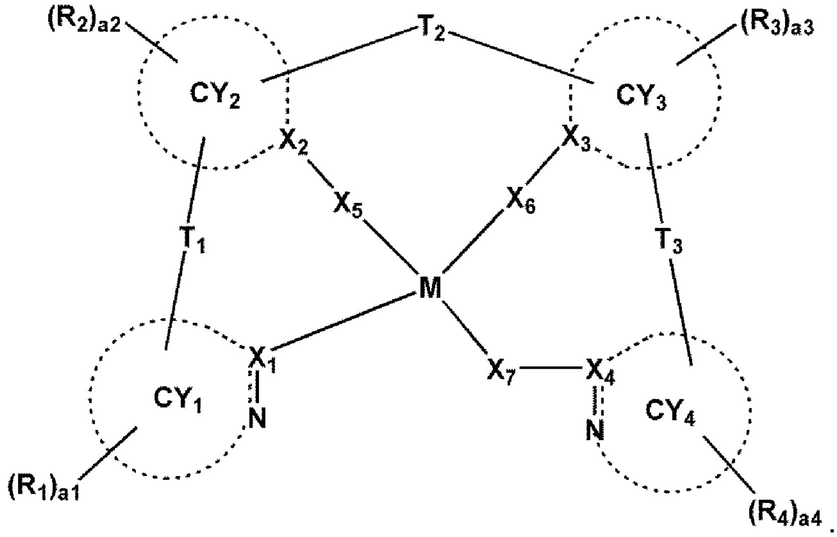

In Formula 1A, M, $X_1$ to $X_7$, rings $CY_1$ to $CY_3$, $T_1$ to $T_3$, $R_1$ to $R_4$, and a1 to a4 are the same as described herein, and ring $CY_4$ may be a $C_1$-$C_{30}$ heterocyclic group having at least one N atom as a ring-forming atom.

For example, $X_4$ in Formula 1A may be N, and ring $CY_4$ is the same as described in connection with ring $CY_1$, but embodiments of the present disclosure are not limited thereto.

In an embodiment, ring $CY_1$ and ring $CY_4$ in Formulae 1 and 1A may be identical to each other.

In one or more embodiments, ring $CY_1$ and ring $CY_4$ in Formulae 1 and 1A may be identical to each other, and ring $CY_2$ and ring $CY_3$ may be identical to each other.

In one or more embodiments, in Formulae 1 and 1A, a group represented by

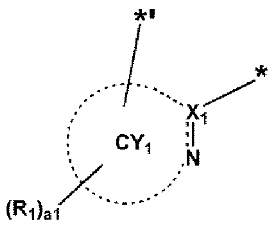

and a group represented by

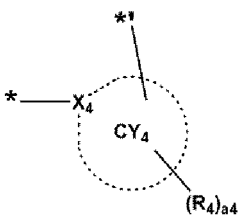

(or

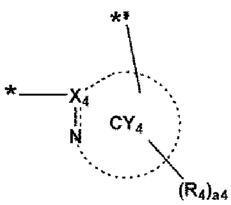

)

may be identical to each other and/or a group represented by

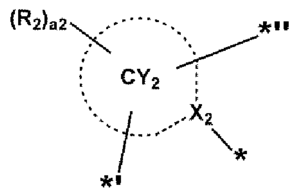

and a group represented by

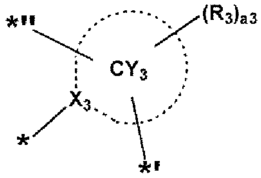

may be identical to each other.

In one or more embodiments, the organometallic compound may have a linearly symmetrical structure with respect to a symmetrical axis connecting M and $T_2$ in Formulae 1 and 1A.

In one or more embodiments, the organometallic compound may be represented by Formula 1(1):

Formula 1(1)

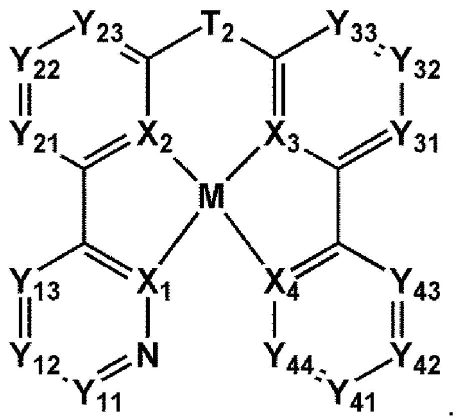

In Formula 1(1),

M, $X_1$ to $X_4$, and $T_2$ are the same as described herein,

$Y_{11}$ may be $C(Z_{11})$ or N, $Y_{12}$ may be $C(Z_{12})$ or N, $Y_{13}$ may be $C(Z_{13})$ or N, $Y_{21}$ may be $C(Z_{21})$ or N, $Y_{22}$ may be $C(Z_{22})$ or N, $Y_{23}$ may be $C(Z_{23})$ or N, $Y_{31}$ may be $C(Z_{31})$ or N, $Y_{32}$ may be $C(Z_{32})$ or N, $Y_{33}$ may be $C(Z_{33})$ or N, $Y_{41}$ may be $C(Z_{41})$ or N, $Y_{42}$ may be $C(Z_{42})$ or N, $Y_{43}$ may be $C(Z_{43})$ or N, and $Y_{44}$ may be $C(Z_{44})$ or N,

$Z_{11}$ to $Z_{13}$ are the same as described in connection with $R_1$, and at least two of $Z_{11}$ to $Z_{13}$ may optionally be linked to form a $C_5$-$C_{30}$ carbocyclic group unsubstituted or substituted with at least one $R_{10a}$ or a $C_1$-$C_{30}$ heterocyclic group unsubstituted or substituted with at least one $R_{10a}$ (for example, a benzene group, a cyclopentane group, a cyclopentadiene group, a furan group, a thiophene group, a pyrrole group, a silole group, an indene group, a benzofuran group, a benzothiophene group, an indole group, or a benzosilole group, each unsubstituted or substituted with at least one $R_{10a}$),

$Z_{21}$ to $Z_{23}$ are the same as described in connection with $R_2$, and at least two of $Z_{21}$ to $Z_{23}$ may optionally be linked to form a $C_5$-$C_{30}$ carbocyclic group unsubstituted or substituted with at least one $R_{10a}$ or a $C_1$-$C_{30}$ heterocyclic group unsubstituted or substituted with at least one $R_{10a}$ (for example, a benzene group, a cyclopentane group, a cyclopentadiene group, a furan group, a thiophene group, a pyrrole group, a silole group, an indene group, a benzofuran group, a benzothiophene group, an indole group, or benzosilole group, each unsubstituted or substituted with at least one $R_{10a}$),

$Z_{31}$ to $Z_{33}$ are the same as described in connection with $R_3$, and at least two of $Z_{31}$ to $Z_{33}$ may optionally be linked to form a $C_5$-$C_{30}$ carbocyclic group unsubstituted or substituted with at least one $R_{10a}$ or a $C_1$-$C_{30}$ heterocyclic group unsubstituted or substituted with at least one $R_{10a}$ (for example, a benzene group, a cyclopentane group, a cyclopentadiene group, a furan group, a thiophene group, a pyrrole group, a silole group, an indene group, a benzofuran group, a benzothiophene group, an indole group, or benzosilole group, each unsubstituted or substituted with at least one $R_{10a}$),

$Z_{41}$ to $Z_{44}$ are the same as described in connection with $R_4$, and at least two of $Z_{41}$ to $Z_{44}$ may optionally be linked to form a $C_5$-$C_{30}$ carbocyclic group unsubstituted or substituted with at least one $R_{10a}$ or a $C_1$-$C_{30}$ heterocyclic group unsubstituted or substituted with at least one $R_{10a}$ (for example, a benzene group, a cyclopentane group, a cyclopentadiene group, a furan group, a thiophene group, a pyrrole group, a silole group, an indene group, a benzofuran group, a benzothiophene group, an indole group, or a benzosilole group, each unsubstituted or substituted with at least one $R_{10a}$),

$R_{10a}$ is the same as described in connection with $R_1$.

For example, $Y_{44}$ in Formula 1(1) may be N.

In an embodiment, in Formula 1(1), $Y_{11}$ and $Y_{41}$ may be identical to each other, $Y_{12}$ and $Y_{42}$ may be identical to each other, $Y_{13}$ and $Y_{43}$ may be identical to each other, $Y_{21}$ and $Y_{31}$ may be identical to each other, $Y_{22}$ and $Y_{32}$ may be identical to each other, and $Y_{23}$ and $Y_{33}$ may be identical to each other, but embodiments of the present disclosure are not limited thereto.

In the present disclosure, "an azaindole group, an azabenzoborole group, an azabenzophosphole group, an azaindene group, an azabenzosilole group, an azabenzogermole group, an azabenzothiophene group, an azabenzoselenophene group, an azabenzofuran group, an azacarbazole group, an azadibenzoborole group, an azadibenzophosphole group, an azafluorene group, an azadibenzosilole group, an azadibenzogermole group, an azadibenzothiophene group, an azadibenzoselenophene group, an azadibenzofuran group, an azadibenzothiophene 5-oxide group, an aza-9H-fluorene-9-one group, and an azadibenzothiophene 5,5-dioxide group" as used herein each refer to a heteroring having the same backbone as "an indole group, a benzoborole group, a benzophosphole group, an indene group, a benzosilole group, a benzogermole group, a benzothiophene group, a benzoselenophene group, a benzofuran group, a carbazole group, a dibenzoborole group, a dibenzophosphole group, a fluorene group, a dibenzosilole group, a dibenzogermole group, a dibenzothiophene group, a dibenzoselenophene group, a dibenzofuran group, a dibenzothiophene 5-oxide group, a 9H-fluorene-9-one group, and a dibenzothiophene 5,5-dioxide group", in which at least one carbon constituting rings thereof is substituted with nitrogen.

The organometallic compound represented by Formula 1 may be one selected from Compounds 1 to 16, but embodiments of the present disclosure are not limited thereto:

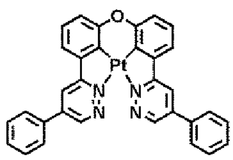
1

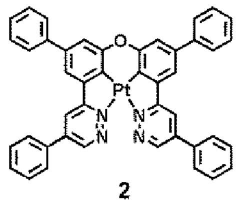
2

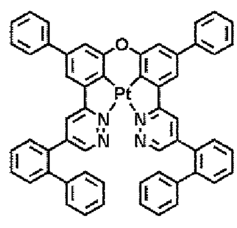
3

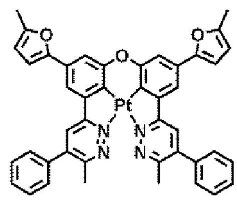
4

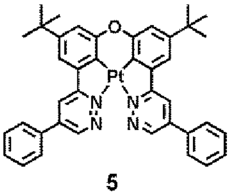
5

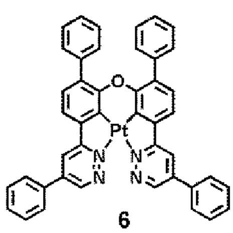
6

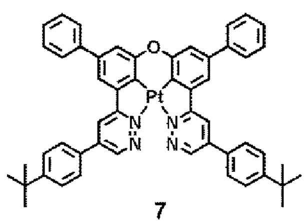
7

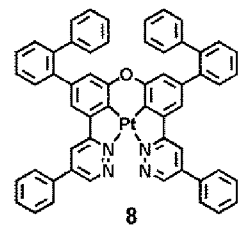
8

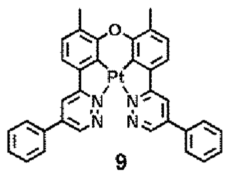
9

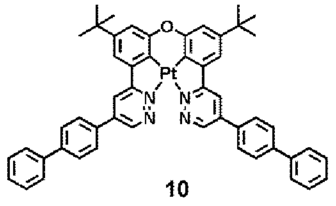
10

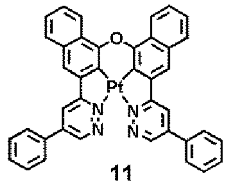
11

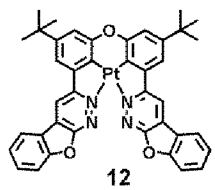
12

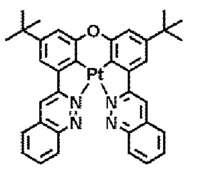
13

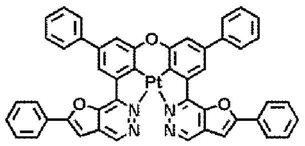
14

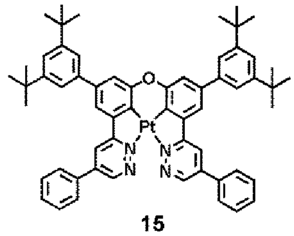
15

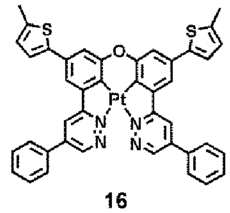
16

In Formula 1, since $X_1$ is N and a bond between $X_1$ and M is a coordinate bond, ring $CY_1$ in Formula 1 may contribute to a lowest unoccupied molecular orbital (LUMO) energy level of the organometallic compound represented by Formula 1. An atom that is closest to ring $CY_4$ among neighboring atoms of $X_1$ of ring $CY_1$ is essentially "nitrogen" as represented in Formula 1'.

Formula 1'

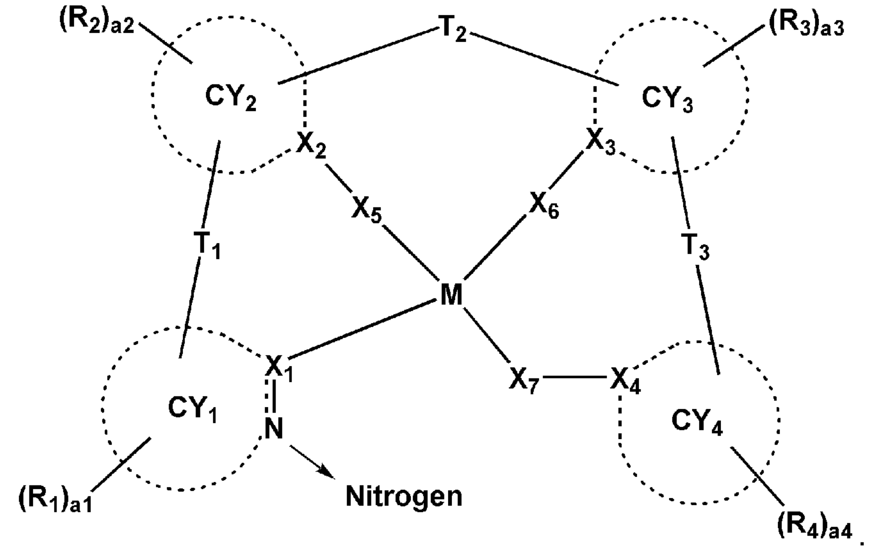

As such, since a bond between $X_1$ and M in Formula 1 is a coordinate bond and an atom that is closest to ring $CY_4$ among neighboring atoms of $X_1$ of ring $CY_1$ is essentially "nitrogen", a bond strength between $X_1$ of ring $CY_1$ and M in Formula 1 may be stronger, as compared with that in a virtual compound in which two atoms neighboring to $X_1$ of ring $CY_1$ are "carbon". Although not limited by a particular theory, for example, when ring $CY_1$ is a pyridazine group, a bond length between N of the pyridazine group and a metal is shorter than a bond length between N of a pyridine group and a metal, and thus, a bond strength between N of the pyridazine group and the metal may be stronger than a bond strength between N of the pyridine group and the metal. Therefore, an emission peak in a photoluminescence spectrum of a solution of the organometallic compound represented by Formula 1 may have a relatively narrow full width at half maximum (FWHM) (for example, an FWHM of about 50 nm to about 70 nm or an FWHM of about 55 nm to about 64 nm), a non-radiative decay rate of the organometallic compound represented by Formula 1 may decrease, and/or a radiative decay rate may increase.

In addition, since the atom that is closest to ring $CY_4$ among the atoms neighboring to $X_1$ of ring $CY_1$ in Formula 1 is essentially "nitrogen", a repulsion between ring $CY_1$ and ring $CY_4$ decreases (see Formula 1" or 1(1)), and a tetradentate ligand in Formula 1 may not be structurally twisted. Although not limited by a particular theory, for example, in the following "virtual Formula" in which a moiety that is closest to ring $CY_4$ among neighboring atoms of $X_1$ of ring

$CY_1$ is "CH", there is a high probability that a tetradentate ligand will be twisted by a repulsion between hydrogen of ring $CY_1$ and hydrogen of ring $CY_4$. Therefore, an electronic device, for example, an organic light-emitting device, which includes the organometallic compound represented by Formula 1, may have excellent quantum emission efficiency.

Formula 1"

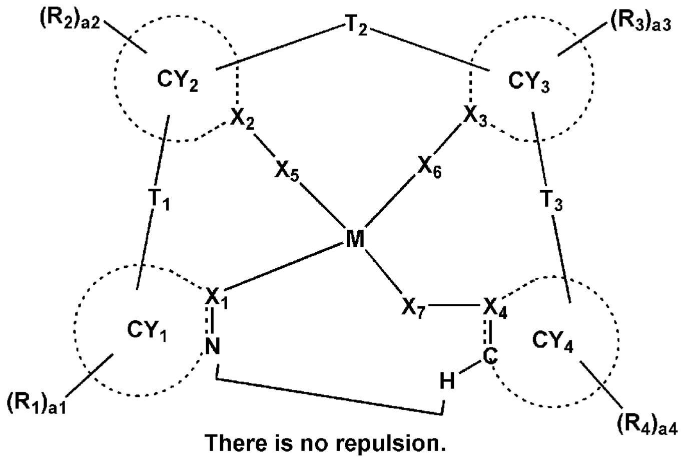


Virtual Formula

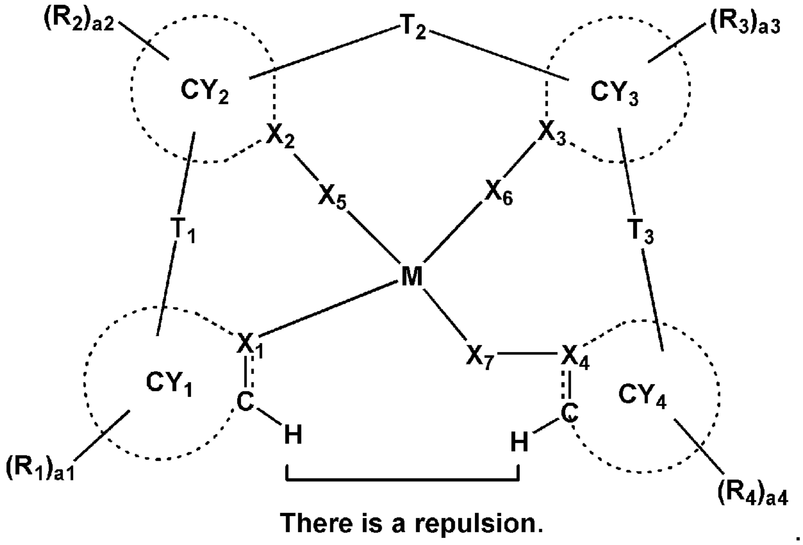


Therefore, the electronic device, for example, the organic light-emitting device, which includes the organometallic compound represented by Formula 1, may have excellent color purity, quantum emission efficiency, and long lifespan characteristics.

For example, highest occupied molecular orbital (HOMO), LUMO, and $T_1$ energy levels of some Compounds were evaluated by a DFT method of Gaussian program (structurally optimized at a level of B3LYP, 6-31G(d,p)), and evaluation results thereof are shown in Table 1.

Table 1

| Compound No. | HOMO (eV) | LUMO (eV) | $T_1$ (eV) |
|---|---|---|---|
| 1 | -4.900 | -2.107 | 1.981 |
| 2 | -4.919 | -2.167 | 1.949 |
| 3 | -4.859 | -2.044 | 1.990 |

(continued)

| Compound No. | HOMO (eV) | LUMO (eV) | $T_1$ (eV) |
|---|---|---|---|
| 4 | -4.619 | -1.979 | 1.865 |
| 5 | -4.786 | -2.055 | 1.933 |
| 6 | -4.915 | -2.125 | 1.990 |
| 7 | -4.859 | -2.085 | 1.967 |
| 8 | -4.851 | -2.104 | 1.911 |
| 9 | -4.875 | -2.052 | 2.009 |
| 10 | -4.768 | -2.099 | 1.907 |
| 11 | -4.683 | -2.087 | 1.854 |
| 12 | -4.788 | -2.228 | 1.821 |
| 13 | -4.843 | -2.211 | 1.901 |
| 14 | -4.777 | -2.205 | 1.987 |
| 15 | -4.862 | -2.126 | 1.937 |
| 16 | -4.833 | -2.175 | 1.882 |

From Table 1, it is confirmed that the organometallic compound represented by Formula 1 has such electric characteristics that are suitable for use in an electronic device, for example, for use as a dopant for an organic light-emitting device.

Synthesis methods of the organometallic compound represented by Formula 1 may be recognizable by one of ordinary skill in the art by referring to Synthesis Examples provided below.

The organometallic compound represented by Formula 1 is suitable for use in an organic layer of an organic light-emitting device, for example, for use as a dopant in an emission layer of the organic layer. Thus, another aspect provides an organic light-emitting device that includes:

a first electrode;
a second electrode; and
an organic layer that is disposed between the first electrode and the second electrode,
wherein the organic layer includes an emission layer and at least one organometallic compound represented by Formula 1.

The organic light-emitting device may have, due to the inclusion of an organic layer including the organometallic compound represented by Formula 1, a low driving voltage, high efficiency, high power, high quantum efficiency, a long lifespan, a low roll-off ratio, and excellent color purity.

The organometallic compound of Formula 1 may be used between a pair of electrodes of an organic light-emitting device. For example, the organometallic compound represented by Formula 1 may be included in the emission layer. In this regard, the organometallic compound may act as a dopant, and the emission layer may further include a host (that is, an amount of the organometallic compound represented by Formula 1 is smaller than an amount of the host).

In one or more embodiment, the emission layer may include a host and a dopant, and the dopant may include the organometallic compound represented by Formula 1. The organometallic compound represented by Formula 1 may be a red phosphorescent dopant.

The expression "(an organic layer) includes at least one organometallic compounds" as used herein may include an embodiment in which "(an organic layer) includes identical organometallic compounds represented by Formula 1" and an embodiment in which "(an organic layer) includes two or more different organometallic compounds represented by Formula 1."

For example, the organic layer may include, as the organometallic compound, only Compound 1. In this regard, Compound 1 may be included in an emission layer of the organic light-emitting device. In one or more embodiments, the organic layer may include, as the organometallic compound, Compound 1 and Compound 2. In this regard, Compound 1 and Compound 2 may be included in the same layer (for example, Compound 1 and Compound 2 all may be included in an emission layer).

The first electrode may be an anode, which is a hole injection electrode, and the second electrode may be a

cathode, which is an electron injection electrode; or the first electrode may be a cathode, which is an electron injection electrode, and the second electrode may be an anode, which is a hole injection electrode.

In an embodiment, in the organic light-emitting device, the first electrode is an anode, and the second electrode is a cathode, and the organic layer further includes a hole transport region disposed between the first electrode and the emission layer and an electron transport region disposed between the emission layer and the second electrode, wherein the hole transport region includes a hole injection layer, a hole transport layer, an electron blocking layer, or any combination thereof, and wherein the electron transport region includes a hole blocking layer, an electron transport layer, an electron injection layer, or any combination thereof.

The term "organic layer" as used herein refers to a single layer and/or a plurality of layers disposed between the first electrode and the second electrode of the organic light-emitting device. The "organic layer" may include, in addition to an organic compound, an organometallic complex including metal.

The FIGURE is a schematic view of an organic light-emitting device 10 according to an embodiment. Hereinafter, the structure of an organic light-emitting device according to an embodiment and a method of manufacturing an organic light-emitting device according to an embodiment will be described in connection with the FIGURE. The organic light-emitting device 10 includes a first electrode 11, an organic layer 15, and a second electrode 19, which are sequentially stacked.

A substrate may be additionally disposed under the first electrode 11 or above the second electrode 19. For use as the substrate, any substrate that is used in general organic light-emitting devices may be used, and the substrate may be a glass substrate or a transparent plastic substrate, each having excellent mechanical strength, thermal stability, transparency, surface smoothness, ease of handling, and water resistance.

The first electrode 11 may be formed by depositing or sputtering a material for forming the first electrode 11 on the substrate. The first electrode 11 may be an anode. The material for forming the first electrode 11 may be selected from materials with a high work function to facilitate hole injection. The first electrode 11 may be a reflective electrode, a semi-transmissive electrode, or a transmissive electrode. The material for forming the first electrode may be, for example, indium tin oxide (ITO), indium zinc oxide (IZO), tin oxide ($SnO_2$), and zinc oxide (ZnO). In one or more embodiments, magnesium (Mg), aluminum (Al), aluminum-lithium (Al-Li), calcium (Ca), magnesium-indium (Mg-In), or magnesium-silver (Mg-Ag) may be used as the material for forming the first electrode.

The first electrode 11 may have a single-layered structure or a multi-layered structure including two or more layers. For example, the first electrode 11 may have a three-layered structure of ITO/Ag/ITO, but the structure of the first electrode 110 is not limited thereto.

The organic layer 15 is disposed on the first electrode 11.

The organic layer 15 may include a hole transport region, an emission layer, and an electron transport region.

The hole transport region may be disposed between the first electrode 11 and the emission layer.

The hole transport region may include a hole injection layer, a hole transport layer, an electron blocking layer, a buffer layer, or any combination thereof.

The hole transport region may include only either a hole injection layer or a hole transport layer. In one or more embodiments, the hole transport region may have a hole injection layer/hole transport layer structure or a hole injection layer/hole transport layer/electron blocking layer structure, which are sequentially stacked in this stated order from the first electrode 11.

A hole injection layer may be formed on the first electrode 11 by using one or more suitable methods selected from vacuum deposition, spin coating, casting, or Langmuir-Blodgett deposition.

When a hole injection layer is formed by vacuum deposition, the deposition conditions may vary according to a compound that is used to form the hole injection layer, and the structure and thermal characteristics of the hole injection layer. For example, the deposition conditions may include a deposition temperature of about 100 °C to about 500 °C, a vacuum pressure of about $10^{-8}$ torr to about $10^{-3}$ torr (wherein 1 torr = 133.322 Pa), and a deposition rate of about 0.01 Angstroms per second (Å/sec) to about 100 Å/sec. However, embodiments of the present disclosure are not limited thereto.

When the hole injection layer is formed using spin coating, coating conditions may vary according to the material used to form the hole injection layer, and the structure and thermal properties of the hole injection layer. For example, a coating speed may be from about 2,000 revolutions per minute (rpm) to about 5,000 rpm (wherein 1 rpm =1/60 Hz), and a temperature at which a heat treatment is performed to remove a solvent after coating may be from about 80 °C to about 200 °C. However, the coating conditions are not limited thereto.

Conditions for forming a hole transport layer and an electron blocking layer may be understood by referring to conditions for forming the hole injection layer.

The hole transport region may include at least one selected from m-MTDATA, TDATA, 2-TNATA, NPB, β-NPB, TPD, Spiro-TPD, Spiro-NPB, methylated-NPB, TAPC, HMTPD, 4,4',4"-tris(N-carbazolyl)triphenylamine (TCTA), polyaniline/dodecylbenzene sulfonic acid (PANI/DBSA), poly(3,4-ethylenedioxythiophene)/poly(4-styrene sulfonate) (PEDOT/PSS), polyaniline/camphor sulfonic acid (PANI/CSA), polyaniline/poly(4-styrene sulfonate) (PANI/PSS), a compound represented by Formula 201 below, and a compound represented by Formula 202 below:

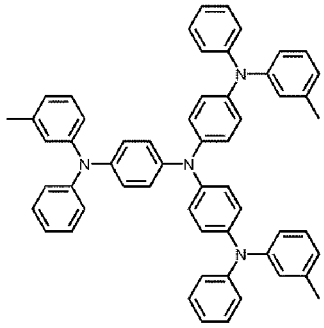

m-MTDATA

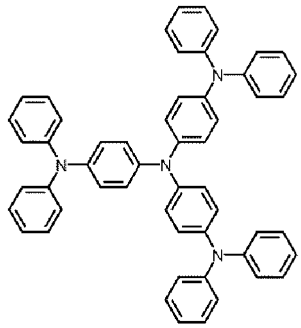

TDATA

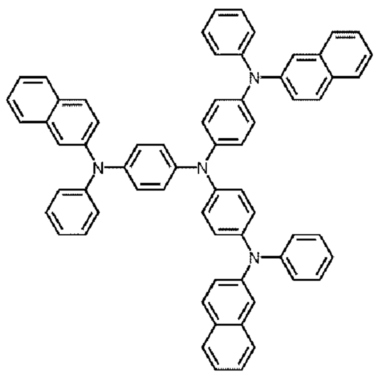

2-TNATA

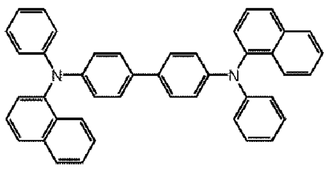

NPB

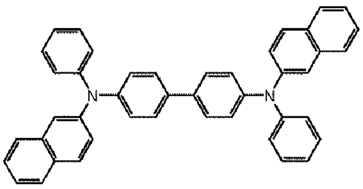

β-NPB

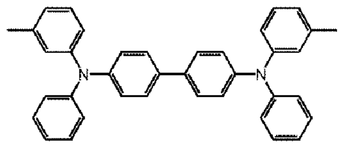

TPD

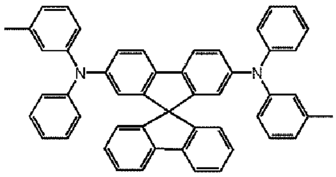

Spiro-TPD

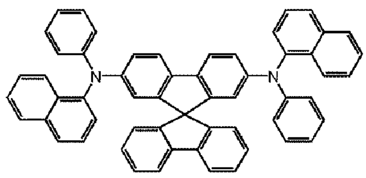

Spiro-NPB

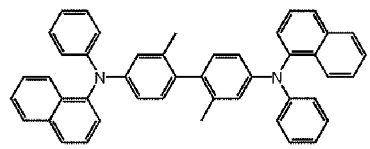

methylated NPB

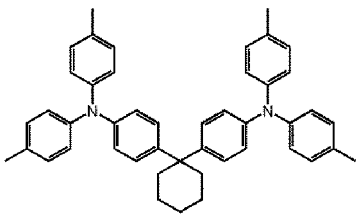

TAPC

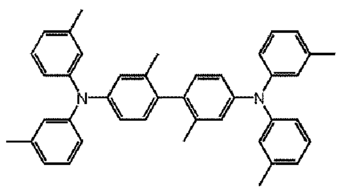

HMTPD

Formula 201

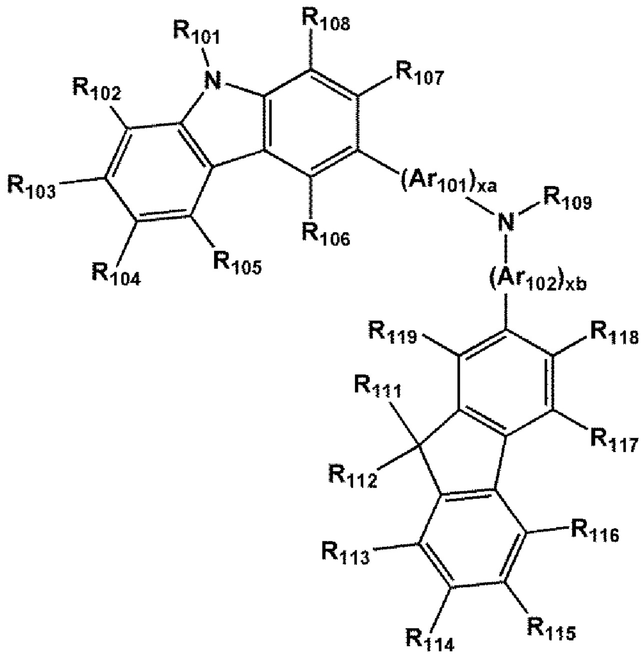

Formula 202

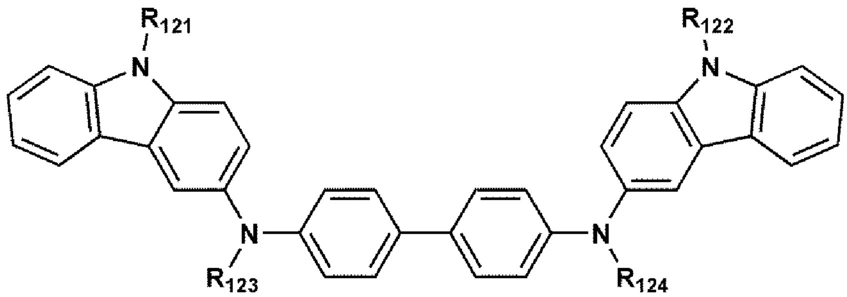

$Ar_{101}$ and $Ar_{102}$ in Formula 201 may each independently be selected from:

a phenylene group, a pentalenylene group, an indenylene group, a naphthylene group, an azulenylene group, a heptalenylene group, an acenaphthylene group, a fluorenylene group, a phenalenylene group, a phenanthrenylene group, an anthracenylene group, a fluoranthenylene group, a triphenylenylene group, a pyrenylene group, a chrysenylenylene group, a naphthacenylene group, a picenylene group, a perylenylene group, and a pentacenylene group; and

a phenylene group, a pentalenylene group, an indenylene group, a naphthylene group, an azulenylene group, a heptalenylene group, an acenaphthylene group, a fluorenylene group, a phenalenylene group, a phenanthrenylene group, an anthracenylene group, a fluoranthenylene group, a triphenylenylene group, a pyrenylene group, a chrysenylenylene group, a naphthacenylene group, a picenylene group, a perylenylene group, and a pentacenylene group, each substituted with at least one selected from deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{60}$ alkyl group, a $C_2$-$C_{60}$ alkenyl group, a $C_2$-$C_{60}$ alkynyl group, a $C_1$-$C_{60}$ alkoxy group, a $C_3$-$C_{10}$ cycloalkyl group, a $C_3$-$C_{10}$ cycloalkenyl group, a $C_1$-$C_{10}$ heterocycloalkyl group, a $C_1$-$C_{10}$ heterocycloalkenyl group, a $C_6$-$C_{60}$ aryl group, a $C_6$-$C_{60}$ aryloxy group, a $C_6$-$C_{60}$ arylthio group, a $C_7$-$C_{60}$ aryl alkyl group, a $C_1$-$C_{60}$ heteroaryl group, a $C_1$-$C_{60}$ heteroaryloxy group, a $C_1$-$C_{60}$ heteroarylthio group, a $C_2$-$C_{60}$ heteroaryl alkyl group, a monovalent non-aromatic condensed polycyclic group, and a monovalent non-aromatic condensed heteropolycyclic group.

In Formula 201, xa and xb may each independently be an integer from 0 to 5, or 0, 1, or 2. For example, xa is

1 and xb is 0, but xa and xb are not limited thereto.

$R_{101}$ to $R_{108}$, $R_{111}$ to $R_{119}$, and $R_{121}$ to $R_{124}$ in Formulae 201 and 202 may each independently be selected from:

hydrogen, deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{10}$ alkyl group (for example, a methyl group, an ethyl group, a propyl group, a butyl group, a pentyl group, a hexyl group, and so on), and a $C_1$-$C_{10}$ alkoxy group (for example, a methoxy group, an ethoxy group, a propoxy group, a butoxy group, a pentoxy group, and so on);
a $C_1$-$C_{10}$ alkyl group or a $C_1$-$C_{10}$ alkoxy group, each substituted with at least one selected from deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, and a phosphoric acid group or a salt thereof;
a phenyl group, a naphthyl group, an anthracenyl group, a fluorenyl group, and a pyrenyl group; and
a phenyl group, a naphthyl group, an anthracenyl group, a fluorenyl group, and a pyrenyl group, each substituted with at least one selected from deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{10}$ alkyl group, and a $C_1$-$C_{10}$ alkoxy group, but embodiments of the present disclosure are not limited thereto.

$R_{109}$ in Formula 201 may be selected from:

a phenyl group, a naphthyl group, an anthracenyl group, and a pyridinyl group; and
a phenyl group, a naphthyl group, an anthracenyl group, and a pyridinyl group, each substituted with at least one selected from deuterium, - F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{20}$ alkyl group, a $C_1$-$C_{20}$ alkoxy group, a phenyl group, a naphthyl group, an anthracenyl group, and a pyridinyl group.

According to an embodiment, the compound represented by Formula 201 may be represented by Formula 201A, but embodiments of the present disclosure are not limited thereto:

Formula 201A

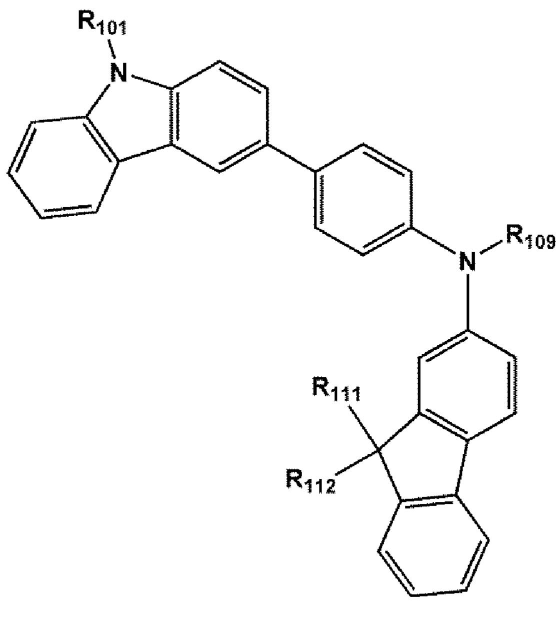

$R_{101}$, $R_{111}$, $R_{112}$, and $R_{109}$ in Formula 201A may be understood by referring to the description provided herein.

For example, the compound represented by Formula 201, and the compound represented by Formula 202 may include compounds HT1 to HT20 illustrated below, but are not limited thereto.

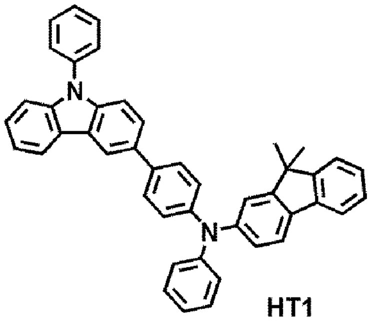

HT1

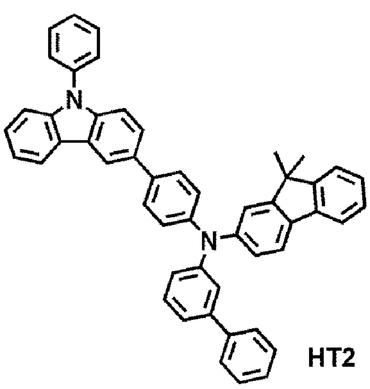

HT2

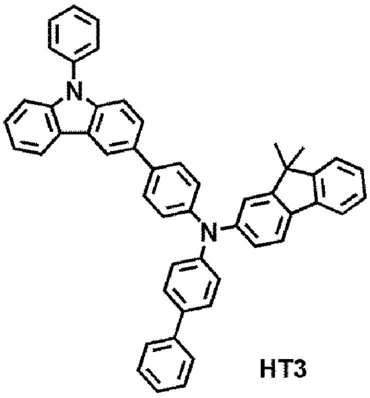

HT3

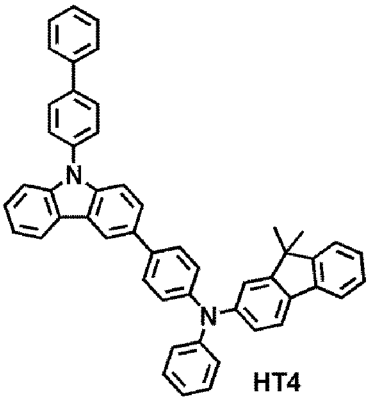

HT4

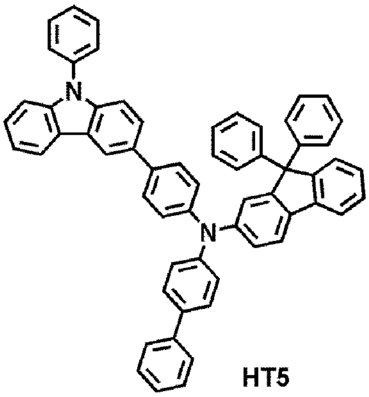

HT5

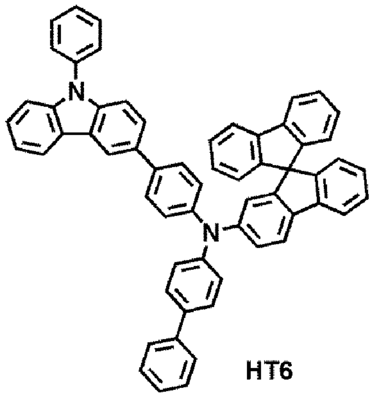

HT6

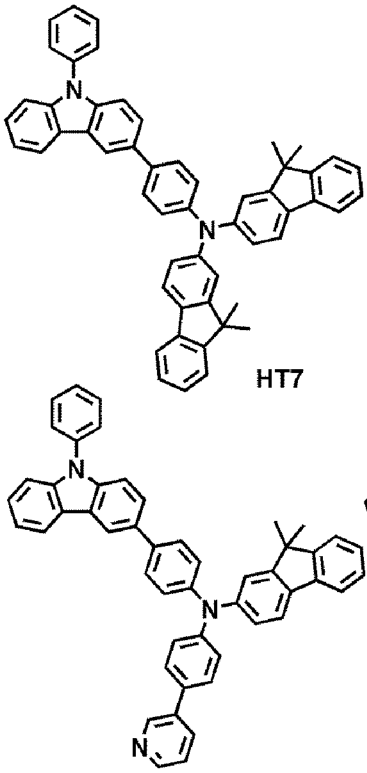

HT7

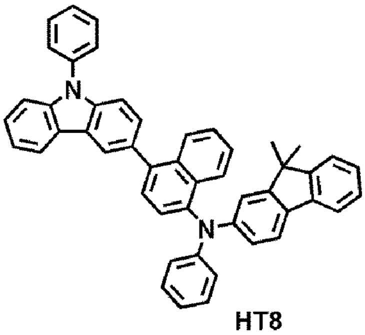

HT8

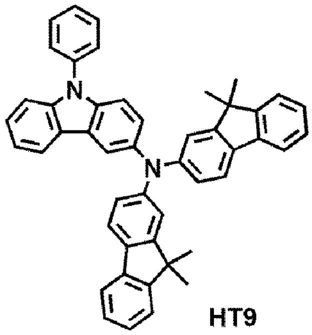

HT9

HT10

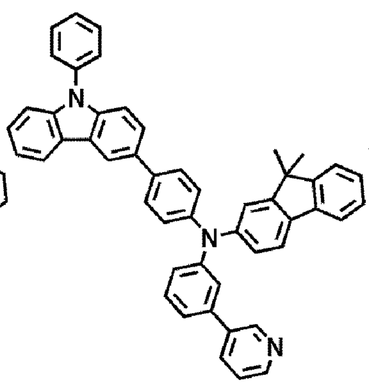

HT11

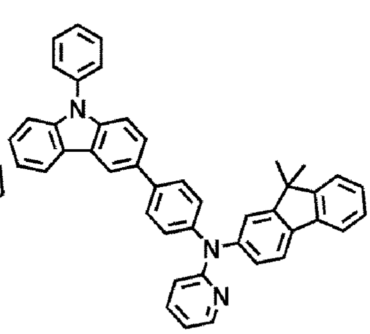

HT12

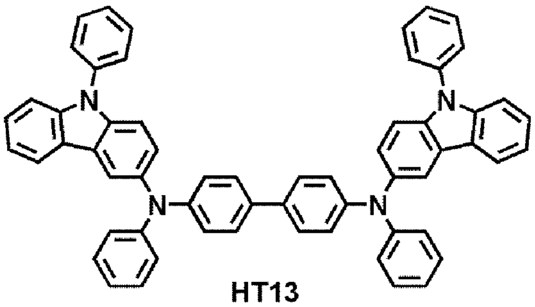

HT13

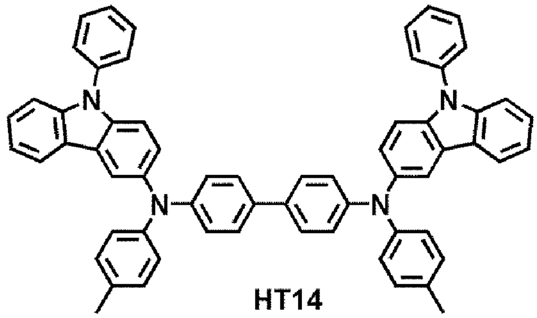

HT14

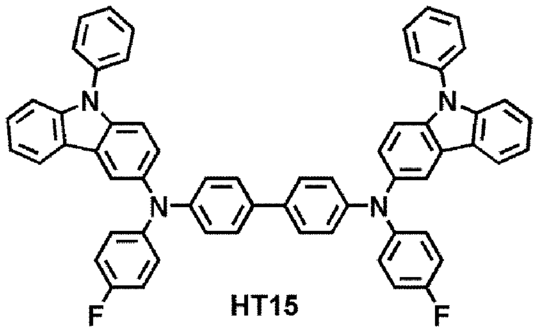

HT15

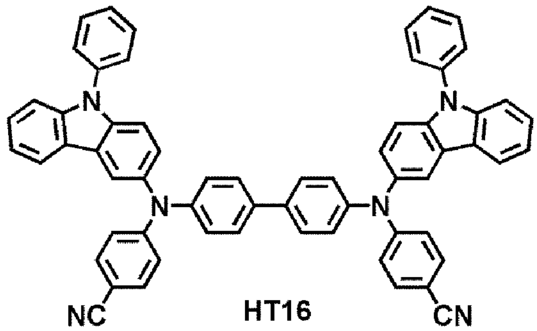

HT16

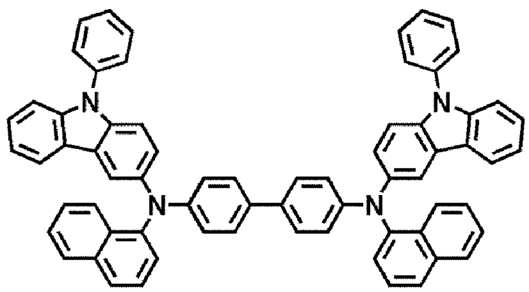

HT17

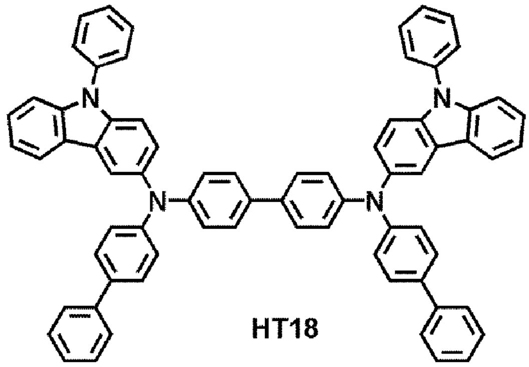

HT18

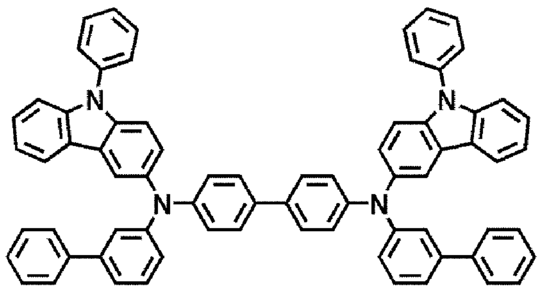

HT19

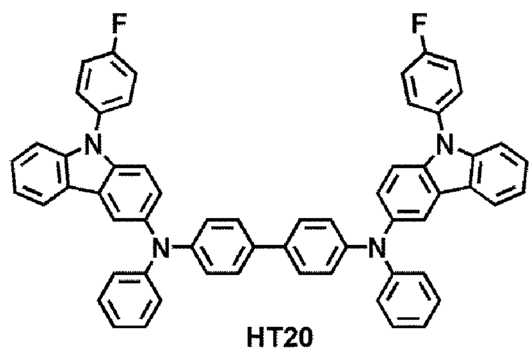

HT20

A thickness of the hole transport region may be in a range of about 100 Å to about 10,000 Å, for example, about 100 Å to about 1,000 Å. When the hole transport region includes at least one of a hole injection layer and a hole transport layer, the thickness of the hole injection layer may be in a range of about 100 Å to about 10,000 Å, and for example, about 100 Å to about 1,000 Å, and the thickness of the hole transport layer may be in a range of about 50 Å to about 2,000 Å, and for example, about 100 Å to about 1,500 Å. While not wishing to be bound by theory, it is understood that when the thicknesses of the hole transport region, the hole injection layer, and the hole transport layer are within these ranges, satisfactory hole transporting characteristics may be obtained without a substantial increase in driving voltage.

The hole transport region may further include, in addition to these materials, a charge-generation material for

the improvement of conductive properties. The charge-generation material may be homogeneously or non-homogeneously dispersed in the hole transport region.

The charge-generation material may be, for example, a p-dopant. The p-dopant may be one selected from a quinone derivative, a metal oxide, and a cyano group-containing compound, but embodiments of the present disclosure are not limited thereto. Non-limiting examples of the p-dopant are a quinone derivative, such as tetracyanoquinonedimethane (TCNQ) or 2,3,5,6-tetrafluoro-tetracyano-1,4-benzoquinonedimethane (F4-TCNQ); a metal oxide, such as a tungsten oxide or a molybdenium oxide; and a cyano group-containing compound, such as Compound HT-D1 below, but are not limited thereto.

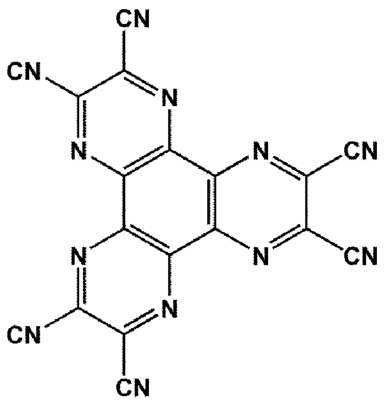

HT-D1

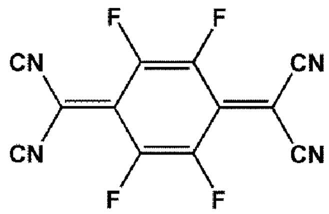

F4-TCNQ

The hole transport region may include a buffer layer.

Also, the buffer layer may compensate for an optical resonance distance according to a wavelength of light emitted from the emission layer, and thus, efficiency of a formed organic light-emitting device may be improved.

Then, an emission layer (EML) may be formed on the hole transport region by vacuum deposition, spin coating, casting, LB deposition, or the like. When the emission layer is formed by vacuum deposition or spin coating, the deposition or coating conditions may be similar to those applied in forming the hole injection layer although the deposition or coating conditions may vary according to a compound that is used to form the emission layer.

Meanwhile, when the hole transport region includes an electron blocking layer, a material for the electron blocking layer may be selected from materials for the hole transport region described above and materials for a host to be explained later. However, the material for the electron blocking layer is not limited thereto. For example, when the hole transport region includes an electron blocking layer, a material for the electron blocking layer may be mCP, which will be explained later.

The emission layer may include a host and a dopant, and the dopant may include the organometallic compound represented by Formula 1.

The host may include at least one selected from TPBi, TBADN, ADN (also referred to as "DNA"), CBP, CDBP, TCP, mCP, Compound H50, and Compound H51:

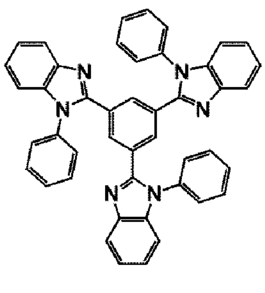

TPBi

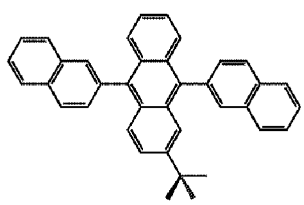

TBADN

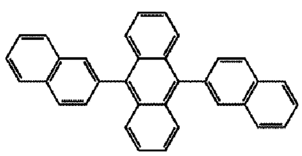

ADN

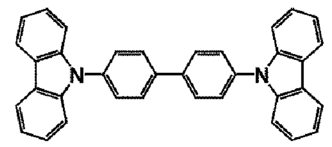

CBP

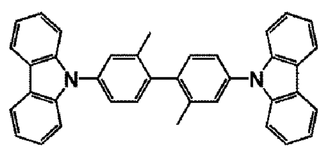

CDBP

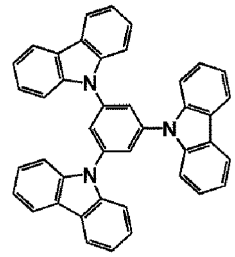

TCP

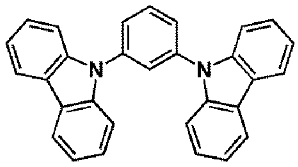

mCP

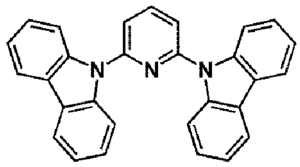

H50

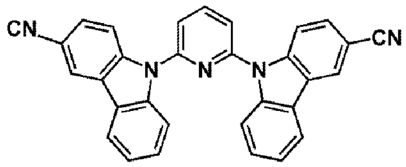

H51

In one or more embodiments, the host may further include a compound represented by Formula 301 below.

Formula 301

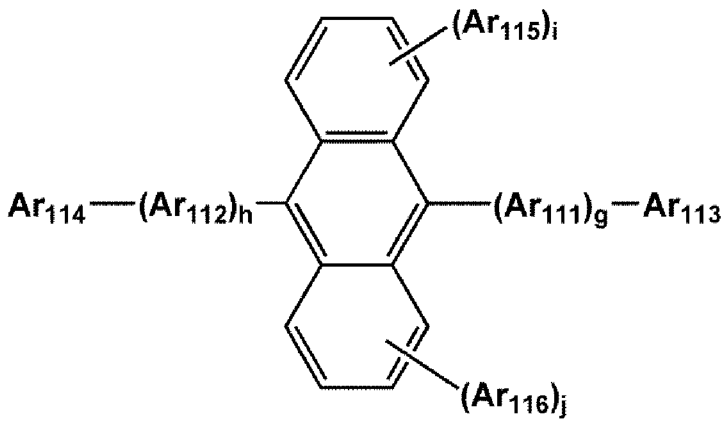

$Ar_{111}$ and $Ar_{112}$ in Formula 301 may each independently be selected from:

a phenylene group, a naphthylene group, a phenanthrenylene group, and a pyrenylene group; and
a phenylene group, a naphthylene group, a phenanthrenylene group, and a pyrenylene group, each substituted with at least one selected from a phenyl group, a naphthyl group, and an anthracenyl group.

$Ar_{113}$ to $Ar_{116}$ in Formula 301 may each independently be selected from:

a $C_1$-$C_{10}$ alkyl group, a phenyl group, a naphthyl group, a phenanthrenyl group, and a pyrenyl group; and
a phenyl group, a naphthyl group, a phenanthrenyl group, and a pyrenyl group, each substituted with at least one selected from a phenyl group, a naphthyl group, and an anthracenyl group.

g, h, i, and j in Formula 301 may each independently be an integer from 0 to 4, and may be, for example, 0, 1, or 2.

$Ar_{113}$ to $Ar_{116}$ in Formula 301 may each independently be selected from:

a $C_1$-$C_{10}$ alkyl group substituted with at least one selected from a phenyl group, a naphthyl group, and an anthracenyl group;
a phenyl group, a naphthyl group, an anthracenyl group, a pyrenyl, a phenanthrenyl group, and a fluorenyl group;
a phenyl group, a naphthyl group, an anthracenyl group, a pyrenyl group, a phenanthrenyl group, and a fluorenyl group, each substituted with at least one selected from deuterium, -F, -Cl, -Br, -I, a hydroxyl group, a cyano group,

a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{60}$ alkyl group, a $C_2$-$C_{60}$ alkenyl group, a $C_2$-$C_{60}$ alkynyl group, a $C_1$-$C_{60}$ alkoxy group, a phenyl group, a naphthyl group, an anthracenyl group, a pyrenyl group, a phenanthrenyl group, and a fluorenyl group; and

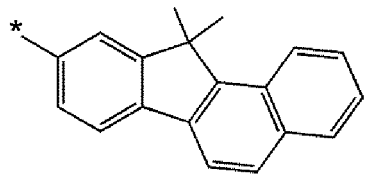

;

but embodiments of the present disclosure are not limited thereto.

In one or more embodiments, the host may include a compound represented by Formula 302 below:

Formula 302

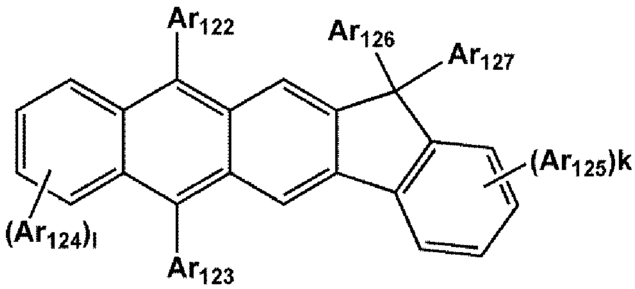

.

$Ar_{122}$ to $Ar_{125}$ in Formula 302 are the same as described in detail in connection with $Ar_{113}$ in Formula 301.

$Ar_{126}$ and $Ar_{127}$ in Formula 302 may each independently be a $C_1$-$C_{10}$ alkyl group (for example, a methyl group, an ethyl group, or a propyl group).

k and l in Formula 302 may each independently be an integer from 0 to 4. For example, k and l may be 0, 1, or 2.

When the organic light-emitting device is a full-color organic light-emitting device, the emission layer may be patterned into a red emission layer, a green emission layer, and a blue emission layer. In one or more embodiments, due to a stacked structure including a red emission layer, a green emission layer, and/or a blue emission layer, the emission layer may emit white light.

When the emission layer includes a host and a dopant, an amount of the dopant may be in a range of about 0.01 parts by weight to about 15 parts by weight based on 100 parts by weight of the host, but embodiments of the present disclosure are not limited thereto.

The dopant may include the organometallic compound represented by Formula 1 above. For example, the dopant may be a red phosphorescent dopant.

A thickness of the emission layer may be in a range of about 100 Å to about 1,000 Å, for example, about 200 Å to about 600 Å. While not wishing to be bound by theory, it is understood that when the thickness of the emission layer is within this range, excellent light-emission characteristics may be obtained without a substantial increase in driving voltage.

Then, an electron transport region may be disposed on the emission layer.

The electron transport region may include a hole blocking layer, an electron transport layer, an electron injection layer, or any combination thereof.

For example, the electron transport region may have a hole blocking layer/electron transport layer/electron injection layer structure or an electron transport layer/electron injection layer structure, but the structure of the electron transport region is not limited thereto. The electron transport layer may have a single-layered structure or a multi-layered structure including two or more different materials.

Conditions for forming the hole blocking layer, the electron transport layer, and the electron injection layer which constitute the electron transport region may be understood by referring to the conditions for forming the hole injection layer.

When the electron transport region includes a hole blocking layer, the hole blocking layer may include, for example, at least one of BCP, Bphen, and BAlq but embodiments of the present disclosure are not limited thereto.

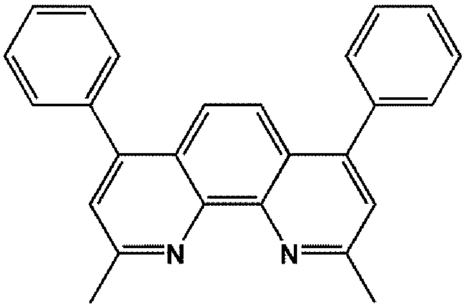

BCP

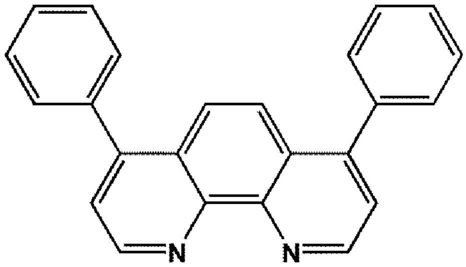

Bphen

A thickness of the hole blocking layer may be in a range of about 20 Å to about 1,000 Å, for example, about 30 Å to about 300 Å. While not wishing to be bound by theory, it is understood that when the thickness of the hole blocking layer is within these ranges, the hole blocking layer may have improved hole blocking ability without a substantial increase in driving voltage.

The electron transport layer may further include at least one selected from BCP, Bphen, $Alq_3$, BAlq, TAZ, and NTAZ.

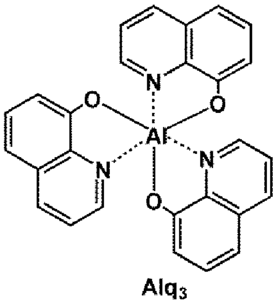

$Alq_3$

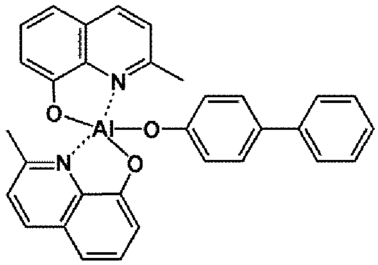

BAlq

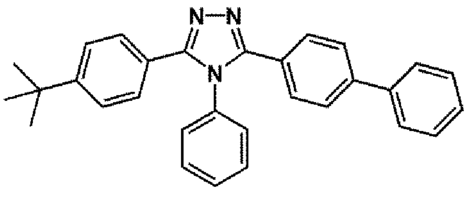

TAZ

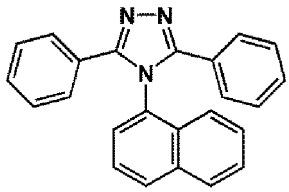

NTAZ

In one or more embodiments, the electron transport layer may include at least one of ET1 to ET25, but are not limited thereto:

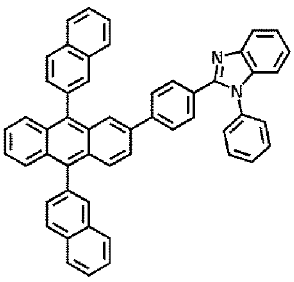

ET1

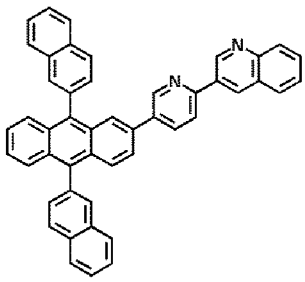

ET2

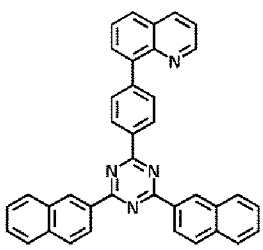

ET3

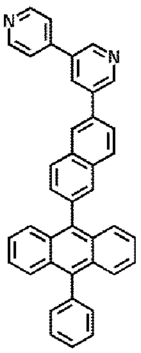

ET4

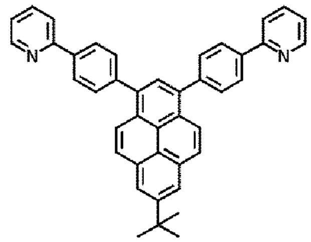

ET5

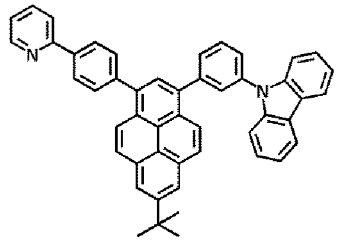

ET6

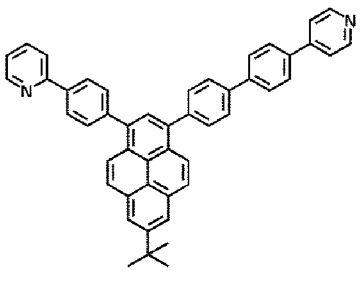

ET7

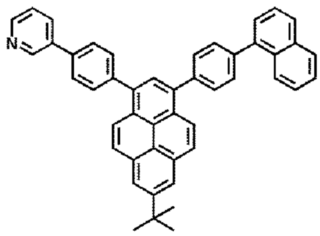

ET8

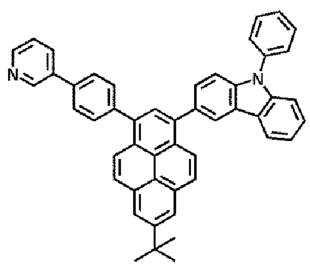

ET9

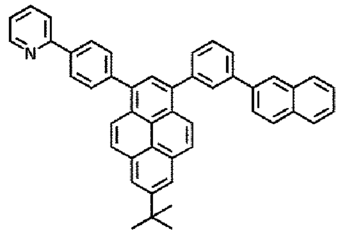

ET10

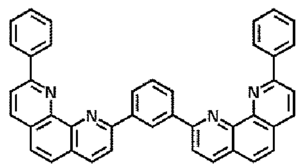

ET11

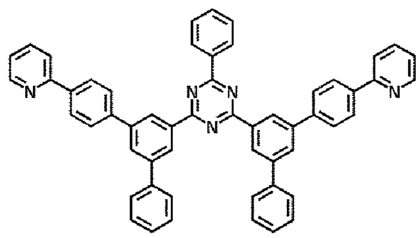

ET12

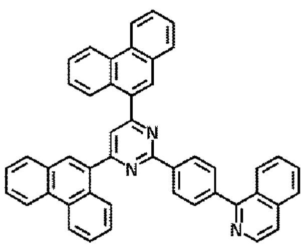

ET13

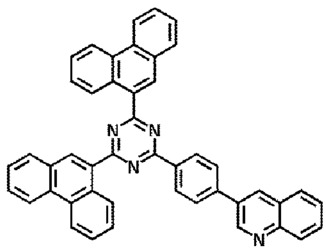

ET14

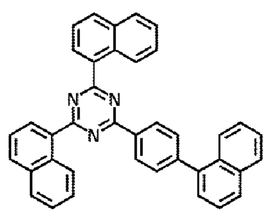

ET15

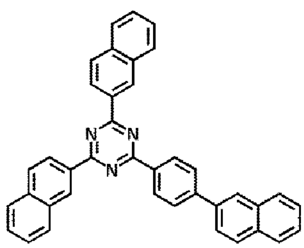

ET16

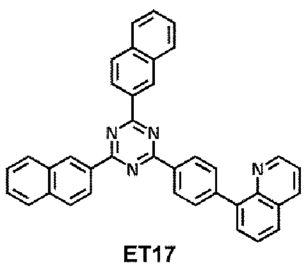

ET17

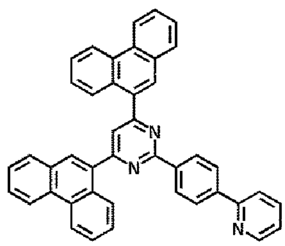

ET18

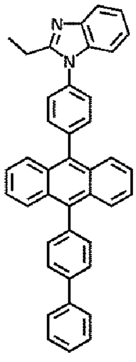

ET19

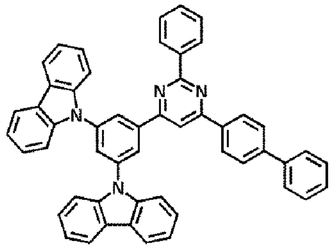

ET20

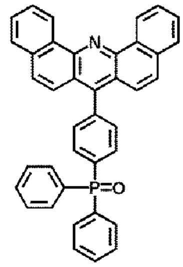

ET21

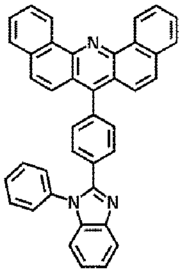

ET22

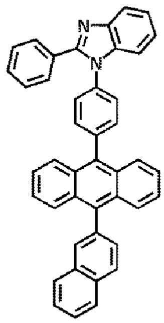

ET23

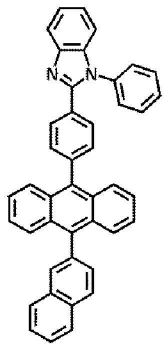

ET24

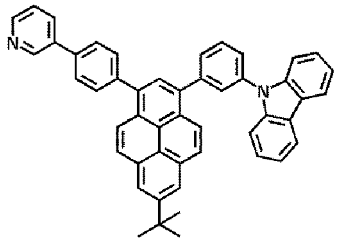

ET25

A thickness of the electron transport layer may be in a range of about 100 Å to about 1,000 Å, for example, about 150 Å to about 500 Å. While not wishing to be bound by theory, it is understood that when the thickness of the electron transport layer is within the range described above, the electron transport layer may have satisfactory electron transport characteristics without a substantial increase in driving voltage.

Also, the electron transport layer may further include, in addition to the materials described above, a metal-containing material.

The metal-containing material may include a Li complex. The Li complex may include, for example, Compound ET-D1 (8-hydroxylithium quinolate, LiQ) or ET-D2.

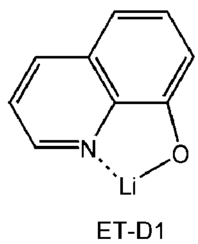

ET-D1

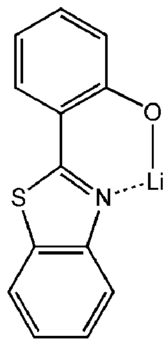

ET-D2

The electron transport region may include an electron injection layer (EIL) that promotes flow of electrons from the second electrode 19 thereinto.

The electron injection layer may include at least one selected from LiF, NaCl, CsF, $Li_2O$, and BaO.

A thickness of the electron injection layer may be in a range of about 1 Å to about 100 Å, for example, about 3 Å to about 90 Å. While not wishing to be bound by theory, it is understood that when the thickness of the electron injection layer is within the range described above, the electron injection layer may have satisfactory electron injection characteristics without a substantial increase in driving voltage.

The second electrode 19 is disposed on the organic layer 15. The second electrode 19 may be a cathode. A material for forming the second electrode 19 may be selected from metal, an alloy, an electrically conductive compound, and a combination thereof, which have a relatively low work function. For example, lithium (Li), magnesium (Mg), aluminum (Al), aluminum-lithium (Al-Li), calcium (Ca), magnesium-indium (Mg-In), or magnesium-silver (Mg-Ag) may be used as a material for forming the second electrode 19. In one or more embodiments, to manufacture a top-emission type light-emitting device, a transmissive electrode formed using ITO or IZO may be used as the second electrode 19.

Hereinbefore, the organic light-emitting device has been described with reference to the FIGURE, but embodiments of the present disclosure are not limited thereto.

Another aspect of the present disclosure provides a diagnostic composition including at least one organometallic compound represented by Formula 1.

The organometallic compound represented by Formula 1 provides high luminescent efficiency. Accordingly, a diagnostic composition including the organometallic compound may have high diagnostic efficiency.

The diagnostic composition may be used in various applications including a diagnosis kit, a diagnosis reagent, a biosensor, and a biomarker.

The term "$C_1$-$C_{60}$ alkyl group" as used herein refers to a linear or branched saturated aliphatic hydrocarbon monovalent group having 1 to 60 carbon atoms, and non-limiting examples thereof include a methyl group, an ethyl group, a propyl group, an iso-butyl group, a sec-butyl group, a tert-butyl group, a pentyl group, an iso-amyl group, and a hexyl group. The term "$C_1$-$C_{60}$ alkylene group" as used herein refers to a divalent group having the same structure as the $C_1$-$C_{60}$ alkyl group.

The term "$C_1$-$C_{60}$ alkoxy group" as used herein refers to a monovalent group represented by $-OA_{101}$ (wherein $A_{101}$ is the $C_1$-$C_{60}$ alkyl group), and non-limiting examples thereof include a methoxy group, an ethoxy group, and an iso-propyloxy group.

The term "$C_2$-$C_{60}$ alkenyl group" as used herein refers to a hydrocarbon group formed by including at least one carbon-carbon double bond in the middle or at the terminus of the $C_2$-$C_{60}$ alkyl group, and examples thereof include an ethenyl group, a propenyl group, and a butenyl group. The term "$C_2$-$C_{60}$ alkenylene group" as used herein refers to a divalent group having the same structure as the $C_2$-$C_{60}$ alkenyl group.

The term "$C_2$-$C_{60}$ alkynyl group" as used herein refers to a hydrocarbon group formed by including at least one carbon-carbon triple bond in the middle or at the terminus of the $C_2$-$C_{60}$ alkyl group, and examples thereof include an ethynyl group, and a propynyl group. The term "$C_2$-$C_{60}$ alkynylene group" as used herein refers to a divalent group having the same structure as the $C_2$-$C_{60}$ alkynyl group.

The term "$C_3$-$C_{10}$ cycloalkyl group" as used herein refers to a monovalent saturated hydrocarbon monocyclic group having 3 to 10 carbon atoms, and non-limiting examples thereof include a cyclopropyl group, a cyclobutyl group, a cyclopentyl group, a cyclohexyl group, and a cycloheptyl group. The term "$C_3$-$C_{10}$ cycloalkylene group" as used herein refers to a divalent group having the same structure as the $C_3$-$C_{10}$ cycloalkyl group.

The term "$C_1$-$C_{10}$ heterocycloalkyl group" as used herein refers to a monovalent saturated monocyclic group having at least one heteroatom selected from N, O, P, Si and S as a ring-forming atom and 1 to 10 carbon atoms, and non-limiting examples thereof include a tetrahydrofuranyl group, and a tetrahydrothiophenyl group. The term "$C_1$-$C_{10}$ heterocycloalkylene group" as used herein refers to a divalent group having the same structure as the $C_1$-$C_{10}$ heterocycloalkyl group.

The term "$C_3$-$C_{10}$ cycloalkenyl group" as used herein refers to a monovalent monocyclic group that has 3 to 10 carbon atoms and at least one double bond in the ring thereof and no aromaticity, and non-limiting examples thereof include a cyclopentenyl group, a cyclohexenyl group, and a cycloheptenyl group. The term "$C_3$-$C_{10}$ cycloalkenylene group" as used herein refers to a divalent group having the same structure as the $C_3$-$C_{10}$ cycloalkenyl group.

The term "$C_1$-$C_{10}$ heterocycloalkenyl group" as used herein refers to a monovalent monocyclic group that has at least one heteroatom selected from N, O, P, Si, and S as a ring-forming atom, 1 to 10 carbon atoms, and at least one carbon-carbon double bond in its ring. Examples of the $C_1$-$C_{10}$ heterocycloalkenyl group are a 2,3-dihydrofuranyl group, and a 2,3-dihydrothiophenyl group. The term "$C_1$-$C_{10}$ heterocycloalkenylene group" as used herein refers to a divalent group having the same structure as the $C_1$-$C_{10}$ heterocycloalkenyl group.

The term "$C_6$-$C_{60}$ aryl group" as used herein refers to a monovalent group having a carbocyclic aromatic system having 6 to 60 carbon atoms, and the term "$C_6$-$C_{60}$ arylene group" as used herein refers to a divalent group having a carbocyclic aromatic system having 6 to 60 carbon atoms. Non-limiting examples of the $C_6$-$C_{60}$ aryl group include a phenyl group, a naphthyl group, an anthracenyl group, a phenanthrenyl group, a pyrenyl group, and a chrysenyl group. When the $C_6$-$C_{60}$ aryl group and the $C_6$-$C_{60}$ arylene group each include two or more rings, the rings may be fused to each other.

The term "$C_7$-$C_{60}$ alkylaryl group" as used herein refers to a $C_6$-$C_{60}$ aryl group substituted at least one $C_1$-$C_{60}$ alkyl group.

The term "$C_1$-$C_{60}$ heteroaryl group" as used herein refers to a monovalent group having a heterocyclic aromatic system that has at least one heteroatom selected from N, O, P, Si, and S as a ring-forming atom, and 1 to 60 carbon

atoms. The term "$C_1$-$C_{60}$ heteroarylene group" as used herein refers to a divalent group having a heterocyclic aromatic system that has at least one heteroatom selected from N, O, P, Si and S as a ring-forming atom, and 1 to 60 carbon atoms. Non-limiting examples of the $C_1$-$C_{60}$ heteroaryl group include a pyridinyl group, a pyrimidinyl group, a pyrazinyl group, a pyridazinyl group, a triazinyl group, a quinolinyl group, and an isoquinolinyl group. When the $C_1$-$C_{60}$ heteroaryl group and the $C_1$-$C_{60}$ heteroarylene group each include two or more rings, the rings may be fused to each other.

The term "$C_2$-$C_{60}$ alkyl heteroaryl group" as used herein refers to a $C_1$-$C_{60}$ heteroaryl group substituted with at least one $C_1$-$C_{60}$ alkyl group.

The term "$C_6$-$C_{60}$ aryloxy group" as used herein indicates $-OA_{102}$ (wherein $A_{102}$ is the $C_6$-$C_{60}$ aryl group), and the term a "$C_6$-$C_{60}$ arylthio group" as used herein indicates $-SA_{103}$ (wherein $A_{103}$ is the $C_6$-$C_{60}$ aryl group), and the term "$C_7$-$C_{60}$ aryl alkyl group" as used herein indicates $-A_{104}A_{105}$ (wherein $A_{105}$ is the $C_6$-$C_{59}$ aryl group and $A_{104}$ is the $C_1$-$C_{53}$ alkylene group).

The term "$C_1$-$C_{60}$ heteroaryloxy group" as used herein refers to $-OA_{106}$ (wherein $A_{106}$ is the $C_2$-$C_{60}$ heteroaryl group), the term "$C_1$-$C_{60}$ heteroarylthio group" as used herein indicates $-SA_{107}$ (wherein $A_{107}$ is the $C_1$-$C_{60}$ heteroaryl group), and the term "$C_2$-$C_{60}$ heteroaryl alkyl group" as used herein refers to $-A_{108}A_{109}$ ($A_{109}$ is a $C_1$-C59 heteroaryl group, and $A_{108}$ is a $C_1$-$C_{59}$ alkylene group).

The term "monovalent non-aromatic condensed polycyclic group" as used herein refers to a monovalent group (for example, having 8 to 60 carbon atoms) having two or more rings condensed to each other, only carbon atoms as ring-forming atoms, and no aromaticity in its entire molecular structure. Examples of the monovalent non-aromatic condensed polycyclic group include a fluorenyl group. The term "divalent non-aromatic condensed polycyclic group" as used herein refers to a divalent group having the same structure as the monovalent non-aromatic condensed polycyclic group.

The term "monovalent non-aromatic condensed heteropolycyclic group" as used herein refers to a monovalent group (for example, having 2 to 60 carbon atoms) having two or more rings condensed to each other, a heteroatom selected from N, O, P, Si, and S, other than carbon atoms, as a ring-forming atom, and no aromaticity in its entire molecular structure. Non-limiting examples of the monovalent non-aromatic condensed heteropolycyclic group include a carbazolyl group. The term "divalent non-aromatic condensed heteropolycyclic group" as used herein refers to a divalent group having the same structure as the monovalent non-aromatic condensed heteropolycyclic group.

The term "$C_5$-$C_{30}$ carbocyclic group" as used herein refers to a saturated or unsaturated cyclic group having, as a ring-forming atom, 5 to 30 carbon atoms only. The $C_5$-$C_{30}$ carbocyclic group may be a monocyclic group or a polycyclic group.

The term "$C_1$-$C_{30}$ heterocyclic group" as used herein refers to a saturated or unsaturated cyclic group having, as a ring-forming atom, at least one heteroatom selected from N, O, Si, P, and S other than 1 to 30 carbon atoms. The $C_1$-$C_{30}$ heterocyclic group may be a monocyclic group or a polycyclic group.

At least one substituent selected from the substituted $C_5$-$C_{30}$ carbocyclic group, the substituted $C_2$-$C_{30}$ heterocyclic group, the substituted $C_1$-$C_{60}$ alkyl group, the substituted $C_2$-$C_{60}$ alkenyl group, the substituted $C_2$-$C_{60}$ alkynyl group, the substituted $C_1$-$C_{60}$ alkoxy group, the substituted $C_3$-$C_{10}$ cycloalkyl group, the substituted $C_1$-$C_{10}$ heterocycloalkyl group, the substituted $C_3$-$C_{10}$ cycloalkenyl group, the substituted $C_1$-$C_{10}$ heterocycloalkenyl group, the substituted $C_6$-$C_{60}$ aryl group, the substituted $C_7$-$C_{60}$ alkyl aryl group, the substituted $C_6$-$C_{60}$ aryloxy group, the substituted $C_6$-$C_{60}$ arylthio group, the substituted $C_7$-$C_{60}$ aryl alkyl group, the substituted $C_1$-$C_{60}$ heteroaryl group, the substituted $C_1$-$C_{60}$ heteroaryloxy group, the substituted $C_1$-$C_{60}$ heteroarylthio group, the substituted $C_2$-$C_{60}$ heteroaryl alkyl group, the substituted $C_2$-$C_{60}$ alkyl heteroaryl group, the substituted monovalent non-aromatic condensed polycyclic group, and the substituted monovalent non-aromatic condensed heteropolycyclic group may be selected from:

deuterium, -F, -Cl, -Br, -I, $-CD_3$, $-CD_2H$, $-CDH_2$, $-CF_3$, $-CF_2H$, $-CFH_2$, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a $C_1$-$C_{60}$ alkyl group, a $C_2$-$C_{60}$ alkenyl group, a $C_2$-$C_{60}$ alkynyl group, and a $C_1$-$C_{60}$ alkoxy group;

a $C_1$-$C_{60}$ alkyl group, a $C_2$-$C_{60}$ alkenyl group, a $C_2$-$C_{60}$ alkynyl group, and a $C_1$-$C_{60}$ alkoxy group, each substituted with at least one selected from deuterium, -F, -Cl, -Br, -I, $-CD_3$, $-CD_2H$, $-CDH_2$, $-CF_3$, $-CF_2H$, $-CFH_2$, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_7$-$C_{60}$ alkyl aryl group, a $C_6$-$C_{60}$ aryloxy group, a $C_6$-$C_{60}$ arylthio group, a $C_7$-$C_{60}$ aryl alkyl group, a $C_1$-$C_{60}$ heteroaryl group, a $C_1$-$C_{60}$ heteroaryloxy group, a $C_1$-$C_{60}$ heteroarylthio group, a $C_2$-$C_{60}$ heteroaryl alkyl group, a $C_2$-$C_{60}$ alkyl heteroaryl group, a monovalent non-aromatic condensed polycyclic group, a monovalent non-aromatic condensed heteropolycyclic group, $-N(Q_{11})(Q_{12})$,$-Si(Q_{13})(Q_{14})(Q_{15})$, $-B(Q_{16})(Q_{17})$, and $-P(=O)(Q_{18})(Q_{19})$;

a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl

group, a $C_6$-$C_{60}$ aryl group, a $C_7$-$C_{60}$ alkyl aryl group, a $C_6$-$C_{60}$ aryloxy group, a $C_6$-$C_{60}$ arylthio group, a $C_7$-$C_{60}$ aryl alkyl group, a $C_1$-$C_{60}$ heteroaryl group, a $C_1$-$C_{60}$ heteroaryloxy group, a $C_1$-$C_{60}$ heteroarylthio group, a $C_2$-$C_{60}$ heteroaryl alkyl group, a $C_2$-$C_{60}$ alkyl heteroaryl group, a monovalent non-aromatic condensed polycyclic group, and a monovalent non-aromatic condensed heteropolycyclic group;

a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_7$-$C_{60}$ alkyl aryl group, a $C_6$-$C_{60}$ aryloxy group, a $C_6$-$C_{60}$ arylthio group, a $C_7$-$C_{60}$ aryl alkyl group, a $C_1$-$C_{60}$ heteroaryl group, a $C_1$-$C_{60}$ heteroaryloxy group, a $C_1$-$C_{60}$ heteroarylthio group, a $C_2$-$C_{60}$ heteroaryl alkyl group, a $C_2$-$C_{60}$ alkyl heteroaryl group, a monovalent non-aromatic condensed polycyclic group, and a monovalent non-aromatic condensed heteropolycyclic group, each substituted with at least one selected from deuterium, -F, -Cl, -Br, -I, $-CD_3$, - $CD_2H$, $-CDH_2$, $-CF_3$, $-CF_2H$, $-CFH_2$, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a $C_1$-$C_{60}$ alkyl group, a $C_2$-$C_{60}$ alkenyl group, a $C_2$-$C_{60}$ alkynyl group, a $C_1$-$C_{60}$ alkoxy group, a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_7$-$C_{60}$ alkyl aryl group, a $C_6$-$C_{60}$ aryloxy group, a $C_6$-$C_{60}$ arylthio group, a $C_7$-$C_{60}$ aryl alkyl group, a $C_1$-$C_{60}$ heteroaryl group, a $C_1$-$C_{60}$ heteroaryloxy group, a $C_1$-$C_{60}$ heteroarylthio group, a $C_2$-$C_{60}$ heteroaryl alkyl group, a $C_2$-$C_{60}$ alkyl heteroaryl group, a monovalent non-aromatic condensed polycyclic group, a monovalent non-aromatic condensed heteropolycyclic group, $-N(Q_{21})(Q_{22})$, $-Si(Q_{23})(Q_{24})(Q_{25})$, $-B(Q_{26})(Q_{27})$, and $-P(=O)(Q_{28})(Q_{29})$; and

$-N(Q_{31})(Q_{32})$, $-Si(Q_{33})(Q_{34})(Q_{35})$, $-B(Q_{36})(Q_{37})$, and $-P(=O)(Q_{38})(Q_{39})$, and

$Q_1$ to $Q_9$, $Q_{11}$ to $Q_{19}$, $Q_{21}$ to $Q_{29}$, and $Q_{31}$ to $Q_{39}$ may each independently be selected from hydrogen, deuterium, -F, -Cl, -Br, -I, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a $C_1$-$C_{60}$ alkyl group, a $C_2$-$C_{60}$ alkenyl group, a $C_2$-$C_{60}$ alkynyl group, a $C_1$-$C_{60}$ alkoxy group, a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_7$-$C_{60}$ alkyl aryl group, a $C_6$-$C_{60}$ aryl group substituted with at least one selected from a $C_1$-$C_{60}$ alkyl group and a $C_6$-$C_{60}$ aryl group, a $C_6$-$C_{60}$ aryloxy group, a $C_6$-$C_{60}$ arylthio group, a $C_7$-$C_{60}$ aryl alkyl group, a $C_1$-$C_{60}$ heteroaryl group, a $C_1$-$C_{60}$ heteroaryloxy group, a $C_1$-$C_{60}$ heteroarylthio group, a $C_2$-$C_{60}$ heteroaryl alkyl group, a $C_2$-$C_{60}$ alkyl heteroaryl group, a monovalent non-aromatic condensed polycyclic group, and a monovalent non-aromatic condensed heteropolycyclic group.

Hereinafter, a compound and an organic light-emitting device according to embodiments are described in detail with reference to Synthesis Example and Examples. However, the organic light-emitting device is not limited thereto. The expression "B was used instead of A" used in describing Synthesis Examples means that an identical number of molar equivalents of A was used in place of molar equivalents of B.

EXAMPLES

Synthesis Example 1 (Compound 2)

Compound 2 was synthesized according to the Reaction Scheme:

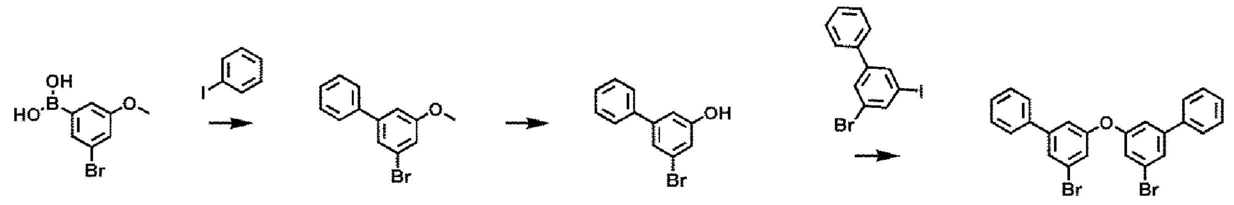

2-5 2-4 2-3

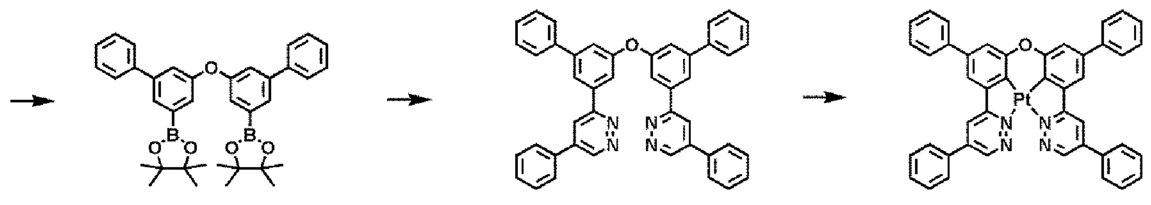

2-2 2-1 2

Synthesis of Intermediate 2-5

10.0 grams (g) (43.3 millimoles, mmol) of (3-bromo-5-methoxyphenyl)boronic acid, 80 milliliters (ml) of tetrahydrofuran (THF), and 20 ml of water were mixed, and 9.7 g (47.6 mmol) of iodobenzene, 3.5 g (3.0 mmol) of $Pd(PPh_3)_4$, and 18.0 g (130.0 mmol) of $K_2CO_3$ were mixed. Then, the reaction mixture was heated under reflux at a temperature of 80 °C for 18 hours. After the reaction was completed, the reaction mixture was concentrated under reduced pressure and dissolved in 50 ml of ethyl acetate to extract the organic layer. The extracted organic layer was dried by using magnesium sulfate, distilled under reduced pressure, and purified by liquid chromatography to obtain 9.1 g (35 mmol, yield: 80 %) of Intermediate 2-5. LC-MS m/z = 263 $(M+H)^+$.

Synthesis of Intermediate 2-4

5.0 g (19.0 mmol) of Intermediate 2-5 and 80 ml of dichloromethane were mixed, and 95 ml (95.0 mmol) of 1.0 molar (M) $BBr_3$ in dichloromethane was slowly added by drops thereto at a temperature of 0 °C for 1 hour. Then, the reaction mixture was stirred at room temperature for about 4 hour, and a small amount of methanol was added by drops thereto again at a temperature of 0 °C. After several minutes, a saturated sodium hydrogen carbonate solution was added by drops thereto to adjust pH to 12 to 13. The organic layer obtained therefrom was dried by using magnesium sulfate, distilled under reduced pressure, and purified by liquid chromatography to obtain 4.2 g (17 mmol, yield: 90 %) of Intermediate 2-4. LC-MS m/z = 249 $(M+H)^+$.

Synthesis of Intermediate 2-3

4.2 g (17.0 mmol) of Intermediate 2-4, 6.1 g (17.0 mmol) of 3-bromo-5-iodo-1,1'-biphenyl, and 80 ml of dimethyl sulfoxide (DMSO) were mixed, and 0.6 g (3.4 mmol) of CuI, 0.8 g (6.8 mmol) of pyridine-2-carboxylic acid, and 7.2 g (34.0 mmol) of $K_3PO_4$ were added thereto. The reaction mixture was then heated under reflux at a temperature of 120 °C for 18 hours. After the reaction mixture was completed, the organic layer was extracted therefrom by using ethyl acetate and water, dried by using magnesium sulfate, distilled under reduced pressure, and purified by liquid chromatography to obtain 4.1 g (8.5 mmol, yield: 50%) of Intermediate 2-3. LC-MS m/z = 479 $(M+H)^+$.

Synthesis of Intermediate 2-2

4.1 g (8.5 mmol) of Intermediate 2-3 and 80 ml of toluene were mixed, and 6.4 g (25.5 mmol) of 4,4,4',4',5,5,5',5'-octamethyl-2,2'-bi(1,3,2-dioxaborolane), 1.2 g (1.7 mmol) of $Pd(PPh_3)_4$, and 2.5 g (25.5 mmol) of KOAc were added thereto. The reaction mixture was heated under reflux at a temperature of 120 °C for 18 hours. After the reaction was completed, the reaction was concentrated under reduced pressure and dissolved in 80 ml of ethyl acetate to extract the organic layer. The extracted organic layer was dried by using magnesium sulfate, distilled under reduced pressure, and purified by liquid chromatography to obtain 3.4 g (6.0 mmol, yield: 70 %) of Intermediate 2-2. LC-MS m/z = 575 $(M+H)^+$.

Synthesis of Intermediate 2-1

3.4 g (6.0 mmol) of Intermediate 2-2 and 80 ml of THF were mixed, and 2.8 g (12.0 mmol) of 3-bromo-5-phenylpyridazine, 1.0 g (0.9 mmol) of $Pd(PPh_3)_4$, and 2.5 g (18.0 mmol) of $K_2CO_3$ were added thereto. The reaction mixture was heated under reflux at a temperature of 80 °C for 18 hours. After the reaction was completed, the organic layer was extracted therefrom by using ethyl acetate and water, dried by using magnesium sulfate, distilled under reduced pressure, and purified by liquid chromatography to obtain 2.2 g (3.6 mmol, yield: 60 %) of Intermediate 2-1. LC-MS m/z = 631 $(M+H)^+$.

Synthesis of Compound 2

1.6 g (2.5 mmol) of Intermediate 2-1, 100 ml of o-xylene, and 200 ml of benzonitrile were mixed at room temperature, and 1.2 g (2.5 mmol) of $PtCl_2(NCPh)_2$ was added thereto. The reaction mixture was heated under reflux for 26 hours. After completion of the reaction was confirmed by LCMS, the reaction mixture was concentrated under reduced pressure and purified by liquid chromatography to obtain 0.7 g (0.8 mmol, yield: 30 %) of Compound 2. The obtained compound was identified by LC-MS. LC-MS m/z = 824 $(M+H)^+$.

Synthesis Example 2 (Compound 1)

Compound 1 was synthesized according to the Reaction Scheme:

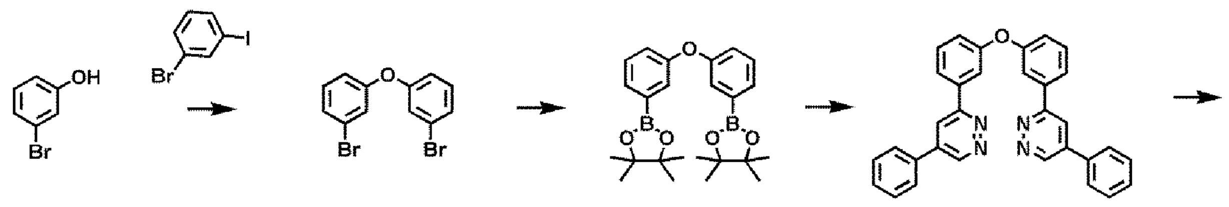

1-3 1-2 1-1

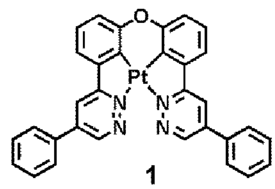

1

Synthesis of Intermediate 1-3

Intermediate 1-3 (yield: 65 %) was synthesized in the same manner as Intermediate 2-3 of Synthesis Example 1, except that 3-bromophenol was used instead of Intermediate 2-4, and 1-bromo-3-iodobenzene was used instead of 3-bromo-5-iodo-1,1'-biphenyl. The obtained compound was identified by LC-MS. LC-MS m/z = 327 $(M+H)^+$.

Synthesis of Intermediate 1-2

Intermediate 1-2 (yield: 80 %) was synthesized in the same manner as Intermediate 2-2 of Synthesis Example 1, except that Intermediate 1-3 was used instead of Intermediate 2-3. The obtained compound was identified by LC-MS. LC-MS m/z = 423 $(M+H)^+$.

Synthesis of Intermediate 1-1

Intermediate 1-1 (yield: 75 %) was synthesized in the same manner as Intermediate 2-1 of Synthesis Example 1, except that Intermediate 1-2 was used instead of Intermediate 2-2. The obtained compound was identified by LC-MS. LC-MS m/z = 479 $(M+H)^+$.

Synthesis of Compound 1

Compound 1 (yield: 43%) was synthesized in the same manner as Compound 2 of Synthesis Example 1, except that Intermediate 1-1 was used instead of Intermediate 2-1. The obtained compound was identified by LC-MS. LC-MS m/z = 672 $(M+H)^+$.

Synthesis Example 3 (Compound 3)

Compound 3 was synthesized according to the Reaction Scheme:

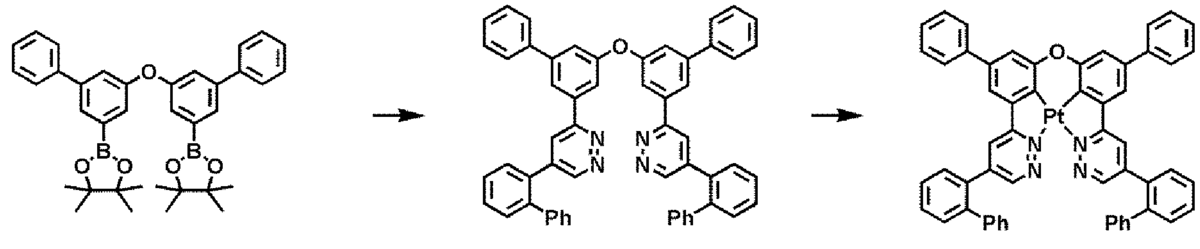

2-2 3-1 3

Synthesis of Intermediate 3-1

Intermediate 3-1 (yield: 80%) was synthesized in the same manner as Intermediate 2-1 of Synthesis Example 1, except that 5-([1,1'-biphenyl]-2-yl)-3-chloropyridazine was used instead of 3-bromo-5-phenylpyridazine. The obtained compound was identified by LC-MS. LC-MS m/z = 783 $(M+H)^+$.

Synthesis of Compound 3

Compound 3 (yield: 63%) was synthesized in the same manner as Compound 2 of Synthesis Example 1, except that Intermediate 3-1 was used instead of Intermediate 2-1. The obtained compound was identified by LC-MS. LC-MS m/z = 976 $(M+H)^+$.

Synthesis Example 4 (Compound 4)

Compound 4 was synthesized according to the Reaction Scheme:

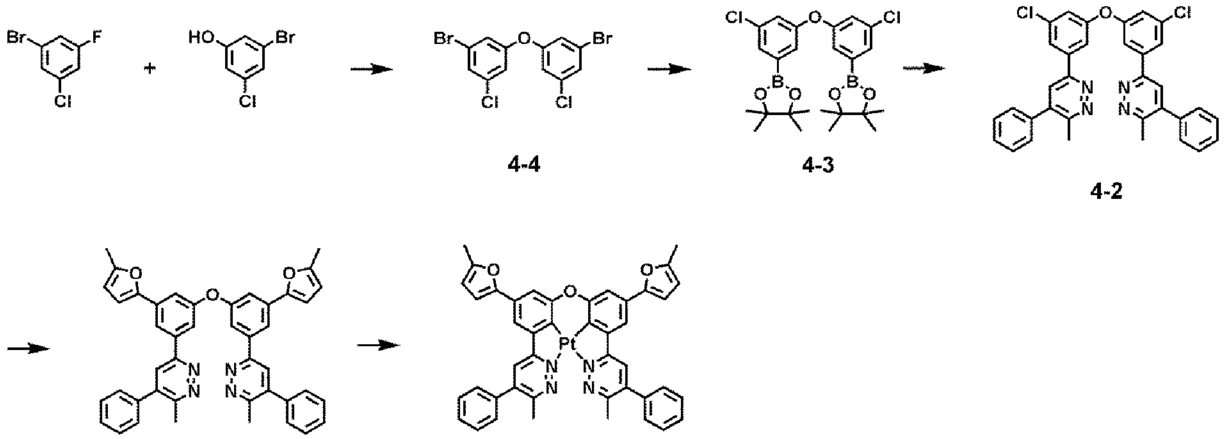

4-4 4-3 4-2

4-1 4

Synthesis of Intermediate 4-4

50.0 g (238.7 mmol) of 1-bromo-3-chloro-5-fluorobenzene and N-methyl-2-pyrrolidone (NMP) were mixed, and 44.5 g (214.8 mmol) of 3-bromo-5-chlorophenol and 59.0 g (429.6 mmol) of $K_2CO_3$ were mixed. Then, the reaction

mixture was heated at a temperature of 180 °C for 16 hours. After the reaction was completed, the reaction mixture was concentrated under reduced pressure and the organic layer was extracted therefrom by using dichloromethane and water. The extracted organic layer was dried by using magnesium sulfate, distilled under reduced pressure, and purified by liquid chromatography to obtain 51.0 g (129 mmol, yield: 60 %) of Intermediate 4-4. LC-MS m/z = 394 $(M+H)^+$.

Synthesis of Intermediate 4-3

Intermediate 4-3 (yield: 70 %) was synthesized in the same manner as Intermediate 2-2 of Synthesis Example 1, except that Intermediate 4-4 was used instead of Intermediate 2-3. The obtained compound was identified by LC-MS. LC-MS m/z = 491 $(M+H)^+$.

Synthesis of Intermediate 4-2

Intermediate 4-2 (yield: 85 %) was synthesized in the same manner as Intermediate 2-1 of Synthesis Example 1, except that 6-bromo-3-methyl-4-phenylpyridazine was used instead of 3-bromo-5-phenylpyridazine. The obtained compound was identified by LC-MS. LC-MS m/z = 575 $(M+H)^+$.

Synthesis of Intermediate 4-1

1.1 g (1.9 mmol) of Intermediate 4-2 and 0.9 ml (4.2 mmol) of 5-methylfuran-2-boronic acid pinacole ester were mixed with 60 ml of dioxane and 12 ml of water, and 0.05 g (0.2 mmol) of $Pd(OAc)_2$, 0.15 g (0.4 mmol) of S-Phos, and 1.0 g (6.0 mmol) of $K_2CO_3$ were added thereto. The reaction mixture was then heated under reflux at a temperature of 110 °C for 18 hours. After the reaction was completed, the reaction mixture was concentrated under reduced pressure and dissolved in 50 ml of ethyl acetate to extract the organic layer. The extracted organic layer was dried by magnesium sulfate, distilled under reduced pressure, and purified by liquid chromatography to obtain 1.2 g (1.8 mmol, yield: 95 %) of Intermediate 4-1. LC-MS m/z = 667 $(M+H)^+$.

Synthesis of Compound 4

Compound 4 (yield: 55 %) was synthesized in the same manner as Compound 2 of Synthesis Example 1, except that Intermediate 4-1 was used instead of Intermediate 2-1. The obtained compound was identified by LC-MS. LC-MS m/z = 860 $(M+H)^+$.

Synthesis Example 5 (Compound 5)

Compound 5 was synthesized according to the Reaction Scheme:

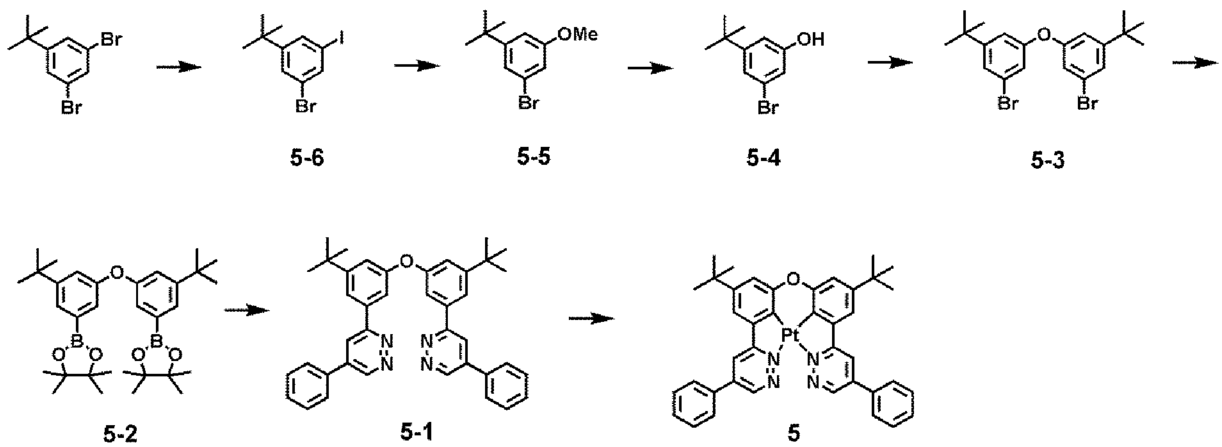

5-6 5-5 5-4 5-3

5-2 5-1 5

Synthesis of Intermediate 5-6 17.7 g (60.47 mmol) of 1,3-dibromo-5-(tert-butyl)benzene was mixed with 200 ml of diethyl ether, and n-BuLi (1.6 M in hexane) was slowly added thereto at a temperature of -78 °C. After the reaction mixture was stirred at a temperature of - 78 °C for 1 hour, 15 g (72.6 mmol) of iodine mixed with 20 ml of THF was slowly added by drops thereto. The reaction mixture was stirred at room temperature for 16 hours. After the reaction was completed, the organic layer was extracted by using ethyl acetate and a sodium thiosulfate aqueous solution, dried by using magnesium

sulfate, distilled under reduced pressure, and purified by liquid chromatography to obtain 18 g (54.5 mmol, yield: 60 %) of Intermediate 5-6. LC-MS m/z = 291 $(M+H)^+$.

Synthesis of Intermediate 5-5

9.0 g (27.2 mmol) of Intermediate 5-6 and 150 ml of methyl alcohol were mixed, and 0.5 g (2.7 mmol) of CuI, 17.7 g (54.5 mmol) of $Cs_2CO_3$, and 1.3 g (5.5 mmol) of 4,7-dimethoxy-1,10-phenanthroline were added thereto. The reaction mixture was stirred in a seal-tube at 100 °C for 18 hours. After the reaction was completed, the reaction mixture was concentrated under reduced pressure, and the organic layer was extracted therefrom by using dichloromethane and water. The extracted organic layer was dried by using magnesium sulfate, distilled under reduced pressure, and purified by liquid chromatography to obtain 5 g (20.4 mmol, yield: 75%) of Intermediate 5-5. LC-MS m/z = 244 $(M+H)^+$.

Synthesis of Intermediate 5-4

5.0 g (20.4 mmol) of Intermediate 5-5 and 200 ml of dichloromethane were mixed, and 100 ml (100.0 mmol) of $BBr_3$ (1.0 M solution in dichloromethane) was slowly added by drops thereto at a temperature of 0 °C. The reaction mixture was stirred at room temperature for about 6 hours. After the reaction was completed, a saturated $NaHCO_3$ aqueous solution was added thereto to obtain the organic layer. The organic layer was dried by using magnesium sulfate, distilled under reduced pressure, and purified by liquid chromatography to obtain 4.5 g (19.5 mmol, yield: 96 %) of Intermediate 5-4. LC-MS m/z = 229 $(M+H)^+$.

Synthesis of Intermediate 5-3

4.5 g (19.5 mmol) of Intermediate 5-4 and 7.0 g (19.5 mmol) of Intermediate 5-6 were mixed with 100 ml of DMSO, and 0.4 g (2.0 mmol) of CuI, 0.5 g (4.0 mmol) of picolinic acid, and 8.3 g (39.0 mmol) of $K_3PO_4$ added thereto. The reaction mixture was heated at a temperature of 120 °C for 18 hours. After the reaction was completed, a saturated NaCl aqueous solution was added thereto to extract the organic layer. The extracted organic layer was dried by using magnesium sulfate, distilled under reduced pressure, and purified by liquid chromatography to obtain 5.5 g (12.7 mmol, yield: 65%) of Intermediate 5-3. LC-MS m/z = 535 $(M+H)^+$.

Synthesis of Intermediate 5-2

Intermediate 5-2 (yield: 75 %) was synthesized in the same manner as Intermediate 2-2 of Synthesis Example 1, except that Intermediate 5-3 was used instead of Intermediate 2-3. The obtained compound was identified by LC-MS. LC-MS m/z = 534 $(M+H)^+$.

Synthesis of Intermediate 5-1

Intermediate 5-1 (yield: 80 %) was synthesized in the same manner as Intermediate 2-1 of Synthesis Example 1, except that Intermediate 5-2 was used instead of Intermediate 2-2. The obtained compound was identified by LC-MS. LC-MS m/z = 591 $(M+H)^+$.

Synthesis of Compound 5

Compound 5 (yield: 55 %) was synthesized in the same manner as Compound 2 of Synthesis Example 1, except that Intermediate 5-1 was used instead of Intermediate 2-1. The obtained compound was identified by LC-MS. LC-MS m/z = 784 $(M+H)^+$.

Synthesis Example 6 (Compound 6)

Compound 6 was synthesized according to Reaction Scheme:

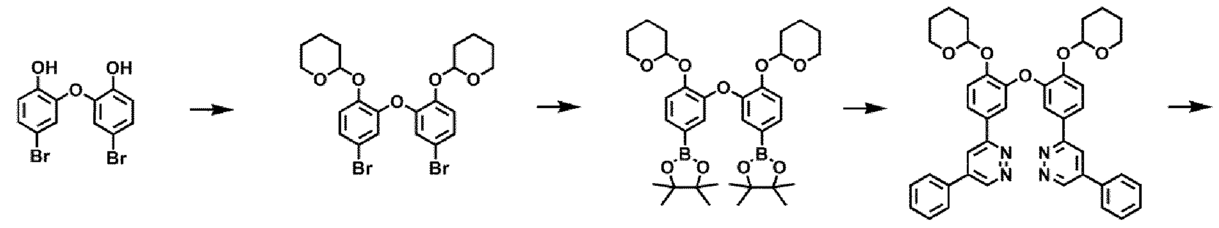

6-6 6-5 6-4

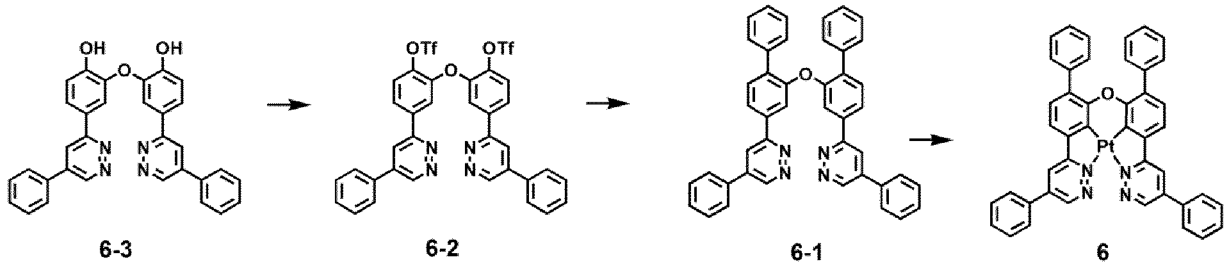

6-3 6-2 6-1 6

Synthesis of Intermediate 6-6

8.0 g (22.2 mmol) of 2,2'-oxybis(4-bromophenol) and 120 ml of dichloromethane were mixed, and 6.0 ml (66.6 mmol) of 3,4-dihydro-2H-pyran and 0.2 g (0.8 mmol) of pyridinium p-toluenesulfonate were added thereto. The reaction mixture was stirred at a temperature of 35 °C for about 18 hours. After the reaction was completed, a saturated $NaHCO_3$ aqueous solution was added thereto to extract the organic layer. The extracted organic layer was dried by using magnesium sulfate, distilled under reduced pressure, and purified by liquid chromatography to obtain 8.9 g (17.0 mmol, yield: 75 %) of Intermediate 6-6. LC-MS m/z = 529 $(M+H)^+$.

Synthesis of Intermediate 6-5

Intermediate 6-5 (yield: 70 %) was synthesized in the same manner as Intermediate 2-2 of Synthesis Example 1, except that Intermediate 6-6 was used instead of Intermediate 2-3. The obtained compound was identified by LC-MS. LC-MS m/z = 527 $(M+H)^+$.

Synthesis of Intermediate 6-4

Intermediate 6-4 (yield: 75 %) was synthesized in the same manner as Intermediate 2-1 of Synthesis Example 1, except that Intermediate 6-5 was used instead of Intermediate 2-2. The obtained compound was identified by LC-MS. LC-MS m/z = 679 $(M+H)^+$.

Synthesis of Intermediate 6-3

5.7 g (8.4 mmol) of Intermediate 6-4 and 80 ml of dioxane were mixed, and 1.0 M HCl solution (in MeOH) was added thereto. Then, the reaction mixture was stirred for 18 hours. After the reaction was completed, a saturated $NaHCO_3$ aqueous solution was added thereto to extract the organic layer. The extracted organic layer was dried by using magnesium sulfate, distilled under reduced pressure, and purified by liquid chromatography to obtain 3.9 g (7.6 mmol, yield: 90 %) of Intermediate 6-3. LC-MS m/z = 511 $(M+H)^+$.

Synthesis of Intermediate 6-2

2.7 g (5.3 mmol) of Intermediate 6-3 and 120 ml of dichloromethane were mixed, and 4.5 ml (32.1 mmol) of trimethylamine was added thereto. 3.1 ml (19.0 mmol) of triflic anhydride was slowly added by drops to the reaction mixture at a temperature of 0 °C. The reaction mixture was stirred at room temperature for 12 hours. After the reaction was completed, a saturated $NaHCO_3$ aqueous solution was added thereto to extract the organic layer. The organic layer was dried by using magnesium sulfate, distilled under reduced pressure, and purified by liquid chromatography to obtain 2.3 g (3.0 mmol, yield: 55%) of Intermediate 6-2. LC-MS m/z = 775 $(M+H)^+$.

Synthesis of Intermediate 6-1

1.5 g (1.9 mmol) of Intermediate 6-2 and 0.5 ml (4.2 mmol) of phenylboronic acid were mixed with 50 ml of toluene, 10 ml of ethyl alcohol, and 10 ml of water, and 0.06 g (0.3 mmol) of $Pd(OAc)_2$, 0.3 g (0.6 mmol) of X-Phos, and 1.0 g (7.6 mmol) of $K_2CO_3$ were added thereto. The reaction mixture was heated under reflux at a temperature of 100 °C for 18 hours. After the reaction was completed, the reaction mixture was concentrated under reduced pressure and the organic layer was extracted therefrom by using dichloromethane and water. The result extracted therefrom was dried by using magnesium sulfate. The reaction mixture was distilled under reduced pressure and purified by liquid chromatography to obtain 0.7 g (1.2 mmol, yield: 65%) of Intermediate 6-1. LC-MS m/z = 631 $(M+H)^+$.

Synthesis of Compound 6

Compound 6 (yield: 25 %) was synthesized in the same manner as Compound 2 of Synthesis Example 1, except that Intermediate 6-1 was used instead of Intermediate 2-1. The obtained compound was identified by LC-MS. LC-MS m/z = 824 $(M+H)^+$.

Synthesis Example 7 (Compound 7)

Compound 7 was synthesized according to the Reaction Scheme:

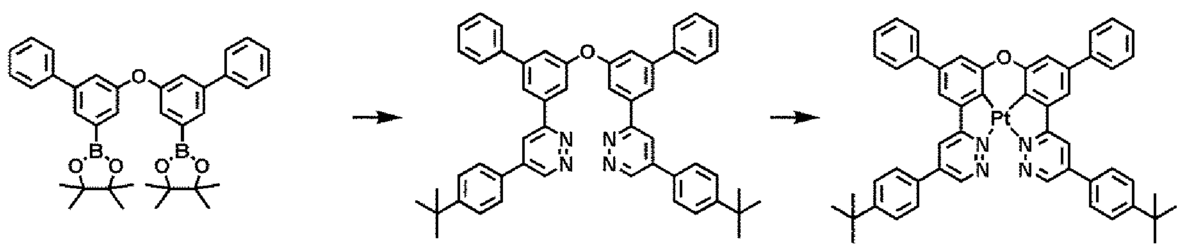

2-2 7-1 7

Synthesis of Intermediate 7-1

Intermediate 7-1 (yield: 70 %) was synthesized in the same manner as Intermediate 2-1 of Synthesis Example 1, except that 3-bromo-5-(4-(tert-butyl)phenyl)pyridazine was used instead of 3-bromo-5-phenylpyridazine. The obtained compound was identified by LC-MS. LC-MS m/z = 743 $(M+H)^+$.

Synthesis of Compound 7

Compound 7 (yield: 50 %) was synthesized in the same manner as Compound 2 of Synthesis Example 1, except that Intermediate 7-1 was used instead of Intermediate 2-1. The obtained compound was identified by LC-MS. LC-MS m/z = 936 $(M+H)^+$.

Synthesis Example 8 (Compound 8)

Compound 8 was synthesized according to the Reaction Scheme:

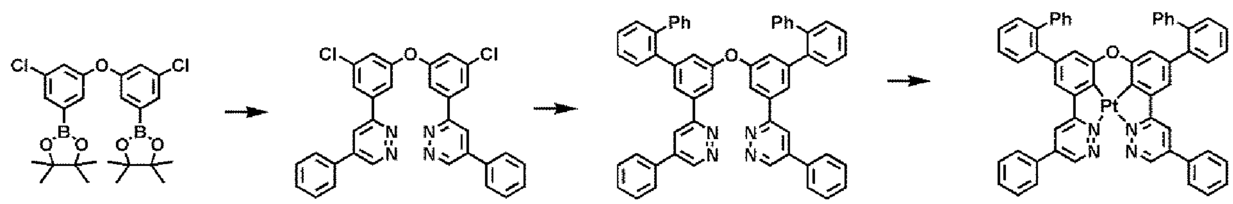

4-3 8-2 8-1 8

Synthesis of Intermediate 8-2

Intermediate 8-2 (yield: 80 %) was synthesized in the same manner as Intermediate 4-2 of Synthesis Example 4, except that 3-bromo-5-phenylpyridazine was used instead of 6-bromo-3-methyl-4-phenylpyridazine. The obtained compound was identified by LC-MS. LC-MS m/z = 547 $(M+H)^+$.

Synthesis of Intermediate 8-1

Intermediate 8-1 (yield: 65 %) was synthesized in the same manner as Intermediate 4-1 of Synthesis Example 4, except that [1,1'-biphenyl]-2-ylboronic acid was used instead of 5-methylfuran-2-boronic acid pinacole ester. The obtained compound was identified by LC-MS. LC-MS m/z = 783 $(M+H)^+$.

Synthesis of Compound 8

Compound 8 (yield: 70 %) was synthesized in the same manner as Compound 2 of Synthesis Example 1, except that Intermediate 8-1 was used instead of Intermediate 2-1. The obtained compound was identified by LC-MS. LC-MS m/z = 976 $(M+H)^+$.

Synthesis Example 9 (Compound 9)

Compound 9 was synthesized according to the Reaction Scheme:

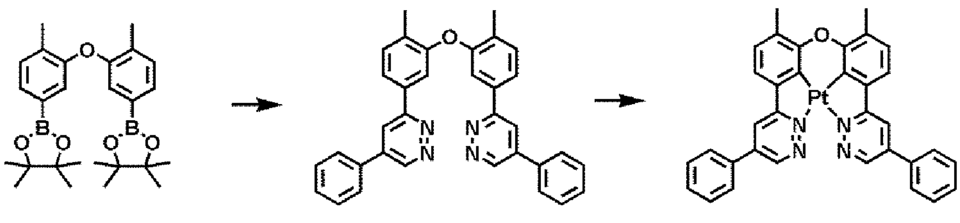

9-1 9

Synthesis of Intermediate 9-1

Intermediate 9-1 (yield: 55 %) was synthesized in the same manner as Intermediate 2-1 of Synthesis Example 1, except that 2,2'-(oxybis(4-methyl-3,1-phenylene))bis(4,4,5,5-tetramethyl-1,3,2-dioxaborolane) was used instead of Intermediate 2-2. The obtained compound was identified by LC-MS. LC-MS m/z = 541 $(M+H)^+$.

Synthesis of Compound 9

Compound 9 (yield: 15 %) was synthesized in the same manner as Compound 2 of Synthesis Example 1, except that Intermediate 9-1 was used instead of Intermediate 2-1. The obtained compound was identified by LC-MS. LC-MS m/z = 700 $(M+H)^+$.

Synthesis Example 10 (Compound 10)

Compound 10 was synthesized according to the Reaction Scheme:

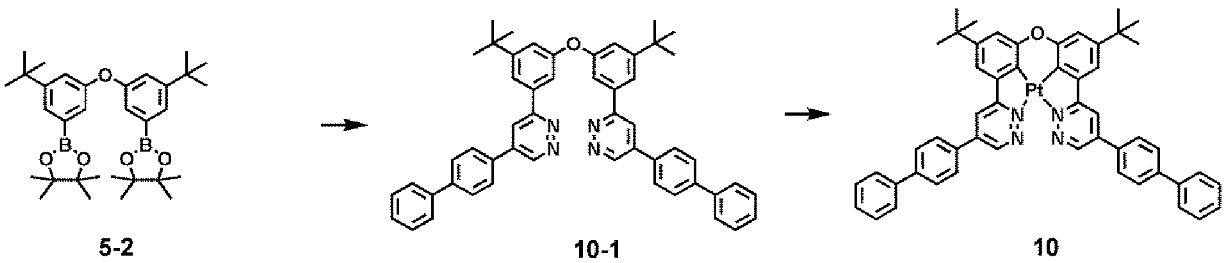

5-2 10-1 10

Synthesis of Intermediate 10-1

Intermediate 10-1 (yield: 70 %) was synthesized in the same manner as Intermediate 5-1 of Synthesis Example 5, except that 5-([1,1'-biphenyl]-4-yl)-3-pyridazine was used instead of 3-bromo-5-phenylpyridazine. The obtained compound was identified by LC-MS. LC-MS m/z = 743 $(M+H)^+$.

Synthesis of Compound 10

Compound 10 (yield: 35%) was synthesized in the same manner as Compound 2 of Synthesis Example 1, except that Intermediate 10-1 was used instead of Intermediate 2-1. The obtained compound was identified by LC-MS. LC-MS m/z = 936 $(M+H)^+$.

Synthesis Example 11 (Compound 11)

Compound 11 was synthesized according to the Reaction Scheme:

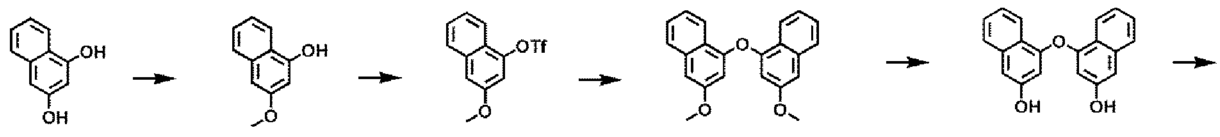

11-7 11-6 11-5 11-4

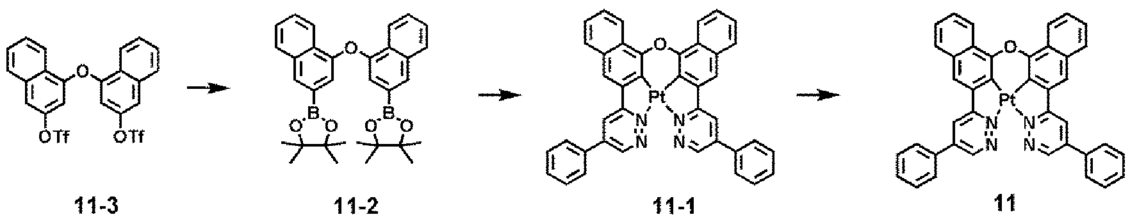

11-3 11-2 11-1 11

Synthesis of Intermediate 11-7

10.0 g (62.4 mmol) of naphthalene-1,3-diol and 120 ml of MeOH were mixed, and 4 ml of HCl was added thereto. The reaction mixture was heated under reflux at a temperature of 80 °C for 18 hours. After the reaction was completed, the reaction mixture was concentrated under reduced pressure, and the organic layer was extracted therefrom by using 60 ml of dichloromethane, 2-propanol, and a saturated $NaHCO_3$ aqueous solution. The extracted organic layer was dried by using magnesium sulfate, distilled under reduced pressure, and purified by liquid chromatography to obtain 9.2 g (53 mmol, yield: 85 %) of Intermediate 11-7. LC-MS m/z = 175 $(M+H)^+$.

Synthesis of Intermediate 11-6

4.6 g (26.5 mmol) of Intermediate 11-7 and 150 ml of dichloromethane were mixed, 6 ml (40.0 mmol) of trimethylamine was added thereto. 9 ml (53.0 mmol) of triflic anhydride was slowly added by drops to the reaction mixture at a temperature of 0 °C and stirred at room temperature for 12 hours. After the reaction was completed, a saturated $NaHCO_3$ aqueous solution was added thereto to extract the organic layer. The extracted organic layer was dried by using magnesium sulfate, distilled under reduced pressure, and purified by liquid chromatography to obtain 6.5 g (21.2 mmol, yield: 80 %) of Intermediate 11-6. LC-MS m/z = 307 $(M+H)^+$.

Synthesis of Intermediate 11-5

Intermediate 11-5 (yield: 55 %) was synthesized in the same manner as used to synthesize Intermediate 5-3 of Synthesis Example 5, except that Intermediate 11-6 and Intermediate 11-7 were used instead of Intermediate 5-4 and Intermediate 5-6, respectively. The obtained compound was identified by LC-MS. LC-MS m/z = 331 $(M+H)^+$.

Synthesis of Intermediate 11-4

3.3 g (10.0 mmol) of Intermediate 11-5 was dissolved in 150 ml of dichloromethane, and 60 ml (60.0 mmol) of $BBr_3$ (1.0 M solution in dichloromethane) was slowly added by drops thereto at a temperature of 0 °C. The reaction mixture was stirred at room temperature for about 6 hours. After the reaction was completed, a saturated $NaHCO_3$ aqueous solution was added thereto to extract the organic layer. The extracted organic layer was dried by using magnesium sulfate, distilled under reduced pressure, and purified by liquid chromatography to obtain 2.9 g (9.5 mmol, yield: 95 %) of Intermediate 11-4. LC-MS m/z = 303 $(M+H)^+$.

Synthesis of Intermediate 11-3

Intermediate 11-3 (yield: 70 %) was synthesized in the same manner as Intermediate 6-2 of Synthesis Example 6, except that Intermediate 11-4 was used instead of Intermediate 6-3. The obtained compound was identified by LC-MS. LC-MS m/z = 567 $(M+H)^+$.

Synthesis of Intermediate 11-2

Intermediate 11-2 (yield: 70 %) was synthesized in the same manner as Intermediate 2-2 of Synthesis Example 1, except that Intermediate 11-3 was used instead of Intermediate 2-3. The obtained compound was identified by LC-MS. LC-MS m/z = 523 $(M+H)^+$.

Synthesis of Intermediate 11-1

Intermediate 11-1 (yield: 65 %) was synthesized in the same manner as Intermediate 2-1 of Synthesis Example 1, except that Intermediate 11-2 was used instead of Intermediate 2-2. The obtained compound was identified by LC-MS. LC-MS m/z = 772 $(M+H)^+$.

Synthesis of Compound 11

Compound 11 (yield: 20 %) was synthesized in the same manner as Compound 2 of Synthesis Example 1, except that Intermediate 11-1 was used instead of Intermediate 2-1. The obtained compound was identified by LC-MS. LC-MS m/z = 772 $(M+H)^+$.

Synthesis Example 12 (Compound 12)

Compound 12 was synthesized according to the Reaction Scheme:

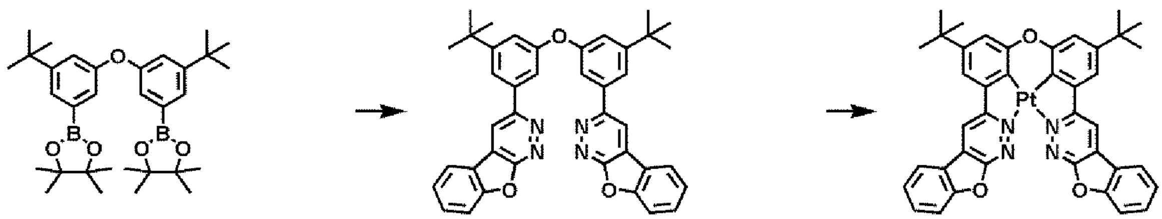

5-2 12-1 12

Synthesis of Intermediate 12-1

Intermediate 12-1 (yield: 85 %) was synthesized in the same manner as Intermediate 5-1 of Synthesis Example 5, except that 3-chlorobenzofuro[2,3-c]pyridazine was used instead of 3-bromo-5-phenylpyridazine. The obtained compound was identified by LC-MS. LC-MS m/z = 619 $(M+H)^+$.

Synthesis of Compound 12

Compound 12 (yield: 45%) was synthesized in the same manner as Compound 5 of Synthesis Example 5, except that Intermediate 12-1 was used instead of Intermediate 5-1. The obtained compound was identified by LC-MS. LC-MS m/z = 812 $(M+H)^+$.

Synthesis Example 13 (Compound 13)

Compound 13 was synthesized according to the Reaction Scheme:

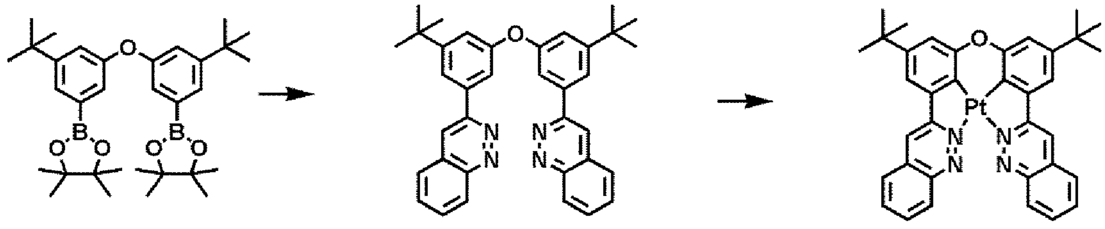

5-2 13-1 13

Synthesis of Intermediate 13-1

Intermediate 13-1 (yield: 60 %) was synthesized in the same manner as Intermediate 5-1 of Synthesis Example 5, except that 3-bromocinnoline was used instead of 3-bromo-5-phenylpyridazine. The obtained compound was identified by LC-MS. LC-MS m/z = 539 $(M+H)^+$.

Synthesis of Compound 13

Compound 13 (yield: 40 %) was synthesized in the same manner as Compound 5 of Synthesis Example 5, except that Intermediate 13-1 was used instead of Intermediate 5-1. The obtained compound was identified by LC-MS. LC-MS m/z = 732 $(M+H)^+$.

Synthesis Example 14 (Compound 14)

Compound 14 was synthesized according to the Reaction Scheme:

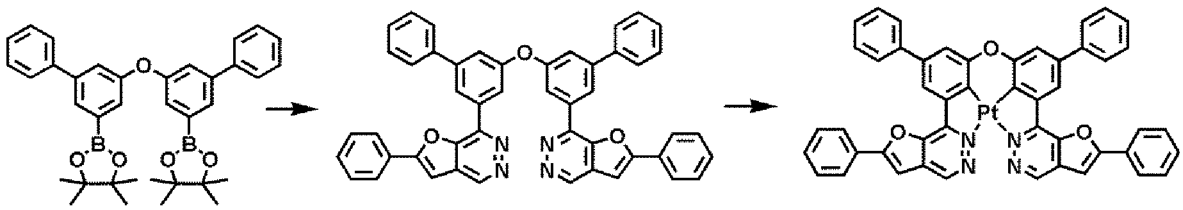

2-2 14-1 14

Synthesis of Intermediate 14-1

Intermediate 14-1 (yield: 85 %) was synthesized in the same manner as Intermediate 2-1 of Synthesis Example 1, except that 7-chloro-2-phenylfuro[2,3-d]pyridazine was used instead of 3-bromo-5-phenylpyridazine. The obtained compound was identified by LC-MS. LC-MS m/z = 711 $(M+H)^+$.

Synthesis of Compound 14

Compound 14 (yield: 40%) was synthesized in the same manner as Compound 2 of Synthesis Example 1, except that Intermediate 14-1 was used instead of Intermediate 2-1. The obtained compound was identified by LC-MS. LC-MS m/z = 904 $(M+H)^+$.

Synthesis Example 15 (Compound 15)

Compound 15 was synthesized according to the Reaction Scheme:

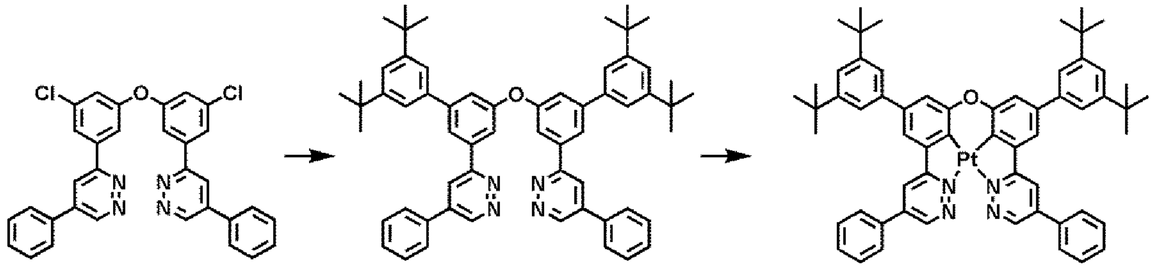

8-2 15-1 15

Synthesis of Intermediate 15-1

Intermediate 15-1 (yield: 85%) was synthesized in the same manner as Intermediate 8-1 of Synthesis Example 8, except that (3,5-di-tert-butylphenyl)boronic acid was used instead of [1,1'-biphenyl]-2-ylboronic acid. The obtained compound was identified by LC-MS. LC-MS m/z = 855 $(M+H)^+$.

Synthesis of Compound 15

Compound 15 (yield: 33%) was synthesized in the same manner as Compound 2 of Synthesis Example 1, except that Intermediate 15-1 was used instead of Intermediate 2-1. The obtained compound was identified by LC-MS. LC-MS m/z = 1048 $(M+H)^+$.

Synthesis Example 16 (Compound 16)

Compound 16 was synthesized according to the Reaction Scheme:

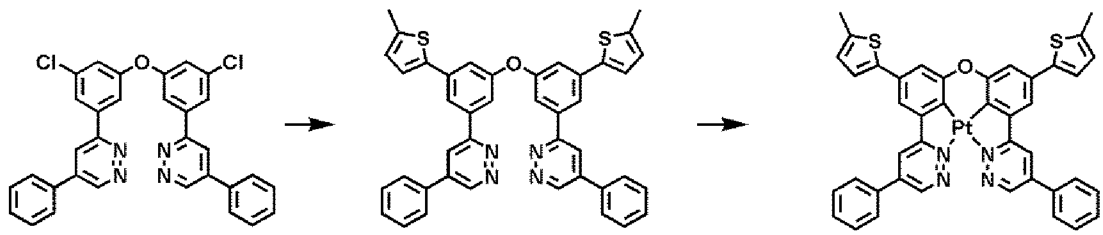

8-2 16-1 16

Synthesis of Intermediate 16-1

Intermediate 16-1 (yield: 85%) was synthesized in the same manner as Intermediate 8-1 of Synthesis Example 8, except that 4,4,5,5-tetramethyl-2-(5-methylthiophen-2-yl)-1,3,2-dioxaborolane was used instead of [1,1'-biphenyl]-2-ylboronic acid. The obtained compound was identified by LC-MS. LC-MS m/z = 671 $(M+H)^+$.

Synthesis of Compound 16

Compound 16 (yield: 20%) was synthesized in the same manner as Compound 2 of Synthesis Example 1, except that Intermediate 16-1 was used instead of Intermediate 2-1. The obtained compound was identified by LC-MS. LC-MS m/z = 864 $(M+H)^+$.

Evaluation Example 1: Evaluation of photoluminescence quantum yields (PLQY) and radiative decay rate

CBP and Compound 1 were co-deposited at a weight ratio of 9:1 at the degree of vacuum of $10^{-7}$ torr to form a film having a thickness of 40 nanometers (nm).

Luminescence quantum yields (PLQY) in film was evaluated by using a Hamamatsu Photonics absolute PL quantum yield measurement system equipped with a xenon light source, a monochromator, a photonic multichannel analyzer, and an integrating sphere and employing PLQY measurement software (Hamamatsu Photonics, Ltd., Shizuoka, Japan). The PLQY in film of Compound 1 was confirmed, and results thereof are shown in Table 2.

Then, the PL spectrum of the film was evaluated at room temperature by using a time-resolved photoluminescence (TRPL) measurement system Fluo Time 300 (manufactured by PicoQuant) and a pumping source PLS340 (excitation wavelength = 340 nm, spectral width = 20 nm) (manufactured by PicoQuant), a wavelength of main peak of the spectrum was determined, and the number of photons emitted from the film at the wavelength of the main peak by a photon pulse (pulse width = 500 picoseconds, ps) applied to the film by PLS340 was measured over time based on Time-Correlated Single Photon Counting (TCSPC). By repeating the above processes, a sufficiently fittable TRPL curve was obtained. Then, a decay time $T_{decay}(E_x)$ of the film was obtained by fitting at least one exponential decay function to a result obtained from the TRPL curve, and a radiative decay rate corresponding to a reciprocal of the decay time was calculated. Results thereof are shown in Table 2. A function represented by Equation 1 was used for the fitting, and a greatest value among $T_{decay}$ obtained from the exponential decay function used for the fitting was taken as $T_{decay}(Ex)$. At this time, the same measurement was performed once more for the same measurement as that for calculating the TRPL curve in a dark state (a state in which the pumping signal input to the certain film was blocked) to obtain a baseline or background signal curve. The baseline or background signal curve was used as a baseline for fitting.

$f(t) = \sum_{i=1}^{n} A_i\, exp\left(-t/T_{decay,i}\right)$ Equation 20 Results obtained by performing PLOY and radiative decay rate measurement on Compounds 2, 3, 4, 5, 8, 10, A, B, and C are shown in Table 2.

Table 2

| Compound No. | PLQY (%) | Radiative decay rate ($s^{-1}$) |
|---|---|---|
| 1 | 97 | $3.28 \times 10^5$ |
| 2 | 95 | $3.66 \times 10^5$ |
| 3 | 98 | $3.46 \times 10^5$ |
| 4 | 92 | $3.00 \times 10^5$ |
| 5 | 99 | $3.43 \times 10^5$ |
| 8 | 99 | $3.50 \times 10^5$ |
| 10 | 99 | $3.50 \times 10^5$ |
| A | 70 | $1.09 \times 10^5$ |
| B | 80 | $1.78 \times 10^5$ |
| C | 73 | $2.00 \times 10^5$ |

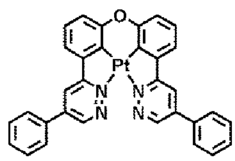

1

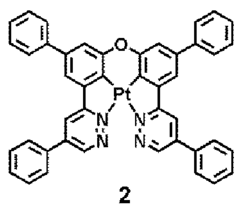

2

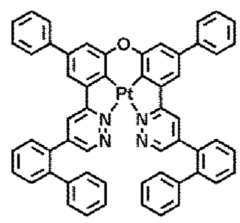

3

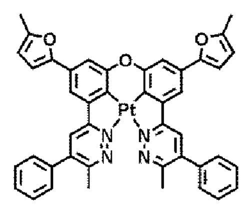

4

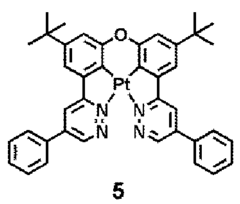

5

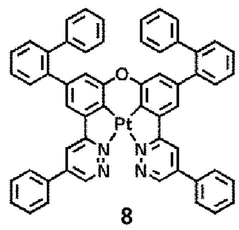

8

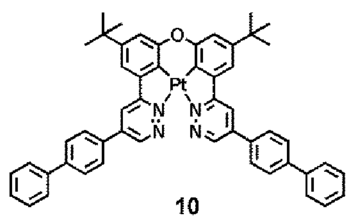

10

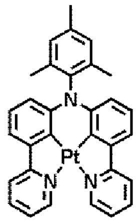
A

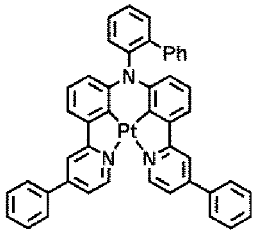
B

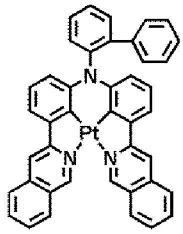
C

Referring to Table 2, it is confirmed that Compounds 1, 2, 3, 4, 5, 8, and 10 have a higher PLQY and a higher radiative decay rate, as compared with Compounds A, B, and C.

Evaluation Example 2: Evaluation of maximum emission wavelength and FWHM

Compound 1 was diluted in toluene at a concentration of 10 millimolar (mM), and a photoluminescence (PL) spectrum was measured at room temperature by using ISC PC1 Spectrofluorometer equipped with a xenon lamp. A maximum emission wavelength and FWHM of Compound 1 was evaluated from the PL spectrum. This process was repeated on Compounds 2, 3, 4, 5, 8, 10, A, B, and C, and results thereof are shown in Table 3. The term "maximum emission wavelength" as used herein refers to a wavelength at which the emission intensity is maximum.

Table 3

| Compound No. | $\lambda_{max}$ (nm) | FWHM (nm) |
|---|---|---|
| 1 | 610 | 64 |
| 2 | 625 | 55 |
| 3 | 618 | 64 |
| 4 | 626 | 57 |
| 5 | 624 | 63 |
| 8 | 622 | 55 |
| 10 | 627 | 57 |
| A | 615 | 72 |
| B | 631 | 75 |
| C | 577 | 85 |

Referring to Table 3, it is confirmed that Compounds 1, 2, 3, 4, 5, 8, and 10 have a small FWHM, as compared with Compounds A, B, and C.

Example 1

A glass substrate, on which ITO/Ag/ITO (70 Å /1,000 Å /70 Å) were deposited as an anode, was cut to a size of 50 mm x 50 mm x 0.5 mm (mm = millimeter), sonicated with iso-propyl alcohol and pure water each for 5 minutes, and then cleaned by exposure to ultraviolet rays and ozone for 30 minutes. Then, the glass substrate was provided to a vacuum deposition apparatus.

2-TNATA was vacuum-deposited on the anode of the glass substrate to form a hole injection layer having a thickness of 600 Å, and 4,4'-bis[N-(1-naphthyl)-N-phenylamino]biphenyl (NPB) was vacuum-deposited on the hole injection layer to form a hole transport layer having a thickness of 1,350 Å.

CBP (host) and Compound 1 (dopant) were co-deposited on the hole transport layer at a weight ratio of 94:6 to form an emission layer having a thickness of 400 Å.

Then, BCP was vacuum-deposited on the emission layer to form a hole blocking layer having a thickness of 50 Å, $Alq_3$ was vacuum-deposited on the hole blocking layer to form an electron transport layer having a thickness of 350 Å, LiF was deposited on the electron transport layer to form an electron injection layer having a thickness of 10 Å, and Mg and Ag were deposited on the electron injection layer at a weight ratio of 90:10 to form a cathode having a

thickness of 120 Å, thereby completing the manufacture of an organic light-emitting device (emitting red light) having a structure of anode / 2-TNATA (600 Å) / NPB (1,350 Å) / CBP + Compound 1 (6 weight%) (400 Å) / BCP(50 Å) / $Alq_3$ (350 Å) / LiF (10 Å) / MgAg (120 A).

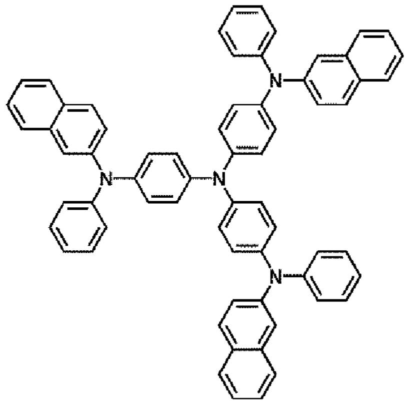

2-TNATA

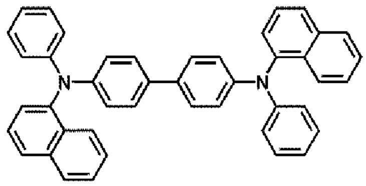

NPB

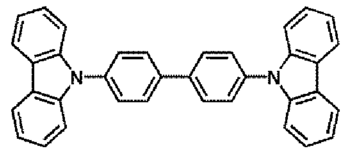

CBP

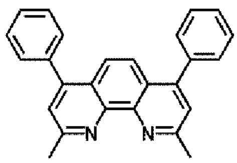

BCP

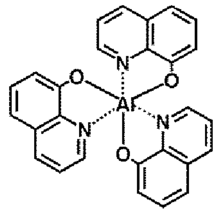

$Alq_3$

Examples 2 to 6 and Comparative Examples A to C

Organic light-emitting devices were manufactured in the same manner as in Example 1, except that Compounds shown in Table 4 were each used instead of Compound 1 as a dopant in forming an emission layer.

Evaluation Example 3: Evaluation of characteristics of organic light-emitting devices.

The driving voltage, current density, maximum quantum emission efficiency, roll-off ratio, FWHM, and lifespan of the organic light-emitting devices manufactured according to Examples 1 to 6 and Comparative Examples A to C were evaluated by using a current-voltage meter (Keithley 2400) and a luminance meter (Minolta Cs-1000A), and results thereof are shown in Tables 4 and 5. The roll-off ratio was calculated by using Equation 30. The lifespan ($LT_{99}$, at 3500 nit) indicates an amount of time that lapsed when luminance was 99 % of initial luminance (100 %).

Equation 30

Roll off ratio = {1- (Efficiency (at 3500 nit) / Maximum Emission Efficiency)} X 100%

Table 4

| | Dopant compound No. | Driving voltage (V) | Current density ($mA/cm^2$) | Maximum quantum emission efficiency (%) | Roll-off ratio (%) | FWHM (nm) |
|---|---|---|---|---|---|---|
| Example 1 | 1 | 4.5 | 10 | 18 | 10 | 56 |
| Example 2 | 2 | 4.2 | 10 | 19 | 9 | 51 |
| Example 3 | 5 | 4.3 | 10 | 21 | 9 | 48 |

(continued)

| | Dopant compound No. | Driving voltage (V) | Current density ($mA/cm^2$) | Maximum quantum emission efficiency (%) | Roll-off ratio (%) | FWHM (nm) |
|---|---|---|---|---|---|---|
| Example 4 | 8 | 4.2 | 10 | 22 | 10 | 51 |
| Example 5 | 10 | 4.2 | 10 | 23 | 10 | 52 |
| Example 6 | 12 | 4.4 | 10 | 21 | 10 | 66 |
| Comparative Example A | A | 5.8 | 10 | 15 | 30 | 75 |
| Comparative Example B | B | 5.7 | 10 | 17 | 38 | 72 |
| Comparative Example C | C | 5.2 | 10 | 18 | 22 | 98 |

Table 5

| | Dopant compound No. | Emission color | Lifespan (LT99) (at 3500 nit) (hr) |
|---|---|---|---|
| Example 1 | 1 | Red | 250 |
| Example 2 | 2 | Red | 350 |
| Example 3 | 5 | Red | 350 |
| Example 4 | 8 | Red | 450 |
| Example 5 | 10 | Red | 450 |
| Example 6 | 12 | Red | 300 |
| Comparative Example A | A | Red | 150 |
| Comparative Example B | B | Red | 100 |
| Comparative Example C | C | Orange | 100 |

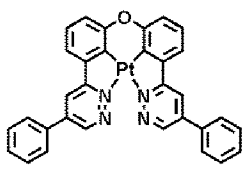

1

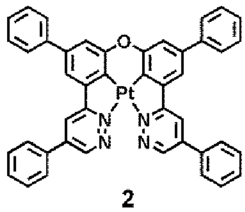

2

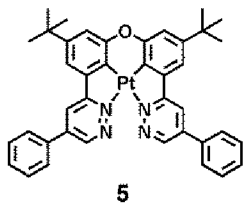

5

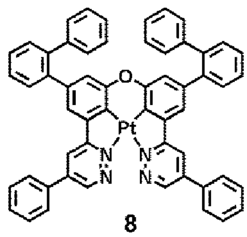

8

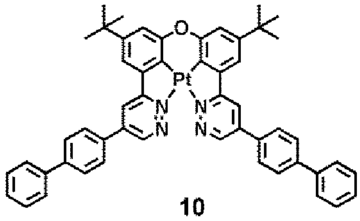

10

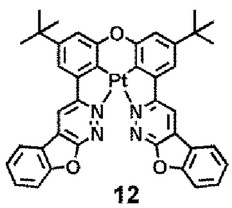

12

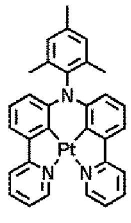
A

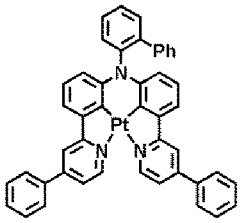
B

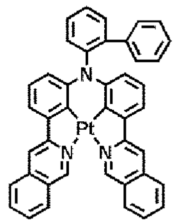
C

Referring to Tables 4 and 5, it is confirmed that the organic light-emitting devices of Examples 1 to 6 have improved driving voltage, maximum quantum emission efficiency, roll-off ratio, and lifespan characteristics and a reduced FWHM, as compared with those of the organic light-emitting devices of Comparative Examples A to C.

Since the organometallic compound emits light having a relatively small FWHM and has high PLQY and a high radiative decay rate, an organic light-emitting device including the organometallic compound may have improved driving voltage, maximum quantum emission efficiency, roll-off ratio, and lifespan characteristics. In addition, since the organometallic compound has excellent phosphorescence characteristics, a diagnostic composition including the organometallic compound may have high diagnostic efficiency.

It should be understood that embodiments described herein should be considered in a descriptive sense only and not for purposes of limitation. Descriptions of features or aspects within each embodiment should typically be considered as available for other similar features or aspects in other embodiments.

While one or more embodiments have been described with reference to the figures, it will be understood by those of ordinary skill in the art that various changes in form and details may be made therein without departing from the scope of the present description as defined by the following claims.

## Claims

**1.** An organometallic compound represented by Formula 1:

Formula 1

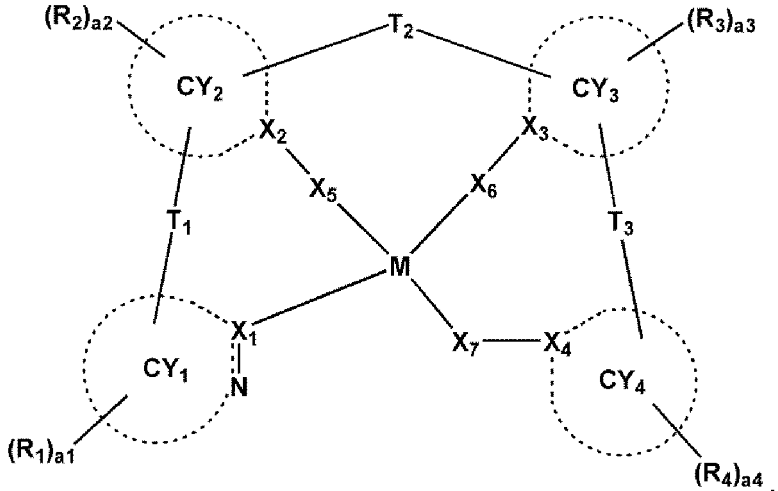

wherein, in Formula 1,

M is beryllium (Be), magnesium (Mg), aluminum (Al), calcium (Ca), titanium (Ti), manganese (Mn), cobalt (Co), copper (Cu), zinc (Zn), gallium (Ga), germanium (Ge), ruthenium (Ru), rhodium (Rh), silver (Ag), rhenium (Re), platinum (Pt), or gold (Au),
$X_1$ is N,
$X_2$ to $X_4$ are each independently C or N,
$X_5$ to $X_7$ are each independently a chemical bond, O, S, $B(R_7)$, $N(R_7)$, $P(R_7)$, $C(R_7)(R_8)$, $Si(R_7)(R_8)$, $Ge(R_7)(R_8)$, C(=O), $B(R_7)(R_8)$, $N(R_7)(R_8)$, or $P(R_7)(R_8)$,

when $X_5$ is a chemical bond, $X_2$ and M are directly linked to each other, when $X_6$ is a chemical bond, $X_3$ and M are directly linked to each other, and when $X_7$ is a chemical bond, $X_4$ and M are directly linked to each other, a bond between $X_1$ and M is a coordinate bond, one bond selected from a bond between $X_2$ or $X_5$ and M, a bond between $X_3$ or $X_6$ and M, and a bond between $X_4$ or $X_7$ and M is a coordinate bond, and the others thereof are each a covalent bond,

ring $CY_1$ is a $C_1$-$C_{30}$ heterocyclic group having at least two N atoms as ring-forming atoms,

ring $CY_2$ to ring $CY_4$ are each independently selected from a $C_5$-$C_{30}$ carbocyclic group and a $C_1$-$C_{30}$ heterocyclic group,

$T_1$ and $T_3$ are each independently a single bond, a double bond, *-N(R')-*', *-B(R')-*', *-P(R')-*', *-C(R')(R")-*', *-Si(R')(R")-*', *-Ge(R')(R")-*', *-S-*', *-Se-*', *-O-*', *-C(=O)-*', *-S(=O)-*', *-S(=O)$_2$-*', *-C(R')=*', *=C(R')-*', *-C(R')=C(R")-*', *-C(=S)-*', or *-C=C-*',

$T_2$ is a single bond, a double bond, *-N($R_5$)-*', *-B($R_5$)-*', *-P($R_5$)-*', *-C($R_5$)($R_6$)-*', *-Si($R_5$)($R_6$)-*', *-Ge($R_5$)($R_6$)-*', *-S-*', *-Se-*', *-O-*', *-C(=O)-*', *-S(=O)-*', *-S(=O)$_2$-*', *-C($R_5$)=*', *=C($R_5$)-*', *-C($R_5$)=C($R_6$)-*', *-C(=S)-*', or *-C=C-*',

$R_1$ to $R_8$, R', and R" are each independently selected from hydrogen, deuterium, -F, -Cl, -Br, -I, -$SF_5$, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a substituted or unsubstituted $C_1$-$C_{60}$ alkyl group, a substituted or unsubstituted $C_2$-$C_{60}$ alkenyl group, a substituted or unsubstituted $C_2$-$C_{60}$ alkynyl group, a substituted or unsubstituted $C_1$-$C_{60}$ alkoxy group, a substituted or unsubstituted $C_3$-$C_{10}$ cycloalkyl group, a substituted or unsubstituted $C_1$-$C_{10}$ heterocycloalkyl group, a substituted or unsubstituted $C_3$-$C_{10}$ cycloalkenyl group, a substituted or unsubstituted $C_1$-$C_{10}$ heterocycloalkenyl group, a substituted or unsubstituted $C_6$-$C_{60}$ aryl group, a substituted or unsubstituted $C_7$-$C_{60}$ alkyl aryl group, a substituted or unsubstituted $C_6$-$C_{60}$ aryloxy group, a substituted or unsubstituted $C_6$-$C_{60}$ arylthio group, a substituted or unsubstituted $C_7$-$C_{60}$ aryl alkyl group, a substituted or unsubstituted $C_1$-$C_{60}$ heteroaryl group, a substituted or unsubstituted $C_1$-$C_{60}$ heteroaryloxy group, a substituted or unsubstituted $C_1$-$C_{60}$ heteroarylthio group, a substituted or unsubstituted $C_2$-$C_{60}$ heteroaryl alkyl group, a substituted or unsubstituted $C_2$-$C_{60}$ alkyl heteroaryl group, a substituted or unsubstituted monovalent non-aromatic condensed polycyclic group, a substituted or unsubstituted monovalent non-aromatic condensed heteropolycyclic group, - N($Q_1$)($Q_2$), -Si($Q_3$)($Q_4$)($Q_5$), -B($Q_6$)($Q_7$), and -P(=O)($Q_8$)($Q_9$),

a1 to a4 are each independently an integer from 0 to 20,

two of a plurality of neighboring groups $R_1$ are optionally linked to form a $C_5$-$C_{30}$ carbocyclic group which is unsubstituted or substituted with at least one $R_{10a}$ or a $C_1$-$C_{30}$ heterocyclic group which is unsubstituted or substituted with at least one $R_{10a}$,

two of a plurality of neighboring groups $R_2$ are optionally linked to form a $C_5$-$C_{30}$ carbocyclic group which is unsubstituted or substituted with at least one $R_{10a}$ or a $C_1$-$C_{30}$ heterocyclic group which is unsubstituted or substituted with at least one $R_{10a}$,

two of a plurality of neighboring groups $R_3$ are optionally linked to form a $C_5$-$C_3$ carbocyclic group which is unsubstituted or substituted with at least one $R_{10a}$ or a $C_1$-$C_{30}$ heterocyclic group which is unsubstituted or substituted with at least one $R_{10a}$,

two of a plurality of neighboring groups $R_4$ are optionally linked to form a $C_5$-$C_{30}$ carbocyclic group which is unsubstituted or substituted with at least one $R_{10a}$ or a $C_1$-$C_{30}$ heterocyclic group which is unsubstituted or substituted with at least one $R_{10a}$,

two of $R_1$ to $R_8$, R', and R" are optionally linked to form a $C_5$-$C_{30}$ carbocyclic group which is unsubstituted or substituted with at least one $R_{10a}$ or a $C_1$-$C_{30}$ heterocyclic group which is unsubstituted or substituted with at least one $R_{10a}$,

$R_{10a}$ is the same as described in connection with $R_1$,

* and *' each indicate a binding site to a neighboring atom,

at least one substituent of the substituted $C_1$-$C_{60}$ alkyl group, the substituted $C_2$-$C_{60}$ alkenyl group, the substituted $C_2$-$C_{60}$ alkynyl group, the substituted $C_1$-$C_{60}$ alkoxy group, the substituted $C_3$-$C_{10}$ cycloalkyl group, the substituted $C_1$-$C_{10}$ heterocycloalkyl group, the substituted $C_3$-$C_{10}$ cycloalkenyl group, the substituted $C_1$-$C_{10}$ heterocycloalkenyl group, the substituted $C_6$-$C_{60}$ aryl group, the substituted $C_7$-$C_{60}$ alkyl aryl group, the substituted $C_6$-$C_{60}$ aryloxy group, the substituted $C_6$-$C_{60}$ arylthio group, the substituted $C_7$-$C_{60}$ aryl alkyl group, the substituted $C_1$-$C_{60}$ heteroaryl group, the substituted $C_1$-$C_{60}$ heteroaryloxy group, the substituted $C_1$-$C_{60}$ heteroarylthio group, the substituted $C_2$-$C_{60}$ heteroaryl alkyl group, the substituted $C_2$-$C_{60}$ alkyl heteroaryl group, the substituted monovalent non-aromatic condensed polycyclic group, and the substituted monovalent non-aromatic condensed heteropolycyclic group is selected from:

deuterium, -F, -Cl, -Br, -I, -$CD_3$, -$CD_2H$, -$CDH_2$, -$CF_3$, -$CF_2H$, -$CFH_2$, a hydroxyl group, a cyano group, a nitro group, an amidino group, a hydrazine group, a hydrazone group, a carboxylic acid group or a salt thereof, a

sulfonic acid group or a salt thereof, a phosphoric acid group or a salt thereof, a $C_1$-$C_{60}$ alkyl group, a $C_2$-$C_{60}$ alkenyl group, a $C_2$-$C_{60}$ alkynyl group, and a $C_1$-$C_{60}$ alkoxy group;

a $C_1$-$C_{60}$ alkyl group, a $C_2$-$C_{60}$ alkenyl group, a $C_2$-$C_{60}$ alkynyl group, and a $C_1$-$C_{60}$ alkoxy group, each substituted with at least one selected from deuterium, -F, -Cl, -Br, -I, $-CD_3$, $-CD_2H$, $-CDH_2$, $-CF_3$, $-CF_2H$, $-CFH_2$, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_7$-$C_{60}$ alkyl aryl group, a $C_6$-$C_{60}$ aryloxy group, a $C_6$-$C_{60}$ arylthio group, a $C_7$-$C_{60}$ aryl alkyl group, a $C_1$-$C_{60}$ heteroaryl group, a $C_1$-$C_{60}$ heteroaryloxy group, a $C_1$-$C_{60}$ heteroarylthio group, a $C_2$-$C_{60}$ heteroaryl alkyl group, a $C_2$-$C_{60}$ alkyl heteroaryl group, a monovalent non-aromatic condensed polycyclic group, a monovalent non-aromatic condensed heteropolycyclic group, $-N(Q_{11})(Q_{12})$, $-Si(Q_{13})(Q_{14})(Q_{15})$, $-B(Q_{16})(Q_{17})$, and $-P(=O)(Q_{18})(Q_{19})$;

a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_7$-$C_{60}$ alkyl aryl group, a $C_6$-$C_{60}$ aryloxy group, a $C_6$-$C_{60}$ arylthio group, a $C_7$-$C_{60}$ aryl alkyl group, a $C_1$-$C_{60}$ heteroaryl group, a $C_1$-$C_{60}$ heteroaryloxy group, a $C_1$-$C_{60}$ heteroarylthio group, a $C_2$-$C_{60}$ heteroaryl alkyl group, a $C_2$-$C_{60}$ alkyl heteroaryl group, a monovalent non-aromatic condensed polycyclic group, and a monovalent non-aromatic condensed heteropolycyclic group;

a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_7$-$C_{60}$ alkyl aryl group, a $C_6$-$C_{60}$ aryloxy group, a $C_6$-$C_{60}$ arylthio group, a $C_7$-$C_{60}$ aryl alkyl group, a $C_1$-$C_{60}$ heteroaryl group, a $C_1$-$C_{60}$ heteroaryloxy group, a $C_1$-$C_{60}$ heteroarylthio group, a $C_2$-$C_{60}$ heteroaryl alkyl group, a $C_2$-$C_{60}$ alkyl heteroaryl group, a monovalent non-aromatic condensed polycyclic group, and a monovalent non-aromatic condensed heteropolycyclic group, each substituted with at least one selected from deuterium, -F, -Cl, -Br, -I, $-CD_3$, $-CD_2H$, $-CDH_2$, $-CF_3$, $-CF_2H$, $-CFH_2$, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a $C_1$-$C_{60}$ alkyl group, a $C_2$-$C_{60}$ alkenyl group, a $C_2$-$C_{60}$ alkynyl group, a $C_1$-$C_{60}$ alkoxy group, a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_7$-$C_{60}$ alkyl aryl group, a $C_6$-$C_{60}$ aryloxy group, a $C_6$-$C_{60}$ arylthio group, a $C_7$-$C_{60}$ aryl alkyl group, a $C_1$-$C_{60}$ heteroaryl group, a $C_1$-$C_{60}$ heteroaryloxy group, a $C_1$-$C_{60}$ heteroarylthio group, a $C_2$-$C_{60}$ heteroaryl alkyl group, a $C_2$-$C_{60}$ alkyl heteroaryl group, a monovalent non-aromatic condensed polycyclic group, a monovalent non-aromatic condensed heteropolycyclic group, $-N(Q_{21})(Q_{22})$, $-Si(Q_{23})(Q_{24})(Q_{25})$, $-B(Q_{26})(Q_{27})$, and $-P(=O)(Q_{28})(Q_{29})$; and

$-N(Q_{31})(Q_{32})$, $-Si(Q_{33})(Q_{34})(Q_{35})$, $-B(Q_{36})(Q_{37})$, and $-P(=O)(Q_{38})(Q_{39})$, and

$Q_1$ to $Q_9$, $Q_{11}$ to $Q_{19}$, $Q_{21}$ to $Q_{29}$, and $Q_{31}$ to $Q_{39}$ are each independently selected from hydrogen, deuterium, -F, -Cl, -Br, -I, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a $C_1$-$C_{60}$ alkyl group, a $C_2$-$C_{60}$ alkenyl group, a $C_2$-$C_{60}$ alkynyl group, a $C_1$-$C_{60}$ alkoxy group, a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_6$-$C_{60}$ aryl group substituted with at least one selected from a $C_7$-$C_{60}$ alkylaryl group, a $C_1$-$C_{60}$ alkyl group, and a $C_6$-$C_{60}$ aryl group, a $C_6$-$C_{60}$ aryloxy group, a $C_6$-$C_{60}$ arylthio group, a $C_7$-$C_{60}$ aryl alkyl group, a $C_1$-$C_{60}$ heteroaryl group, a $C_1$-$C_{60}$ heteroaryloxy group, a $C_1$-$C_{60}$ heteroarylthio group, a $C_2$-$C_{60}$ heteroaryl alkyl group, a $C_2$-$C_{60}$ alkyl heteroaryl group, a monovalent non-aromatic condensed polycyclic group, and a monovalent non-aromatic condensed heteropolycyclic group.

**2.** The organometallic compound of claim 1, wherein
M is Pt or Au; and/or
wherein
$X_2$ and $X_3$ are each C, $X_4$ is N, and $X_5$ to $X_7$ are each a chemical bond, or
$X_2$ and $X_4$ are each C, $X_3$ is N, $X_5$ and $X_6$ are each a chemical bond, and $X_7$ is a chemical bond, O, or S.

**3.** The organometallic compound of claims 1 or 2, wherein
ring $CY_1$ is selected from i) a first ring, ii) a condensed ring in which at least two of the first ring is condensed, and iii) a condensed ring in which at least one of the first ring and at least one of a second ring are condensed with each other,
the first ring is a pyridazine group, a triazine group, or a tetrazine group,
the second ring is selected from a cyclopentane group, a cyclopentadiene group, a furan group, a thiophene group, a pyrrole group, a silole group, an indene group, a benzofuran group, a benzothiophene group, an indole group, a benzosilole group, an oxazole group, an isoxazole group, an oxadiazole group, an isoxadiazole group, an oxatriazole

group, an isoxatriazole group, a thiazole group, an isothiazole group, a thiadiazole group, an isothiadiazole group, a thiatriazole group, an isothiatriazole group, a pyrazole group, an imidazole group, a triazole group, a tetrazole group, an azasilole group, a diazasilole group, a triazasilole group, an adamantane group, a norbornane group, a norbornene group, a cyclohexane group, a cyclohexene group, a benzene group, a pyridine group, a pyrimidine group, and a pyrazine group, and
when ring $CY_1$ is a condensed ring in which at least one of the first ring and at least one of the second ring are condensed with each other, N in the first ring of the condensed ring is coordinately bonded to M in Formula 1.

**4.** The organometallic compound of any of claims 1-3, wherein
ring $CY_2$ to ring $CY_4$ are each independently selected from i) a third ring, ii) a fourth ring, iii) a condensed ring in which at least two of the third ring are condensed to each other, iv) a condensed ring in which at least two of the fourth ring are condensed to each other, and v) a condensed ring in which at least one of the third ring and at least one of the fourth ring are condensed to each other,
the third ring is selected from a cyclopentane group, a cyclopentadiene group, a furan group, a thiophene group, a pyrrole group, a silole group, an indene group, a benzofuran group, a benzothiophene group, an indole group, a benzosilole group, an oxazole group, an isoxazole group, an oxadiazole group, an isoxadiazole group, an oxatriazole group, an isoxatriazole group, a thiazole group, an isothiazole group, a thiadiazole group, an isothiadiazole group, a thiatriazole group, an isothiatriazole group, a pyrazole group, an imidazole group, a triazole group, a tetrazole group, an azasilole group, a diazasilole group, and a triazasilole group, and
the fourth ring is selected from an adamantane group, a norbornane group, a norbornene group, a cyclohexane group, a cyclohexene group, a benzene group, a pyridine group, a pyrimidine group, a pyrazine group, a pyridazine group, and a triazine group.

**5.** The organometallic compound of any of claims 1-4, wherein
$T_1$ and $T_3$ are each a single bond, and
$T_2$ is *-N($R_5$)-*', *-C($R_5$)($R_6$)-*', *-Si($R_5$)($R_6$)-*', *-S-*', or *-O-*'.

**6.** The organometallic compound of any of claims 1-5, wherein
$R_1$ to $R_8$, R', and R" are each independently selected from:

hydrogen, deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, $-SF_5$, $C_1$-$C_{20}$ alkyl group, and a $C_1$-$C_{20}$ alkoxy group;
a $C_1$-$C_{20}$ alkyl group and a $C_1$-$C_{20}$ alkoxy group, each substituted with at least one selected from deuterium, -F, -Cl, -Br, -I, $-CD_3$, $-CD_2H$, $-CDH_2$, $-CF_3$, $-CF_2H$, - $CFH_2$, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{10}$ alkyl group, a cyclopentyl group, a cyclohexyl group, a cycloheptyl group, a cycloctyl group, an adamantanyl group, a norbornanyl group, a norbornenyl group, a cyclopentenyl group, a cyclohexenyl group, a cycloheptenyl group, a phenyl group, a biphenyl group, a naphthyl group, a pyridinyl group, and a pyrimidinyl group;
a cyclopentyl group, a cyclohexyl group, a cycloheptyl group, a cycloctyl group, an adamantanyl group, a norbornanyl group, a norbornenyl group, a cyclopentenyl group, a cyclohexenyl group, a cycloheptenyl group, a phenyl group, a biphenyl group, a $C_1$-$C_{20}$ alkyl phenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, and an imidazopyrimidinyl group;
a cyclopentyl group, a cyclohexyl group, a cycloheptyl group, a cycloctyl group, an adamantanyl group, a norbornanyl group, a norbornenyl group, a cyclopentenyl group, a cyclohexenyl group, a cycloheptenyl group, a phenyl group, a biphenyl group, a $C_1$-$C_{20}$ alkyl phenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl

group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, and an imidazopyrimidinyl group, each substituted with at least one selected from deuterium, -F, -Cl, -Br, -I, $-CD_3$, $-CD_2H$, $-CDH_2$, $-CF_3$, $-CF_2H$, $-CFH_2$, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{20}$ alkyl group, a $C_1$-$C_{20}$ alkoxy group, a cyclopentyl group, a cyclohexyl group, a cycloheptyl group, a cycloctyl group, an adamantanyl group, a norbornanyl group, a norbornenyl group, a cyclopentenyl group, a cyclohexenyl group, a cycloheptenyl group, a phenyl group, a biphenyl group, a $C_1$-$C_{20}$ alkyl phenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, and an imidazopyrimidinyl group; and $-N(Q_1)(Q_2)$, $-Si(Q_3)(Q_4)(Q_5)$, $-B(Q_6)(Q_7)$, and $-P(=O)(Q_8)(Q_9)$, and
$Q_1$ to $Q_9$ are each independently selected from:

$-CH_3$, $-CD_3$, $-CD_2H$, $-CDH_2$, $-CH_2CH_3$, $-CH_2CD_3$, $-CH_2CD_2H$, $-CH_2CDH_2$,$-CHDCH_3$, $-CHDCD_2H$, $-CHDCDH_2$, $-CHDCD_3$, $-CD_2CD_3$, $-CD_2CD_2H$, $-CD_2CH_3$, and$-CD_2CDH_2$;
an n-propyl group, an iso-propyl group, an n-butyl group, an iso-butyl group, a sec-butyl group, a tert-butyl group, an n-pentyl group, an isopentyl group, a sec-pentyl group, a tert-pentyl group, a phenyl group, and a naphthyl group; and
an n-propyl group, an iso-propyl group, an n-butyl group, an iso-butyl group, a sec-butyl group, a tert-butyl group, an n-pentyl group, an isopentyl group, a sec-pentyl group, a tert-pentyl group, a phenyl group, and a naphthyl group, each substituted with at least one selected from deuterium, a $C_1$-$C_{10}$ alkyl group, and a phenyl group.

**7.** The organometallic compound of any of claims 1-6, wherein
a moiety represented by

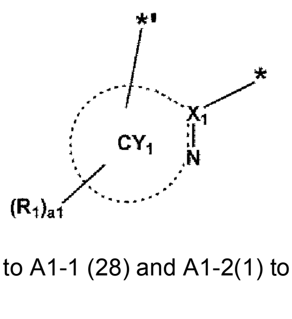

is represented by one of Formulae A1-1 (1) to A1-1 (28) and A1-2(1) to A1-2(9):

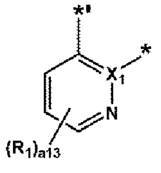
A1-1(1)

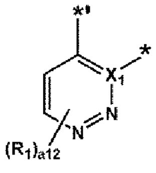
A1-1(2)

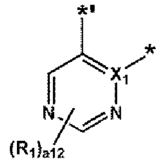
A1-1(3)

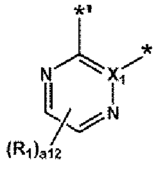
A1-1(4)

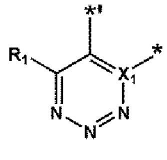
A1-1(5)

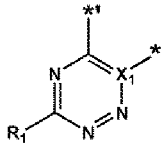
A1-1(6)

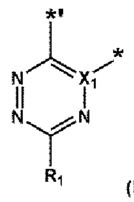
A1-1(7)

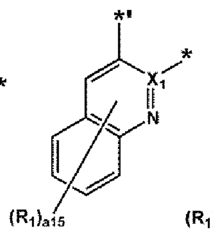
A1-1(8)

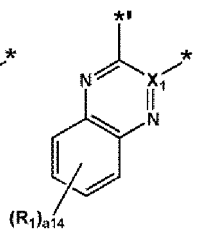
A1-1(9)

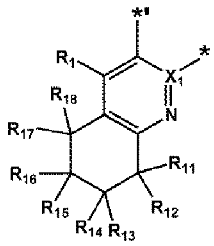
A1-1(10)

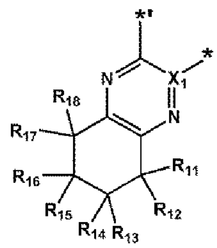
A1-1(11)

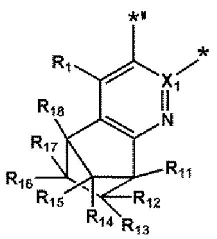
A1-1(12)

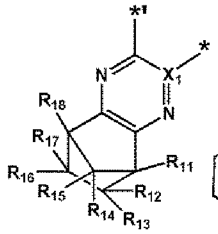
A1-1(13)

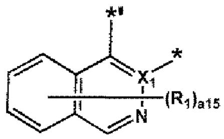
A1-1(14)

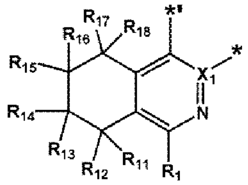
A1-1(15)

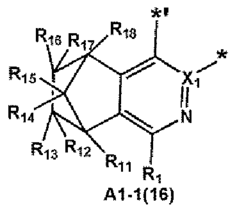
A1-1(16)

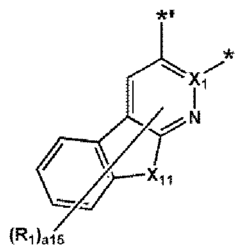
A1-1(17)

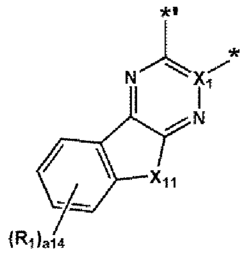
A1-1(18)

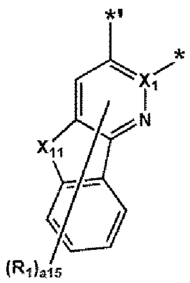
A1-1(19)

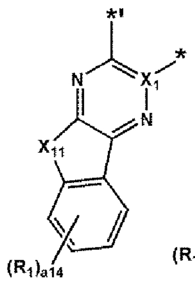
A1-1(20)

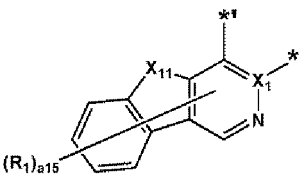
A1-1(21)

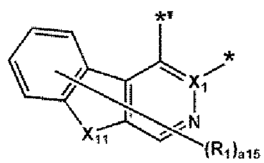
A1-1(22)

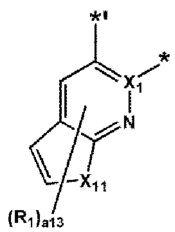
A1-1(23)

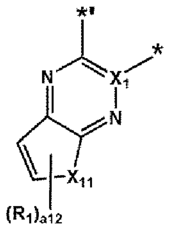
A1-1(24)

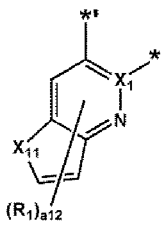
A1-1(25)

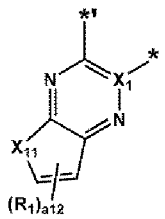
A1-1(26)

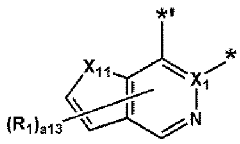
A1-1(27)

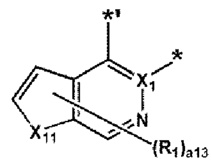
A1-1(28)

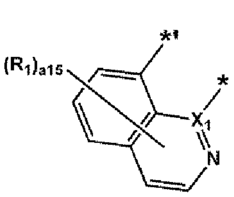
A1-2(1)

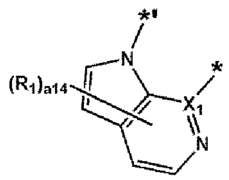
A1-2(2)

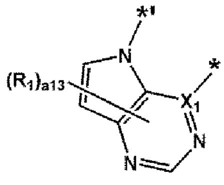
A1-2(3)

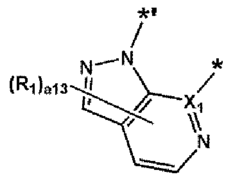
A1-2(4)

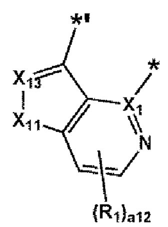
A1-2(5)

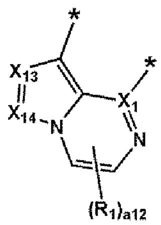
A1-2(6)

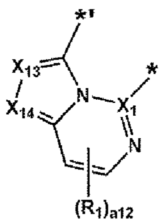
A1-2(7)

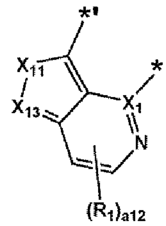
A1-2(8)

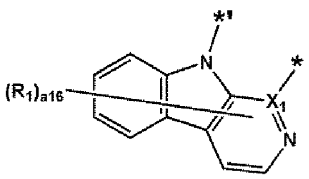
A1-2(9)

,

wherein, in Formulae A1-1 (1) to A1-1 (28) and A1-2(1) to A1-2(9),

$X_1$ and $R_1$ are the same as described in claim 1,
$X_{11}$ is O, S, $N(R_{11})$, $C(R_{11})(R_{12})$, or $Si(R_{11})(R_{12})$,
$X_{13}$ is N or $C(R_{13})$,
$X_{14}$ is N or $C(R_{14})$,
$R_{11}$ to $R_{18}$ are the same as described in connection with $R_1$ in claim 1,
a15 is an integer from 0 to 5,
a14 is an integer from 0 to 4,
a13 is an integer from 0 to 3,
a12 is an integer from 0 to 2,
* indicates a binding site to M in Formula 1, and
*' indicates a binding site to $T_1$ in Formula 1.

**8.** The organometallic compound of any of claims 1-7, wherein a moiety represented by

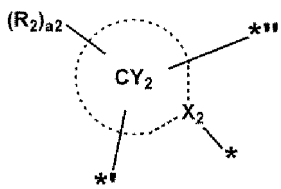

is represented by one of Formulae A2-1 (1) to A2-1 (21), A2-2(1) to A2-2(58), and A2-3(1) to A2-3(58):

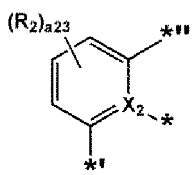
A2-1(1)

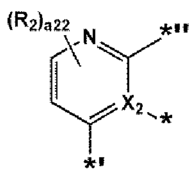
A2-1(2)

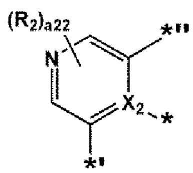
A2-1(3)

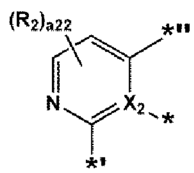
A2-1(4)

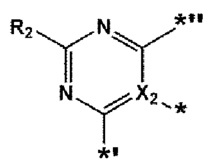
A2-1(5)

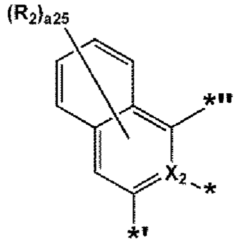
A2-1(6)

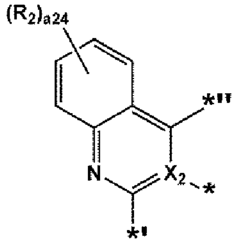
A2-1(7)

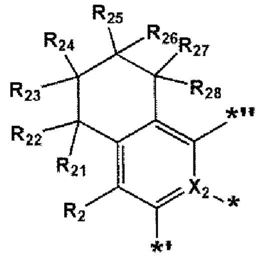
A2-1(8)

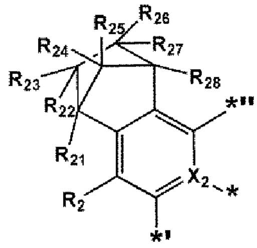
A2-1(9)

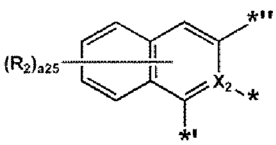
A2-1(10)

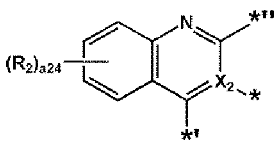
A2-1(11)

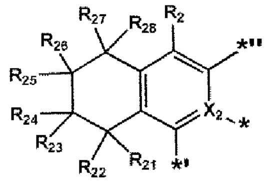
A2-1(12)

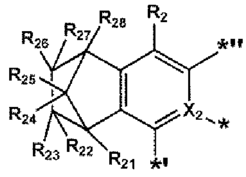
A2-1(13)

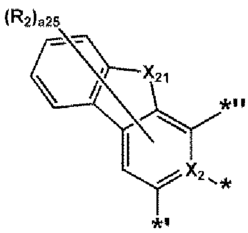
A2-1(14)

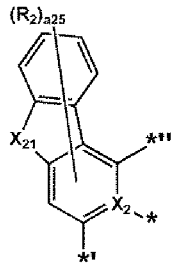
A2-1(15)

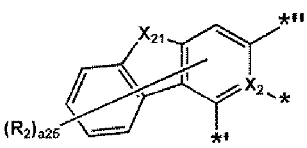
A2-1(16)

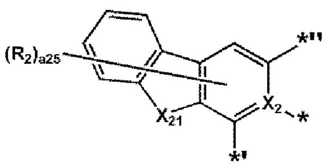
A2-1(17)

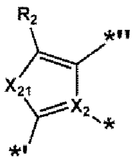
A2-1(18)

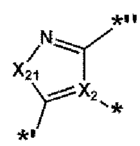
A2-1(19)

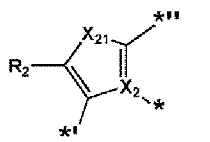
A2-1(20)

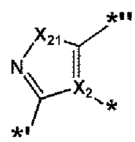
A2-1(21)

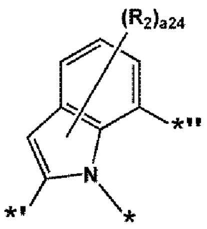
A2-2(1)

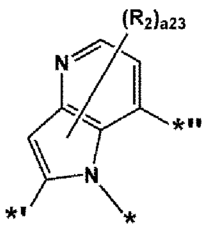
A2-2(2)

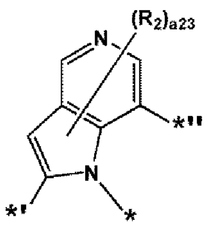
A2-2(3)

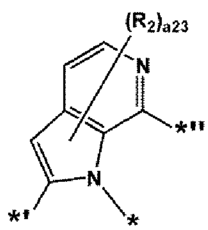
A2-2(4)

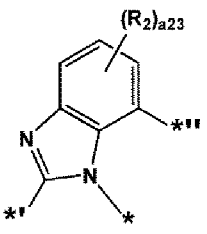
A2-2(5)

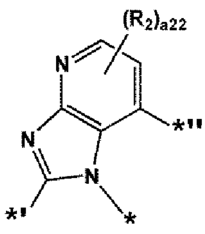
A2-2(6)

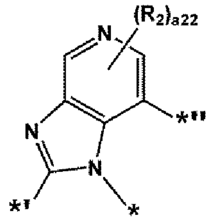
A2-2(7)

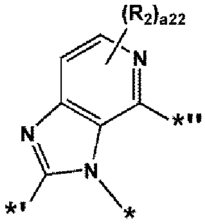
A2-2(8)

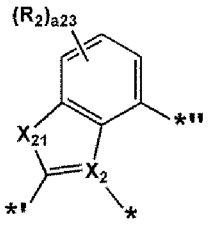
A2-2(9)

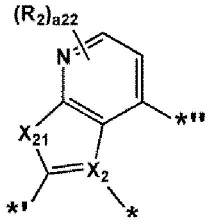
A2-2(10)

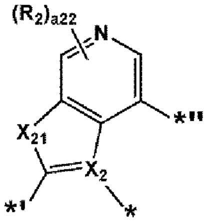
A2-2(11)

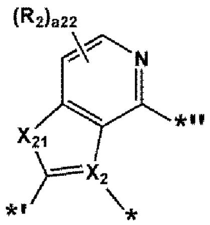
A2-2(12)

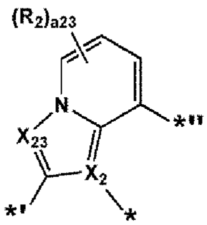
A2-2(13)

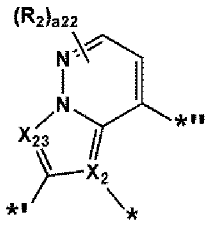
A2-2(14)

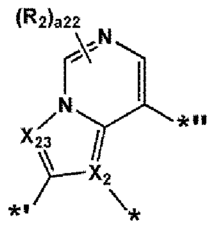
A2-2(15)

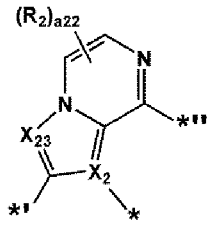
A2-2(16)

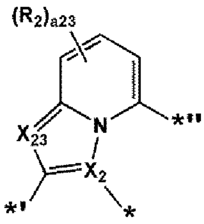
A2-2(17)

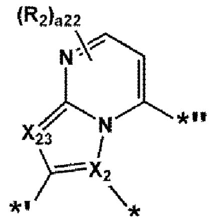
A2-2(18)

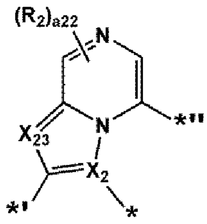
A2-2(19)

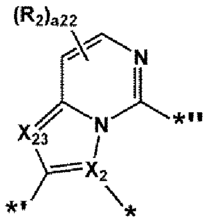
A2-2(20)

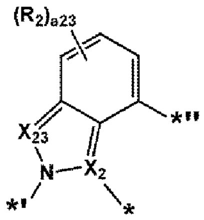
A2-2(21)

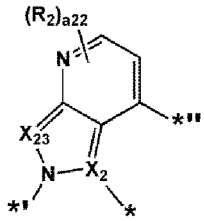
A2-2(22)

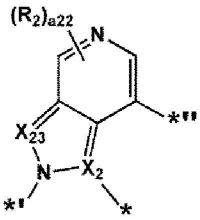
A2-2(23)

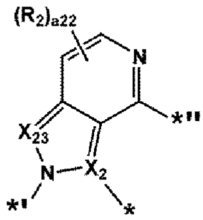
A2-2(24)

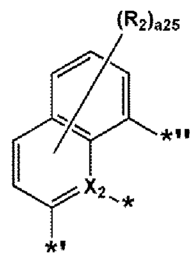
A2-2(25)

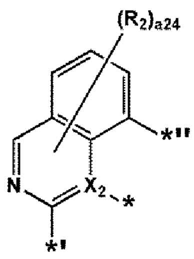
A2-2(26)

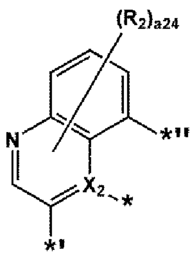
A2-2(27)

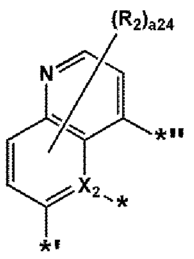
A2-2(28)

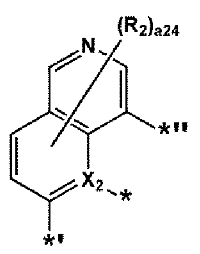
A2-2(29)

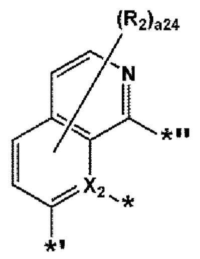
A2-2(30)

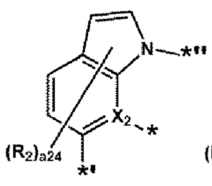
A2-2(31)

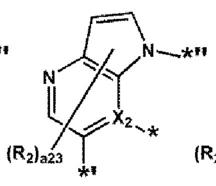
A2-2(32)

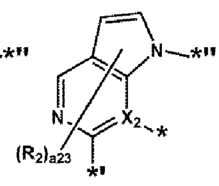
A2-2(33)

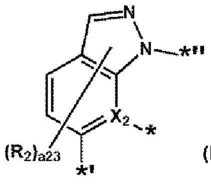
A2-2(34)

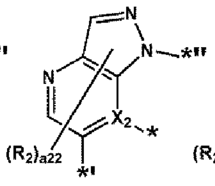
A2-2(35)

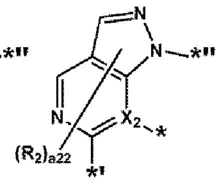
A2-2(36)

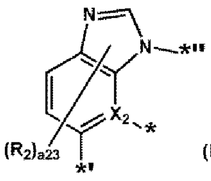
A2-2(37)

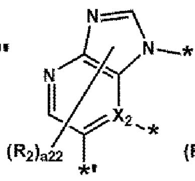
A2-2(38)

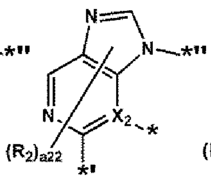
A2-2(39)

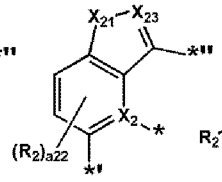
A2-2(40)

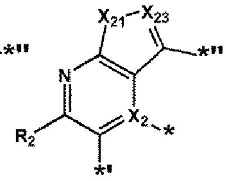
A2-2(41)

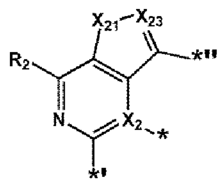
A2-2(42)

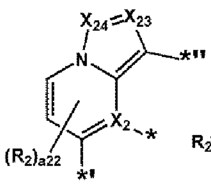
A2-2(43)

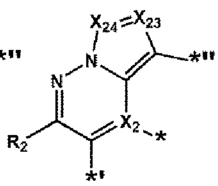
A2-2(44)

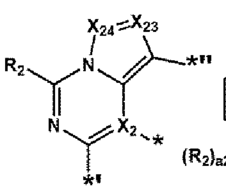
A2-2(45)

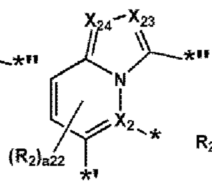
A2-2(46)

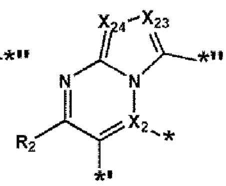
A2-2(47)

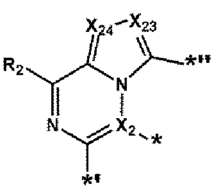
A2-2(48)

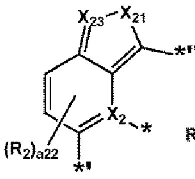
A2-2(49)

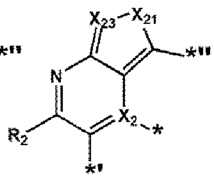
A2-2(50)

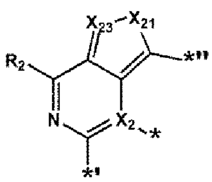
A2-2(51)

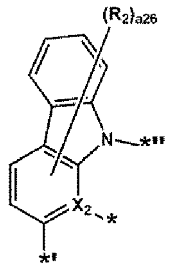
A2-2(52)

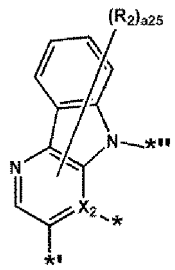
A2-2(53)

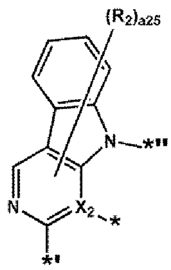
A2-2(54)

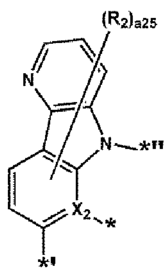
A2-2(55)

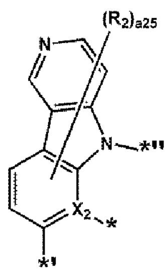
A2-2(56)

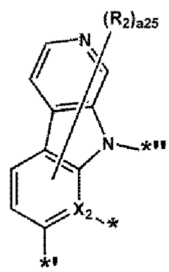
A2-2(57)

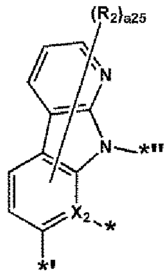
A2-2(58)

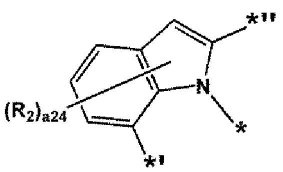
A2-3(1)

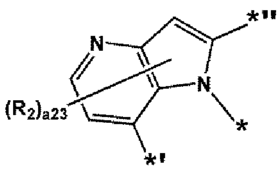
A2-3(2)

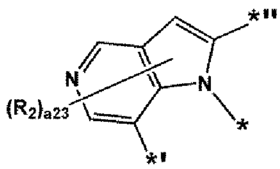
A2-3(3)

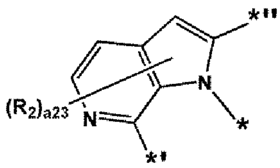
A2-3(4)

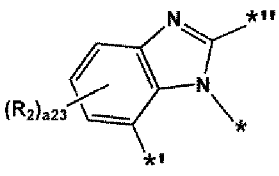
A2-3(5)

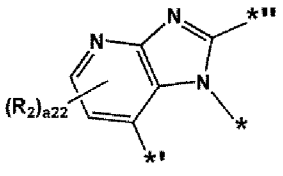
A2-3(6)

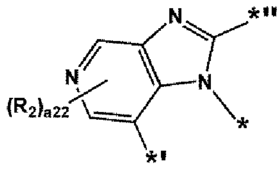
A2-3(7)

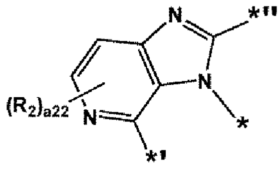
A2-3(8)

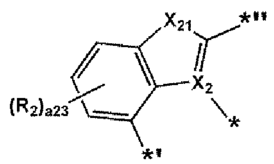
A2-3(9)

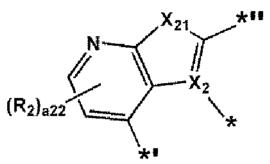
A2-3(10)

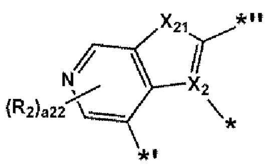
A2-3(11)

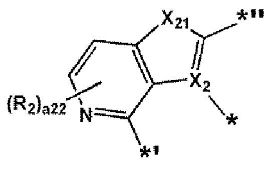
A2-3(12)

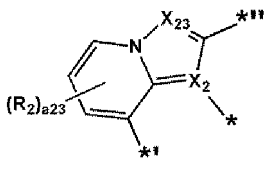
A2-3(13)

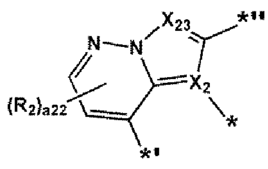
A2-3(14)

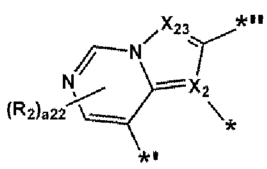
A2-3(15)

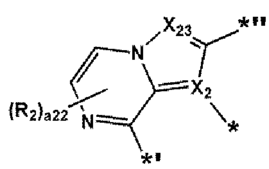
A2-3(16)

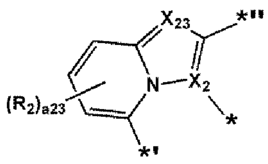
A2-3(17)

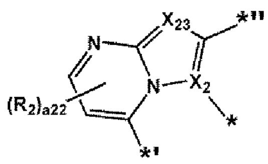
A2-3(18)

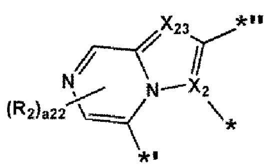
A2-3(19)

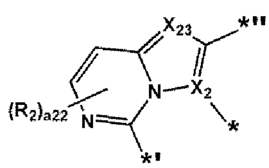
A2-3(20)

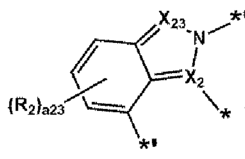
A2-3(21)

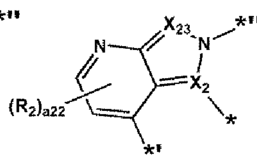
A2-3(22)

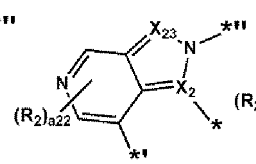
A2-3(23)

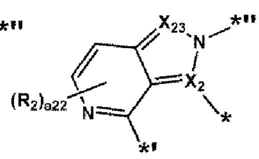
A2-3(24)

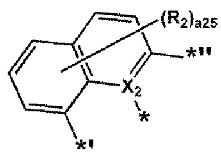
A2-3(25)

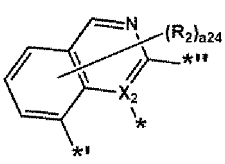
A2-3(26)

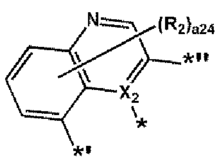
A2-3(27)

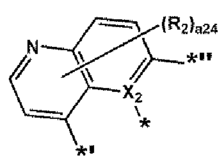
A2-3(28)

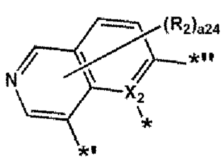
A2-3(29)

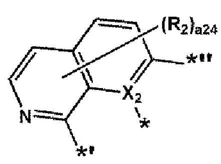
A2-3(30)

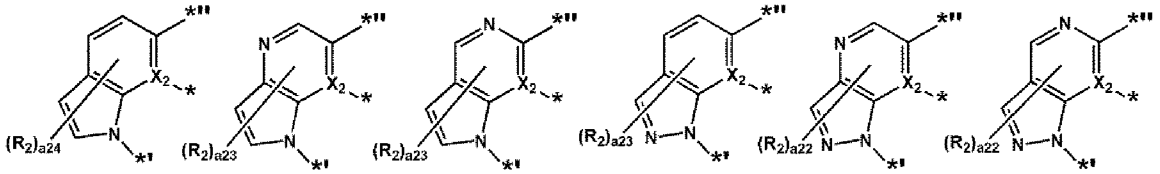
A2-3(31) A2-3(32) A2-3(33) A2-3(34) A2-3(35) A2-3(36)

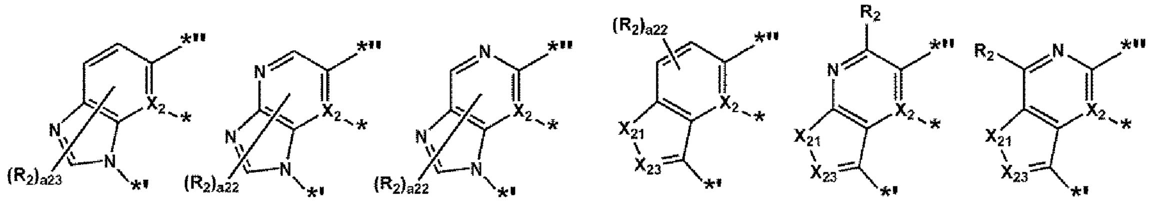

A2-3(37) A2-3(38) A2-3(39) A2-3(40) A2-3(41) A2-3(42)

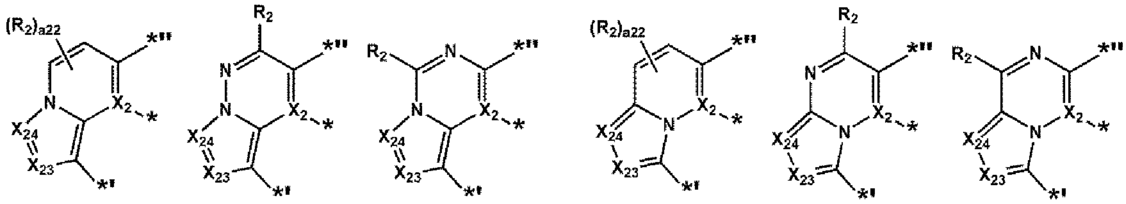

A2-3(43) A2-3(44) A2-3(45) A2-3(46) A2-3(47) A2-3(48)

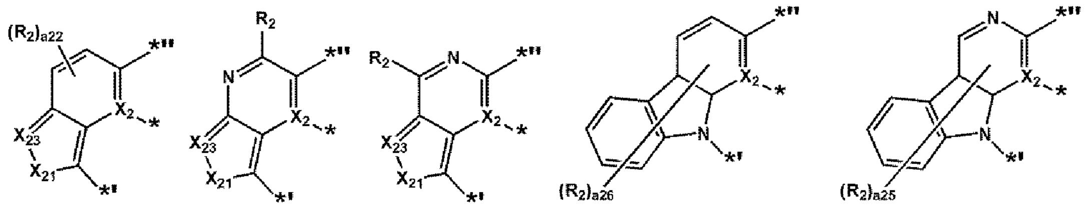

A2-3(49) A2-3(50) A2-3(51) A2-3(52) A2-3(53)

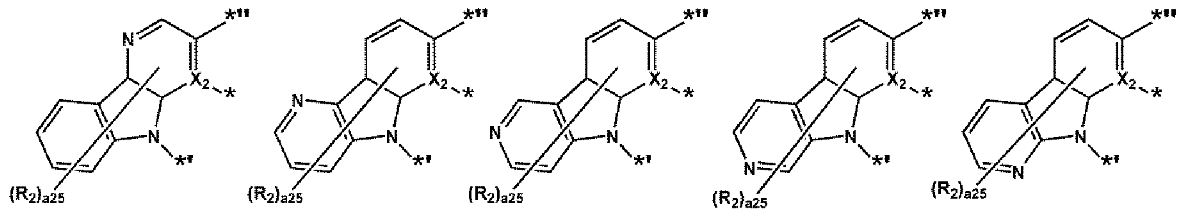

A2-3(54) A2-3(55) A2-3(56) A2-3(57) A2-3(58) ,

wherein, in Formulae A2-1 (1) to A2-1 (21), A2-2(1) to A2-2(58), and A2-3(1) to A2-3(58),

$X_2$ and $R_2$ are the same as described in claim 1,
$X_{21}$ is O, S, $N(R_{21})$, $C(R_{21})(R_{22})$, or $Si(R_{21})(R_{22})$,
$X_{23}$ is N or $C(R_{23})$,
$X_{24}$ is N or $C(R_{24})$,
$R_{21}$ to $R_{28}$ are the same as described in connection with $R_2$ in claim 1,
a26 is an integer from 0 to 6,
a25 is an integer from 0 to 5,
a24 is an integer from 0 to 4,
a23 is an integer from 0 to 3,
a22 is an integer from 0 to 2,
* indicates a binding site to $X_5$ or M in Formula 1,
*' indicates a binding site to $T_1$ in Formula 1, and
*" indicates a binding site to $T_2$ in Formula 1.

**9.** The organometallic compound of any of claims 1-8, wherein a moiety represented by

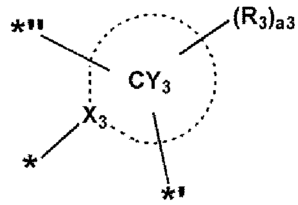

is selected from groups represented by Formulae A3-1(1) to A3-1(21), A3-2(1) to A3-2(58), and A3-3(1) to A3-3(58):

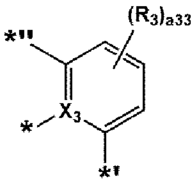
A3-1(1)

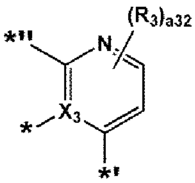
A3-1(2)

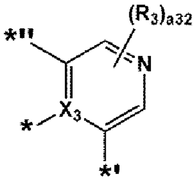
A3-1(3)

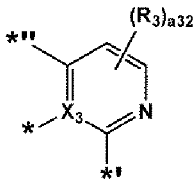
A3-1(4)

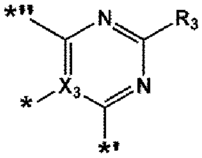
A3-1(5)

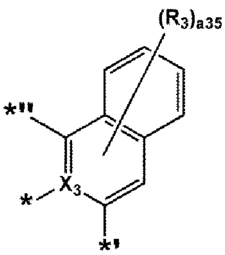
A3-1(6)

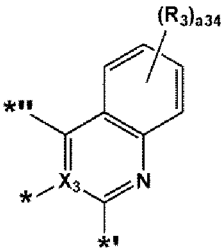
A3-1(7)

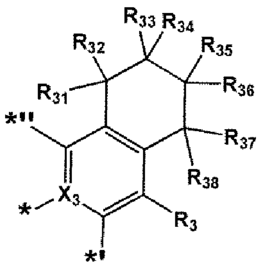
A3-1(8)

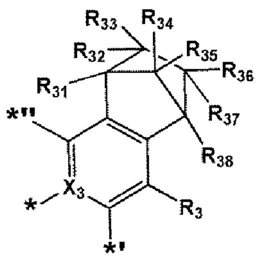
A3-1(9)

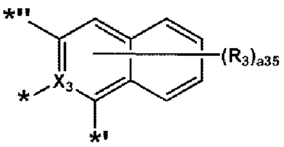
A3-1(10)

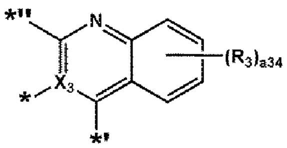
A3-1(11)

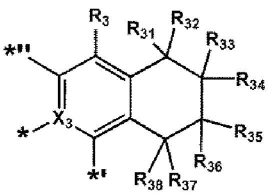
A3-1(12)

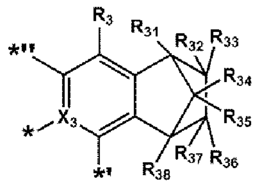
A3-1(13)

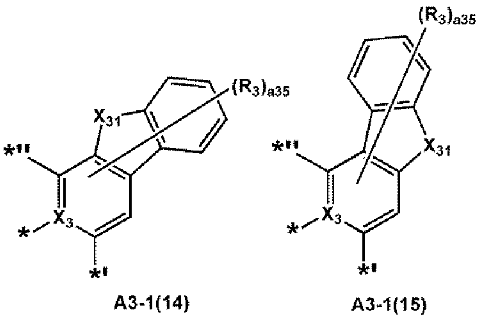
A3-1(14)

A3-1(15)

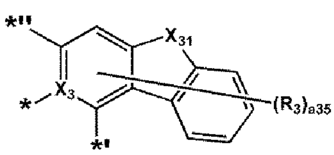
A3-1(16)

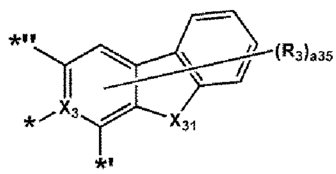
A3-1(17)

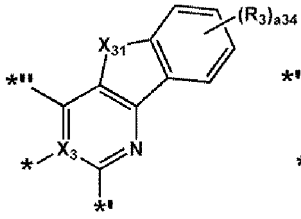
A3-1(18)

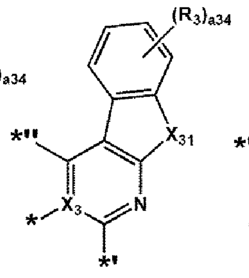
A3-1(19)

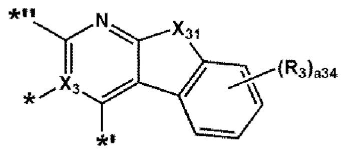
A3-1(20)

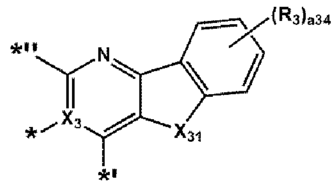
A3-1(21)

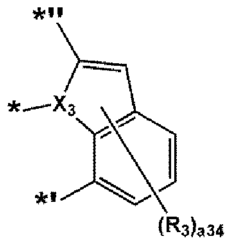
A3-2(1)

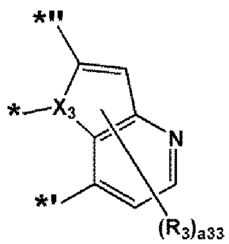
A3-2(2)

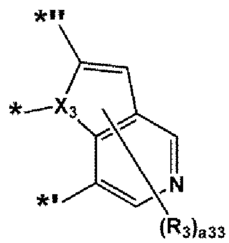
A3-2(3)

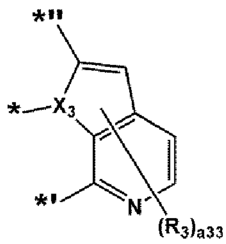
A3-2(4)

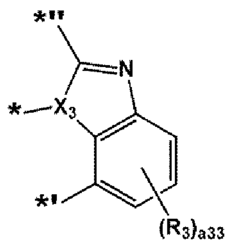
A3-2(5)

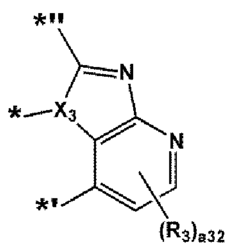
A3-2(6)

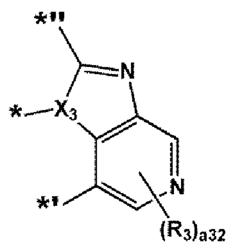
A3-2(7)

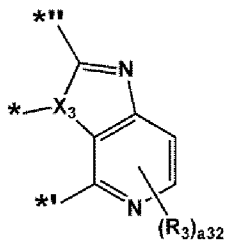
A3-2(8)

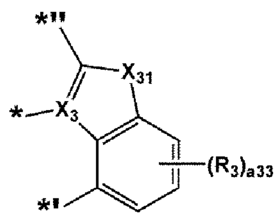
A3-2(9)

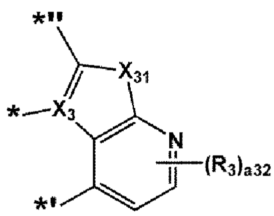
A3-2(10)

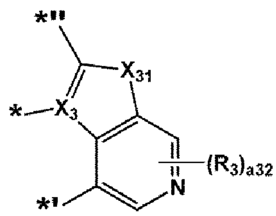
A3-2(11)

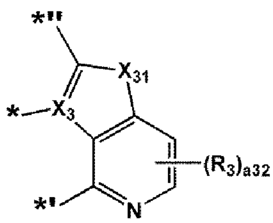
A3-2(12)

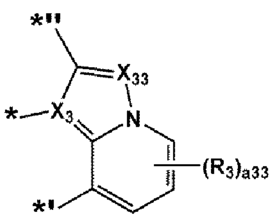
A3-2(13)

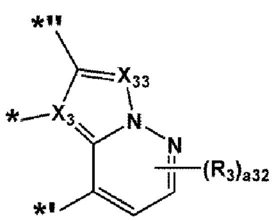
A3-2(14)

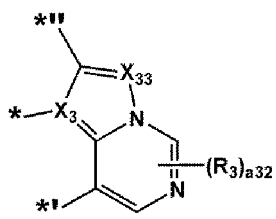
A3-2(15)

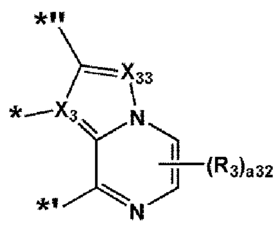
A3-2(16)

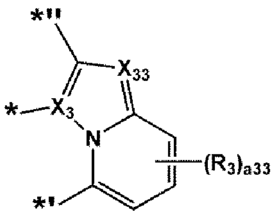
A3-2(17)

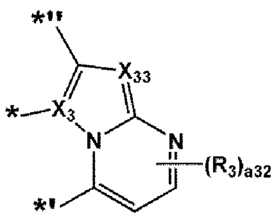
A3-2(18)

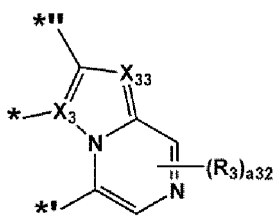
A3-2(19)

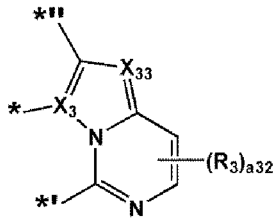
A3-2(20)

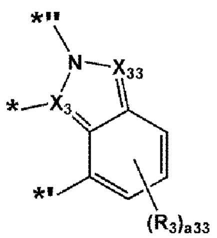
A3-2(21)

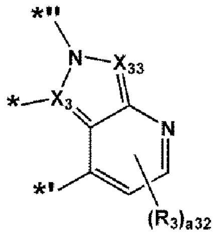
A3-2(22)

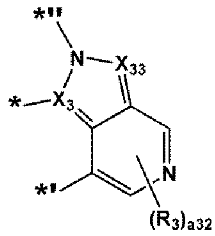
A3-2(23)

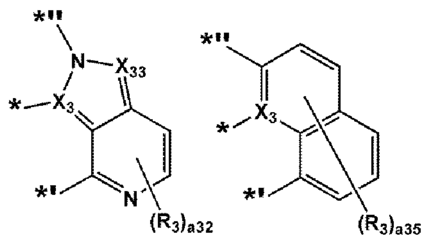
A3-2(24) A3-2(25)

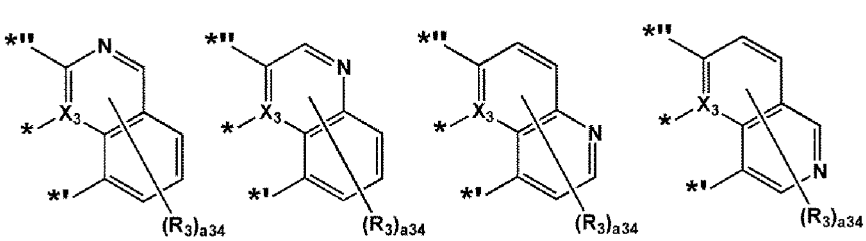
A3-2(26) A3-2(27) A3-2(28) A3-2(29)

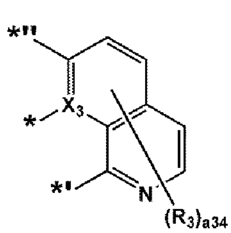
A3-2(30)

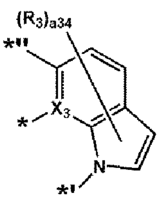
A3-2(31)

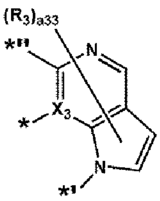
A3-2(32)

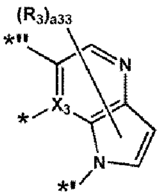
A3-2(33)

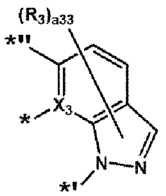
A3-2(34)

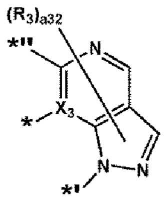
A3-2(35)

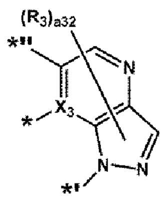
A3-2(36)

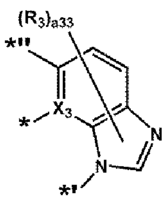
A3-2(37)

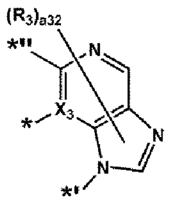
A3-2(38)

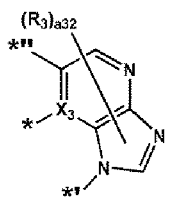
A3-2(39)

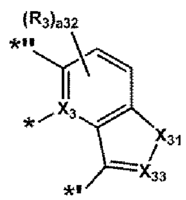
A3-2(40)

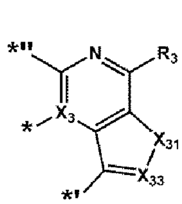
A3-2(41)

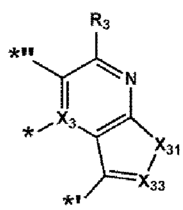
A3-2(42)

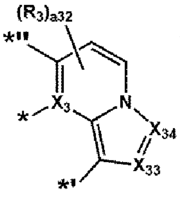
A3-2(43)

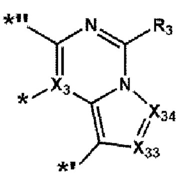
A3-2(44)

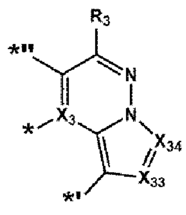
A3-2(45)

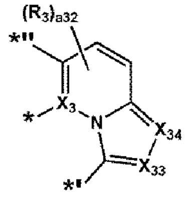
A3-2(46)

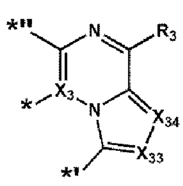
A3-2(47)

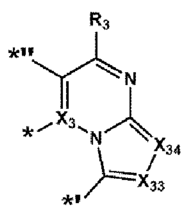
A3-2(48)

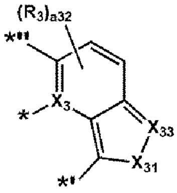
A3-2(49)

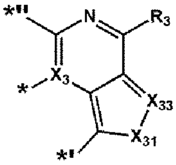
A3-2(50)

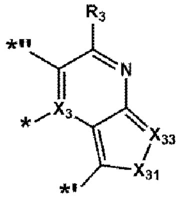
A3-2(51)

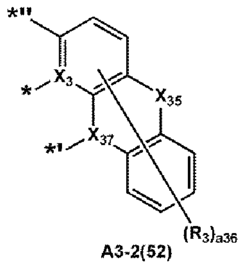
A3-2(52)

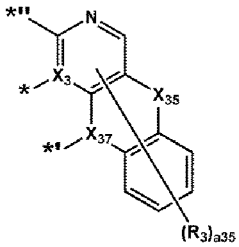
A3-2(53)

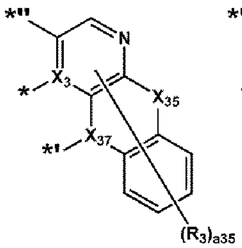
A3-2(54)

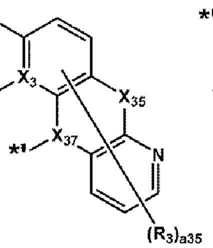
A3-2(55)

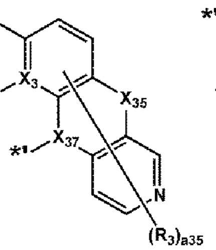
A3-2(56)

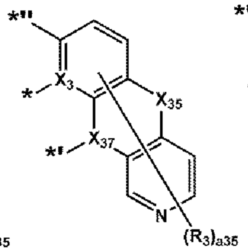
A3-2(57)

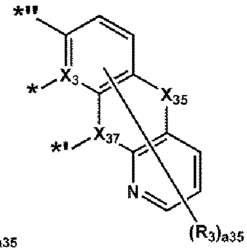
A3-2(58)

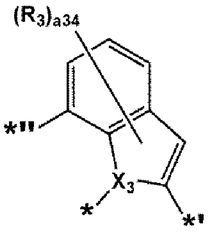
A3-3(1)

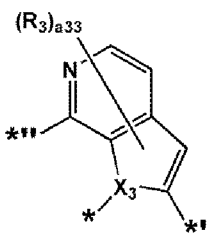
A3-3(2)

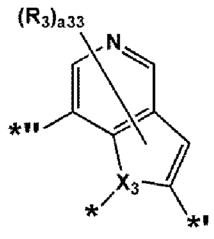
A3-3(3)

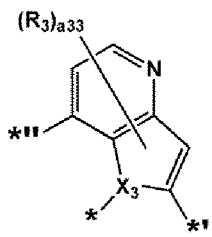
A3-3(4)

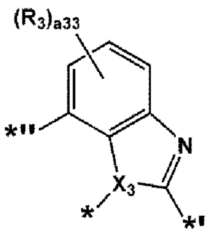
A3-3(5)

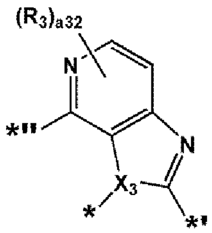
A3-3(6)

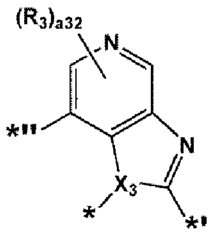
A3-3(7)

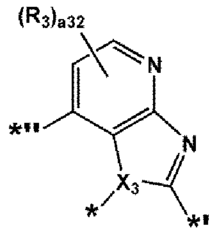
A3-3(8)

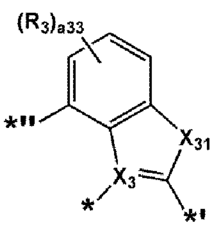
A3-3(9)

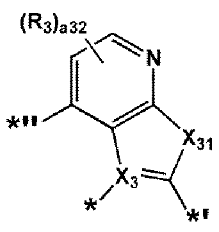
A3-3(10)

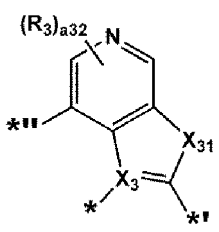
A3-3(11)

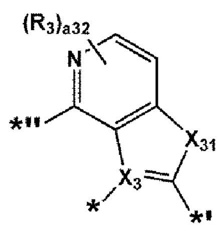
A3-3(12)

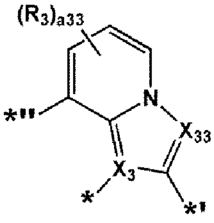
A3-3(13)

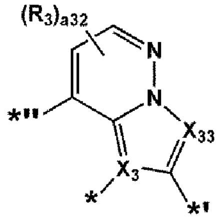
A3-3(14)

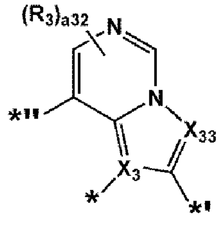
A3-3(15)

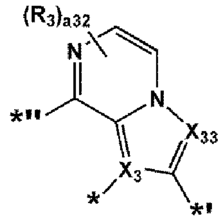
A3-3(16)

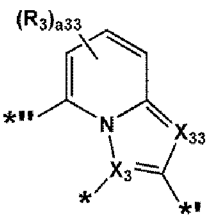
A3-3(17)

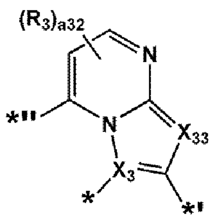
A3-3(18)

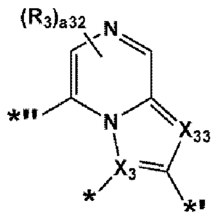
A3-3(19)

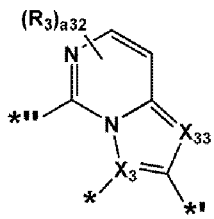
A3-3(20)

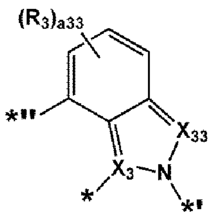
A3-3(21)

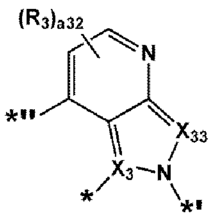
A3-3(22)

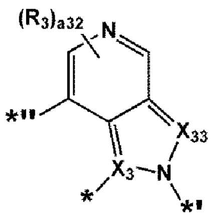
A3-3(23)

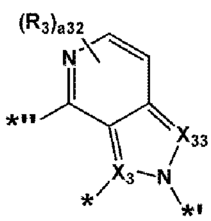
A3-3(24)

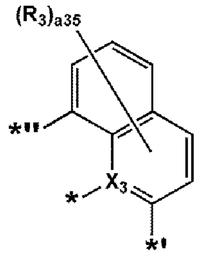
A3-3(25)

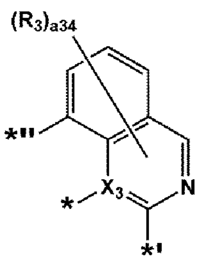
A3-3(26)

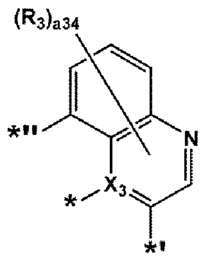
A3-3(27)

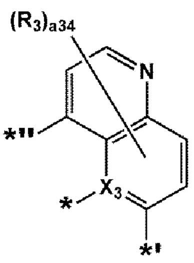
A3-3(28)

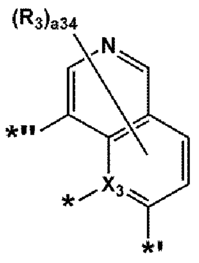
A3-3(29)

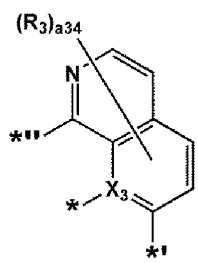
A3-3(30)

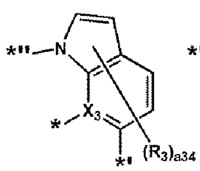
A3-3(31)

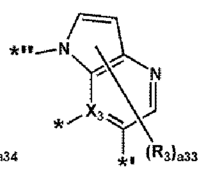
A3-3(32)

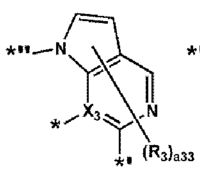
A3-3(33)

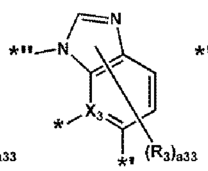
A3-3(34)

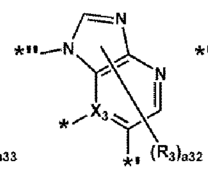
A3-3(35)

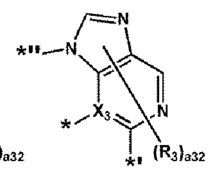
A3-3(36)

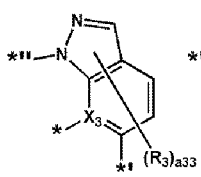
A3-3(37)

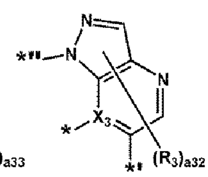
A3-3(38)

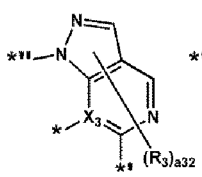
A3-3(39)

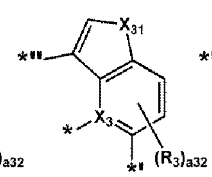
A3-3(40)

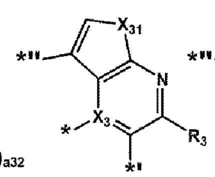
A3-3(41)

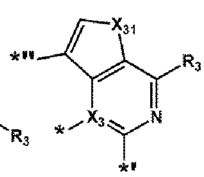
A3-3(42)

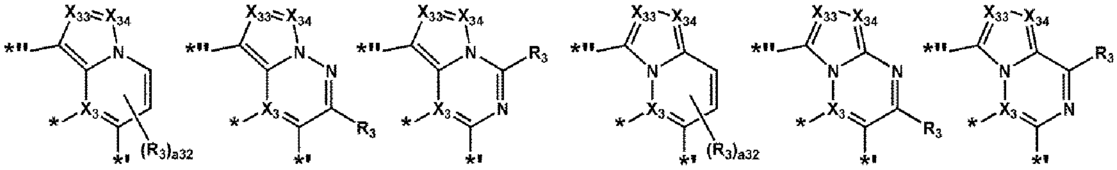

A3-3(43) A3-3(44) A3-3(45) A3-3(46) A3-3(47) A3-3(48)

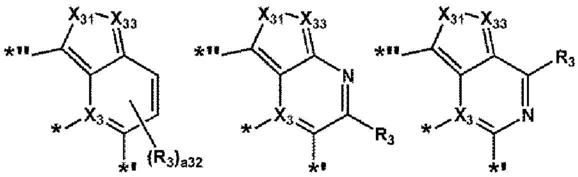

A3-3(49) A3-3(50) A3-3(51)

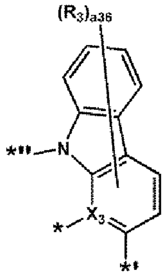

A3-3(52)

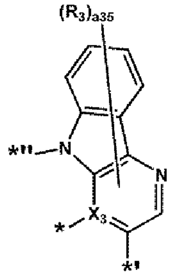

A3-3(53)

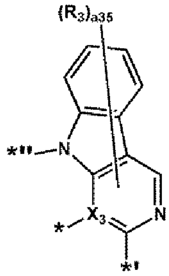

A3-3(54)

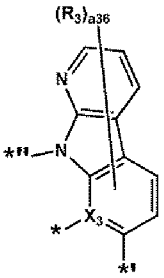

A3-3(55)

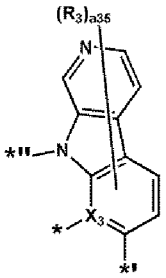

A3-3(56)

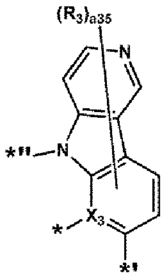

A3-3(57)

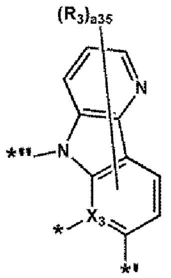

A3-3(58)

,

wherein, in Formulae A3-1(1) to A3-1(21), A3-2(1) to A3-2(58), and A3-3(1) to A3-3(58),

$X_3$ and $R_3$ are the same as described in claim 1,
$X_{31}$ is O, S, $N(R_{31})$, $C(R_{31})(R_{32})$, or $Si(R_{31})(R_{32})$,
$X_{33}$ is N or $C(R_{33})$,
$X_{34}$ is N or $C(R_{34})$,
$X_{35}$ is O, S, $N(R_{35})$, $C(R_{35})(R_{36})$, or $Si(R_{35})(R_{36})$,
$X_{37}$ is N or $C(R_{37})$,
$R_{31}$ to $R_{38}$ are the same as described in connection with $R_3$ in claim 1,
a36 is an integer from 0 to 6,
a35 is an integer from 0 to 5,
a34 is an integer from 0 to 4,
a33 is an integer from 0 to 3,
a32 is an integer from 0 to 2,
*" indicates a binding site to $T_2$ in Formula 1,
* indicates a binding site to $X_6$ or M in Formula 1, and
*' indicates a binding site to $T_3$ in Formula 1.

**10.** The organometallic compound of any of claims 1-9, wherein a moiety represented by

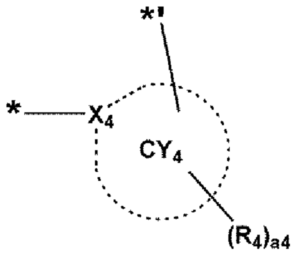

is selected from groups represented by Formulae A4-1(1) to A4-1(51) and A4-2(1) to A4-2(71):

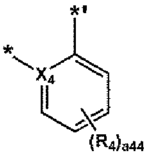
A4-1(1)

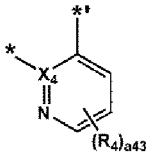
A4-1(2)

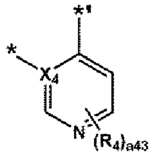
A4-1(3)

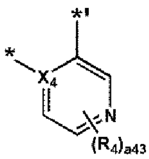
A4-1(4)

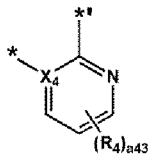
A4-1(5)

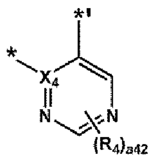
A4-1(6)

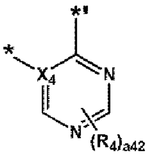
A4-1(7)

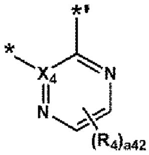
A4-1(8)

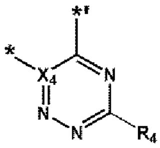
A4-1(9)

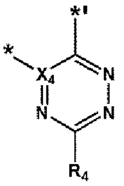
A4-1(10)

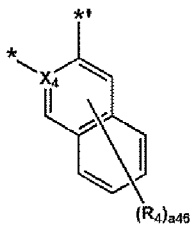
A4-1(11)

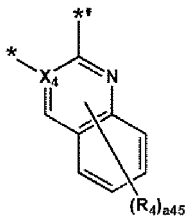
A4-1(12)

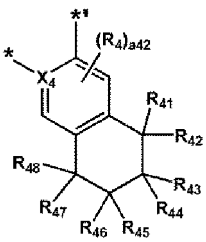
A4-1(13)

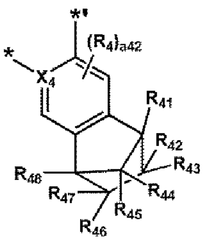
A4-1(14)

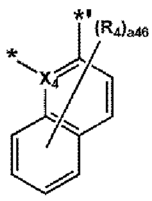
A4-1(15)

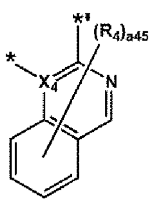
A4-1(16)

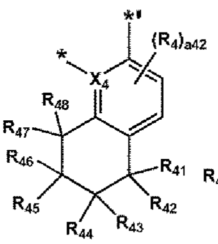
A4-1(17)

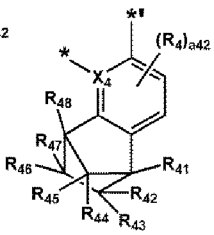
A4-1(18)

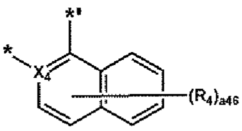
A4-1(19)

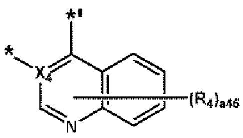
A4-1(20)

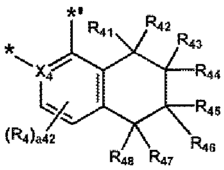
A4-1(21)

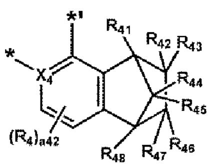
A4-1(22)

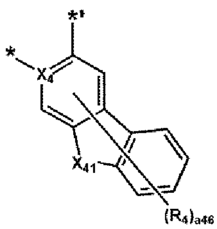
A4-1(23)

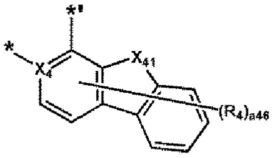
A4-1(24)

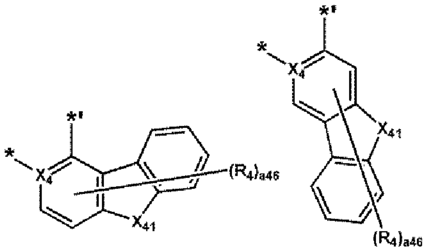
A4-1(25)

A4-1(26)

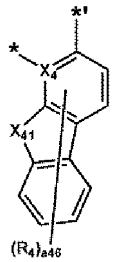
A4-1(27)

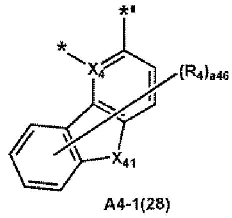
A4-1(28)

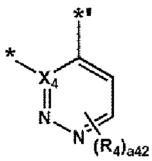
A4-1(29)

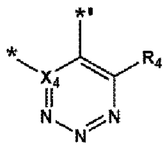
A4-1(30)

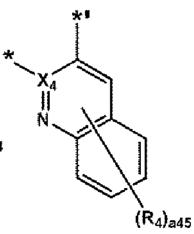
A4-1(31)

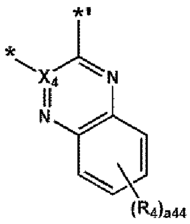
A4-1(32)

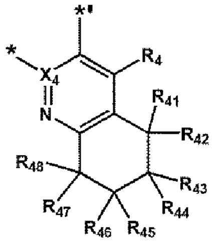
A4-1(33)

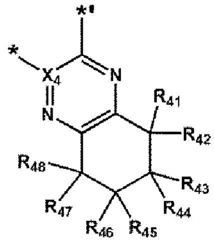
A4-1(34)

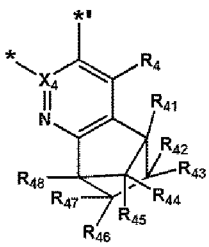
A4-1(35)

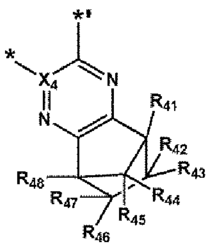
A4-1(36)

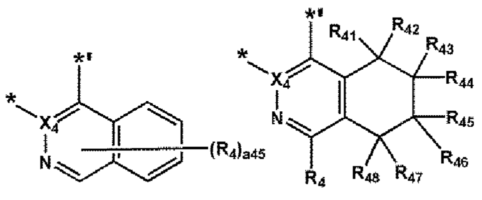
A4-1(37)

A4-1(38)

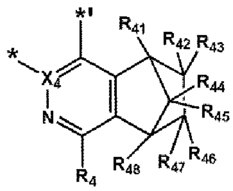
A4-1(39)

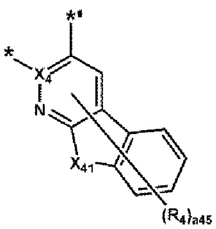
A4-1(40)

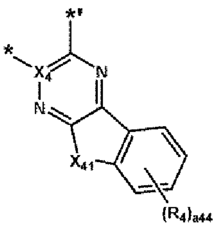
A4-1(41)

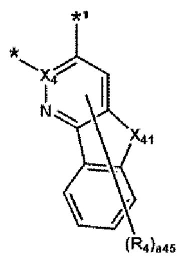
A4-1(42)

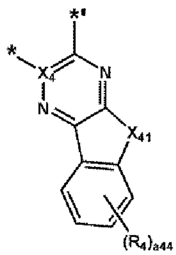
A4-1(43)

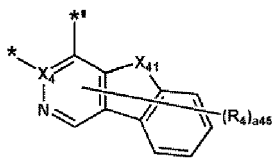
A4-1(44)

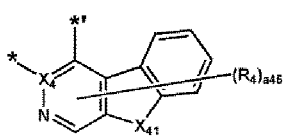
A4-1(45)

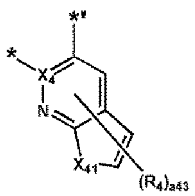
A4-1(46)

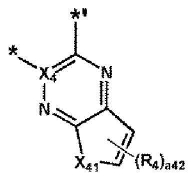
A4-1(47)

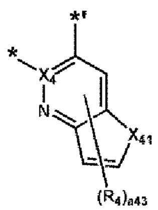
A4-1(48)

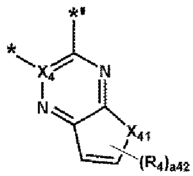
A4-1(49)

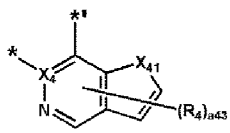
A4-1(50)

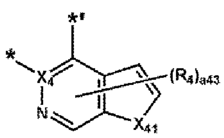
A4-1(51)

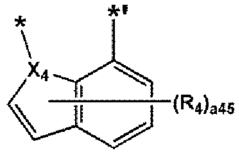
A4-2(1)

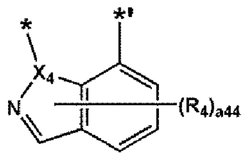
A4-2(2)

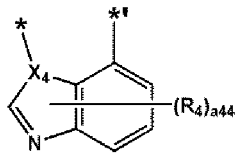
A4-2(3)

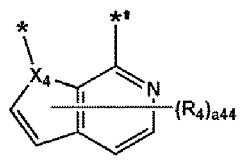
A4-2(4)

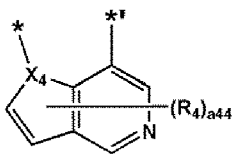
A4-2(5)

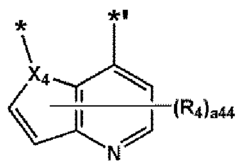
A4-2(6)

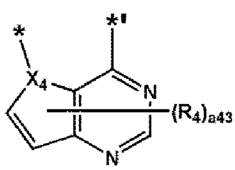
A4-2(7)

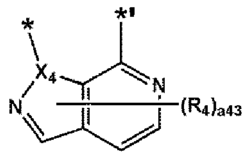
A4-2(8)

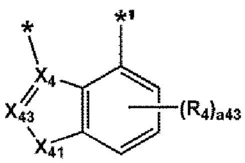
A4-2(9)

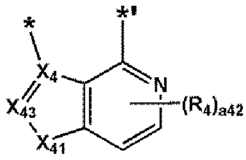
A4-2(10)

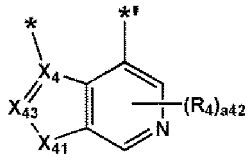
A4-2(11)

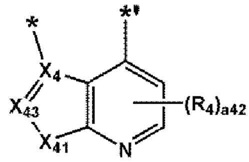
A4-2(12)

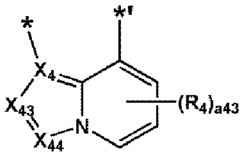
A4-2(13)

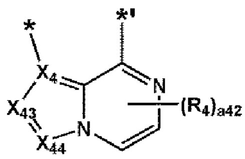
A4-2(14)

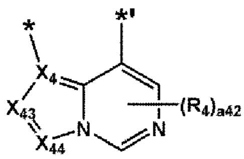
A4-2(15)

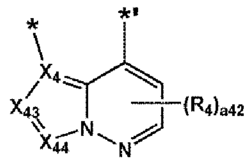
A4-2(16)

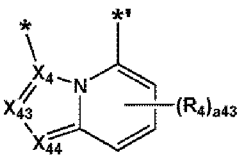
A4-2(17)

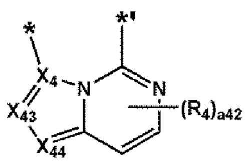
A4-2(18)

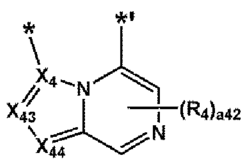
A4-2(19)

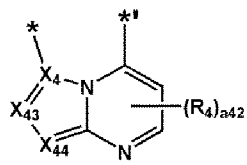
A4-2(20)

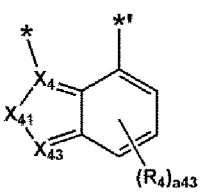
A4-2(21)

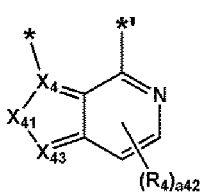
A4-2(22)

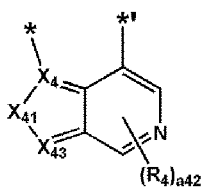
A4-2(23)

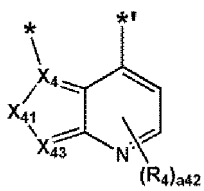
A4-2(24)

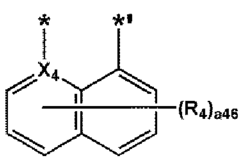
A4-2(25)

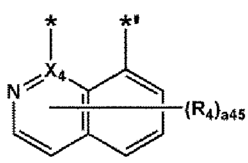
A4-2(26)

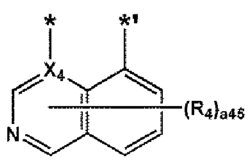
A4-2(27)

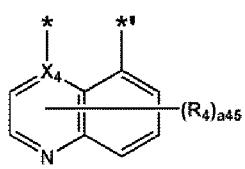
A4-2(28)

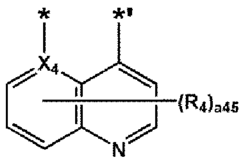

A4-2(29)

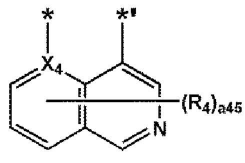

A4-2(30)

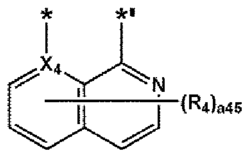

A4-2(31)

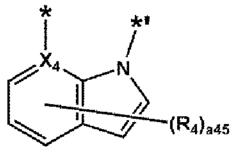

A4-2(32)

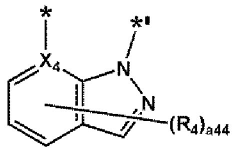

A4-2(33)

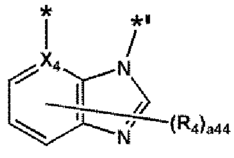

A4-2(34)

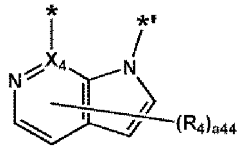

A4-2(35)

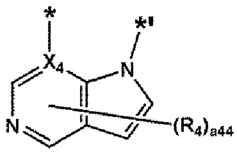

A4-2(36)

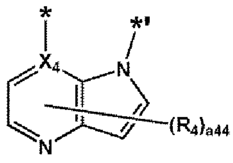

A4-2(37)

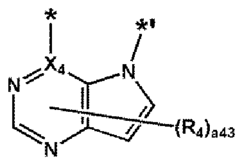

A4-2(38)

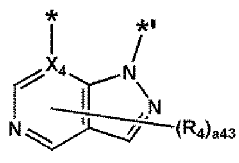

A4-2(39)

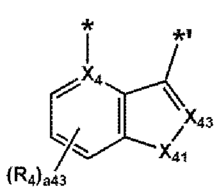

A4-2(40)

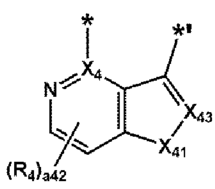

A4-2(41)

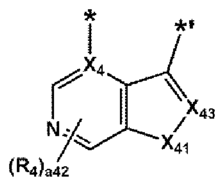

A4-2(42)

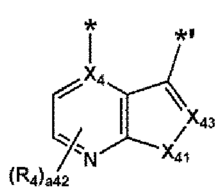

A4-2(43)

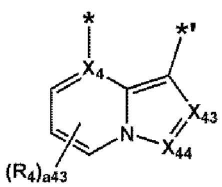

A4-2(44)

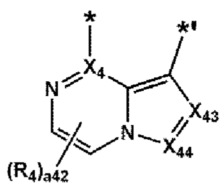

A4-2(45)

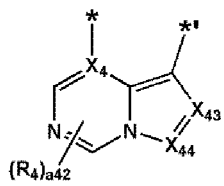

A4-2(46)

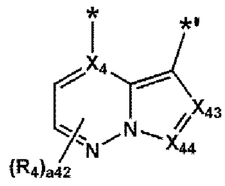

A4-2(47)

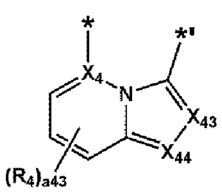

A4-2(48)

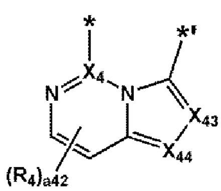

A4-2(49)

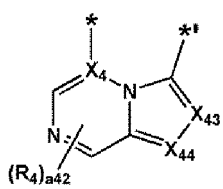

A4-2(50)

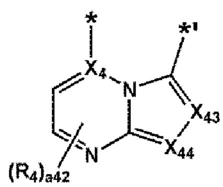

A4-2(51)

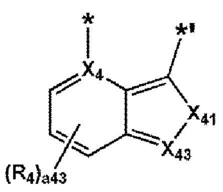

A4-2(52)

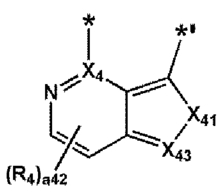

A4-2(53)

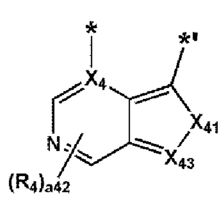

A4-2(54)

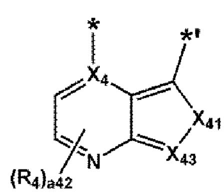

A4-2(55)

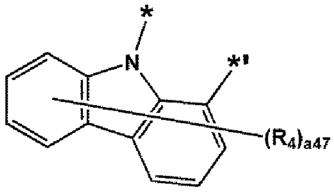

A4-2(56)

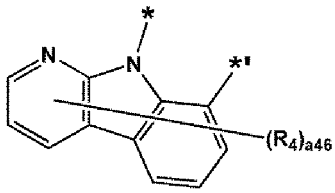

A4-2(57)

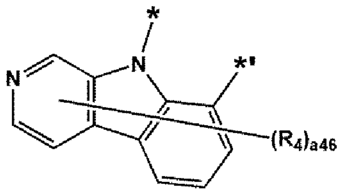

A4-2(58)

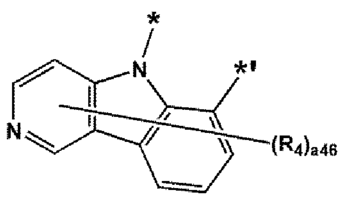

A4-2(59)

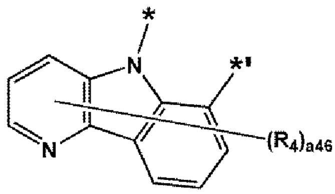

A4-2(60)

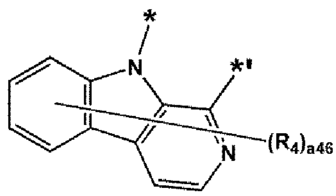

A4-2(61)

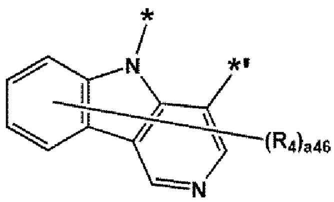

A4-2(62)

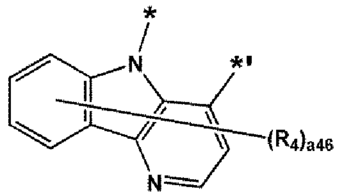

A4-2(63)

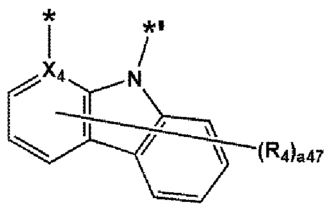

A4-2(64)

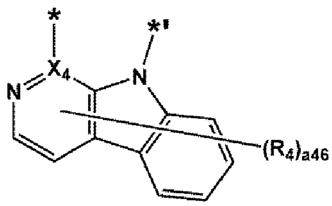

A4-2(65)

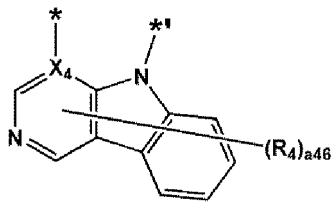

A4-2(66)

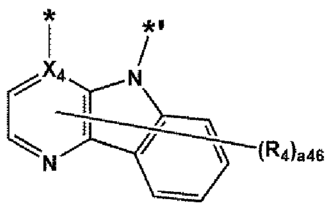

A4-2(67)

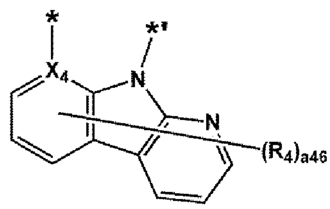

A4-2(68)

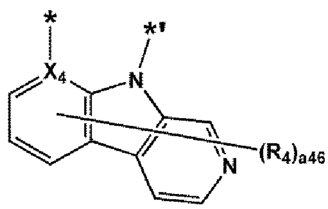

A4-2(69)

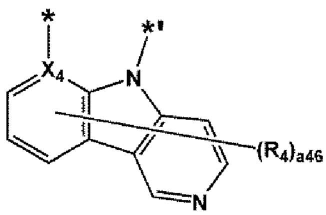

A4-2(70)

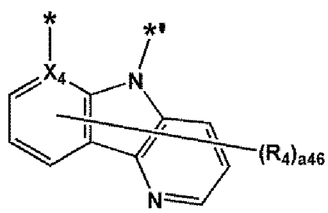

A4-2(71)

,

wherein, in Formulae A4-1(1) to A4-1(51) and A4-2(1) to A4-2(71),

$X_4$ and $R_4$ are the same as described in claim 1,
$X_{41}$ is O, S, $N(R_{41})$, $C(R_{41})(R_{42})$, or $Si(R_{41})(R_{42})$,

$X_{43}$ is N or $C(R_{43})$,
$X_{44}$ is N or $C(R_{44})$,
$R_{41}$ to $R_{48}$ are the same as described in connection with $R_4$ in claim 1,
a47 is an integer from 0 to 7,
a46 is an integer from 0 to 6,
a45 is an integer from 0 to 5,
a44 is an integer from 0 to 4,
a43 is an integer from 0 to 3,
a42 is an integer from 0 to 2,
* indicates a binding site to $X_7$ or M in Formula 1, and
*' indicates a binding site to $T_3$ in Formula 1.

**11.** The organometallic compound of any of claims 1-10, wherein
the organometallic compound has a linearly symmetrical structure with respect to a symmetrical axis connecting M and $T_2$ in Formula 1; and/or
wherein
the organometallic compound is represented by Formula 1A:

Formula 1A

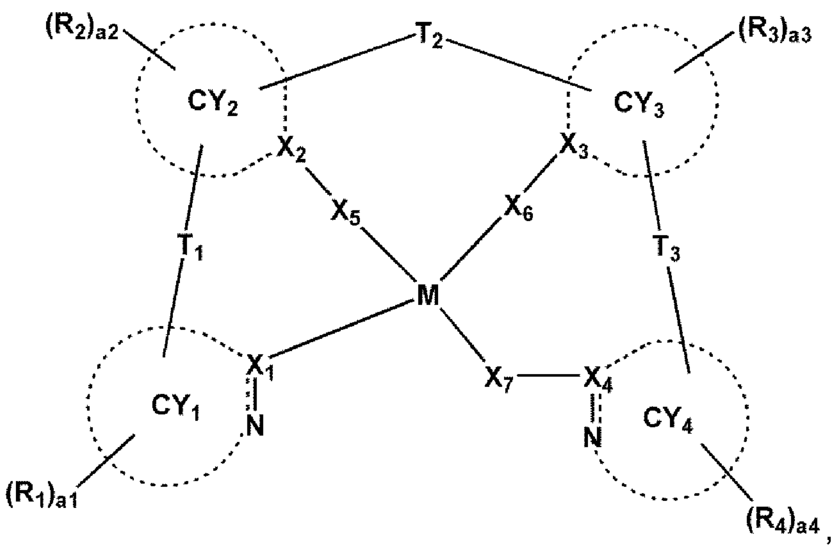

wherein, in Formula 1A, M, $X_1$ to $X_7$, ring $CY_1$ to ring $CY_3$, $T_1$ to $T_3$, $R_1$ to $R_4$, and a1 to a4 are the same as described in claim 1, and ring $CY_4$ is a $C_1$-$C_{30}$ heterocyclic group having at least one N atom as a ring-forming atom; and/or
wherein
the organometallic compound is represented by Formula 1A(1):

Formula 1A(1)

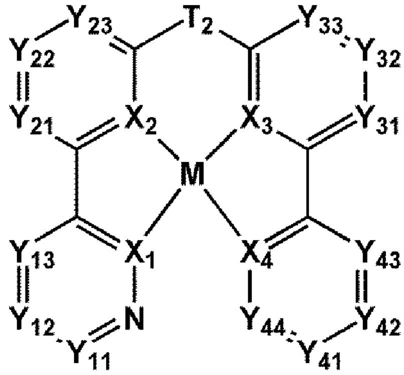

,

wherein, in Formula 1A(1),

M, $X_1$ to $X_4$, and $T_2$ are the same as described in claim 1,
$Y_{11}$ is $C(Z_{11})$ or N, $Y_{12}$ is $C(Z_{12})$ or N, $Y_{13}$ is $C(Z_{13})$ or N, $Y_{21}$ is $C(Z_{21})$ or N, $Y_{22}$ is $C(Z_{22})$ or N, $Y_{23}$ is $C(Z_{23})$ or N, $Y_{31}$ is $C(Z_{31})$ or N, $Y_{32}$ is $C(Z_{32})$ or N, $Y_{33}$ is $C(Z_{33})$ or N, $Y_{41}$ is $C(Z_{41})$ or N, $Y_{42}$ is $C(Z_{42})$ or N, $Y_{43}$ is $C(Z_{43})$ or N, and $Y_{44}$ is $C(Z_{44})$ or N,
$Z_{11}$ to $Z_{13}$ are the same as described in connection with $R_1$ in claim 1, and at least two of $Z_{11}$ to $Z_{13}$ are optionally linked to form a $C_5$-$C_{30}$ carbocyclic group which is unsubstituted or substituted with at least one $R_{10a}$ or a $C_1$-$C_{30}$ heterocyclic group which is unsubstituted or substituted with at least one $R_{10a}$,
$Z_{21}$ to $Z_{23}$ are the same as described in connection with $R_2$ in claim 1, and at least two of $Z_{21}$ to $Z_{23}$ are optionally linked to form a $C_5$-$C_{30}$ carbocyclic group which is unsubstituted or substituted with at least one $R_{10a}$ or a $C_1$-$C_{30}$ heterocyclic group which is unsubstituted or substituted with at least one $R_{10a}$,
$Z_{31}$ to $Z_{33}$ are the same as described in connection with $R_3$ in claim 1, and at least two of $Z_{31}$ to $Z_{33}$ are optionally linked to form a $C_5$-$C_{30}$ carbocyclic group which is unsubstituted or substituted with at least one $R_{10a}$ or a $C_1$-$C_{30}$ heterocyclic group which is unsubstituted or substituted with at least one $R_{10a}$,
$Z_{41}$ to $Z_{44}$ are the same as described in connection with $R_4$ in claim 1, and at least two of $Z_{41}$ to $Z_{44}$ are optionally linked to form a $C_5$-$C_{30}$ carbocyclic group which is unsubstituted or substituted with at least one $R_{10a}$ or a $C_1$-$C_{30}$ heterocyclic group which is unsubstituted or substituted with at least one $R_{10a}$, and
$R_{10a}$ is the same as described in connection with $R_1$ in claim 1.

**12.** The organometallic compound of any of claims 1-11, wherein the organometallic compound is a compound selected from Compounds 1 to 16:

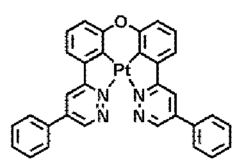
1

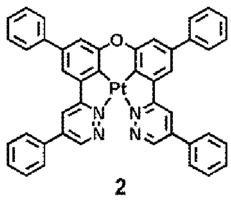
2

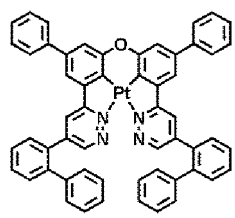
3

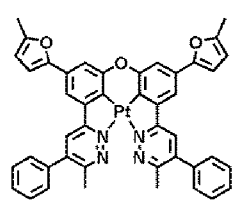
4

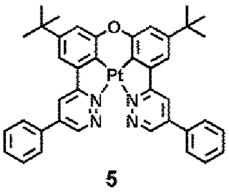
5

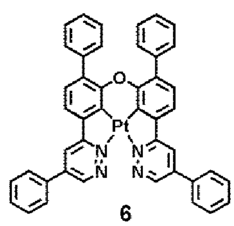
6

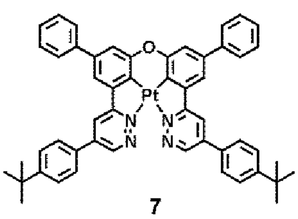
7

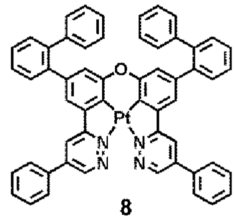
8

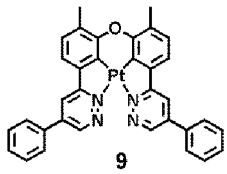
9

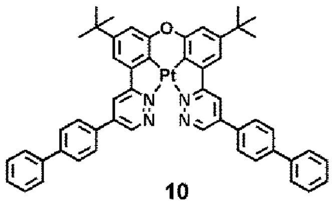
10

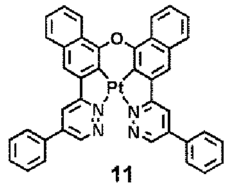
11

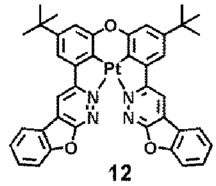
12

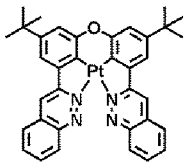
13

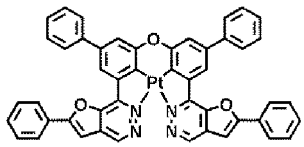
14

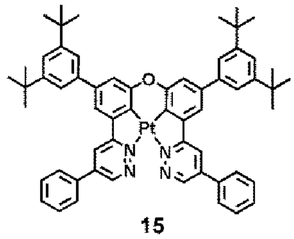
15

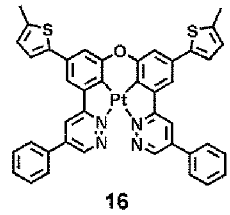
16

.

**13.** An organic light-emitting device comprising:

a first electrode;
a second electrode; and
an organic layer disposed between the first electrode and the second electrode,
wherein the organic layer comprises an emission layer, and
wherein the organic layer further comprises at least one organometallic compound of any of claims 1-12;
preferably wherein
the first electrode is an anode,
the second electrode is a cathode, and
the organic layer further comprises a hole transport region disposed between the first electrode and the emission layer and an electron transport region disposed between the emission layer and the second electrode,
wherein the hole transport region comprises a hole injection layer, a hole transport layer, an electron blocking layer, a buffer layer or any combination thereof, and
wherein the electron transport region comprises a hole blocking layer, an electron transport layer, an electron injection layer, or any combination thereof.

**14.** The organic light-emitting device of claim 13, wherein
the emission layer comprises the organometallic compound;
preferably wherein
the emission layer further comprises a host, and
an amount of the host is larger than an amount of the organometallic compound.

**15.** A diagnostic composition comprising at least one of the organometallic compounds of any of claims 1-12

## Patentansprüche

**1.** Metallorganische Verbindung, dargestellt durch Formel 1:

Formel 1

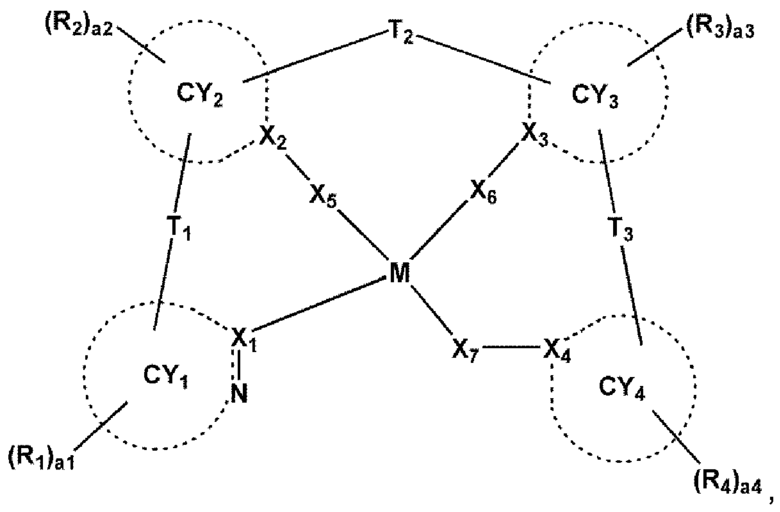

wobei in Formel 1

M Beryllium (Be), Magnesium (Mg), Aluminium (Al), Calcium (Ca), Titan (Ti), Mangan (Mn), Kobalt (Co), Kupfer (Cu), Zink (Zn), Gallium (Ga), Germanium (Ge), Ruthenium (Ru), Rhodium (Rh), Silber (Ag), Rhenium (Re), Platin (Pt) oder Gold (Au) ist,
$X_1$ N ist,
$X_2$ bis $X_4$ jeweils unabhängig C oder N sind,
$X_5$ bis $X_7$ jeweils unabhängig eine chemische Bindung, O, S, $B(R_7)$, $N(R_7)$, $P(R_7)$, $C(R_7)(R_8)$, $Si(R_7)(R_8)$, $Ge(R_7)(R_8)$, C(=O), $B(R_7)(R_8)$, $N(R_7)(R_8)$ oder $P(R_7)(R_8)$ sind,
wenn $X_5$ eine chemische Bindung ist, $X_2$ und M direkt miteinander verbunden sind, wenn $X_6$ eine chemische Bindung ist, $X_3$ und M direkt miteinander verbunden sind, und wenn $X_7$ eine chemische Bindung ist, $X_4$ und M direkt miteinander verbunden sind,
eine Bindung zwischen $X_1$ und M eine Koordinatenbindung ist, wobei eine Bindung ausgewählt aus einer Bindung zwischen $X_2$ oder $X_5$ und M, einer Bindung zwischen $X_3$ oder $X_6$ und M, und einer Bindung zwischen $X_4$ oder $X_7$ und M eine Koordinatenbindung ist, und die anderen davon jeweils eine kovalente Bindung sind,
Ring $CY_1$ eine heterocyclische $C_1$-$C_{30}$-Gruppe ist, die zumindest zwei N-Atome als ringbildende Atome aufweist,
Ring $CY_2$ bis Ring $CY_4$ jeweils unabhängig ausgewählt sind aus einer carbocyclischen $C_5$-$C_{30}$-Gruppe und einer heterocyclischen $C_1$-$C_{30}$-Gruppe,
$T_1$ und $T_3$ jeweils unabhängig eine Einzelbindung, eine Doppelbindung, *-N(R')-*', *-B(R')-*', *-P(R')-*', *-C(R)(R")-*', *-Si(R')(R")-*', *-Ge(R')(R")-*', *-S-*', *-Se-*', *-O-*', *-C(=O)-*', *-S(=O)-*', *-$S(=O)_2$-*', *-C(R')=*', *=C(R')-*', *-C(R')=C(R")-*', *-C(=S)-*' oder *-C≡C-*' sind,
$T_2$ eine Einzelbindung, eine Doppelbindung, *-$N(R_5)$-*', *-$B(R_5)$-*', *-$P(R_5)$-*', *-$C(R_5)(R_6)$-*', *-$Si(R_5)(R_6)$-*', *-$Ge(R_5)(R_6)$-*', *-S-*', *-Se-*', *-O-*1, *-C(=O)-*', *-S(=O)- *-$S(=O)_2$-*', *-$C(R_5)$=*', *=$C(R_5)$-*', *-$C(R_5)=C(R_6)$-*', *-C(=S)-*' oder *-C=C-*' ist,
$R_1$ bis $R_8$, R' und R" jeweils unabhängig ausgewählt sind aus Wasserstoff, Deuterium, -F, -Cl, -Br, -I, -$SF_5$, einer Hydroxylgruppe, einer Cyanogruppe, einer Nitrogruppe, einer Amidinogruppe, einer Hydrazingruppe, einer Hydrazongruppe, einer Carboxylsäuregruppe oder einem Salz davon, einer Sulfonsäuregruppe oder einem Salz davon, einer Phosphorsäuregruppe oder einem Salz davon, einer substituierten oder unsubstituierten $C_1$-$C_{60}$-Alkylgruppe, einer substituierten oder unsubstituierten $C_2$-$C_{60}$-Alkenylgruppe, einer substituierten oder unsubstituierten $C_2$-$C_{60}$-Alkynylgruppe, einer substituierten oder unsubstituierten $C_1$-$C_{60}$-Alkoxygruppe, einer substituierten oder unsubstituierten $C_3$-$C_{10}$-Cycloalkylgruppe, einer substituierten oder unsubstituierten $C_1$-$C_{10}$-Heterocycloalkylgruppe, einer substituierten oder unsubstituierten $C_3$-$C_{10}$-Cycloalkenylgruppe, einer substituierten oder unsubstituierten $C_1$-$C_{10}$-Heterocycloalkenylgruppe, einer substituierten oder unsubstituierten $C_6$-$C_{60}$-Arylgruppe, einer substituierten oder unsubstituierten $C_7$-$C_{60}$-Alkylarylgruppe, einer substituierten oder unsubstituierten $C_6$-$C_{60}$-Aryloxygruppe, einer substituierten oder unsubstituierten $C_6$-$C_{60}$-Arylthiogruppe, einer substituierten oder unsubstituierten $C_7$-$C_{60}$-Arylalkylgruppe, einer substituierten oder unsubstituierten $C_1$-$C_{60}$-Heteroarylgruppe, einer substituierten oder unsubstituierten $C_1$-$C_{60}$-Heteroaryloxygruppe, einer substituierten oder unsubstituierten $C_1$-$C_{60}$-Heteroarylthiogruppe, einer substituierten oder unsubstituierten $C_2$-$C_{60}$-Heteroarylalkylgruppe, einer substituierten oder unsubstituierten $C_2$-$C_{60}$-Alkylheteroarylgruppe, einer

substituierten oder unsubstituierten monovalenten nichtaromatischen kondensierten polycyclischen Gruppe, einer substituierten oder unsubstituierten monovalenten nichtaromatischen kondensierten heteropolycyclischen Gruppe, - $N(Q_1)(Q_2)$, $-Si(Q_3)(Q_4)(Q_5)$, $-B(Q_6)(Q_7)$ und $-P(=O)(Q_8)(Q_9)$,

a1 bis a4 jeweils unabhängig eine ganze Zahl von 0 bis 20 sind,

zwei aus einer Vielzahl von benachbarten Gruppen $R_1$ optional verbunden sind, um eine carbocyclische $C_5$-$C_{30}$-Gruppe, die unsubstituiert oder mit zumindest einem $R_{10a}$ substituiert sind, oder eine heterocyclische $C_1$-$C_{30}$-Gruppe zu bilden, die unsubstituiert oder mit zumindest einem $R_{10a}$ substituiert ist,

zwei aus einer Vielzahl von benachbarten Gruppen $R_2$ optional verbunden sind, um eine carbocyclische $C_5$-$C_{30}$-Gruppe, die unsubstituiert oder mit zumindest einem $R_{10a}$ substituiert ist, oder eine heterocyclische $C_1$-$C_{30}$-Gruppe zu bilden, die unsubstituiert oder mit zumindest einem $R_{10a}$ substituiert ist,

zwei aus einer Vielzahl von benachbarten Gruppen $R_3$ optional verbunden sind, um eine carbocyclische $C_5$-$C_{30}$-Gruppe, die unsubstituiert oder mit zumindest einem $R_{10a}$ substituiert ist, oder eine heterocyclische $C_1$-$C_{30}$-Gruppe zu bilden, die unsubstituiert oder mit zumindest einem $R_{10a}$ substituiert ist,

zwei aus einer Vielzahl von benachbarten Gruppen $R_4$ optional verbunden sind, um eine carbocyclische $C_5$-$C_{30}$-Gruppe, die unsubstituiert oder mit zumindest einem $R_{10a}$ substituiert ist, oder eine heterocyclische $C_1$-$C_{30}$-Gruppe zu bilden, die unsubstituiert oder mit zumindest einem $R_{10a}$ substituiert ist,

zwei von $R_1$ bis $R_8$, R' und R" optional verbunden sind, um eine carbocyclische $C_5$-$C_{30}$-Gruppe, die unsubstituiert oder mit zumindest einem $R_{10a}$ substituiert ist, oder eine heterocyclische $C_1$-$C_{30}$-Gruppe zu bilden, die unsubstituiert oder mit zumindest einem $R_{10a}$ substituiert ist,

$R_{10a}$ das gleiche wie in Verbindung mit $R_1$ beschrieben ist,

* und *' jeweils eine Bindungsstelle zu einem benachbarten Atom angeben,

zumindest ein Substituent der substituierten $C_1$-$C_{60}$-Alkylgruppe, der substituierten $C_2$-$C_{60}$-Alkenylgruppe, der substituierten $C_2$-$C_{60}$-Alkynylgruppe, der substituierten $C_1$-$C_{60}$-Alkoxygruppe, der substituierten $C_3$-$C_{10}$-Cycloalkylgruppe, der substituierten $C_1$-$C_{10}$-Heterocycloalkylgruppe, der substituierten $C_3$-$C_{10}$-Cycloalkenylgruppe, der substituierten $C_1$-$C_{10}$-Heterocycloalkenylgruppe, der substituierten $C_6$-$C_{60}$-Arylgruppe, der substituierten $C_7$-$C_{60}$-Alkylarylgruppe, der substituierten $C_6$-$C_{60}$-Aryloxygruppe, der substituierten $C_6$-$C_{60}$-Arylthiogruppe, der substituierten $C_7$-$C_{60}$-Arylalkylgruppe, der substituierten $C_1$-$C_{60}$-Heteroarylgruppe, der substituierten $C_1$-$C_{60}$-Heteroaryloxygruppe, der substituierten $C_1$-$C_{60}$-Heteroarylthiogruppe, der substituierten $C_2$-$C_{60}$-Heteroarylalkylgruppe, der substituierten $C_2$-$C_{60}$-Alkylheteroarylgruppe, der substituierten monovalenten nichtaromatischen kondensierten polycyclischen Gruppe und der substituierten monovalenten nichtaromatischen kondensierten heteropolycyclischen Gruppe ausgewählt ist aus:

Deuterium, -F, -Cl, -Br, -I, $-CD_3$, $-CD_2H$, $-CDH_2$, $-CF_3$, $-CF_2H$, $-CFH_2$, einer Hydroxylgruppe, einer Cyanogruppe, einer Nitrogruppe, einer Amidinogruppe, einer Hydrazingruppe, einer Hydrazongruppe, einer Carboxylsäuregruppe oder einem Salz davon, einer Sulfonsäuregruppe oder einem Salz davon, einer Phosphorsäuregruppe oder einem Salz davon, einer $C_1$-$C_{60}$-Alkylgruppe, einer $C_2$-$C_{60}$-Alkenylgruppe, einer $C_2$-$C_{60}$-Alkynylgruppe und einer $C_1$-$C_{60}$-Alkoxygruppe;

einer $C_1$-$C_{60}$-Alkylgruppe, einer $C_2$-$C_{60}$-Alkenylgruppe, einer $C_2$-$C_{60}$-Alkynylgruppe und einer $C_1$-$C_{60}$-Alkoxygruppe, jeweils substituiert mit zumindest einem ausgewählt aus Deuterium, -F, -Cl, -Br, -I, $-CD_3$, $-CD_2H$, $-CDH_2$, $-CF_3$, $-CF_2H$, $-CFH_2$, einer Hydroxylgruppe, einer Cyanogruppe, einer Nitrogruppe, einer Amidinogruppe, einer Hydrazingruppe, einer Hydrazongruppe, einer Carboxylsäuregruppe oder einem Salz davon, einer Sulfonsäuregruppe oder einem Salz davon, einer Phosphorsäuregruppe oder einem Salz davon, einer $C_3$-$C_{10}$-Cycloalkylgruppe, einer $C_1$-$C_{10}$-Heterocycloalkylgruppe, einer $C_3$-$C_{10}$-Cycloalkenylgruppe, einer $C_1$-$C_{10}$-Heterocycloalkenylgruppe, einer $C_6$-$C_{60}$-Arylgruppe, einer $C_7$-$C_{60}$-Alkylarylgruppe, einer $C_6$-$C_{60}$-Aryloxygruppe, einer $C_6$-$C_{60}$-Arylthiogruppe, einer $C_7$-$C_{60}$-Arylalkylgruppe, einer $C_1$-$C_{60}$-Heteroarylgruppe, einer $C_1$-$C_{60}$-Heteroaryloxygruppe, einer $C_1$-$C_{60}$-Heteroarylthiogruppe, einer $C_2$-$C_{60}$-Heteroarylalkylgruppe, einer $C_2$-$C_{60}$-Alkylheteroarylgruppe, einer monovalenten nichtaromatischen kondensierten polycyclischen Gruppe, einer monovalenten nichtaromatischen kondensierten heteropolycyclischen Gruppe, $-N(Q_{11})(Q_{12})$, $-Si(Q_{13})(Q_{14})(Q_{15})$, $-B(Q_{16})(Q_{17})$ und - $P(=O)(Q_{18})(Q_{19})$;

einer $C_3$-$C_{10}$-Cycloalkylgruppe, einer $C_1$-$C_{10}$-Heterocycloalkylgruppe, einer $C_3$-$C_{10}$-Cycloalkenylgruppe, einer $C_1$-$C_{10}$-Heterocycloalkenylgruppe, einer $C_6$-$C_{60}$-Arylgruppe, einer $C_7$-$C_{60}$-Alkylarylgruppe, einer $C_6$-$C_{60}$-Aryloxygruppe, einer $C_6$-$C_{60}$-Arylthiogruppe, einer $C_7$-$C_{60}$-Arylalkylgruppe, einer $C_1$-$C_{60}$-Heteroarylgruppe, einer $C_1$-$C_{60}$-Heteroaryloxygruppe, einer $C_1$-$C_{60}$-Heteroarylthiogruppe, einer $C_2$-$C_{60}$-Heteroarylalkylgruppe, einer $C_2$-$C_{60}$-Alkylheteroarylgruppe, einer monovalenten nichtaromatischen kondensierten polycyclischen Gruppe und einer monovalenten nichtaromatischen kondensierten heteropolycyclischen Gruppe;

einer $C_3$-$C_{10}$-Cycloalkylgruppe, einer $C_1$-$C_{10}$-Heterocycloalkylgruppe, einer $C_3$-$C_{10}$-Cycloalkenylgruppe, einer $C_1$-$C_{10}$-Heterocycloalkenylgruppe, einer $C_6$-$C_{60}$-Arylgruppe, einer $C_7$-$C_{60}$-Alkylarylgruppe, einer $C_6$-$C_{60}$-Aryloxygruppe, einer $C_6$-$C_{60}$-Arylthiogruppe, einer $C_7$-$C_{60}$-Arylalkylgruppe, einer $C_1$-$C_{60}$-Heteroarylgruppe, einer $C_1$-$C_{60}$-Heteroaryloxygruppe, einer $C_1$-$C_{60}$-Heteroarylthiogruppe, einer $C_2$-$C_{60}$-Heteroarylalkylgruppe, einer

$C_2$-$C_{60}$-Alkylheteroarylgruppe, einer monovalenten nichtaromatischen kondensierten polycyclischen Gruppe und einer monovalenten nichtaromatischen kondensierten heteropolycyclischen Gruppe, jeweils substituiert mit zumindest einem ausgewählt aus Deuterium, -F, -Cl, -Br, -I, $-CD_3$, $-CD_2H$, $-CDH_2$, $-CF_3$, $-CF_2H$, $-CFH_2$, einer Hydroxylgruppe, einer Cyanogruppe, einer Nitrogruppe, einer Amidinogruppe, einer Hydrazingruppe, einer Hydrazongruppe, einer Carboxylsäuregruppe oder einem Salz davon, einer Sulfonsäuregruppe oder einem Salz davon, einer Phosphorsäuregruppe oder einem Salz davon, einer $C_1$-$C_{60}$-Alkylgruppe, einer $C_2$-$C_{60}$-Alkenylgruppe, einer $C_2$-$C_{60}$-Alkynylgruppe, einer $C_1$-$C_{60}$-Alkoxygruppe, einer $C_3$-$C_{10}$-Cycloalkylgruppe, einer $C_1$-$C_{10}$-Heterocycloalkylgruppe, einer $C_3$-$C_{10}$-Cycloalkenylgruppe, einer $C_1$-$C_{10}$-Heterocycloalkenylgruppe, einer $C_6$-$C_{60}$-Arylgruppe, einer $C_7$-$C_{60}$-Alkylarylgruppe, einer $C_6$-$C_{60}$-Aryloxygruppe, einer $C_6$-$C_{60}$-Arylthiogruppe, einer $C_7$-$C_{60}$-Arylalkylgruppe, einer $C_1$-$C_{60}$-Heteroarylgruppe, einer $C_1$-$C_{60}$-Heteroaryloxygruppe, einer $C_1$-$C_{60}$-Heteroarylthiogruppe, einer $C_2$-$C_{60}$-Heteroarylalkylgruppe, einer $C_2$-$C_{60}$-Alkylheteroarylgruppe, einer monovalenten nichtaromatischen kondensierten polycyclischen Gruppe, einer monovalenten nichtaromatischen kondensierten heteropolycyclischen Gruppe, $-N(Q_{21})(Q_{22})$, $-Si(Q_{23})(Q_{24})(Q_{25})$, $-B(Q_{26})(Q_{27})$ und - $P(=O)(Q_{28})(Q_{29})$; und

$-N(Q_{31})(Q_{32})$, $-Si(Q_{33})(Q_{34})(Q_{35})$, $-B(Q_{36})(Q_{37})$ und $-P(=O)(Q_{38})(Q_{39})$, und

$Q_1$ bis $Q_9$, $Q_{11}$ bis $Q_{19}$, $Q_{21}$ bis $Q_{29}$ und $Q_{31}$ bis $Q_{39}$ jeweils unabhängig ausgewählt sind aus Wasserstoff, Deuterium, -F, -Cl, -Br, -I, einer Hydroxylgruppe, einer Cyanogruppe, einer Nitrogruppe, einer Amidinogruppe, einer Hydrazingruppe, einer Hydrazongruppe, einer Carboxylsäuregruppe oder einem Salz davon, einer Sulfonsäuregruppe oder einem Salz davon, einer Phosphorsäuregruppe oder einem Salz davon, einer $C_1$-$C_{60}$-Alkylgruppe, einer $C_2$-$C_{60}$-Alkenylgruppe, einer $C_2$-$C_{60}$-Alkynylgruppe, einer $C_1$-$C_{60}$-Alkoxygruppe, einer $C_3$-$C_{10}$-Cycloalkylgruppe, einer $C_1$-$C_{10}$-Heterocycloalkylgruppe, einer $C_3$-$C_{10}$-Cycloalkenylgruppe, einer $C_1$-$C_{10}$-Heterocycloalkenylgruppe, einer $C_6$-$C_{60}$-Arylgruppe, einer $C_6$-$C_{60}$-Arylgruppe substituiert mit zumindest einer ausgewählt aus einer $C_7$-$C_{60}$-Alkylarylgruppe, einer $C_1$-$C_{60}$-Alkylgruppe und einer $C_6$-$C_{60}$-Arylgruppe, einer $C_6$-$C_{60}$-Aryloxygruppe, einer $C_6$-$C_{60}$-Arylthiogruppe, einer $C_7$-$C_{60}$-Arylalkylgruppe, einer $C_1$-$C_{60}$-Heteroarylgruppe, einer $C_1$-$C_{60}$-Heteroaryloxygruppe, einer $C_1$-$C_{60}$-Heteroarylthiogruppe, einer $C_2$-$C_{60}$-Heteroarylalkylgruppe, einer $C_2$-$C_{60}$-Alkylheteroarylgruppe, einer monovalenten nichtaromatischen kondensierten polycyclischen Gruppe und einer monovalenten nichtaromatischen kondensierten heteropolycyclischen Gruppe.

**2.** Metallorganische Verbindung nach Anspruch 1, wobei
M Pt oder Au ist; und/oder
wobei
$X_2$ und $X_3$ jeweils C sind, $X_4$ N ist, und $X_5$ bis $X_7$ jeweils eine chemische Bindung sind, oder
$X_2$ und $X_4$ jeweils C sind, $X_3$ N ist, $X_5$ und $X_6$ jeweils eine chemische Bindung sind, und $X_7$ eine chemische Bindung, O oder S ist.

**3.** Metallorganische Verbindung nach Anspruch 1 oder 2, wobei
Ring $CY_1$ ausgewählt ist aus i) einem ersten Ring, ii) einem kondensierten Ring, in dem zumindest zwei von dem ersten Ring kondensiert ist, und iii) einem kondensierten Ring, in dem zumindest einer von dem ersten Ring und zumindest einer von einem zweiten Ring miteinander kondensiert sind,
der erste Ring eine Pyridazingruppe, eine Triazingruppe oder eine Tetrazingruppe ist,
der zweite Ring ausgewählt ist aus einer Cyclopentangruppe, einer Cyclopentadiengruppe, einer Furangruppe, einer Thiophengruppe, einer Pyrrolgruppe, einer Silolgruppe, einer Indengruppe, einer Benzofurangruppe, einer Benzothiophengruppe, einer Indolgruppe, einer Benzosilolgruppe, einer Oxazolgruppe, einer Isoxazolgruppe, einer Oxadiazolgruppe, einer Isoxadiazolgruppe, einer Oxatriazolgruppe, einer Isoxatriazolgruppe, einer Thiazolgruppe, einer Isothiazolgruppe, einer Thiadiazolgruppe, einer Isothiadiazolgruppe, einer Thiatriazolgruppe, einer Isothiatriazolgruppe, einer Pyrazolgruppe, einer Imidazolgruppe, einer Triazolgruppe, einer Tetrazolgruppe, einer Azasilolgruppe, einer Diazasilolgruppe, einer Triazasilolgruppe, einer Adamantangruppe, einer Norbornangruppe, einer Norbornengruppe, einer Cyclohexangruppe, einer Cyclohexengruppe, einer Benzolgruppe, einer Pyridingruppe, einer Pyrimidingruppe und einer Pyrazingruppe, und
wenn Ring $CY_1$ ein kondensierter Ring ist, in dem zumindest einer von dem ersten Ring und zumindest einer von dem zweiten Ring miteinander kondensiert sind, N in dem ersten Ring des kondensierten Rings koordiniert an M in Formel 1 gebunden ist.

**4.** Metallorganische Verbindung nach einem der Ansprüche 1-3, wobei
Ring $CY_2$ bis Ring $CY_4$ jeweils unabhängig ausgewählt sind aus i) einem dritten Ring, ii) einem vierten Ring, iii) einem kondensierten Ring, in dem zumindest zwei von dem dritten Ring miteinander kondensiert sind, iv) einem kondensierten Ring, in dem zumindest zwei von dem vierten Ring miteinander kondensiert sind, und v) einem kondensierten Ring, in dem zumindest einer von dem dritten Ring und zumindest einer von dem vierten Ring

miteinander kondensiert sind,
der dritte Ring ausgewählt ist aus einer Cyclopentangruppe, einer Cyclopentadiengruppe, einer Furangruppe, einer Thiophengruppe, einer Pyrrolgruppe, einer Silolgruppe, einer Indengruppe, einer Benzofurangruppe, einer Benzothiophengruppe, einer Indolgruppe, einer Benzosilolgruppe, einer Oxazolgruppe, einer Isoxazolgruppe, einer Oxadiazolgruppe, einer Isoxadiazolgruppe, einer Oxatriazolgruppe, einer Isoxatriazolgruppe, einer Thiazolgruppe, einer Isothiazolgruppe, einer Thiadiazolgruppe, einer Isothiadiazolgruppe, einer Thiatriazolgruppe, einer Isothiatriazolgruppe, einer Pyrazolgruppe, einer Imidazolgruppe, einer Triazolgruppe, einer Tetrazolgruppe, einer Azasilolgruppe, einer Diazasilolgruppe und einer Triazasilolgruppe, und
der vierte Ring ausgewählt ist aus einer Adamantangruppe, einer Norbornangruppe, einer Norbornengruppe, einer Cyclohexangruppe, einer Cyclohexengruppe, einer Benzolgruppe, einer Pyridingruppe, einer Pyrimidingruppe, einer Pyrazingruppe, einer Pyridazingruppe und einer Triazingruppe.

**5.** Metallorganische Verbindung nach einem der Ansprüche 1-4, wobei
$T_1$ und $T_3$ jeweils eine Einzelbindung sind, und
$T_2$ *-N($R_5$)-*', *-C($R_5$)($R_6$)-*', *-Si($R_5$)($R_6$)-*', *-S-*' oder *-O-*' ist.

**6.** Metallorganische Verbindung nach einem der Ansprüche 1-5, wobei
$R_1$ bis $R_8$, R' und R" jeweils unabhängig ausgewählt sind aus:

Wasserstoff, Deuterium, -F, -Cl, -Br, -I, einer Hydroxylgruppe, einer Cyanogruppe, einer Nitrogruppe, einer Aminogruppe, einer Amidinogruppe, einer Hydrazingruppe, einer Hydrazongruppe, einer Carboxylsäuregruppe oder einem Salz davon, einer Sulfonsäuregruppe oder einem Salz davon, einer Phosphorsäuregruppe oder einem Salz davon, $-SF_5$, $C_1$-$C_{20}$-Alkylgruppe und einer $C_1$-$C_{20}$-Alkoxygruppe;
einer $C_1$-$C_{20}$-Alkylgruppe und einer $C_1$-$C_{20}$-Alkoxygruppe, jeweils substituiert mit zumindest einem ausgewählt aus Deuterium, -F, -Cl, -Br, -I, $-CD_3$, $-CD_2H$, $-CDH_2$, $-CF_3$, $-CF_2H$, $-CFH_2$, einer Hydroxylgruppe, einer Cyanogruppe, einer Nitrogruppe, einer Aminogruppe, einer Amidinogruppe, einer Hydrazingruppe, einer Hydrazongruppe, einer Carboxylsäuregruppe oder einem Salz davon, einer Sulfonsäuregruppe oder einem Salz davon, einer Phosphorsäuregruppe oder einem Salz davon, einer $C_1$-$C_{10}$-Alkylgruppe, einer Cyclopentylgruppe, einer Cyclohexylgruppe, einer Cycloheptylgruppe, einer Cycloctylgruppe, einer Adamantanylgruppe, einer Norbornanylgruppe, einer Norbornenylgruppe, einer Cyclopentenylgruppe, einer Cyclohexenylgruppe, einer Cycloheptenylgruppe, einer Phenylgruppe, einer Biphenylgruppe, einer Naphthylgruppe, einer Pyridinylgruppe und einer Pyrimidinylgruppe;
einer Cyclopentylgruppe, einer Cyclohexylgruppe, einer Cycloheptylgruppe, einer Cycloctylgruppe, einer Adamantanylgruppe, einer Norbornanylgruppe, einer Norbornenylgruppe, einer Cyclopentenylgruppe, einer Cyclohexenylgruppe, einer Cycloheptenylgruppe, einer Phenylgruppe, einer Biphenylgruppe, einer $C_1$-$C_{20}$-Alkylphenylgruppe, einer Naphthylgruppe, einer Fluorenylgruppe, einer Phenanthrenylgruppe, einer Anthracenylgruppe, einer Fluoranthenylgruppe, einer Triphenylenylgruppe, einer Pyrenylgruppe, einer Chrysenylgruppe, einer Pyrrolylgruppe, einer Thiophenylgruppe, einer Furanylgruppe, einer Imidazolylgruppe, einer Pyrazolylgruppe, einer Thiazolylgruppe, einer Isothiazolylgruppe, einer Oxazolylgruppe, einer Isoxazolylgruppe, einer Pyridinylgruppe, einer Pyrazinylgruppe, einer Pyrimidinylgruppe, einer Pyridazinylgruppe, einer Isoindolylgruppe, einer Indolylgruppe, einer Indazolylgruppe, einer Purinylgruppe, einer Quinolinylgruppe, einer Isoquinolinylgruppe, einer Benzoquinolinylgruppe, einer Quinoxalinylgruppe, einer Quinazolinylgruppe, einer Cinnolinylgruppe, einer Carbazolylgruppe, einer Phenanthrolinylgruppe, einer Benzimidazolylgruppe, einer Benzofuranylgruppe, einer Benzothiophenylgruppe, einer Isobenzothiazolylgruppe, einer Benzoxazolylgruppe, einer Isobenzoxazolylgruppe, einer Triazolylgruppe, einer Tetrazolylgruppe, einer Oxadiazolylgruppe, einer Triazinylgruppe, einer Dibenzofuranylgruppe, einer Dibenzothiophenylgruppe, einer Benzocarbazolylgruppe, einer Dibenzocarbazolylgruppe, einer Imidazopyridinylgruppe und einer Imidazopyrimidinylgruppe;
einer Cyclopentylgruppe, einer Cyclohexylgruppe, einer Cycloheptylgruppe, einer Cycloctylgruppe, einer Adamantanylgruppe, einer Norbornanylgruppe, einer Norbornenylgruppe, einer Cyclopentenylgruppe, einer Cyclohexenylgruppe, einer Cycloheptenylgruppe, einer Phenylgruppe, einer Biphenylgruppe, einer $C_1$-$C_{20}$-Alkylphenylgruppe, einer Naphthylgruppe, einer Fluorenylgruppe, einer Phenanthrenylgruppe, einer Anthracenylgruppe, einer Fluoranthenylgruppe, einer Triphenylenylgruppe, einer Pyrenylgruppe, einer Chrysenylgruppe, einer Pyrrolylgruppe, einer Thiophenylgruppe, einer Furanylgruppe, einer Imidazolylgruppe, einer Pyrazolylgruppe, einer Thiazolylgruppe, einer Isothiazolylgruppe, einer Oxazolylgruppe, einer Isoxazolylgruppe, einer Pyridinylgruppe, einer Pyrazinylgruppe, einer Pyrimidinylgruppe, einer Pyridazinylgruppe, einer Isoindolylgruppe, einer Indolylgruppe, einer Indazolylgruppe, einer Purinylgruppe, einer Quinolinylgruppe, einer Isoquinolinylgruppe, einer Benzoquinolinylgruppe, einer Quinoxalinylgruppe, einer Quinazolinylgruppe, einer Cinnolinylgruppe, einer Carbazolylgruppe, einer Phenanthrolinylgruppe, einer Benzimidazolylgruppe, einer Benzofuranylgruppe, einer Benzothiophenylgruppe, einer Isobenzothiazolylgruppe, einer Benzoxazolylgruppe, einer Isobenzoxazolylgruppe, einer Triazolylgruppe, einer Tetrazolylgruppe, einer Oxadiazolylgruppe, einer Triazinylgruppe, einer Dibenzofuranylgruppe, einer Dibenzothiophenylgruppe, einer Benzocarbazolylgruppe, einer Dibenzocarbazolylgruppe, einer Imidazopyridinylgruppe und einer Imidazopyrimidinylgruppe, jeweils substituiert mit zumindest einem ausgewählt aus Deuterium, -F, -Cl, -Br, -I, $-CD_3$, $-CD_2H$, $-CDH_2$, $-CF_3$, $-CF_2H$, $-CFH_2$, einer Hydroxylgruppe, einer Cyanogruppe, einer Nitrogruppe, einer Aminogruppe, einer Amidinogruppe, einer Hydrazingruppe, einer Hydrazongruppe, einer Carboxylsäuregruppe oder einem Salz davon, einer Sulfonsäuregruppe oder einem Salz davon, einer Phosphorsäuregruppe oder einem Salz davon, einer $C_1$-$C_{20}$-Alkylgruppe, einer $C_1$-$C_{20}$-Alkoxygruppe, einer Cyclopentylgruppe, einer Cyclohexylgruppe, einer Cycloheptylgruppe, einer Cycloctylgruppe, einer Adamantanylgruppe, einer Norbornanylgruppe, einer Norbornenylgruppe, einer Cyclopentenylgruppe, einer Cyclohexenylgruppe, einer Cycloheptenylgruppe, einer Phenylgruppe, einer Biphenylgruppe, einer $C_1$-$C_{20}$-Alkylphenylgruppe, einer Naphthylgruppe, einer Fluorenylgruppe, einer Phenanthrenylgruppe, einer Anthracenylgruppe, einer Fluoranthenylgruppe, einer Triphenylenylgruppe, einer Pyrenylgruppe, einer Chrysenylgruppe, einer Pyrrolylgruppe, einer Thiophenylgrupppe, einer Furanylgruppe, einer Imidazolylgruppe, einer Pyrazolylgruppe, einer Thiazolylgruppe, einer Isothiazolylgruppe, einer Oxazolylgruppe, einer Isoxazolylgruppe, einer Pyridinylgruppe, einer Pyrazinylgruppe, einer Pyrimidinylgruppe, einer Pyridazinylgruppe, einer Isoindolylgruppe, einer Indolylgruppe, einer Indazolylgruppe, einer Purinylgruppe, einer Quinolinylgruppe, einer Isoquinolinylgruppe, einer Benzoquinolinylgruppe, einer Quinoxalinylgruppe, einer Quinazolinylgruppe, einer Cinnolinylgruppe, einer Carbazolylgruppe, einer Phenanthrolinylgruppe, einer Benzimidazolylgruppe, einer Benzofuranylgruppe, einer Benzothiophenylgruppe, einer Isobenzothiazolylgruppe, einer Benzoxazolylgruppe, einer Isobenzoxazolylgruppe, einer Triazolylgruppe, einer Tetrazolylgruppe, einer Oxadiazolylgruppe, einer Triazinylgruppe, einer Dibenzofuranylgruppe, einer Dibenzothiophenylgruppe, einer Benzocarbazolylgruppe, einer Dibenzocarbazolylgruppe, einer Imidazopyridinylgruppe und einer Imidazopyrimidinylgruppe; und

$-N(Q_1)(Q_2)$, $-Si(Q_3)(Q_4)(Q_5)$, $-B(Q_6)(Q_7)$ und $-P(=O)(Q_8)(Q_9)$, und

$Q_1$ bis $Q_9$ jeweils unabhängig ausgewählt sind aus:

$-CH_3$, $-CD_3$, $-CD_2H$, $-CDH_2$, $-CH_2CH_3$, $-CH_2CD_3$, $-CH_2CD_2H$, $-CH_2CDH_2$, $-CHDCH_3$, $-CHDCD_2H$, $-CHDCDH_2$, $-CHDCD_3$, $-CD_2CD_3$, $-CD_2CD_2H$, $-CD_2CH_3$ und $-CD_2CDH_2$;

einer n-Propylgruppe, einer Isopropylgruppe, einer n-Butylgruppe, einer Isobutylgruppe, einer sec-Butylgruppe, einer tert-Butylgruppe, einer n-Pentylgruppe, einer Isopentylgruppe, einer sec-Pentylgruppe, einer tert-Pentylgruppe, einer Phenylgruppe und einer Naphthylgruppe; und

einer n-Propylgruppe, einer Isopropylgruppe, einer n-Butylgruppe, einer Isobutylgruppe, einer sec-Butylgruppe, einer tert-Butylgruppe, einer n-Pentylgruppe, einer Isopentylgruppe, einer sec-Pentylgruppe, einer tert-Pentylgruppe, einer Phenylgruppe und einer Naphthylgruppe, jeweils substituiert mit zumindest einem ausgewählt aus Deuterium, einer $C_1$-$C_{10}$-Alkylgruppe und einer Phenylgruppe.

**7.** Metallorganische Verbindung nach einem der Ansprüche 1-6, wobei ein Teil dargestellt durch

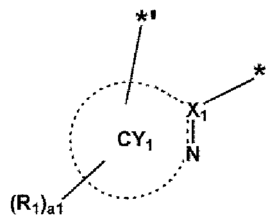

dargestellt wird durch eine von Formel A1-1(1) bis A1-1(28) und A1-2(1) bis A1-2(9):

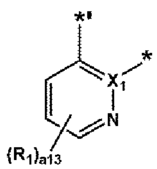
A1-1(1)

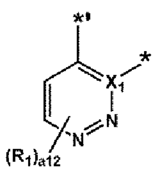
A1-1(2)

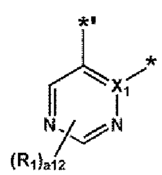
A1-1(3)

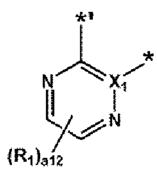
A1-1(4)

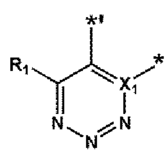
A1-1(5)

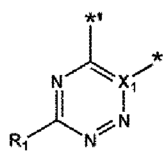
A1-1(6)

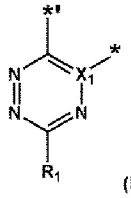
A1-1(7)

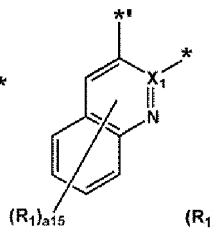
A1-1(8)

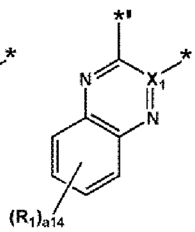
A1-1(9)

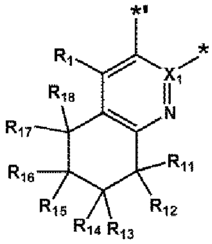
A1-1(10)

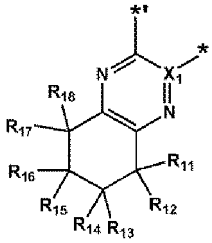
A1-1(11)

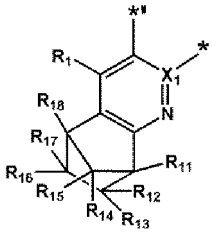
A1-1(12)

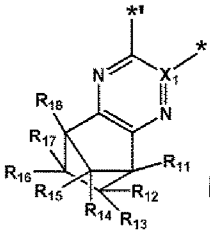
A1-1(13)

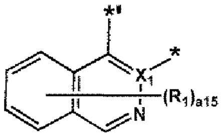
A1-1(14)

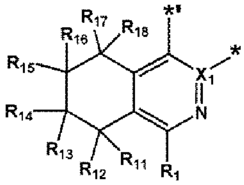
A1-1(15)

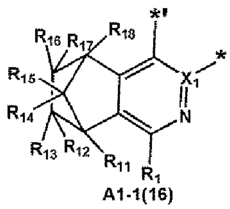
A1-1(16)

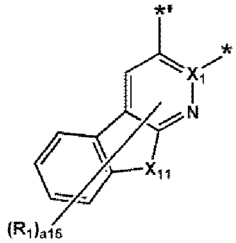
A1-1(17)

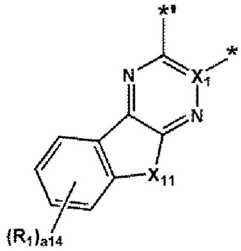
A1-1(18)

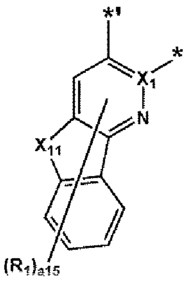
A1-1(19)

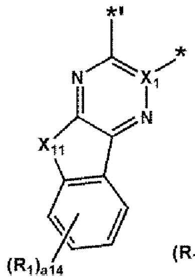
A1-1(20)

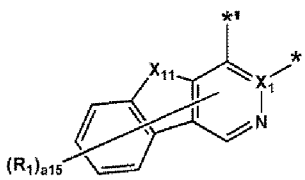
A1-1(21)

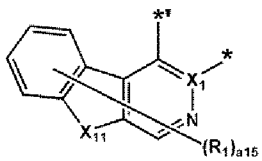
A1-1(22)

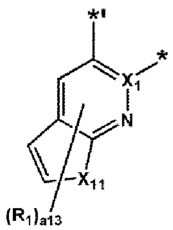
A1-1(23)

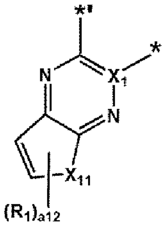
A1-1(24)

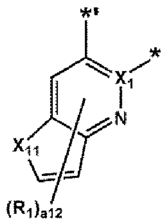
A1-1(25)

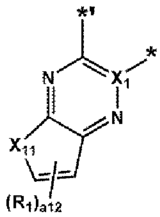
A1-1(26)

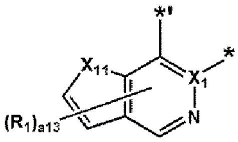
A1-1(27)

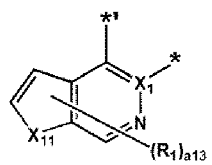
A1-1(28)

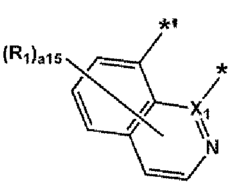
A1-2(1)

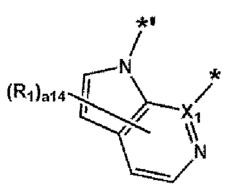
A1-2(2)

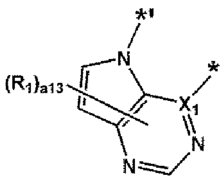
A1-2(3)

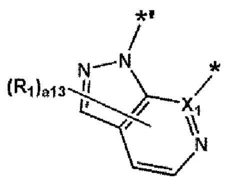
A1-2(4)

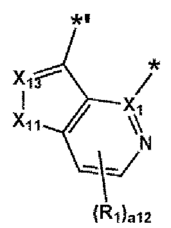
A1-2(5)

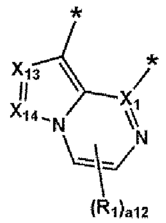
A1-2(6)

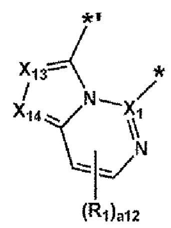
A1-2(7)

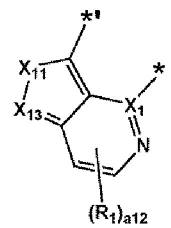
A1-2(8)

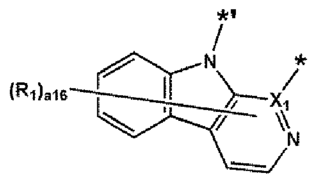
A1-2(9)

,

wobei in Formel A1-1(1) bis A1-1(28) und A1-2(1) bis A1-2(9)

$X_1$ und $R_1$ die gleichen wie in Anspruch 1 beschrieben sind,
$X_{11}$ O, S, $N(R_{11})$, $C(R_{11})(R_{12})$ oder $Si(R_{11})(R_{12})$ ist,
$X_{13}$ N oder $C(R_{13})$ ist,
$X_{14}$ N oder $C(R_{14})$ ist,
$R_{11}$ bis $R_{18}$ die gleichen wie in Verbindung mit $R_1$ in Anspruch 1 beschrieben sind,
a15 eine ganze Zahl von 0 bis 5 ist,
a14 eine ganze Zahl von 0 bis 4 ist,
a13 eine ganze Zahl von 0 bis 3 ist,
a12 eine ganze Zahl von 0 bis 2 ist,
* eine Bindungsstelle zu M in Formel 1 angibt, und
*' eine Bindungsstelle zu $T_1$ in Formel 1 angibt.

**8.** Metallorganische Verbindung nach einem der Ansprüche 1-7, wobei ein Teil dargestellt durch

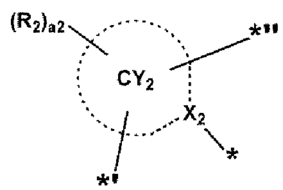

dargestellt wird durch eine von Formel A2-1(1) bis A2-1(21), A2-2(1) bis A2-2(58) und A2-3(1) bis A2-3(58):

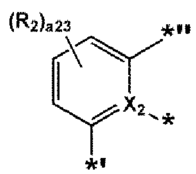
A2-1(1)

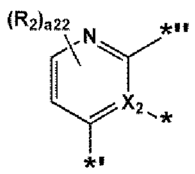
A2-1(2)

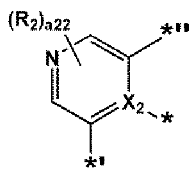
A2-1(3)

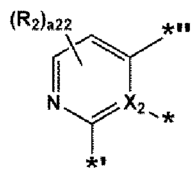
A2-1(4)

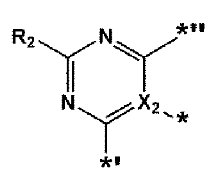
A2-1(5)

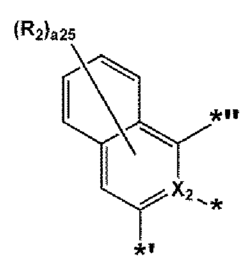
A2-1(6)

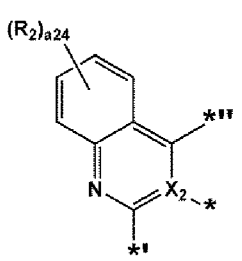
A2-1(7)

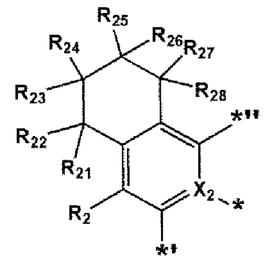
A2-1(8)

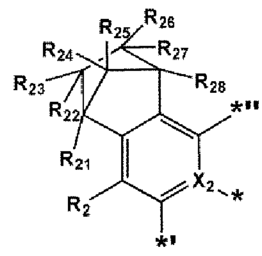
A2-1(9)

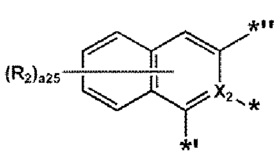
A2-1(10)

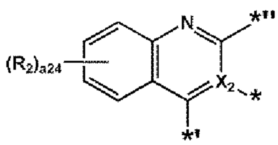
A2-1(11)

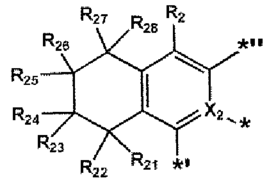
A2-1(12)

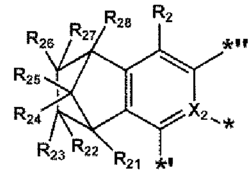
A2-1(13)

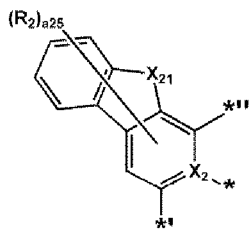
A2-1(14)

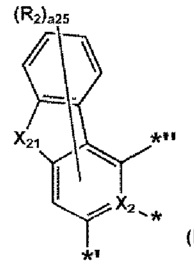
A2-1(15)

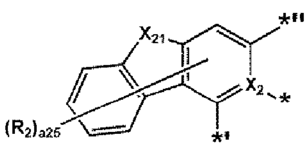
A2-1(16)

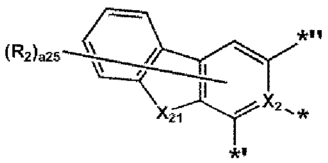
A2-1(17)

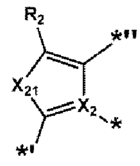
A2-1(18)

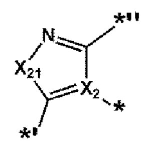
A2-1(19)

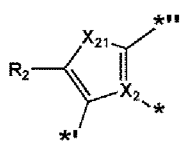
A2-1(20)

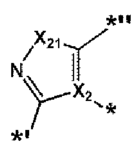
A2-1(21)

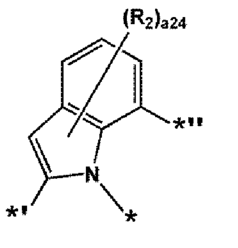
A2-2(1)

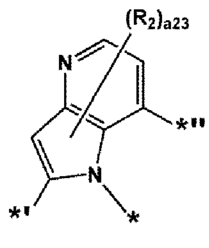
A2-2(2)

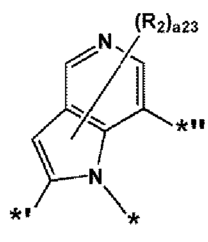
A2-2(3)

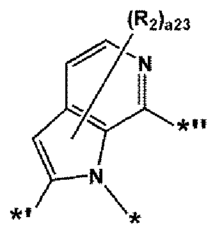
A2-2(4)

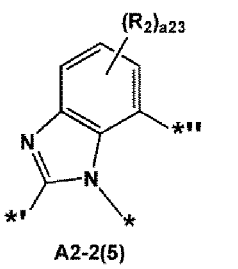
A2-2(5)

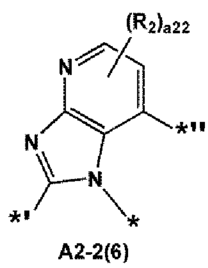
A2-2(6)

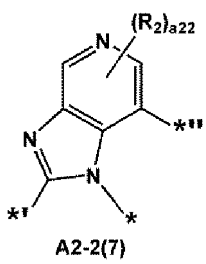
A2-2(7)

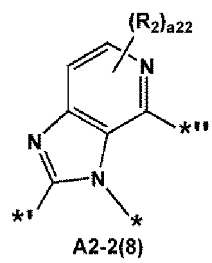
A2-2(8)

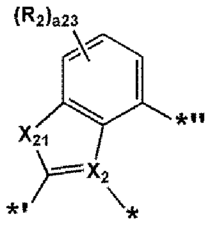
A2-2(9)

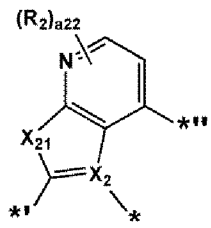
A2-2(10)

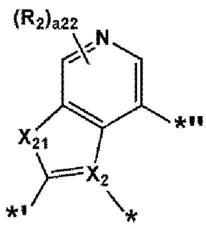
A2-2(11)

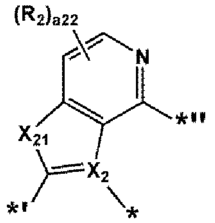
A2-2(12)

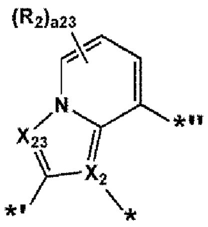
A2-2(13)

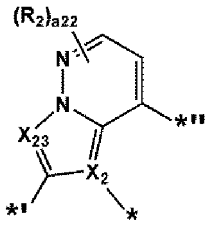
A2-2(14)

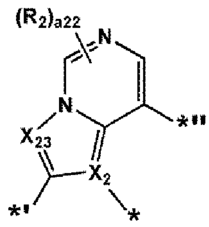
A2-2(15)

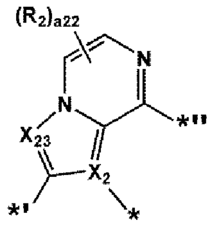
A2-2(16)

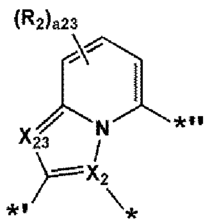
A2-2(17)

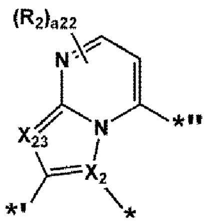
A2-2(18)

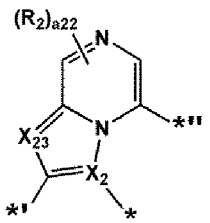
A2-2(19)

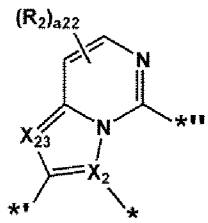
A2-2(20)

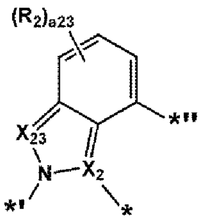
A2-2(21)

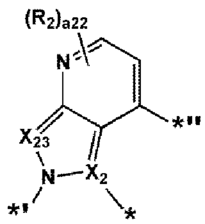
A2-2(22)

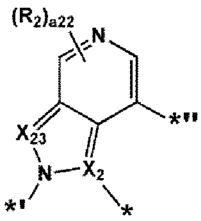
A2-2(23)

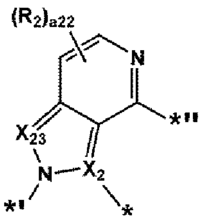
A2-2(24)

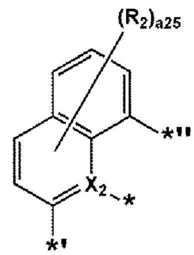
A2-2(25)

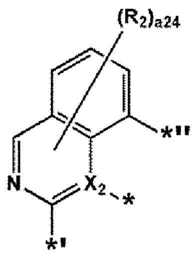
A2-2(26)

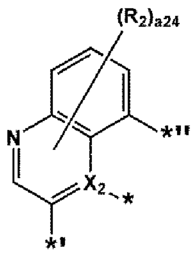
A2-2(27)

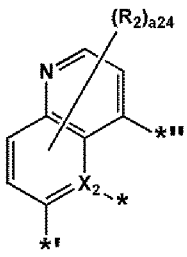
A2-2(28)

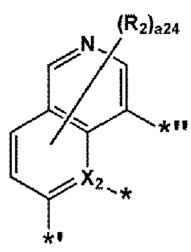
A2-2(29)

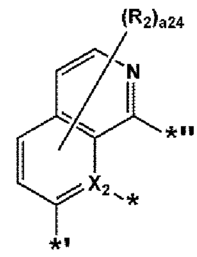
A2-2(30)

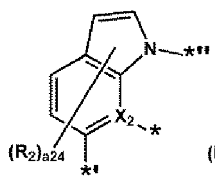
A2-2(31)

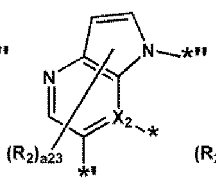
A2-2(32)

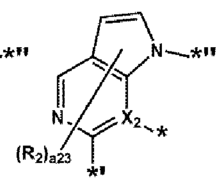
A2-2(33)

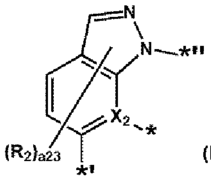
A2-2(34)

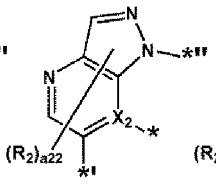
A2-2(35)

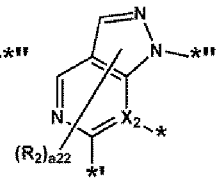
A2-2(36)

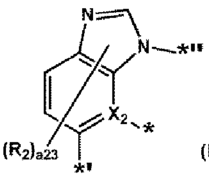
A2-2(37)

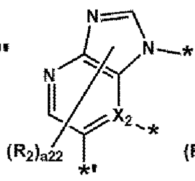
A2-2(38)

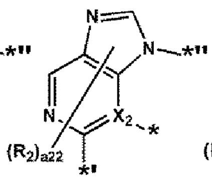
A2-2(39)

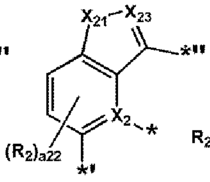
A2-2(40)

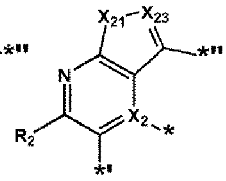
A2-2(41)

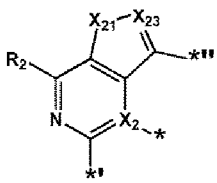
A2-2(42)

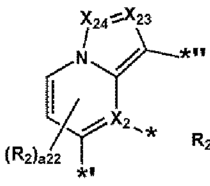
A2-2(43)

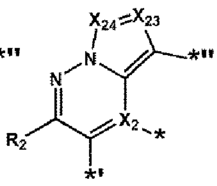
A2-2(44)

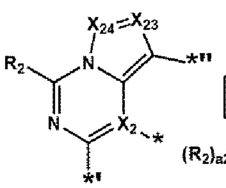
A2-2(45)

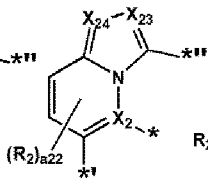
A2-2(46)

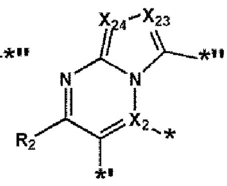
A2-2(47)

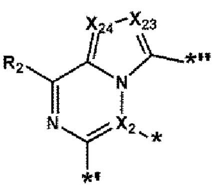
A2-2(48)

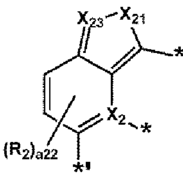
A2-2(49)

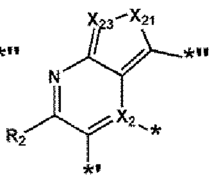
A2-2(50)

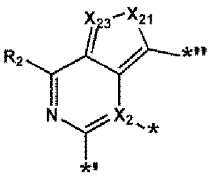
A2-2(51)

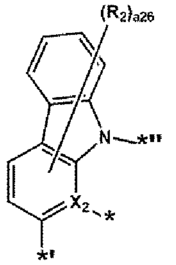
A2-2(52)

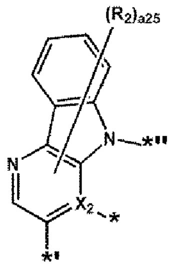
A2-2(53)

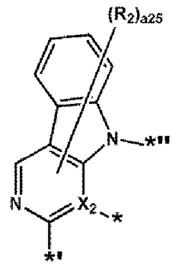
A2-2(54)

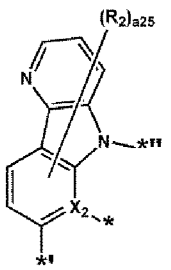
A2-2(55)

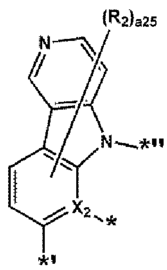
A2-2(56)

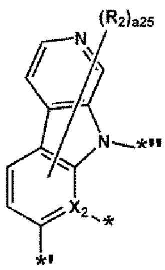
A2-2(57)

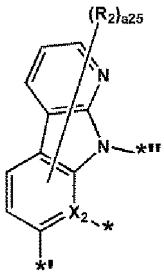
A2-2(58)

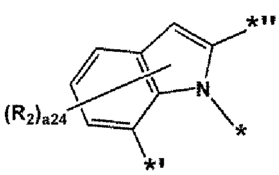
A2-3(1)

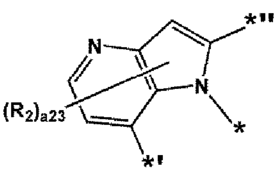
A2-3(2)

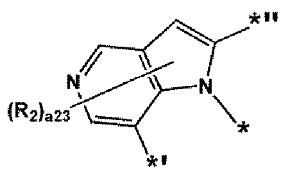
A2-3(3)

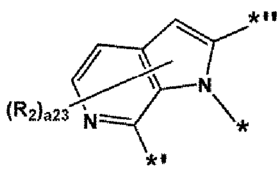
A2-3(4)

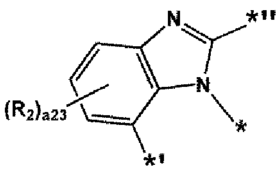
A2-3(5)

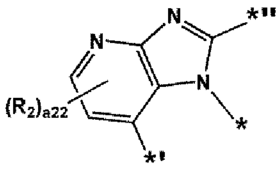
A2-3(6)

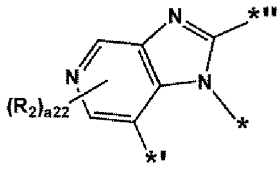
A2-3(7)

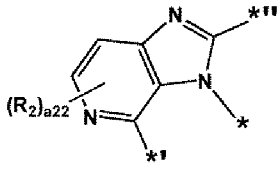
A2-3(8)

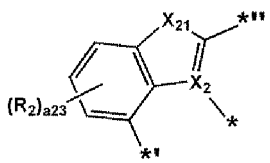
A2-3(9)

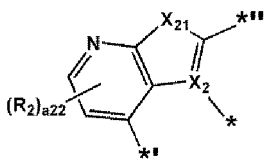
A2-3(10)

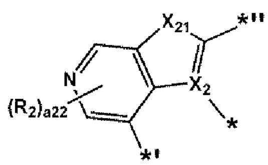
A2-3(11)

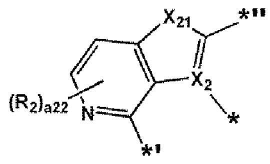
A2-3(12)

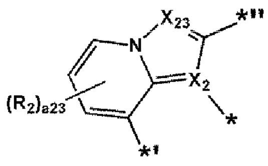
A2-3(13)

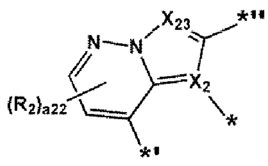
A2-3(14)

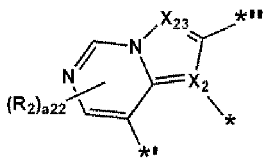
A2-3(15)

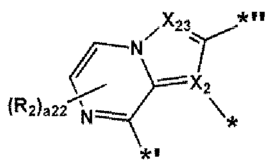
A2-3(16)

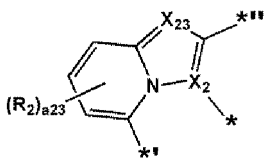
A2-3(17)

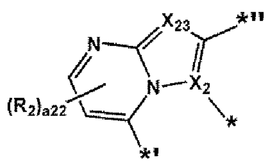
A2-3(18)

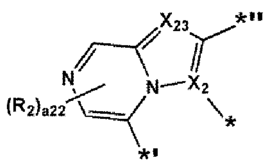
A2-3(19)

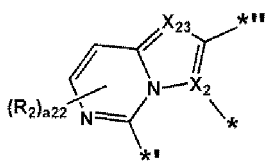
A2-3(20)

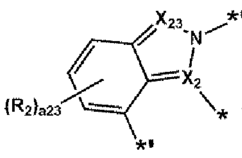
A2-3(21)

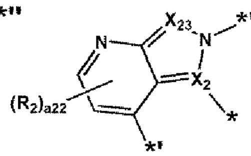
A2-3(22)

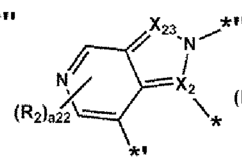
A2-3(23)

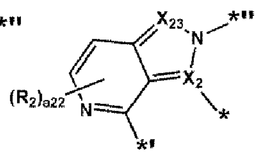
A2-3(24)

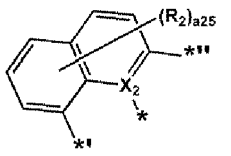
A2-3(25)

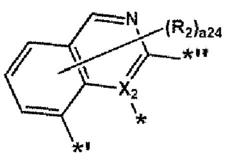
A2-3(26)

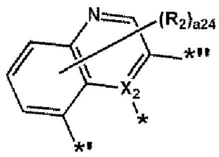
A2-3(27)

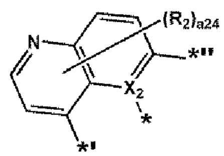
A2-3(28)

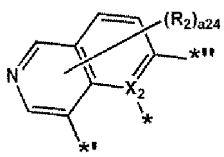
A2-3(29)

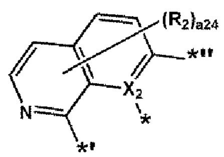
A2-3(30)

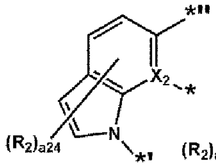
A2-3(31)

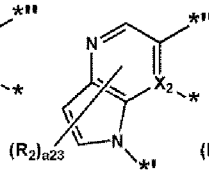
A2-3(32)

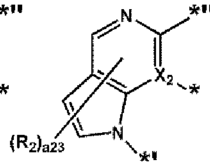
A2-3(33)

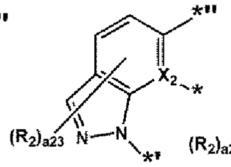
A2-3(34)

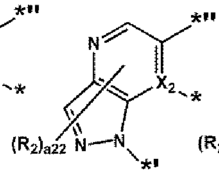
A2-3(35)

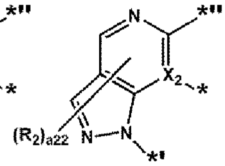
A2-3(36)

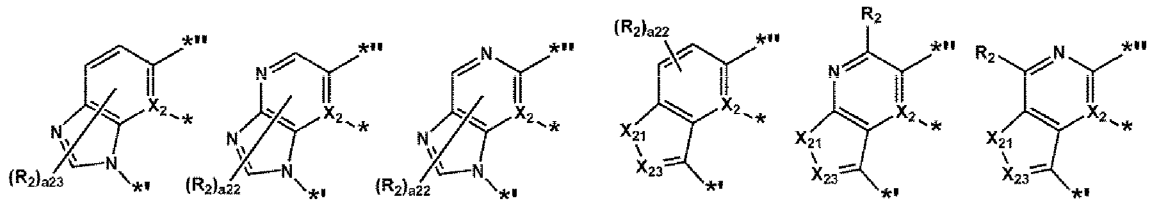

A2-3(37) A2-3(38) A2-3(39) A2-3(40) A2-3(41) A2-3(42)

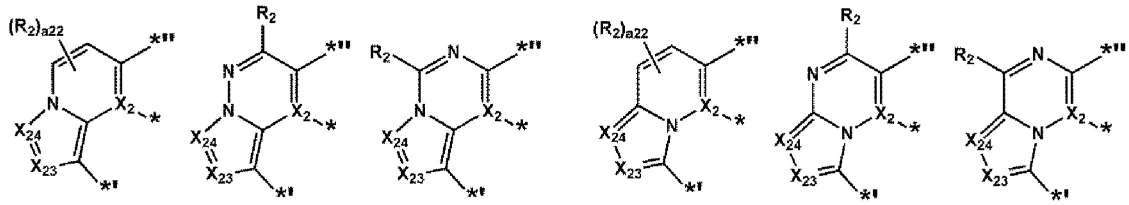

A2-3(43) A2-3(44) A2-3(45) A2-3(46) A2-3(47) A2-3(48)

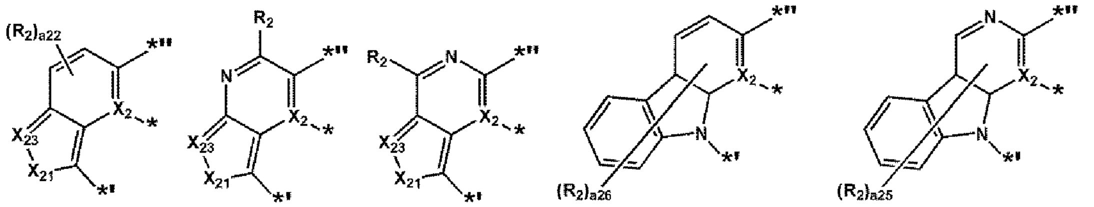

A2-3(49) A2-3(50) A2-3(51) A2-3(52) A2-3(53)

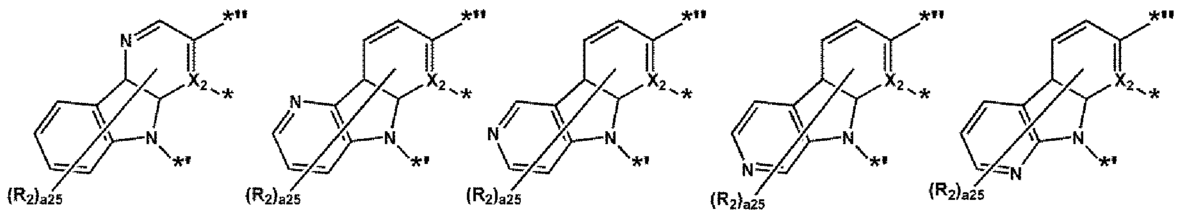

A2-3(54) A2-3(55) A2-3(56) A2-3(57) A2-3(58) ,

wobei in Formel A2-1(1) bis A2-1(21), A2-2(1) bis A2-2(58) und A2-3(1) bis A2-3(58)

$X_2$ und $R_2$ die gleichen wie in Anspruch 1 beschrieben sind,
$X_{21}$ O, S, $N(R_{21})$, $C(R_{21})(R_{22})$ oder $Si(R_{21})(R_{22})$ ist,
$X_{23}$ N oder $C(R_{23})$ ist,
$X_{24}$ N oder $C(R_{24})$ ist,
$R_{21}$ bis $R_{28}$ die gleichen wie in Verbindung mit $R_2$ in Anspruch 1 beschrieben sind,
a26 eine ganze Zahl von 0 bis 6 ist,
a25 eine ganze Zahl von 0 bis 5 ist,
a24 eine ganze Zahl von 0 bis 4 ist,
a23 eine ganze Zahl von 0 bis 3 ist,
a22 eine ganze Zahl von 0 bis 2 ist,
* eine Bindungsstelle zu $X_5$ oder M in Formel 1 angibt,
*' eine Bindungsstelle zu $T_1$ in Formel 1 angibt, und
*" eine Bindungsstelle zu $T_2$ in Formel 1 angibt.

**9.** Metallorganische Verbindung nach einem der Ansprüche 1-8, wobei ein Teil dargestellt durch

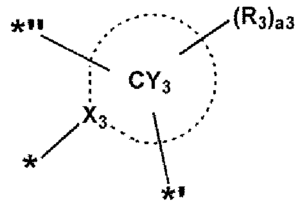

ausgewählt ist aus Gruppen dargestellt durch Formel A3-1(1) bis A3-1(21), A3-2(1) bis A3-2(58) und A3-3(1) bis A3-3(58):

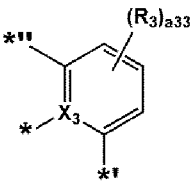
A3-1(1)

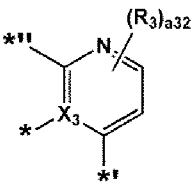
A3-1(2)

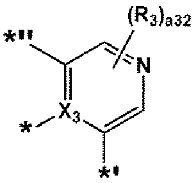
A3-1(3)

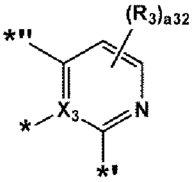
A3-1(4)

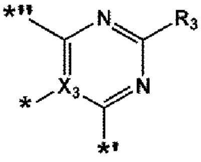
A3-1(5)

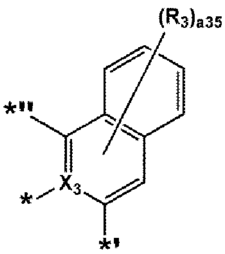
A3-1(6)

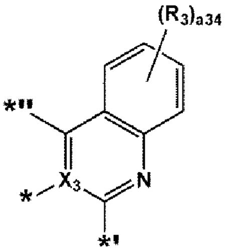
A3-1(7)

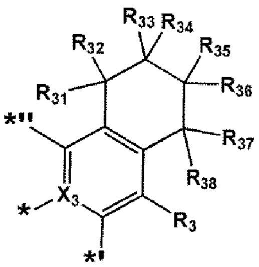
A3-1(8)

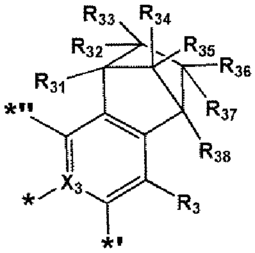
A3-1(9)

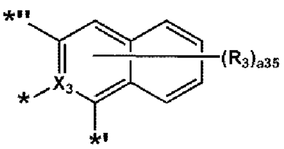
A3-1(10)

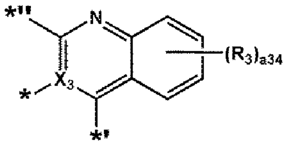
A3-1(11)

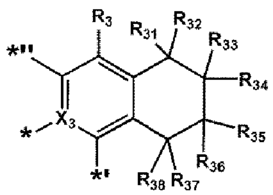
A3-1(12)

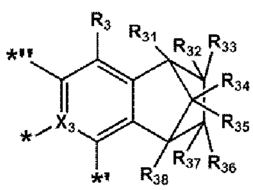
A3-1(13)

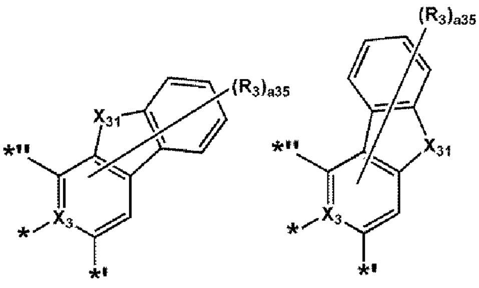
A3-1(14)

A3-1(15)

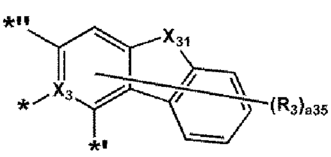
A3-1(16)

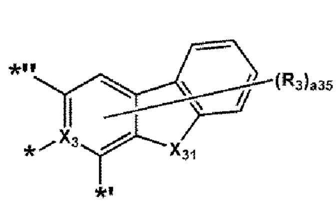
A3-1(17)

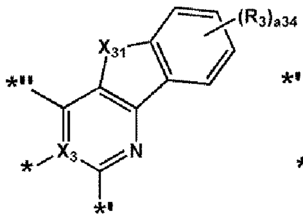
A3-1(18)

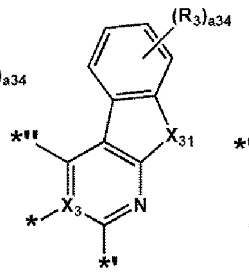
A3-1(19)

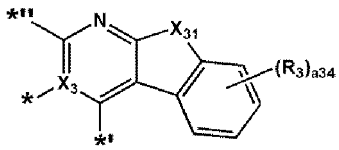
A3-1(20)

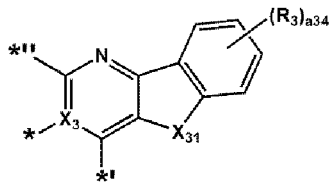
A3-1(21)

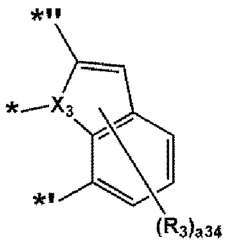
A3-2(1)

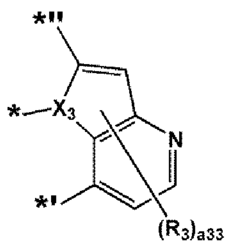
A3-2(2)

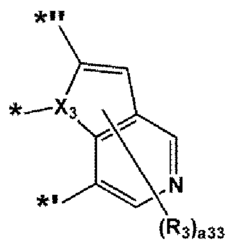
A3-2(3)

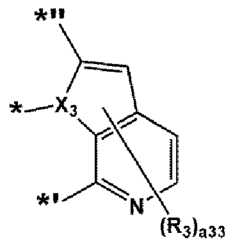
A3-2(4)

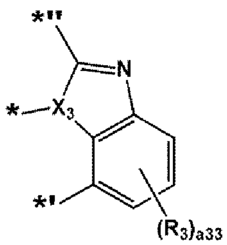
A3-2(5)

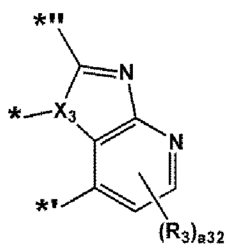
A3-2(6)

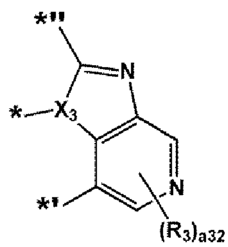
A3-2(7)

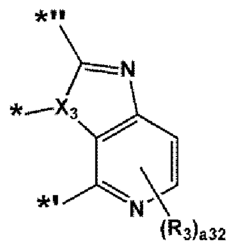
A3-2(8)

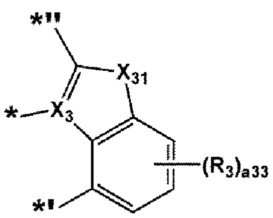
A3-2(9)

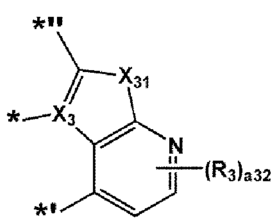
A3-2(10)

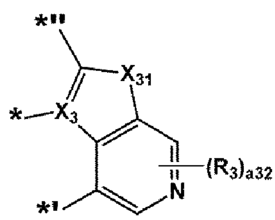
A3-2(11)

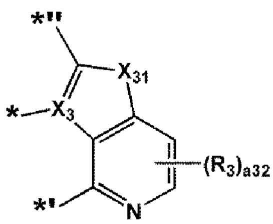
A3-2(12)

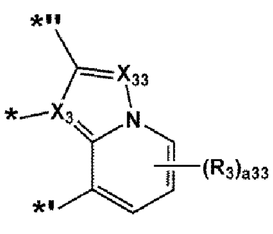
A3-2(13)

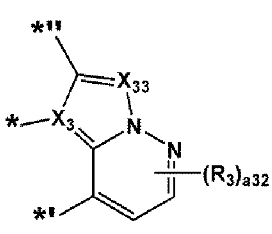
A3-2(14)

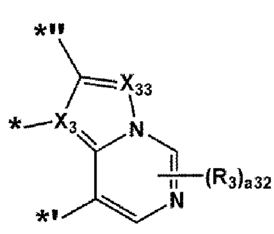
A3-2(15)

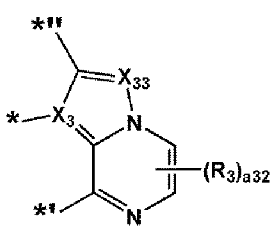
A3-2(16)

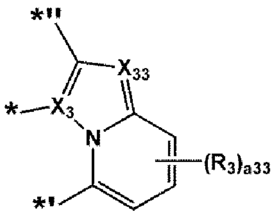
A3-2(17)

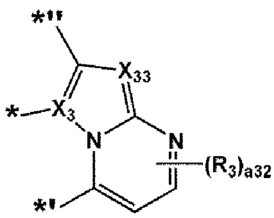
A3-2(18)

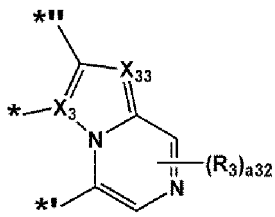
A3-2(19)

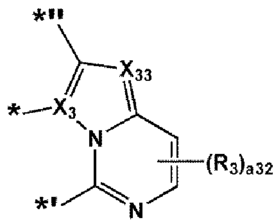
A3-2(20)

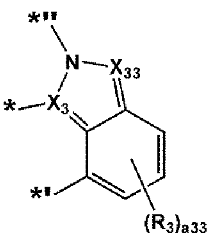
A3-2(21)

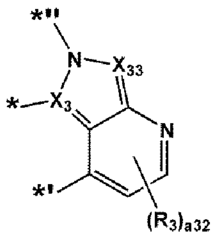
A3-2(22)

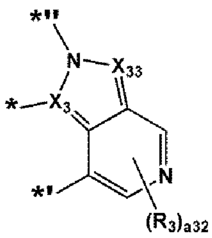
A3-2(23)

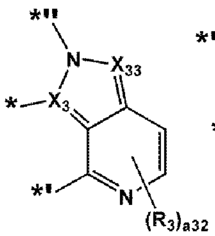
A3-2(24)

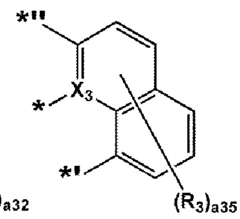
A3-2(25)

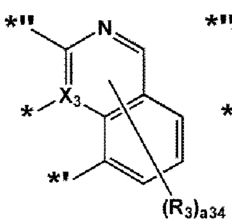
A3-2(26)

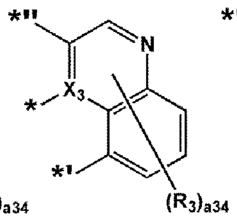
A3-2(27)

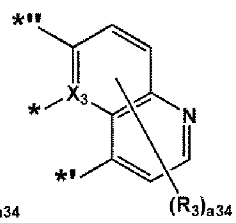
A3-2(28)

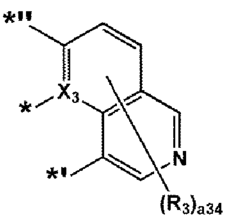
A3-2(29)

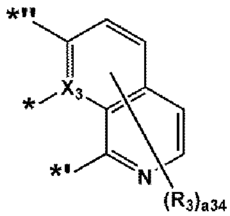
A3-2(30)

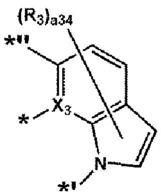
A3-2(31)

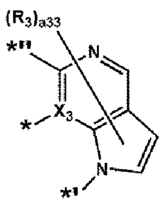
A3-2(32)

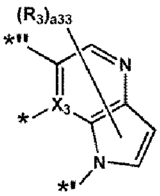
A3-2(33)

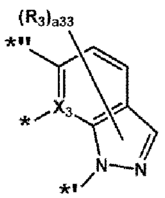
A3-2(34)

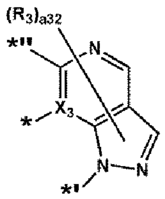
A3-2(35)

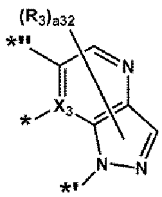
A3-2(36)

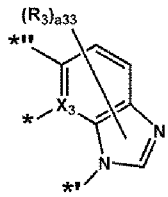
A3-2(37)

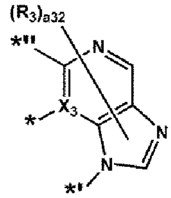
A3-2(38)

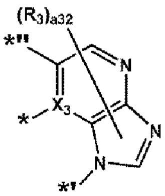
A3-2(39)

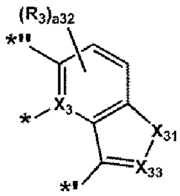
A3-2(40)

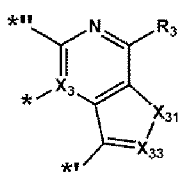
A3-2(41)

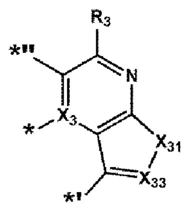
A3-2(42)

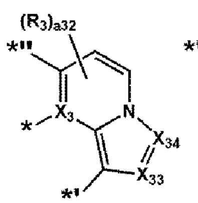
A3-2(43)

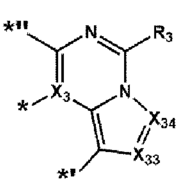
A3-2(44)

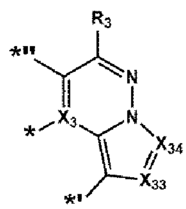
A3-2(45)

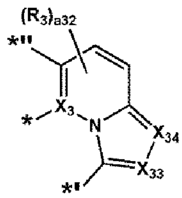
A3-2(46)

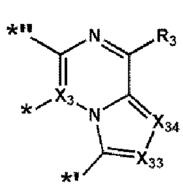
A3-2(47)

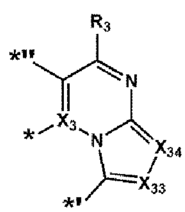
A3-2(48)

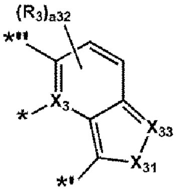
A3-2(49)

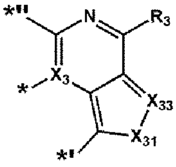
A3-2(50)

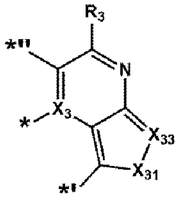
A3-2(51)

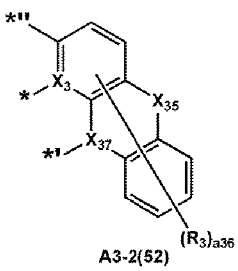
A3-2(52)

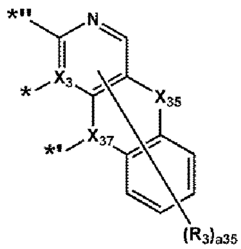
A3-2(53)

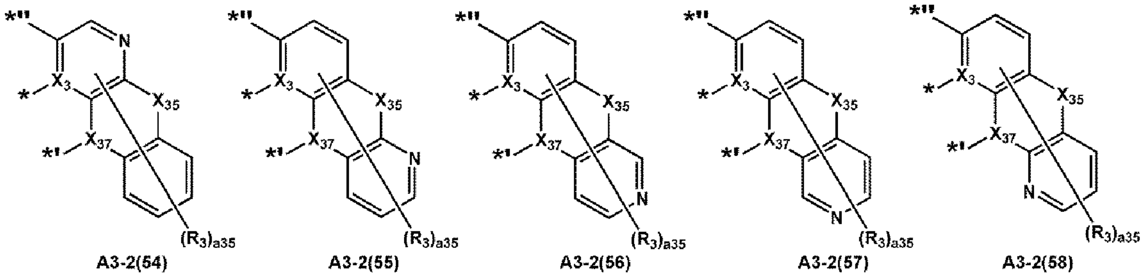
A3-2(54) A3-2(55) A3-2(56) A3-2(57) A3-2(58)

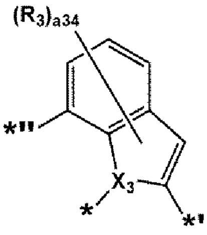
A3-3(1)

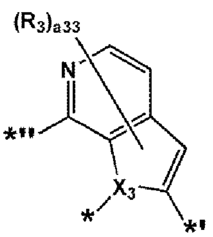
A3-3(2)

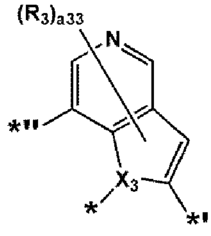
A3-3(3)

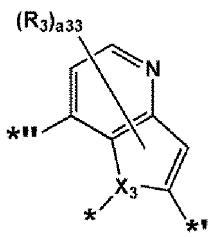
A3-3(4)

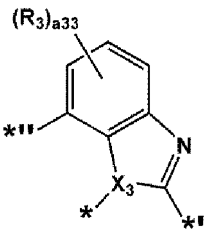
A3-3(5)

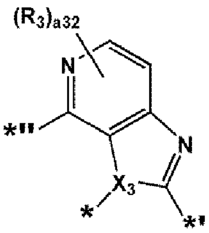
A3-3(6)

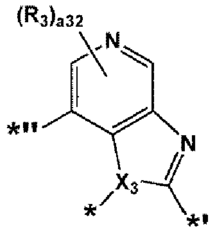
A3-3(7)

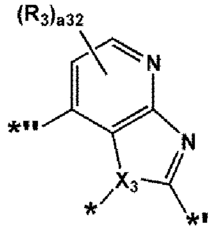
A3-3(8)

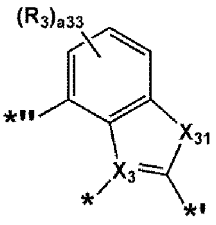
A3-3(9)

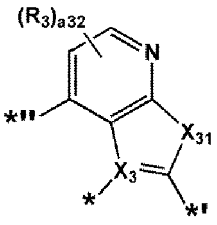
A3-3(10)

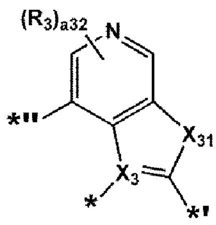
A3-3(11)

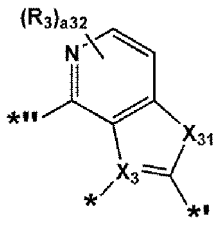
A3-3(12)

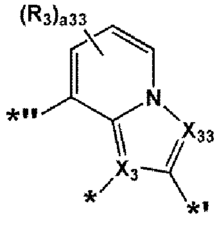
A3-3(13)

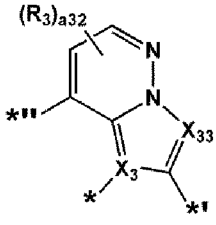
A3-3(14)

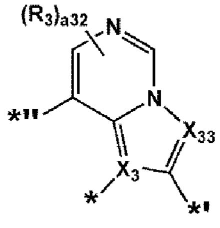
A3-3(15)

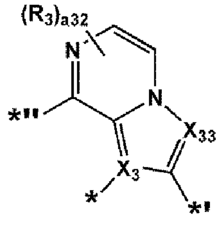
A3-3(16)

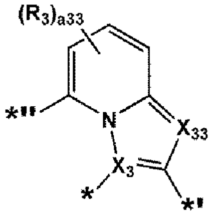
A3-3(17)

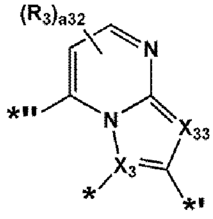
A3-3(18)

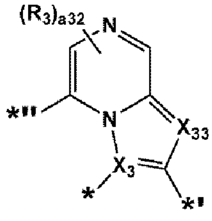
A3-3(19)

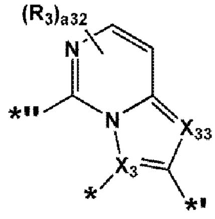
A3-3(20)

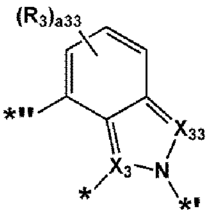
A3-3(21)

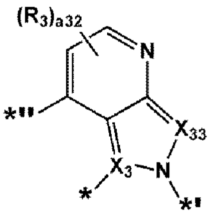
A3-3(22)

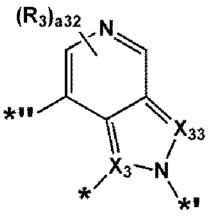
A3-3(23)

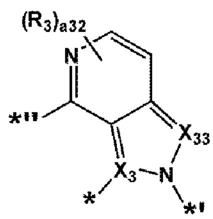
A3-3(24)

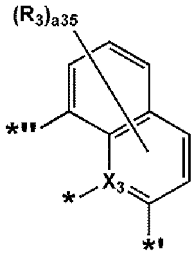
A3-3(25)

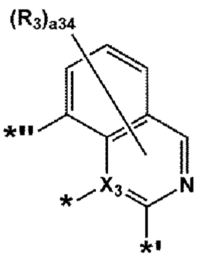
A3-3(26)

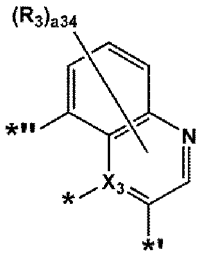
A3-3(27)

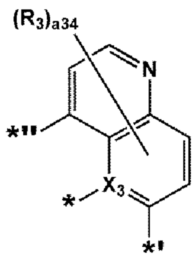
A3-3(28)

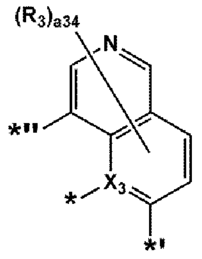
A3-3(29)

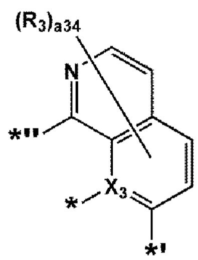
A3-3(30)

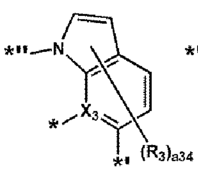
A3-3(31)

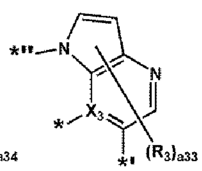
A3-3(32)

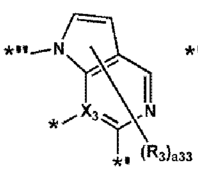
A3-3(33)

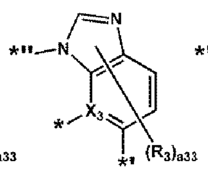
A3-3(34)

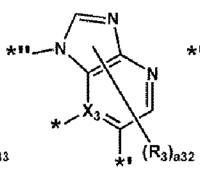
A3-3(35)

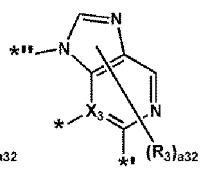
A3-3(36)

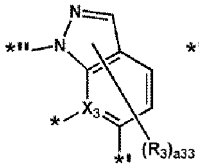
A3-3(37)

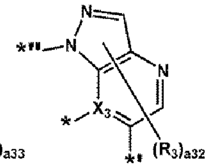
A3-3(38)

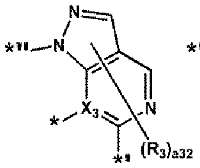
A3-3(39)

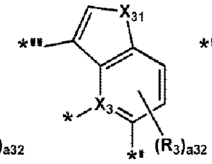
A3-3(40)

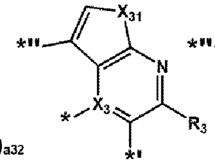
A3-3(41)

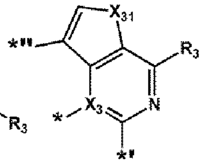
A3-3(42)

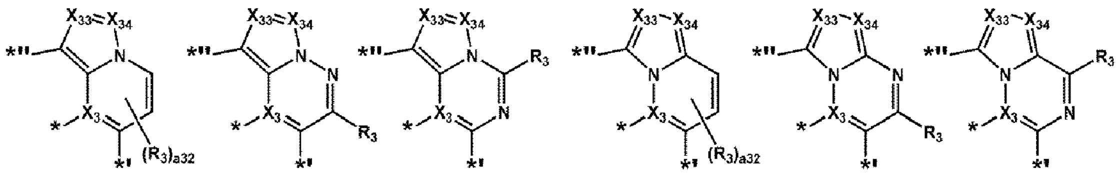

A3-3(43) A3-3(44) A3-3(45) A3-3(46) A3-3(47) A3-3(48)

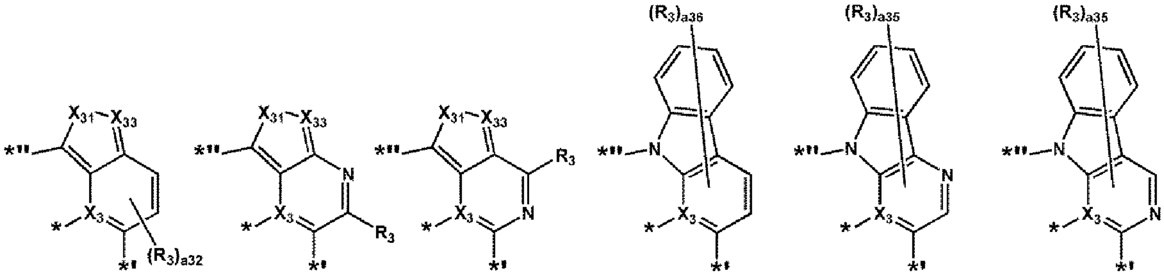

A3-3(49) A3-3(50) A3-3(51) A3-3(52) A3-3(53) A3-3(54)

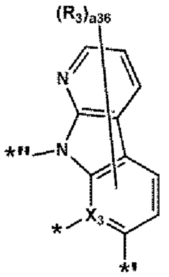

A3-3(55)

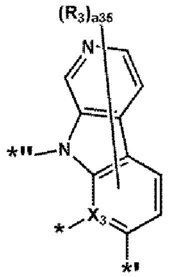

A3-3(56)

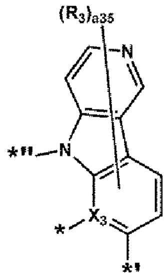

A3-3(57)

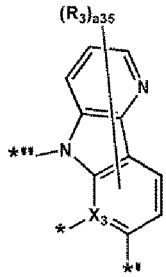

A3-3(58)

wobei in Formel A3-1(1) bis A3-1(21), A3-2(1) bis A3-2(58) und A3-3(1) bis A3-3(58)

$X_3$ und $R_3$ die gleichen wie in Anspruch 1 beschrieben sind,
$X_{31}$ O, S, $N(R_{31})$, $C(R_{31})(R_{32})$, oder $Si(R_{31})(R_{32})$ ist,
$X_{33}$ N oder $C(R_{33})$ ist,
$X_{34}$ N oder $C(R_{34})$ ist,
$X_{35}$ O, S, $N(R_{35})$, $C(R_{35})(R_{36})$ oder $Si(R_{35})(R_{36})$ ist,
$X_{37}$ N oder $C(R_{37})$ ist,
$R_{31}$ bis $R_{38}$ die gleichen wie in Verbindung mit $R_3$ in Anspruch 1 beschrieben sind,
a36 eine ganze Zahl von 0 bis 6 ist,
a35 eine ganze Zahl von 0 bis 5 ist,
a34 eine ganze Zahl von 0 bis 4 ist,
a33 eine ganze Zahl von 0 bis 3 ist,
a32 eine ganze Zahl von 0 bis 2 ist,
*" eine Bindungsstelle zu $T_2$ in Formel 1 angibt,
* eine Bindungsstelle zu $X_6$ oder M in Formel 1 angibt, und
*' eine Bindungsstelle zu $T_3$ in Formel 1 angibt.

**10.** Metallorganische Verbindung nach einem der Ansprüche 1-9, wobei ein Teil dargestellt durch

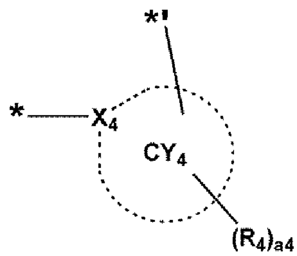

ausgewählt ist aus Gruppen dargestellt durch Formel A4-1(1) bis A4-1(51) und A4-2(1) bis A4-2(71):

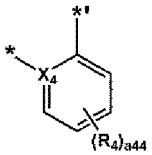
A4-1(1)

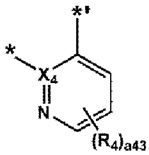
A4-1(2)

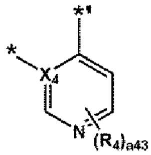
A4-1(3)

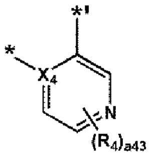
A4-1(4)

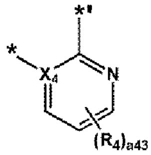
A4-1(5)

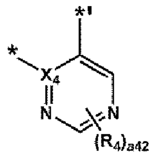
A4-1(6)

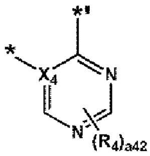
A4-1(7)

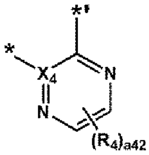
A4-1(8)

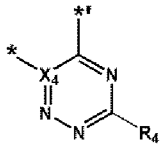
A4-1(9)

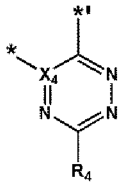
A4-1(10)

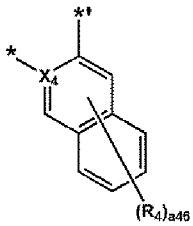
A4-1(11)

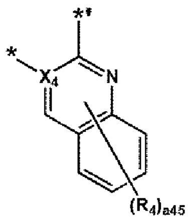
A4-1(12)

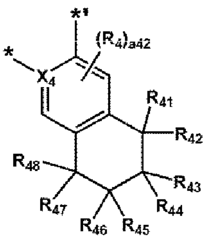
A4-1(13)

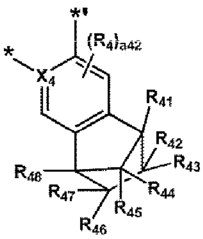
A4-1(14)

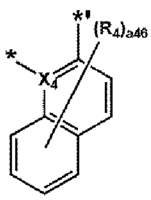
A4-1(15)

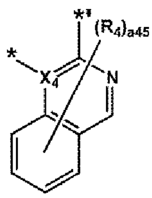
A4-1(16)

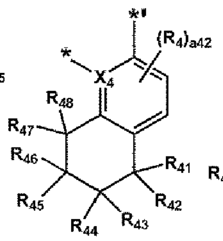
A4-1(17)

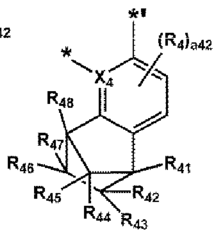
A4-1(18)

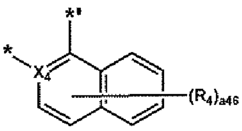
A4-1(19)

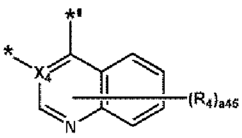
A4-1(20)

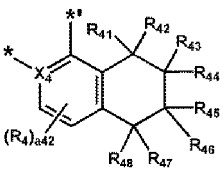
A4-1(21)

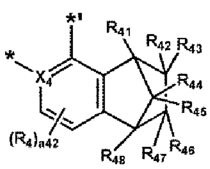
A4-1(22)

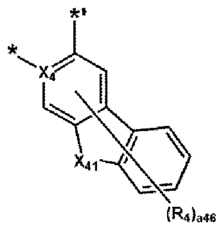
A4-1(23)

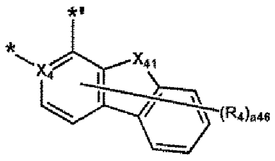
A4-1(24)

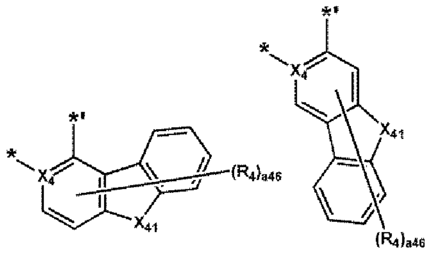
A4-1(25)

A4-1(26)

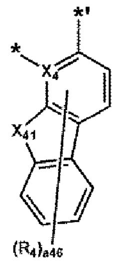
A4-1(27)

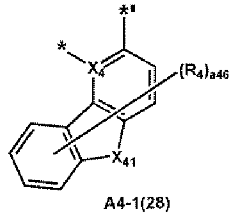
A4-1(28)

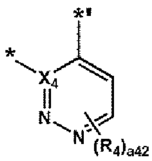
A4-1(29)

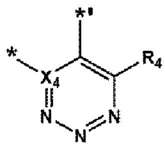
A4-1(30)

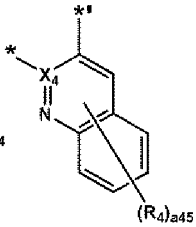
A4-1(31)

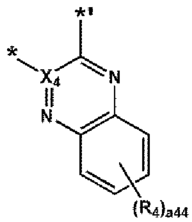
A4-1(32)

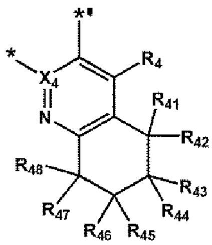
A4-1(33)

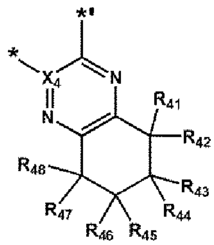
A4-1(34)

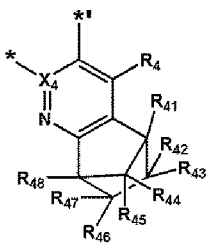
A4-1(35)

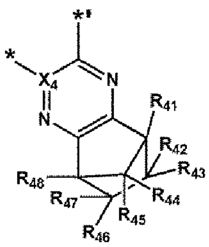
A4-1(36)

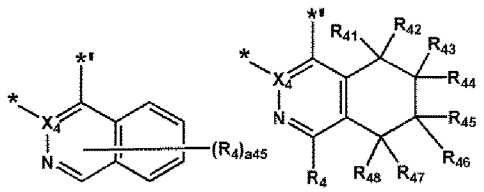
A4-1(37)

A4-1(38)

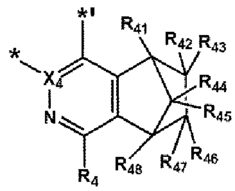
A4-1(39)

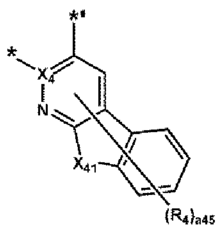
A4-1(40)

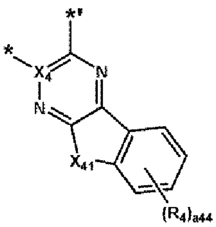
A4-1(41)

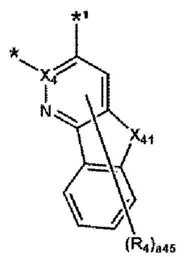
A4-1(42)

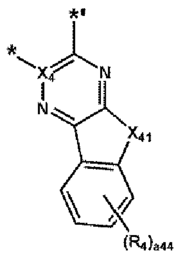
A4-1(43)

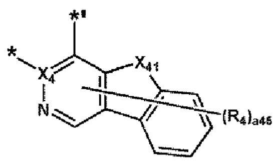
A4-1(44)

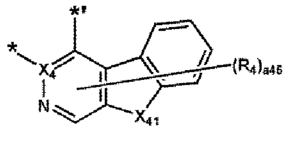
A4-1(45)

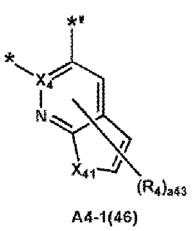
A4-1(46)

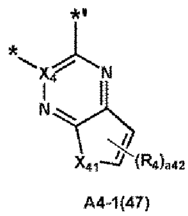
A4-1(47)

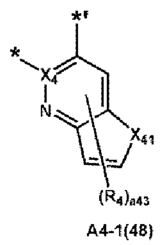
A4-1(48)

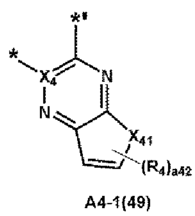
A4-1(49)

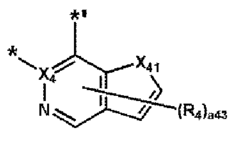
A4-1(50)

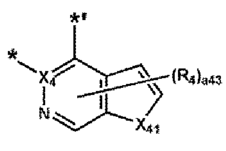
A4-1(51)

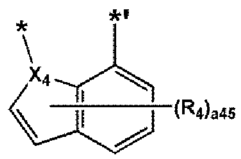

A4-2(1)

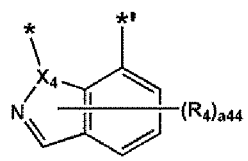

A4-2(2)

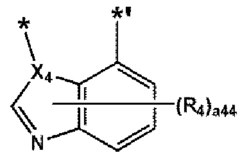

A4-2(3)

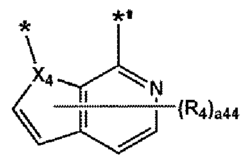

A4-2(4)

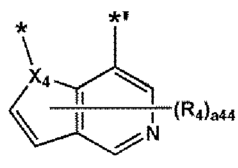

A4-2(5)

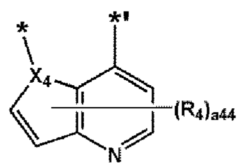

A4-2(6)

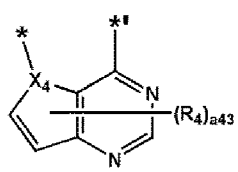

A4-2(7)

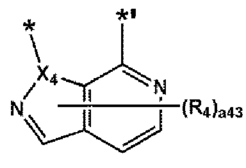

A4-2(8)

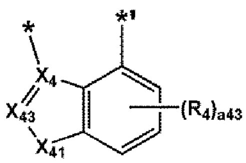

A4-2(9)

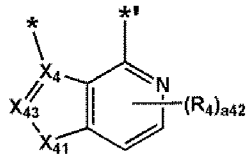

A4-2(10)

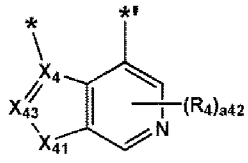

A4-2(11)

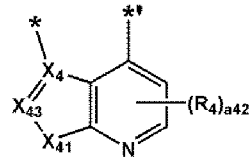

A4-2(12)

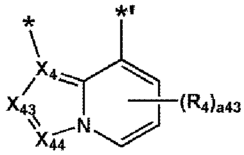

A4-2(13)

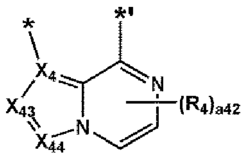

A4-2(14)

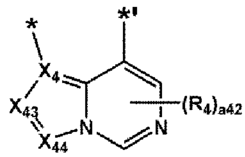

A4-2(15)

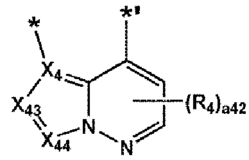

A4-2(16)

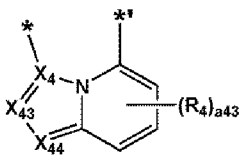

A4-2(17)

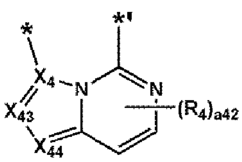

A4-2(18)

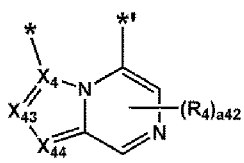

A4-2(19)

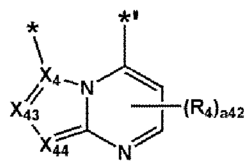

A4-2(20)

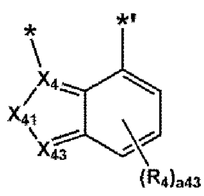

A4-2(21)

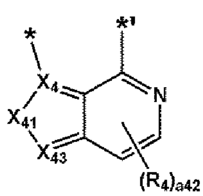

A4-2(22)

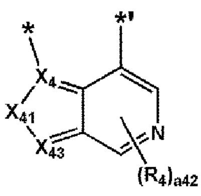

A4-2(23)

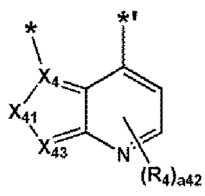

A4-2(24)

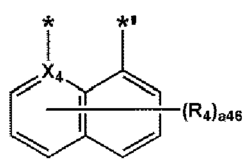

A4-2(25)

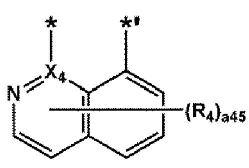

A4-2(26)

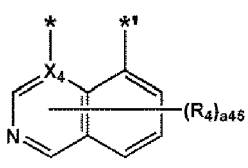

A4-2(27)

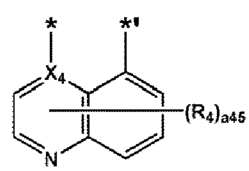

A4-2(28)

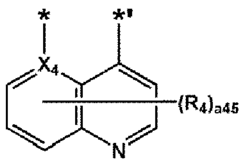
A4-2(29)

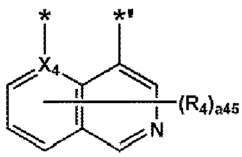
A4-2(30)

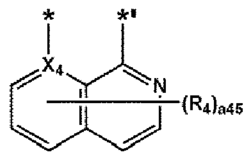
A4-2(31)

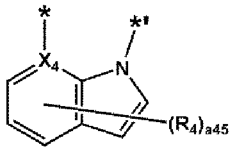
A4-2(32)

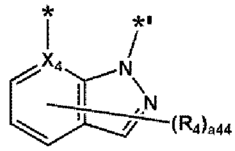
A4-2(33)

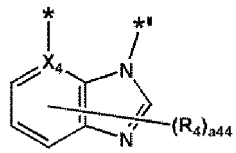
A4-2(34)

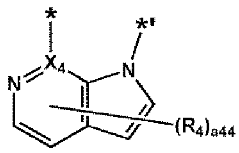
A4-2(35)

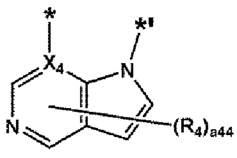
A4-2(36)

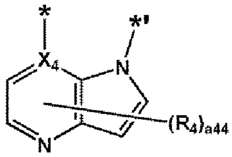
A4-2(37)

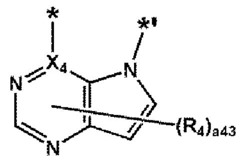
A4-2(38)

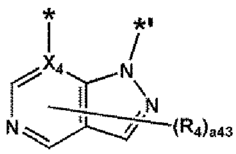
A4-2(39)

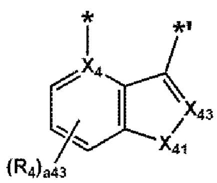
A4-2(40)

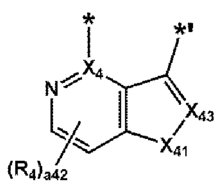
A4-2(41)

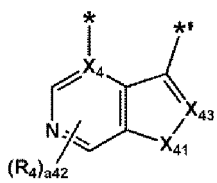
A4-2(42)

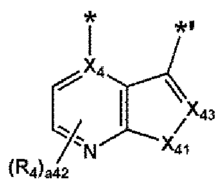
A4-2(43)

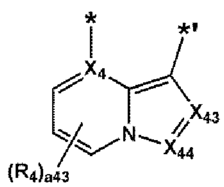
A4-2(44)

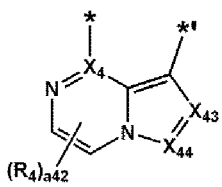
A4-2(45)

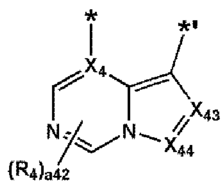
A4-2(46)

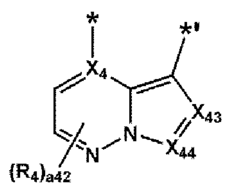
A4-2(47)

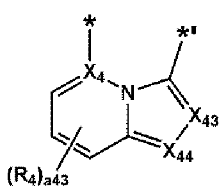
A4-2(48)

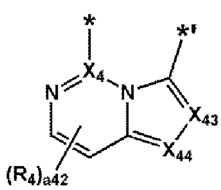
A4-2(49)

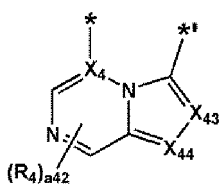
A4-2(50)

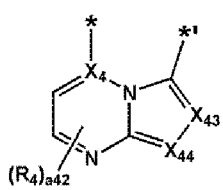
A4-2(51)

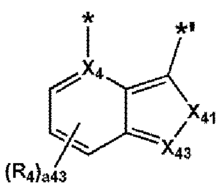
A4-2(52)

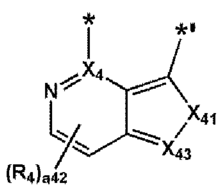
A4-2(53)

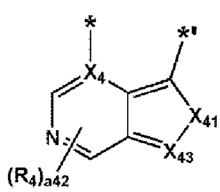
A4-2(54)

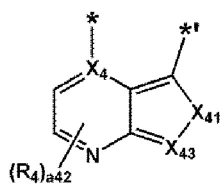
A4-2(55)

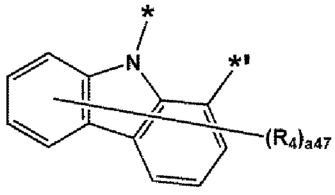

**A4-2(56)**

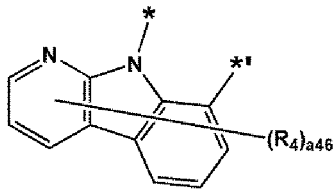

**A4-2(57)**

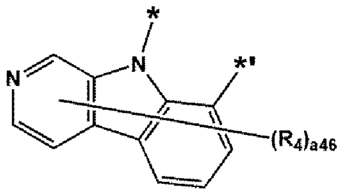

**A4-2(58)**

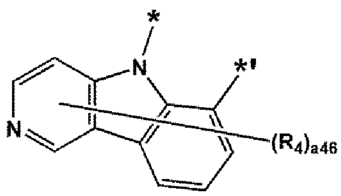

**A4-2(59)**

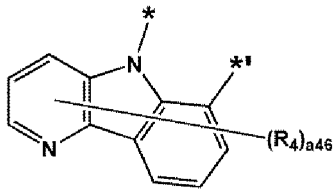

**A4-2(60)**

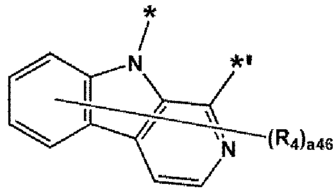

**A4-2(61)**

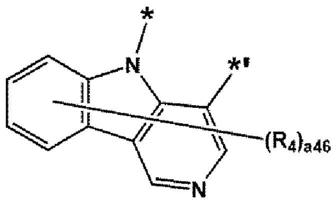

**A4-2(62)**

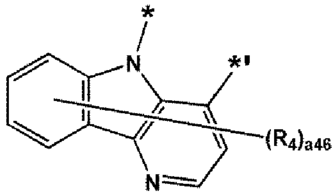

**A4-2(63)**

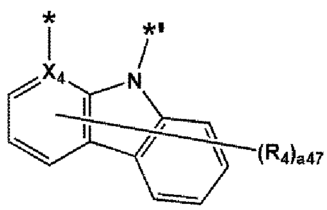

**A4-2(64)**

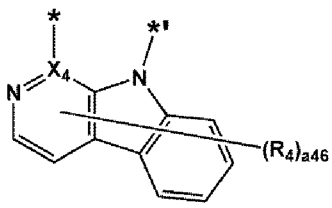

**A4-2(65)**

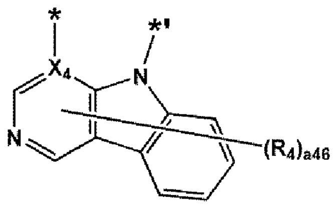

**A4-2(66)**

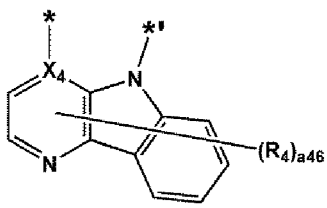

**A4-2(67)**

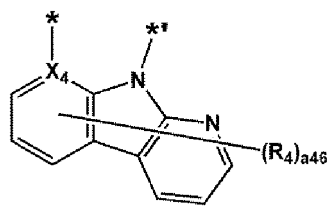

**A4-2(68)**

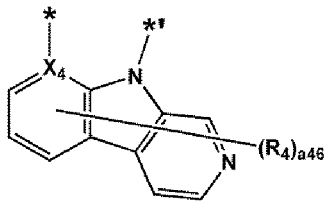

**A4-2(69)**

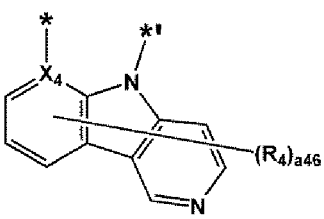

**A4-2(70)**

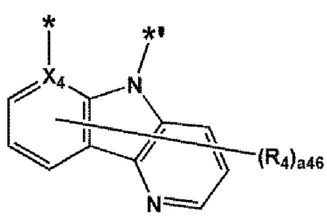

**A4-2(71)**

,

wobei in Formel A4-1(1) bis A4-1(51) und A4-2(1) bis A4-2(71),
$X_4$ und $R_4$ die gleichen wie in Anspruch 1 beschrieben sind,
$X_{41}$ O, S, $N(R_{41})$, $C(R_{41})(R_{42})$ oder $Si(R_{41})(R_{42})$ ist,
$X_{43}$ N oder $C(R_{43})$ ist,

$X_{44}$ N oder $C(R_{44})$ ist,
$R_{41}$ bis $R_{48}$ die gleichen wie in Verbindung mit $R_4$ in Anspruch 1 beschrieben sind,
a47 eine ganze Zahl von 0 bis 7 ist,
a46 eine ganze Zahl von 0 bis 6 ist,
a45 eine ganze Zahl von 0 bis 5 ist,
a44 eine ganze Zahl von 0 bis 4 ist,
a43 eine ganze Zahl von 0 bis 3 ist,
a42 eine ganze Zahl von 0 bis 2 ist,
* eine Bindungsstelle zu $X_7$ oder M in Formel 1 angibt, und
*' eine Bindungsstelle zu $T_3$ in Formel 1 angibt.

**11.** Metallorganische Verbindung nach einem der Ansprüche 1-10, wobei
die metallorganische Verbindung eine linear symmetrische Struktur in Bezug auf eine symmetrische Achse aufweist, die M und $T_2$ in Formel 1 verbindet; und/oder
wobei
die metallorganische Verbindung dargestellt ist durch Formel 1A:

Formel 1A

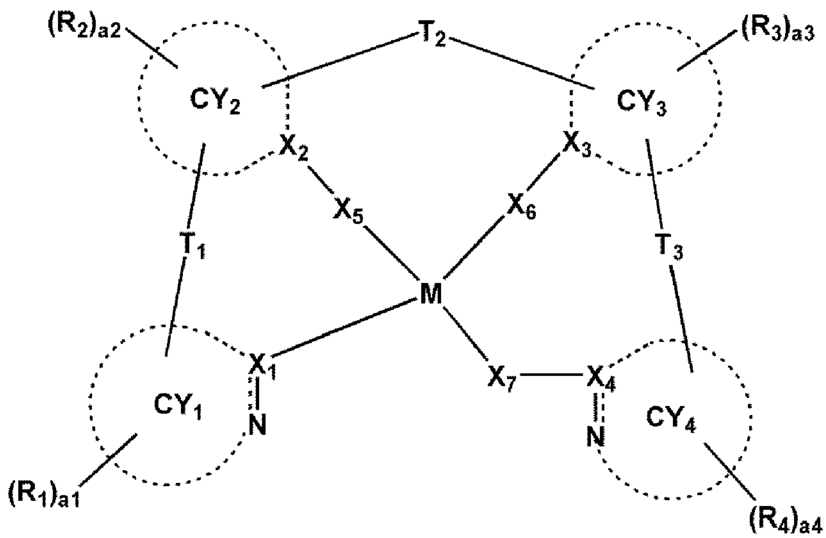

,

wobei in Formel 1A M, $X_1$ bis $X_7$, Ring $CY_1$ bis Ring $CY_3$, $T_1$ bis $T_3$, $R_1$ bis $R_4$ und a1 bis a4 die gleichen wie in Anspruch 1 beschrieben sind, und Ring $CY_4$ eine heterocyclische $C_1$-$C_{30}$-Gruppe ist, die zumindest ein N-Atom als ringbildendes Atom aufweist; und/oder
wobei
die metallorganische Verbindung dargestellt ist durch Formel 1A(1):

Formel 1A(1)

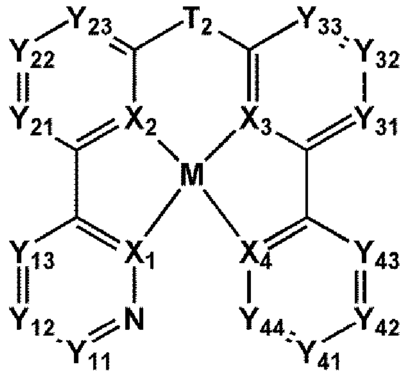

,

wobei in Formel 1A(1)

M, $X_1$ bis $X_4$ und $T_2$ die gleichen wie in Anspruch 1 beschrieben sind,
$Y_{11}$ $C(Z_{11})$ oder N ist, $Y_{12}$ $C(Z_{12})$ oder N ist, $Y_{13}$ $C(Z_{13})$ oder N ist, $Y_{21}$ $C(Z_{21})$ oder N ist, $Y_{22}$ $C(Z_{22})$ oder N ist, $Y_{23}$ $C(Z_{23})$ oder N ist, $Y_{31}$ $C(Z_{31})$ oder N ist, $Y_{32}$ $C(Z_{32})$ oder N ist, $Y_{33}$ $C(Z_{33})$ oder N ist, $Y_{41}$ $C(Z_{41})$ oder N ist, $Y_{42}$ $C(Z_{42})$ oder N ist, $Y_{43}$ $C(Z_{43})$ oder N ist, und $Y_{44}$ $C(Z_{44})$ oder N ist,
$Z_{11}$ bis $Z_{13}$ die gleichen wie in Verbindung mit $R_1$ in Anspruch 1 beschrieben sind, und zumindest zwei von $Z_{11}$ bis $Z_{13}$ optional verbunden sind, um eine carbocyclische $C_5$-$C_{30}$-Gruppe, die unsubstituiert oder mit zumindest einem $R_{10a}$ substituiert ist, oder eine heterocyclische $C_1$-$C_{30}$-Gruppe zu bilden, die unsubstituiert oder mit zumindest einem $R_{10a}$ substituiert ist,
$Z_{21}$ bis $Z_{23}$ die gleichen wie in Verbindung mit $R_2$ in Anspruch 1 beschrieben sind, und zumindest zwei von $Z_{21}$ bis $Z_{23}$ optional verbunden sind, um eine carbocyclische $C_5$-$C_{30}$-Gruppe, die unsubstituiert oder mit zumindest einem $R_{10a}$ substituiert ist, oder eine heterocyclische $C_1$-$C_{30}$-Gruppe zu bilden, die unsubstituiert oder mit zumindest einem $R_{10a}$ substituiert ist,
$Z_{31}$ bis $Z_{33}$ die gleichen wie in Verbindung mit $R_3$ in Anspruch 1 beschrieben sind, und zumindest zwei von $Z_{31}$ bis $Z_{33}$ optional verbunden sind, um eine carbocyclische $C_5$-$C_{30}$-Gruppe, die unsubstituiert oder mit zumindest einem $R_{10a}$ substituiert ist, oder eine heterocyclische $C_1$-$C_{30}$-Gruppe zu bilden, die unsubstituiert oder mit zumindest einem $R_{10a}$ substituiert ist,
$Z_{41}$ bis $Z_{44}$ die gleichen wie in Verbindung mit $R_4$ in Anspruch 1 beschrieben sind, und zumindest zwei von $Z_{41}$ bis $Z_{44}$ optional verbunden sind, um eine carbocyclische $C_5$-$C_{30}$-Gruppe, die unsubstituiert oder mit zumindest einem $R_{10a}$ substituiert ist, oder eine heterocyclische $C_1$-$C_{30}$-Gruppe zu bilden, die unsubstituiert oder mit zumindest einem $R_{10a}$ substituiert ist, und
$R_{10a}$ das gleiche wie in Verbindung mit $R_1$ in Anspruch 1 beschrieben ist.

**12.** Metallorganische Verbindung nach einem der Ansprüche 1-11, wobei die metallorganische Verbindung eine Verbindung ist, die ausgewählt ist aus den Verbindungen 1 bis 16:

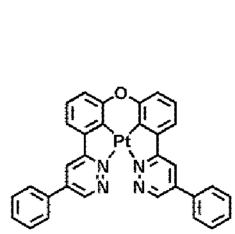

1

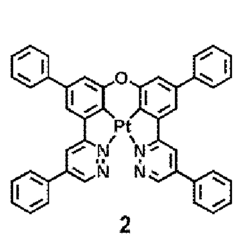

2

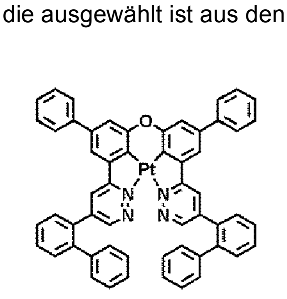

3

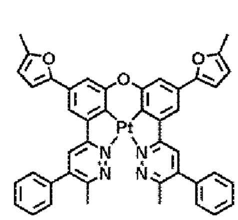

4

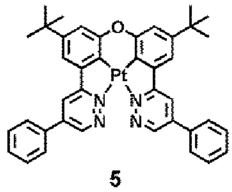
5

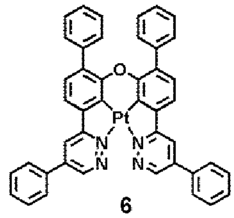
6

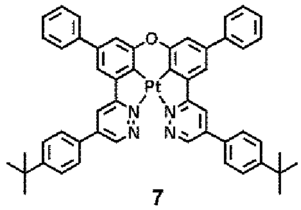
7

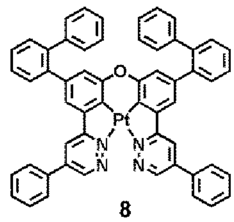
8

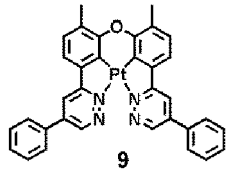
9

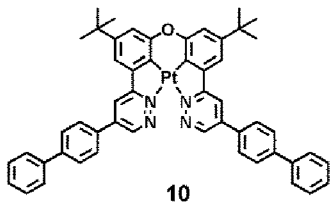
10

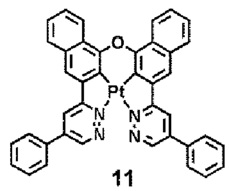
11

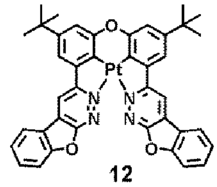
12

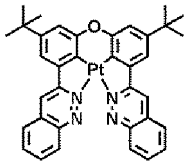
13

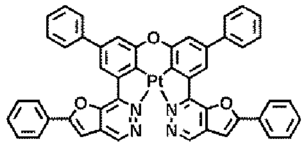
14

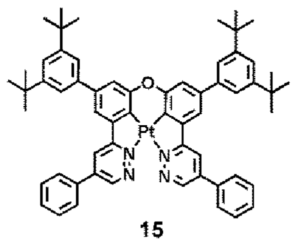
15

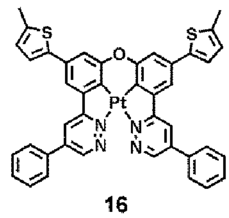
16

.

**13.** Organische lichtemittierende Vorrichtung, umfassend:

eine erste Elektrode;
eine zweite Elektrode; und
eine organische Schicht, die zwischen der ersten Elektrode und der zweiten Elektrode angeordnet ist,
wobei die organische Schicht eine Emissionsschicht umfasst, und
wobei die organische Schicht ferner zumindest eine metallorganische Verbindung nach einem der Ansprüche 1-12 umfasst;
wobei bevorzugt
die erste Elektrode eine Anode ist,
die zweite Elektrode eine Kathode ist, und
die organische Schicht ferner einen Lochtransportbereich, der zwischen der ersten Elektrode und der Emissionsschicht angeordnet ist, und einen Elektronentransportbereich umfasst, der zwischen der Emissionsschicht und der zweiten Elektrode angeordnet ist,
wobei der Lochtransportbereich eine Locheinspritzschicht, eine Lochtransportschicht, eine Elektronenblockierschicht, eine Pufferschicht oder eine beliebige Kombination davon umfasst, und
wobei der Elektronentransportbereich eine Lochblockierschicht, eine Elektronentransportschicht, eine Elektroneneinspritzschicht oder eine beliebige Kombination davon umfasst.

**14.** Organische lichtemittierende Vorrichtung nach Anspruch 13, wobei
die Emissionsschicht die metallorganische Verbindung umfasst;
wobei bevorzugt
die Emissionsschicht ferner einen Wirt umfasst, und
eine Menge des Wirts größer als eine Menge der metallorganischen Verbindung ist.

**15.** Diagnostische Zusammensetzung, umfassend zumindest eine der metallorganischen Verbindungen nach einem der Ansprüche 1-12.

## Revendications

1. Composé organométallique représenté par la Formule 1 :

Formule 1

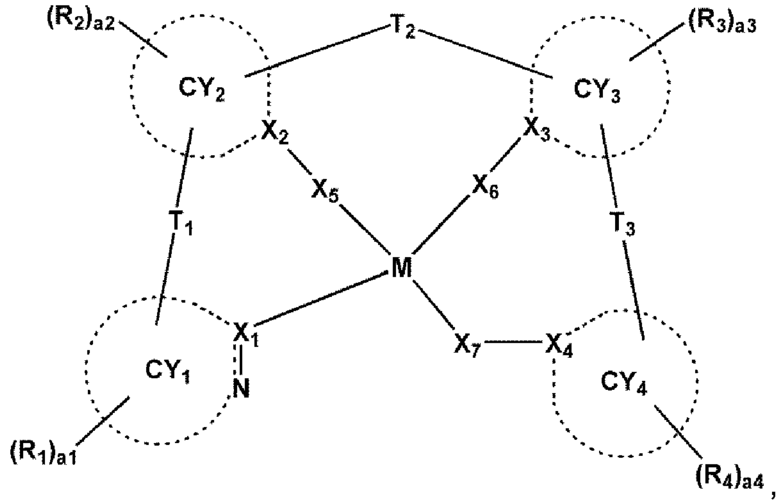

où, dans la Formule 1,

M est : béryllium (Be), magnésium (Mg), aluminium (Al), calcium (Ca), titane (Ti), manganèse (Mn), cobalt (Co), cuivre (Cu), zinc (Zn), gallium (Ga), germanium (Ge), ruthénium (Ru), rhodium (Rh), argent (Ag), rhénium (Re), platine (Pt) ou (Au),
$X_1$ est N,
$X_2$ à $X_4$ sont chacun indépendamment C ou N,
$X_5$ à $X_7$ sont chacun indépendamment une liaison chimique, O, S, $B(R_7)$, $N(R_7)$, $P(R_7)$, $C(R_7)(R_8)$, $Si(R_7)(R_8)$, $Ge(R_7)(R_8)$, C(=O), $B(R_7)(R_8)$, $N(R_7)(R_8)$, ou $P(R_7)(R_8)$,
quand $X_5$ est une liaison chimique, $X_2$ et M sont liés directement l'un à l'autre, quand $X_6$ est une liaison chimique, $X_3$ et M sont liés directement l'un à l'autre, et quand $X_7$ est une liaison chimique, $X_4$ et M sont liés directement l'un à l'autre,
une liaison entre $X_1$ et M est une liaison coordinative, une liaison sélectionnée parmi une liaison entre $X_2$ ou $X_5$ et M, une liaison entre $X_3$ ou $X_6$ et M, et une liaison entre $X_4$ ou $X_7$ et M est une liaison coordinative, et les autres liaisons sont chacune une liaison covalente,
l'anneau $CY_1$ est un groupe hétérocyclique $C_1$-$C_{30}$ ayant au moins deux atomes N comme atomes formant l'anneau,
l'anneau $CY_2$ à l'anneau $CY_4$ sont chacun indépendamment sélectionnés entre un groupe carbocyclique $C_5$-$C_{30}$ et un groupe hétérocyclique $C_1$-$C_{30}$,
$T_1$ et $T_3$ sont chacun indépendamment une liaison simple, une liaison double, *-N(R')-*', *-B(R')-*', *-P(R')-*', *-C(R')(R")-*', *-Si(R')(R")-*', *-Ge(R')(R")-*', *-S-*', *-Se-*', *-O-*1, *-C(=O)-*', *-S(=O)-*', $*-S(=O)_2-*'$, *-C(R')=*', *=C(R')-*', *-C(R')=C(R")-*', *-C(=S)-*', ou *-C≡C-*',
$T_2$ est une liaison simple, une liaison double, $*-N(R_5)-*'$, $*-B(R_5)-*'$, $*-P(R_5)-*'$, $*-C(R_5)(R_6)-*'$, $*-Si(R_5)(R_6)-*'$, $*-Ge(R_5)(R_6)-*'$, *-S-*', *-Se-*', *-O-*', *-C(=O)-*', *-S(=O)-*', $*-S(=O)_2-*'$, $*-C(R_5)=*'$, $*=C(R_5)-*'$, $*-C(R_5)=C(R_6)-*'$, *-C(=S)-*', ou *-C≡C-*',
$R_1$ à $R_8$, R', et R" sont chacun indépendamment sélectionnés entre : hydrogène, deutérium, -F, -Cl, -Br, -I, $-SF_5$, un groupe hydroxyle, un groupe cyano, un groupe nitro, un groupe amidino, un groupe hydrazine, un groupe hydrazone, un groupe acide carboxylique ou un sel de celui-ci, un groupe acide sulfonique ou un sel de celui-ci, un groupe acide phosphorique ou un sel de celui-ci, un groupe alkyle $C_1$-$C_{60}$ substitué ou non substitué, un groupe alkényle $C_2$-$C_{60}$ substitué ou non substitué, un groupe alkynyle $C_2$-$C_{60}$ substitué ou non substitué, un groupe alkoxy $C_1$-$C_{60}$ substitué ou non substitué, un groupe cycloalkyle $C_3$-$C_{10}$ substitué ou non substitué, un groupe hétérocycloalkyle $C_1$-$C_{10}$ substitué ou non substitué, un groupe cycloalkényle $C_3$-$C_{10}$ substitué ou non substitué, un groupe hétérocycloalkényle $C_1$-$C_{10}$ substitué ou non substitué, un groupe aryle $C_6$-$C_{60}$ substitué ou non substitué, un groupe alkylaryle $C_7$-$C_{60}$ substitué ou non substitué, un groupe aryloxy $C_6$-$C_{60}$ substitué ou non substitué, un groupe arylthio $C_6$-$C_{60}$ substitué ou non substitué, un groupe arylalkyle

$C_7$-$C_{60}$ substitué ou non substitué, un groupe hétéroaryle $C_1$-$C_{60}$ substitué ou non substitué, un groupe hétéroaryloxy $C_1$-$C_{60}$ substitué ou non substitué, un groupe hétéroarylthio $C_1$-$C_{60}$ substitué ou non substitué, un groupe hétéroarylalkyle $C_2$-$C_{60}$ substitué ou non substitué, un groupe alkylhétéroaryle $C_2$-$C_{60}$ substitué ou non substitué, un groupe polycyclique condensé non aromatique monovalent substitué ou non substitué, un groupe hétéropolycyclique condensé non aromatique monovalent substitué ou non substitué, $-N(Q_1)(Q_2)$, $-Si(Q_3)(Q_4)(Q_5)$, $-B(Q_6)(Q_7)$, et $-P(=O)(Q_8)(Q_9)$,

a1 à a4 sont chacun indépendamment un nombre entier de 0 à 20,

deux d'une pluralité de groupes $R_1$ voisins sont optionnellement liés pour former un groupe carbocyclique $C_5$-$C_{30}$ qui est non substitué ou substitué avec au moins un $R_{10a}$ ou un groupe hétérocyclique $C_1$-$C_{30}$ qui est non substitué ou substitué avec au moins un $R_{10a}$,

deux d'une pluralité de groupes $R_2$ voisins sont optionnellement liés pour former un groupe carbocyclique $C_5$-$C_{30}$ qui est non substitué ou substitué avec au moins un $R_{10a}$ ou un groupe hétérocyclique $C_1$-$C_{30}$ qui est non substitué ou substitué avec au moins un $R_{10a}$,

deux d'une pluralité de groupes $R_3$ voisins sont optionnellement liés pour former un groupe carbocyclique $C_5$-$C_{30}$ qui est non substitué ou substitué avec au moins un $R_{10a}$ ou un groupe hétérocyclique $C_1$-$C_{30}$ qui est non substitué ou substitué avec au moins un $R_{10a}$,

deux d'une pluralité de groupes $R_4$ voisins sont optionnellement liés pour former un groupe carbocyclique $C_5$-$C_{30}$ qui est non substitué ou substitué avec au moins un $R_{10a}$ ou un groupe hétérocyclique $C_1$-$C_{30}$ qui est non substitué ou substitué avec au moins un $R_{10a}$,

deux de $R_1$ à $R_8$, R' et R" sont optionnellement liés pour former un groupe carbocyclique $C_5$-$C_{30}$ qui est non substitué ou substitué avec au moins un $R_{10a}$ ou un groupe hétérocyclique $C_1$-$C_{30}$ qui est non substitué ou substitué avec au moins un $R_{10a}$,

$R_{10a}$ est identique à la description en rapport avec $R_1$,

* et *' indiquent chacun un site de fixation à un atome voisin,

au moins un substituant du groupe alkyle $C_1$-$C_{60}$ substitué, le groupe alkényle $C_2$-$C_{60}$ substitué, le groupe alkynyle $C_2$-$C_{60}$ substitué, le groupe alkoxy $C_1$-$C_{60}$ substitué, le groupe cycloalkyle $C_3$-$C_{10}$ substitué, le groupe hétérocycloalkyle $C_1$-$C_{10}$ substitué, le groupe cycloalkényle $C_3$-$C_{10}$ substitué, le groupe hétérocycloalkényle $C_1$-$C_{10}$ substitué, le groupe aryle $C_6$-$C_{60}$ substitué, le groupe alkylaryle $C_7$-$C_{60}$ substitué, le groupe aryloxy $C_6$-$C_{60}$ substitué, le groupe arylthio $C_6$-$C_{60}$ substitué, le groupe arylalkyle $C_7$-$C_{60}$ substitué, le groupe hétéroaryle $C_1$-$C_{60}$ substitué, le groupe hétéroaryloxy $C_1$-$C_{60}$ substitué, le groupe hétéroarylthio $C_1$-$C_{60}$ substitué, le groupe hétéroarylalkyle $C_2$-$C_{60}$ substitué, le groupe alkylhétéroaryle $C_2$-$C_{60}$ substitué, le groupe polycyclique condensé non aromatique monovalent substitué, et le groupe hétéropolycyclique condensé non aromatique monovalent substitué est sélectionné entre :

deutérium, -F, -Cl, -Br, -I, $-CD_3$, $-CD_2H$, $-CDH_2$, $-CF_3$, $-CF_2H$, $-CFH_2$, un groupe hydroxyle, un groupe cyano, un groupe nitro, un groupe amidino, un groupe hydrazine, un groupe hydrazone, un groupe acide carboxylique ou un sel de celui-ci, un groupe acide sulfonique ou un sel de celui-ci, un groupe acide phosphorique ou un sel de celui-ci, un groupe alkyle $C_1$-$C_{60}$, un groupe alkényle $C_2$-$C_{60}$, un groupe alkényle $C_2$-$C_{60}$, et un groupe alkoxy $C_1$-$C_{60}$ ;

un groupe alkyle $C_1$-$C_{60}$, un groupe alkényle $C_2$-$C_{60}$, un groupe alkynyle $C_2$-$C_{60}$, et un groupe alkoxy $C_1$-$C_{60}$, chacun substitué avec au moins un élément sélectionné entre deutérium, -F, -Cl, -Br, -I, $-CD_3$, $-CD_2H$, $-CDH_2$, $-CF_3$, $-CF_2H$, $-CFH_2$, un groupe hydroxyle, un groupe cyano, un groupe nitro, un groupe amidino, un groupe hydrazine, un groupe hydrazone, un groupe acide carboxylique ou un sel de celui-ci, un groupe acide sulfonique ou un sel de celui-ci, un groupe acide phosphorique ou un sel de celui-ci, un groupe cycloalkyle $C_3$-$C_{10}$, un groupe hétérocycloalkyle $C_1$-$C_{10}$, un groupe cycloalkényle $C_3$-$C_{10}$, un groupe hétérocycloalkényle $C_1$-$C_{10}$, un groupe aryle $C_6$-$C_{60}$, un groupe alkylaryle $C_7$-$C_{60}$, un groupe aryloxy $C_6$-$C_{60}$, un groupe arylthio $C_6$-$C_{60}$, un groupe arylalkyle $C_7$-$C_{60}$, un groupe hétéroaryle $C_1$-$C_{60}$, un groupe hétéroaryloxy $C_1$-$C_{60}$, un groupe hétéroarylthio $C_1$-$C_{60}$, un groupe hétéroarylalkyle $C_2$-$C_{60}$, un groupe alkylhétéroaryle $C_2$-$C_{60}$, un groupe polycyclique condensé non aromatique monovalent, un groupe hétéropolycyclique condensé non aromatique monovalent, $-N(Q_{11})(Q_{12})$, $-Si(Q_{13})(Q_{14})(Q_{15})$, $-B(Q_{16})(Q_{17})$, et $-P(=O)(Q_{18})(Q_{19})$;

un groupe cycloalkyle $C_3$-$C_{10}$, un groupe hétérocycloalkyle $C_1$-$C_{10}$, un groupe cycloalkényle $C_3$-$C_{10}$, un groupe hétérocycloalkényle $C_1$-$C_{10}$, un groupe aryle $C_6$-$C_{60}$, un groupe alkylaryle $C_7$-$C_{60}$, un groupe aryloxy $C_6$-$C_{60}$, un groupe arylthio $C_6$-$C_{60}$, un groupe arylalkyle $C_7$-$C_{60}$, un groupe hétéroaryle $C_1$-$C_{60}$, un groupe hétéroaryloxy $C_1$-$C_{60}$, un groupe hétéroarylthio $C_1$-$C_{60}$, un groupe hétéroarylalkyle $C_2$-$C_{60}$, un groupe alkylhétéroaryle $C_2$-$C_{60}$, un groupe polycyclique condensé non aromatique monovalent, et un groupe hétéropolycyclique condensé non aromatique monovalent ;

un groupe cycloalkyle $C_3$-$C_{10}$, un groupe hétérocycloalkyle $C_1$-$C_{10}$, un groupe cycloalkényle $C_3$-$C_{10}$, un

groupe hétérocycloalkényle $C_1$-$C_{10}$, un groupe aryle $C_6$-$C_{60}$, un groupe alkylaryle $C_7$-$C_{60}$, un groupe aryloxy $C_6$-$C_{60}$, un groupe arylthio $C_6$-$C_{60}$, un groupe arylalkyle $C_7$-$C_{60}$, un groupe hétéroaryle $C_1$-$C_{60}$, un groupe hétéroaryloxy $C_1$-$C_{60}$, un groupe hétéroarylthio $C_1$-$C_{60}$, un groupe hétéroarylalkyle $C_2$-$C_{60}$, un groupe alkylhétéroaryle $C_2$-$C_{60}$, un groupe polycyclique condensé non aromatique monovalent, et un groupe hétéropolycyclique condensé non aromatique monovalent, chacun substitué avec au moins un élément sélectionné entre : deutérium, -F, -Cl, -Br, -I, $-CD_3$, $-CD_2H$, $-CDH_2$, $-CF_3$, $-CF_2H$, $-CFH_2$, un groupe hydroxyle, un groupe cyano, un groupe nitro, un groupe amidino, un groupe hydrazine, un groupe hydrazone, un groupe acide carboxylique ou un sel de celui-ci, un groupe acide sulfonique ou un sel de celui-ci, un groupe acide phosphorique ou un sel de celui-ci, un groupe alkyle $C_1$-$C_{60}$, un groupe alkényle $C_2$-$C_{60}$, un groupe alkynyle $C_2$-$C_{60}$, un groupe alkoxy $C_1$-$C_{60}$, un groupe cycloalkyle $C_3$-$C_{10}$, un groupe hétérocycloalkyle $C_1$-$C_{10}$, un groupe cycloalkényle $C_3$-$C_{10}$, un groupe hétérocycloalkényle $C_1$-$C_{10}$, un groupe aryle $C_6$-$C_{60}$, un groupe alkylaryle $C_7$-$C_{60}$, un groupe aryloxy $C_6$-$C_{60}$, un groupe arylthio $C_6$-$C_{60}$, un groupe arylalkyle $C_7$-$C_{60}$, un groupe hétéroaryle $C_1$-$C_{60}$, un groupe hétéroaryloxy $C_1$-$C_{60}$, un groupe hétéroarylthio $C_1$-$C_{60}$, un groupe hétéroarylalkyle $C_2$-$C_{60}$, un groupe alkylhétéroaryle $C_2$-$C_{60}$, un groupe polycyclique condensé non aromatique monovalent, un groupe hétéropolycyclique condensé non aromatique monovalent, $-N(Q_{21})(Q_{22})$, $-Si(Q_{23})(Q_{24})(Q_{25})$, $-B(Q_{26})(Q_{27})$, et $-P(=O)(Q_{28})(Q_{29})$ ; et
$-N(Q_{31})(Q_{32})$, $-Si(Q_{33})(Q_{34})(Q_{35})$, $-B(Q_{36})(Q_{37})$, et $-P(=O)(Q_{38})(Q_{39})$, et
$Q_1$ à $Q_9$, $Q_{11}$ à $Q_{19}$, $Q_{21}$ à $Q_{29}$, et $Q_{31}$ à $Q_{39}$ sont chacun indépendamment sélectionnés entre : hydrogène, deutérium, -F, -Cl, -Br, -I, un groupe hydroxyle, un groupe cyano, un groupe nitro, un groupe amidino, un groupe hydrazine, un groupe hydrazone, un groupe acide carboxylique ou un sel de celui-ci, un groupe acide sulfonique ou un sel de celui-ci, un groupe acide phosphorique ou un sel de celui-ci, un groupe alkyle $C_1$-$C_{60}$, un groupe alkényle $C_2$-$C_{60}$, un groupe alkynyle $C_2$-$C_{60}$, un groupe alkoxy $C_1$-$C_{60}$, un groupe cycloalkyle $C_3$-$C_{10}$, un groupe hétérocycloalkyle $C_1$-$C_{10}$, un groupe cycloalkényle $C_3$-$C_{10}$, un groupe hétérocycloalkényle $C_1$-$C_{10}$, un groupe aryle $C_6$-$C_{60}$, un groupe aryle $C_6$-$C_{60}$ substitué avec au moins un groupe sélectionné entre un groupe alkylaryle $C_7$-$C_{60}$, un groupe alkyle $C_1$-$C_{60}$, et un groupe aryle $C_6$-$C_{60}$, un groupe aryloxy $C_6$-$C_{60}$, un groupe arylthio $C_6$-$C_{60}$, un groupe arylalkyle $C_7$-$C_{60}$, un groupe hétéroaryle $C_1$-$C_{60}$, un groupe hétéroaryloxy $C_1$-$C_{60}$, un groupe hétéroarylthio $C_1$-$C_{60}$, un groupe hétéroarylalkyle $C_2$-$C_{60}$, un groupe alkylhétéroaryle $C_2$-$C_{60}$, un groupe polycyclique condensé non aromatique monovalent, et un groupe hétéropolycyclique condensé non aromatique monovalent.

**2.** Composé organométallique selon la revendication 1, dans lequel
M est Pt ou Au ; et/ou
où
$X_2$ et $X_3$ sont chacun C, $X_4$ est N, et $X_5$ à $X_7$ sont chacun une liaison chimique, ou $X_2$ et $X_4$ sont chacun C, $X_3$ est N, $X_5$ et $X_6$ sont chacun une liaison chimique, et $X_7$ est une liaison chimique, O, ou S.

**3.** Composé organométallique selon la revendication 1 ou 2, dans lequel
l'anneau $CY_1$ est sélectionné entre i) un premier anneau, ii) un anneau condensé dans lequel sont condensés au moins deux du premier anneau, et iii) un anneau condensé dans lequel au moins un du premier anneau et au moins un du deuxième anneau sont condensés l'un avec l'autre,
le premier anneau est un groupe pyridazine, un groupe triazine, ou un groupe tétrazine,
le deuxième anneau est sélectionné entre un groupe cyclopentane, un groupe cyclopentadiène, un groupe furane, un groupe thiophène, un groupe pyrrole, un groupe silole, un groupe indène, un groupe benzofurane, un groupe benzothiophène, un groupe indole, un groupe benzosilole, un groupe oxazole, un groupe isoxazole, un groupe oxadiazole, un groupe isoxadiazole, un groupe oxatriazole, un groupe isoxatriazole, un groupe thiazole, un groupe isothiazole, un groupe thiadiazole, un groupe isothiadiazole, un groupe thiatriazole, un groupe isothiatriazole, un groupe pyrazole, un groupe imidazole, un groupe triazole, un groupe tétrazole, un groupe azasilole, un groupe diazasilole, un groupe triazasilole, un groupe adamantane, un groupe norbornane, un groupe norbornène, un groupe cyclohexane, un groupe cyclohexène, un groupe benzène, un groupe pyridine, un groupe pyrimidine, et un groupe pyrazine, et
quand l'anneau $CY_1$ est un anneau condensé dans lequel au moins un du premier anneau et au moins un du deuxième anneau sont condensés ensemble, N dans le premier anneau de l'anneau condensé est lié par coordination à M dans la Formule 1.

**4.** Composé organométallique selon l'une quelconque des revendications 1-3, dans lequel
l'anneau $CY_2$ à l'anneau $CY_4$ sont chacun indépendamment sélectionnés entre i) un troisième anneau, ii) un quatrième anneau, iii) un anneau condensé dans lequel au moins deux du troisième anneau sont condensés ensemble, iv) un anneau condensé dans lequel au moins deux du quatrième anneau sont condensés ensemble, et v) un

anneau condensé dans lequel au moins un du troisième anneau et au moins un du quatrième anneau sont condensés ensemble,
le troisième anneau est sélectionné entre un groupe cyclopentane, un groupe cyclopentadiène, un groupe furane, un groupe thiophène, un groupe pyrrole, un groupe silole, un groupe indène, un groupe benzofurane, un groupe benzothiophène, un groupe indole, un groupe benzosilole, un groupe oxazole, un groupe isoxazole, un groupe oxadiazole, un groupe isoxadiazole, un groupe oxatriazole, un groupe isoxatriazole, un groupe thiazole, un groupe isothiazole, un groupe thiadiazole, un groupe isothiadiazole, un groupe thiatriazole, un groupe isothiatriazole, un groupe pyrazole, un groupe imidazole, un groupe triazole, un groupe tétrazole, un groupe azasilole, un groupe diazasilole, et un groupe triazasilole, et
le quatrième anneau est sélectionné entre un groupe adamantane, un groupe norbornane, un groupe norbornène, un groupe cyclohexane, un groupe cyclohexène, un groupe benzène, un groupe pyridine, un groupe pyrimidine, un groupe pyrazine, un groupe pyridazine et un groupe triazine.

**5.** Composé organométallique selon l'une quelconque des revendications 1-4, dans lequel
$T_1$ et $T_3$ sont chacun une liaison simple, et
$T_2$ est *-N($R_5$)-*', *-C($R_5$)($R_6$)-*', *-Si($R_5$)($R_6$)-*', *-S-*', ou *-O-*'.

**6.** Composé organométallique selon l'une quelconque des revendications 1-5, dans lequel
$R_1$ à $R_8$, R', et R" sont chacun sélectionnés indépendamment entre :

hydrogène, deutérium, -F, -Cl, -Br, -I, un groupe hydroxyle, un groupe cyano, un groupe nitro, un groupe amino, un groupe amidino, un groupe hydrazine, un groupe hydrazone, un groupe acide carboxylique ou un sel de celui-ci, un groupe acide sulfonique ou un sel de celui-ci, un groupe acide phosphorique ou un sel de celui-ci, $-SF_5$, un groupe alkyle $C_1$-$C_{20}$, et un groupe alkoxy $C_1$-$C_{20}$ ;
un groupe alkyle $C_1$-$C_{20}$ et un groupe alkoxy $C_1$-$C_{20}$, chacun substitué avec au moins un élément sélectionné entre : deutérium, -F, -Cl, -Br, -I, $-CD_3$, $-CD_2H$, $-CDH_2$, $-CF_3$, $-CF_2H$, - $CFH_2$, un groupe hydroxyle, un groupe cyano, un groupe nitro, un groupe amino, un groupe amidino, un groupe hydrazine, un groupe hydrazone, un groupe acide carboxylique ou un sel de celui-ci, un groupe acide sulfonique ou un sel de celui-ci, un groupe acide phosphorique ou un sel de celui-ci, un groupe alkyle $C_1$-$C_{10}$, un groupe cyclopentyle, un groupe cyclohexyle, un groupe cycloheptyle, un groupe cycloctyle, un groupe adamantanyle, un groupe norbornanyle, un groupe norbornényle, un groupe cyclopentényle, un groupe cyclohexényle, un groupe cycloheptényle, un groupe phényle, un groupe biphényle, un groupe naphtyle, un groupe pyridinyle, et un groupe pyrimidinyle ;
un groupe cyclopentyle, un groupe cyclohexyle, un groupe cycloheptyle, un groupe cycloctyle, un groupe adamantanyle, un groupe norbornanyle, un groupe norbornényle, un groupe cyclopentényle, un groupe cyclohexényle, un groupe cycloheptényle, un groupe phényle, un groupe biphényle, un groupe alkylphényle $C_1$-$C_{20}$, un groupe naphtyle, un groupe fluorényle, un groupe phénanthrényle, un groupe anthracényle, un groupe fluoranthényle, un groupe triphénylényle, un groupe pyrényle, un groupe chrysényle, un groupe pyrrolyle, un groupe thiophényle, un groupe furanyle, un groupe imidazolyle, un groupe pyrazolyle, un groupe thiazolyle, un groupe isothiazolyle, un groupe oxazolyle, un groupe isoxazolyle, un groupe pyridinyle, un groupe pyrazinyle, un groupe pyrimidinyle, un groupe pyridazinyle, un groupe isoindolyle, un groupe indolyle, un groupe indazolyle, un groupe purinyle, un groupe quinolinyle, un groupe isoquinolinyle, un groupe benzoquinolinyle, un groupe quinoxalinyle, un groupe quinazolinyle, un groupe cinnolinyle, un groupe carbazolyle, un groupe phénanthrolinyle, un groupe benzimidazolyle, un groupe benzofuranyle, un groupe benzothiophényle, un groupe isobenzothiazolyle, un groupe benzoxazolyle, un groupe isobenzoxazolyle, un groupe triazolyle, un groupe tétrazolyle, un groupe oxadiazolyle, un groupe triazinyle, un groupe dibenzofuranyle, un groupe dibenzothiophényle, un groupe benzocarbazolyle, un groupe dibenzocarbazolyle, un groupe imidazopyridinyle, et un groupe imidazopyrimidinyle ;
un groupe cyclopentyle, un groupe cyclohexyle, un groupe cycloheptyle, un groupe cycloctyle, un groupe adamantanyle, un groupe norbornanyle, un groupe norbornényle, un groupe cyclopentényle, un groupe cyclohexényle, un groupe cycloheptényle, un groupe phényle, un groupe biphényle, un groupe alkylphényle $C_1$-$C_{20}$, un groupe naphthyle, un groupe fluorényle, un groupe phénanthrényle, un groupe anthracényle, un groupe fluoranthényle, un groupe triphénylényle, un groupe pyrényle, un groupe chrysényle, un groupe pyrrolyle, un groupe thiophényle, un groupe furanyle, un groupe imidazolyle, un groupe pyrazolyle, un groupe thiazolyle, un groupe isothiazolyle, un groupe oxazolyle, un groupe isoxazolyle, un groupe pyridinyle, un groupe pyrazinyle, un groupe pyrimidinyle, un groupe pyridazinyle, un groupe isoindolyle, un groupe indolyle, un groupe indazolyle, un groupe purinyle, un groupe quinolinyle, un groupe isoquinolinyle, un groupe benzoquinolinyle, un groupe quinoxalinyle, un groupe quinazolinyle, un groupe cinnolinyle, un groupe carbazolyle, un groupe phénanthrolinyle, un groupe benzimidazolyle, un groupe benzofuranyle, un groupe benzothiophényle, un groupe isobenzothiazolyle, un groupe benzoxazolyle, un groupe isobenzoxazolyle, un groupe triazolyle, un groupe tétrazolyle, un groupe

oxadiazolyle, un groupe triazinyle, un groupe dibenzofuranyle, un groupe dibenzothiophényle, un groupe benzocarbazolyle, un groupe dibenzocarbazolyle, un groupe imidazopyridinyle, et un groupe imidazopyrimidinyle, chacun substitué avec au moins un élément sélectionné entre : deutérium, -F, -Cl, -Br, -I, $-CD_3$, $-CD_2H$, $-CDH_2$, $-CF_3$, $-CF_2H$, $-CFH_2$, un groupe hydroxyle, un groupe cyano, un groupe nitro, an amino group, un groupe amidino, un groupe hydrazine, un groupe hydrazone, un groupe acide carboxylique ou un sel de celui-ci, un groupe acide sulfonique ou un sel de celui-ci, un groupe acide phosphorique ou un sel de celui-ci, un groupe alkyle $C_1$-$C_{20}$, un groupe alkoxy $C_1$-$C_{20}$, un groupe cyclopentyle, un groupe cyclohexyle, un groupe cycloheptyle, un groupe cycloctyle, un groupe adamantanyle, un groupe norbornanyle, un groupe norbornényle, un groupe cyclopentényle, un groupe cyclohexényle, un groupe cycloheptényle, un groupe phényle, un groupe biphényle, un groupe alkylphényle $C_1$-$C_{20}$, un groupe naphtyle, un groupe fluorényle, un groupe phénanthrényle, un groupe anthracényle, un groupe fluoranthényle, un groupe triphénylényle, un groupe pyrényle, un groupe chrysényle, un groupe pyrrolyle, un groupe thiophényle, un groupe furanyle, un groupe imidazolyle, un groupe pyrazolyle, un groupe thiazolyle, un groupe isothiazolyle, un groupe oxazolyle, un groupe isoxazolyle, un groupe pyridinyle, un groupe pyrazinyle, un groupe pyrimidinyle, un groupe pyridazinyle, un groupe isoindolyle, un groupe indolyle, un groupe indazolyle, un groupe purinyle, un groupe quinolinyle, un groupe isoquinolinyle, un groupe benzoquinolinyle, un groupe quinoxalinyle, un groupe quinazolinyle, un groupe cinnolinyle, un groupe carbazolyle, un groupe phénanthrolinyle, un groupe benzimidazolyle, un groupe benzofuranyle, un groupe benzothiophényle, un groupe isobenzothiazolyle, un groupe benzoxazolyle, un groupe isobenzoxazolyle, un groupe triazolyle, un groupe tétrazolyle, un groupe oxadiazolyle, un groupe triazinyle, un groupe dibenzofuranyle, un groupe dibenzothiophényle, un groupe benzocarbazolyle, un groupe dibenzocarbazolyle, un groupe imidazopyridinyle, et un groupe imidazopyrimidinyle ; et
$-N(Q_1)(Q_2)$, $-Si(Q_3)(Q_4)(Q_5)$, $-B(Q_6)(Q_7)$, et $-P(=O)(Q_8)(Q_9)$, et
$Q_1$ à $Q_9$ sont chacun indépendamment sélectionnés entre :
$-CH_3$, $-CD_3$, $-CD_2H$, $-CDH_2$, $-CH_2CH_3$, $-CH_2CD_3$, $-CH_2CD_2H$, $-CH_2CDH_2$, $-CHDCH_3$, $-CHDCD_2H$, $-CHDCDH_2$, $-CHDCD_3$, $-CD_2CD_3$, $-CD_2CD_2H$, $-CD_2CH_3$, et $-CD_2CDH_2$ ;
un groupe n-propyle, un groupe isopropyle, un groupe n-butyle, un groupe isobutyle, un groupe sec-butyle, un groupe tert-butyle, un groupe n-pentyle, un groupe isopentyle, un groupe sec-pentyle, un groupe tert-pentyle, un groupe phényle, et un groupe naphtyle ; et
un groupe n-propyle, un groupe isopropyle, un groupe n-butyle, un groupe isobutyle, un groupe sec-butyle, un groupe tert-butyle, un groupe n-pentyle, un groupe isopentyle, un groupe sec-pentyle, un groupe tert-pentyle, un groupe phényle et un groupe naphtyle, chacun substitué avec au moins un élément sélectionné entre le deutérium, un groupe alkyle $C_1$-$C_{10}$ et un groupe phényle.

**7.** Composé organométallique selon l'une quelconque des revendications 1-6, dans lequel un groupement représenté par

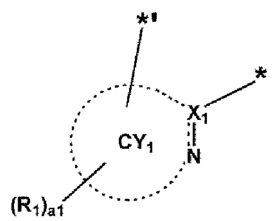

est représenté par une des Formules A1 -1(1) à A1 -1(28) et A1-2(1) à A1-2(9) :

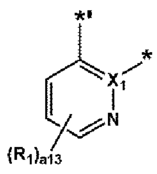
A1-1(1)

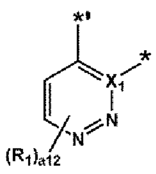
A1-1(2)

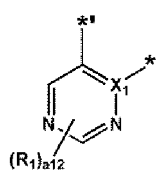
A1-1(3)

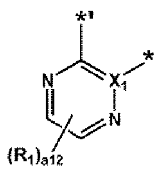
A1-1(4)

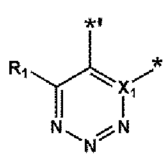
A1-1(5)

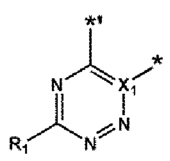
A1-1(6)

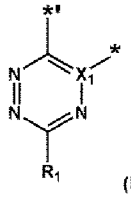
A1-1(7)

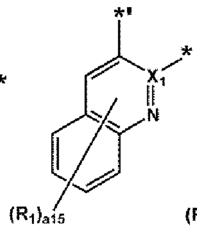
A1-1(8)

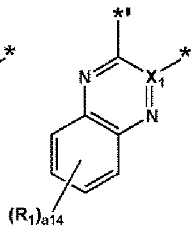
A1-1(9)

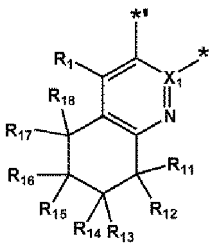
A1-1(10)

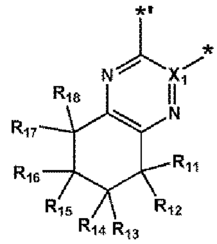
A1-1(11)

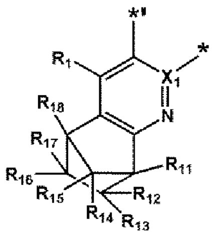
A1-1(12)

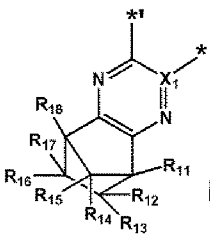
A1-1(13)

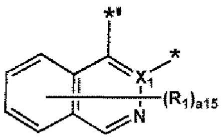
A1-1(14)

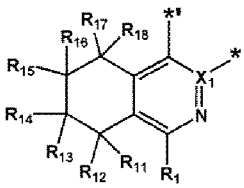
A1-1(15)

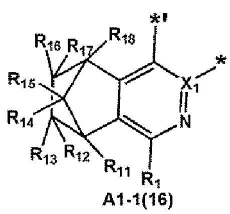
A1-1(16)

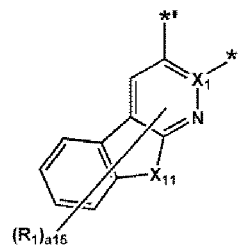
A1-1(17)

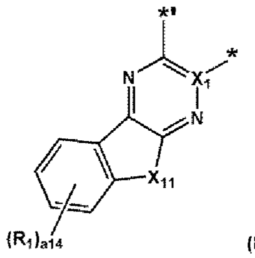
A1-1(18)

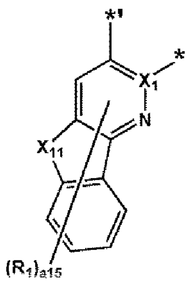
A1-1(19)

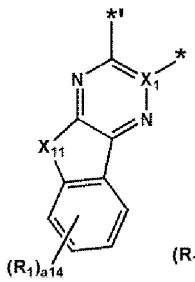
A1-1(20)

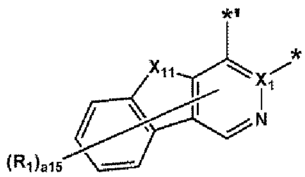
A1-1(21)

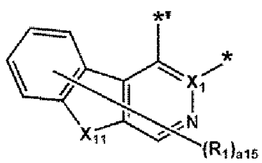
A1-1(22)

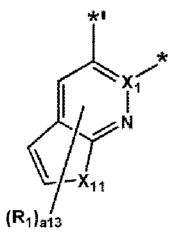
A1-1(23)

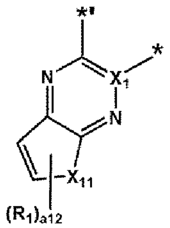
A1-1(24)

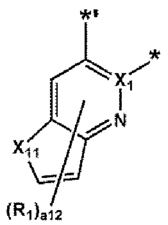
A1-1(25)

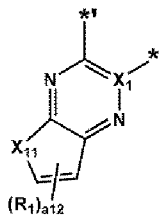
A1-1(26)

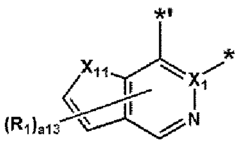
A1-1(27)

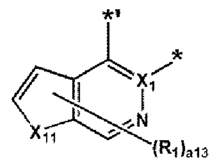
A1-1(28)

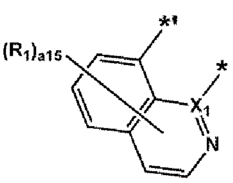
A1-2(1)

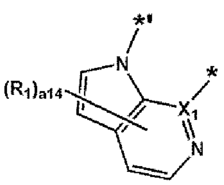
A1-2(2)

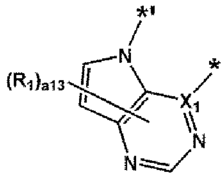
A1-2(3)

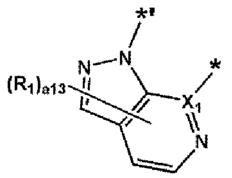
A1-2(4)

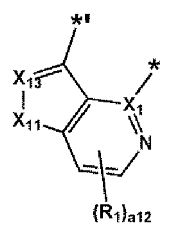
A1-2(5)

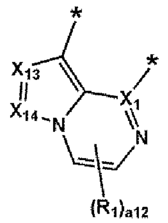
A1-2(6)

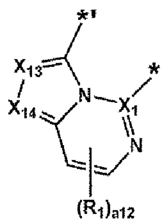
A1-2(7)

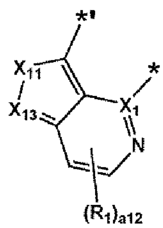
A1-2(8)

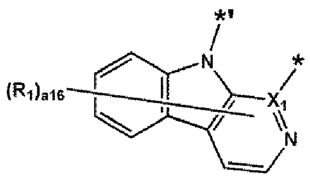
A1-2(9)

,

où, dans les Formules A1-1(1) à A1-1(28) et A1-2(1) à A1-2(9),

$X_1$ et $R_1$ sont identiques à la description de la revendication 1,
$X_{11}$ est O, S, $N(R_{11})$, $C(R_{11})(R_{12})$, ou $Si(R_{11})(R_{12})$,
$X_{13}$ est N ou $C(R_{13})$,
$X_{14}$ est N ou $C(R_{14})$,
$R_{11}$ à $R_{18}$ sont identiques à la description en rapport avec $R_1$ dans la revendication 1,
a15 est un nombre entier de 0 à 5,
a14 est un nombre entier de 0 à 4,
a13 est un nombre entier de 0 à 3,
a12 est un nombre entier de 0 à 2,
* indique un site de fixation à M dans la Formule 1, et
*' indique un site de fixation à $T_1$ dans la Formule 1.

**8.** Composé organométallique selon l'une quelconque des revendications 1-7, dans lequel un groupement représenté par

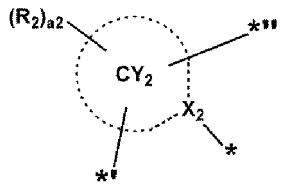

est représenté par l'une des Formules A2-1(1) à A2-1(21), A2-2(1) à A2-2(58), et A2-3(1) à A2-3(58) :

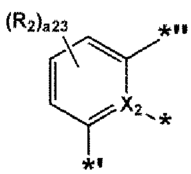
A2-1(1)

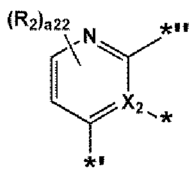
A2-1(2)

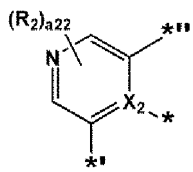
A2-1(3)

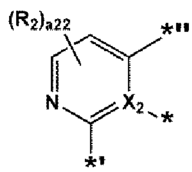
A2-1(4)

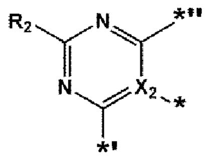
A2-1(5)

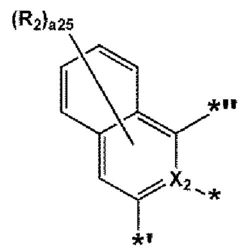
A2-1(6)

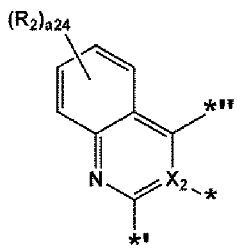
A2-1(7)

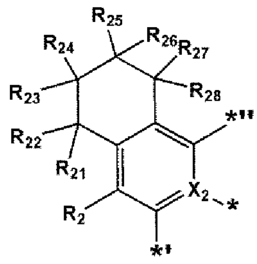
A2-1(8)

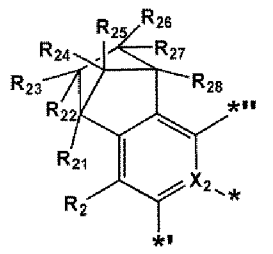
A2-1(9)

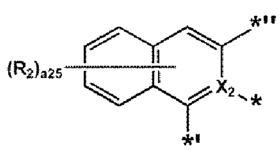
A2-1(10)

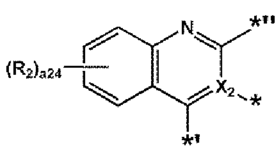
A2-1(11)

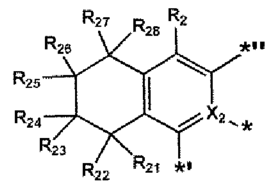
A2-1(12)

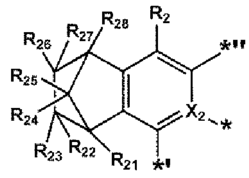
A2-1(13)

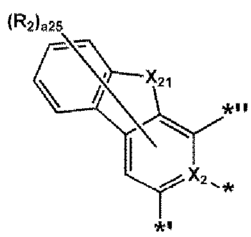
A2-1(14)

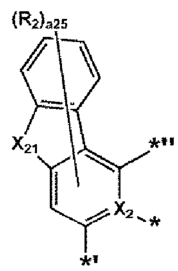
A2-1(15)

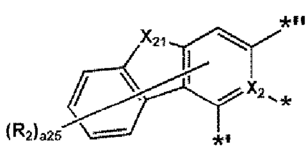
A2-1(16)

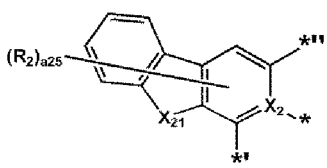
A2-1(17)

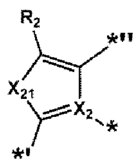
A2-1(18)

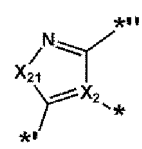
A2-1(19)

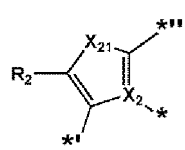
A2-1(20)

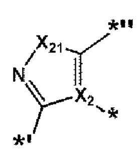
A2-1(21)

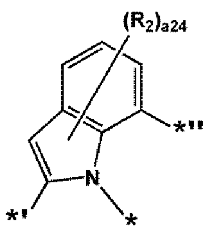
A2-2(1)

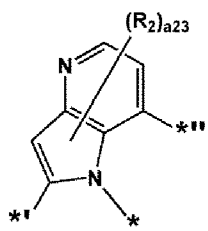
A2-2(2)

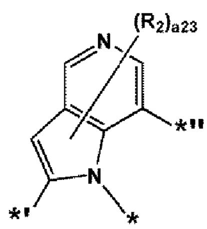
A2-2(3)

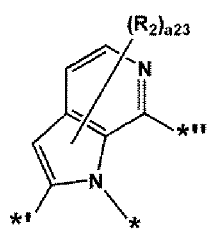
A2-2(4)

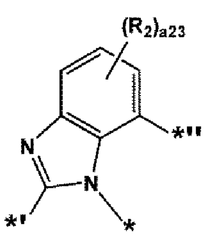
A2-2(5)

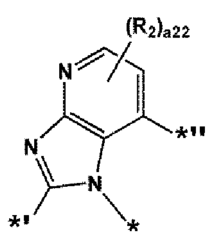
A2-2(6)

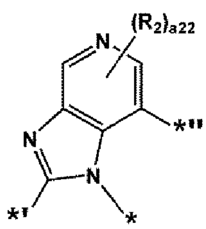
A2-2(7)

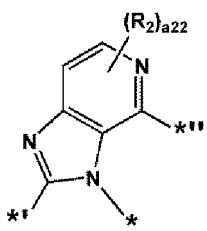
A2-2(8)

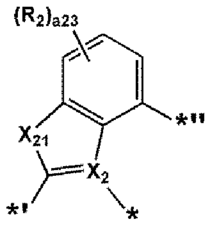
A2-2(9)

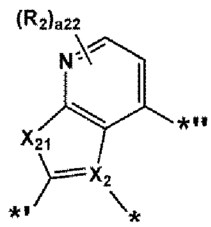
A2-2(10)

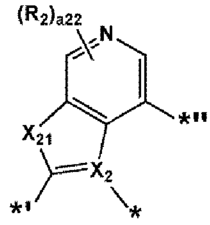
A2-2(11)

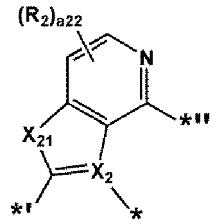
A2-2(12)

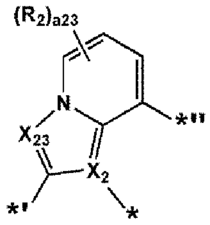
A2-2(13)

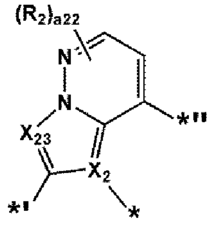
A2-2(14)

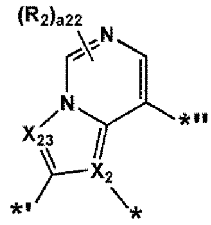
A2-2(15)

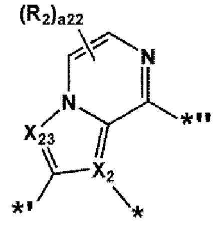
A2-2(16)

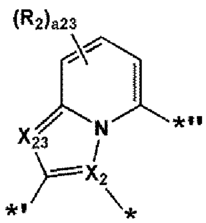
A2-2(17)

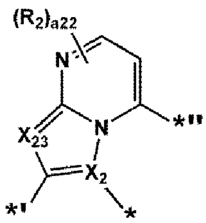
A2-2(18)

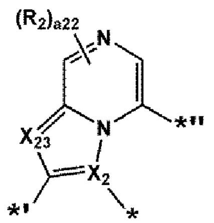
A2-2(19)

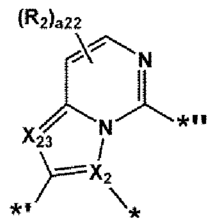
A2-2(20)

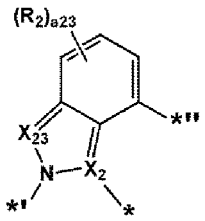
A2-2(21)

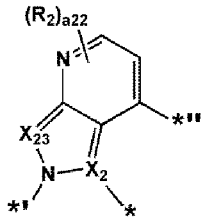
A2-2(22)

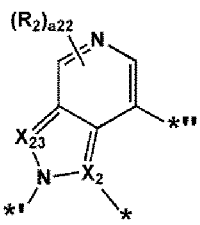
A2-2(23)

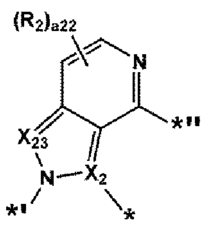
A2-2(24)

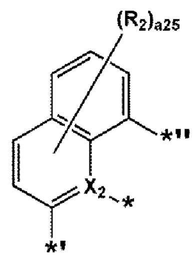
A2-2(25)

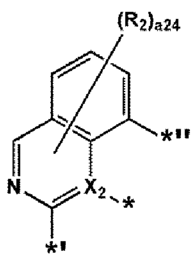
A2-2(26)

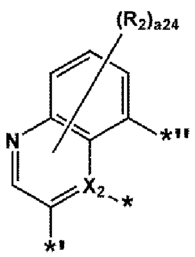
A2-2(27)

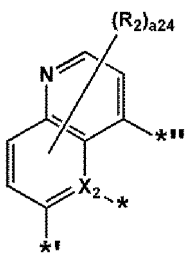
A2-2(28)

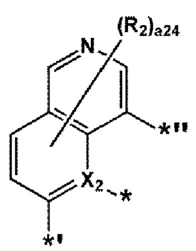
A2-2(29)

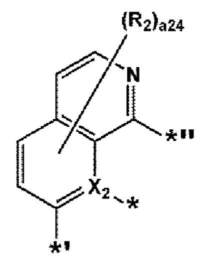
A2-2(30)

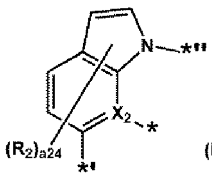
A2-2(31)

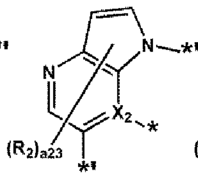
A2-2(32)

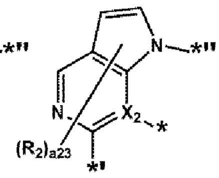
A2-2(33)

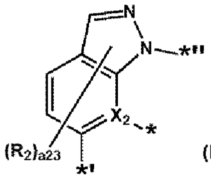
A2-2(34)

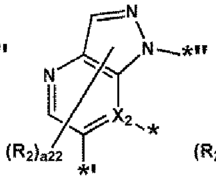
A2-2(35)

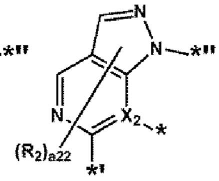
A2-2(36)

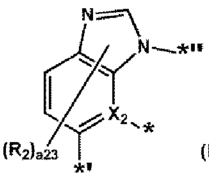
A2-2(37)

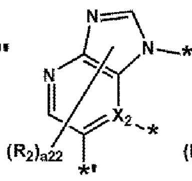
A2-2(38)

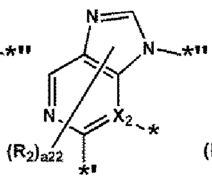
A2-2(39)

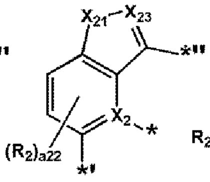
A2-2(40)

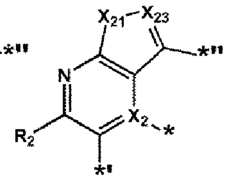
A2-2(41)

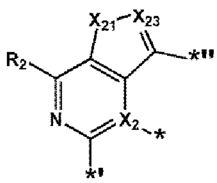
A2-2(42)

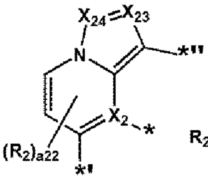
A2-2(43)

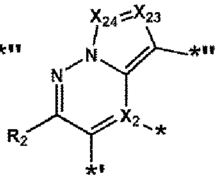
A2-2(44)

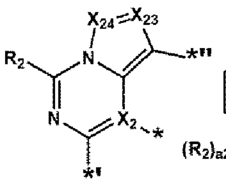
A2-2(45)

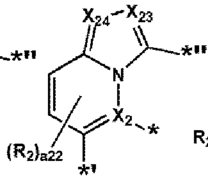
A2-2(46)

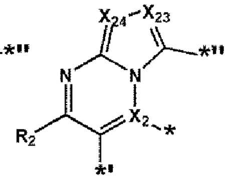
A2-2(47)

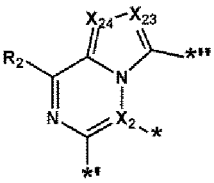
A2-2(48)

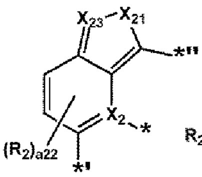
A2-2(49)

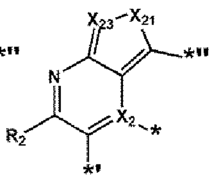
A2-2(50)

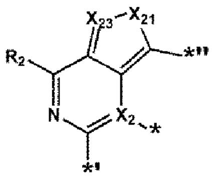
A2-2(51)

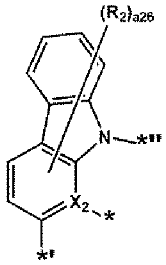
A2-2(52)

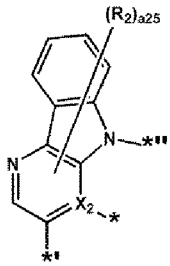
A2-2(53)

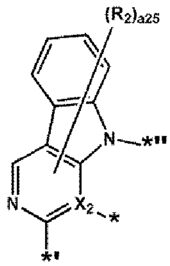
A2-2(54)

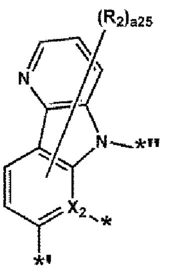
A2-2(55)

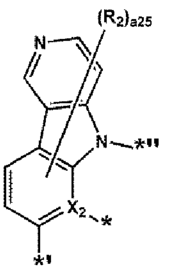
A2-2(56)

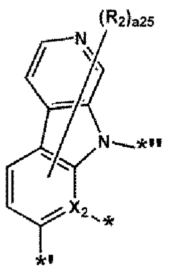
A2-2(57)

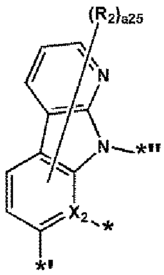
A2-2(58)

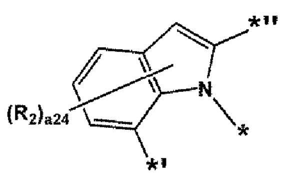
A2-3(1)

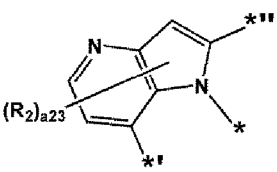
A2-3(2)

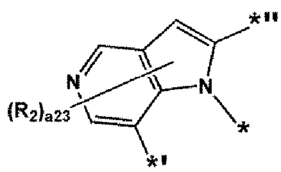
A2-3(3)

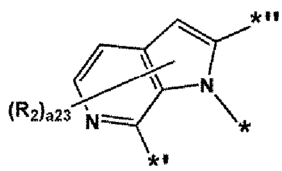
A2-3(4)

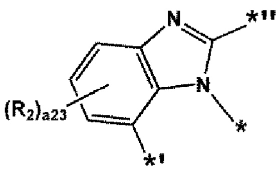
A2-3(5)

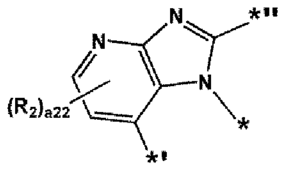
A2-3(6)

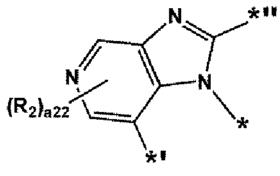
A2-3(7)

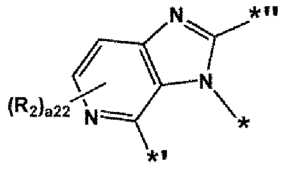
A2-3(8)

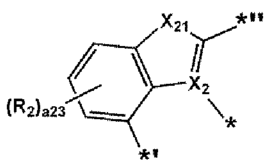
A2-3(9)

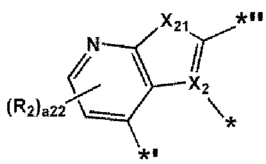
A2-3(10)

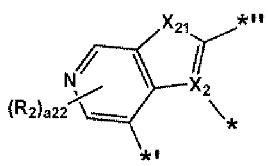
A2-3(11)

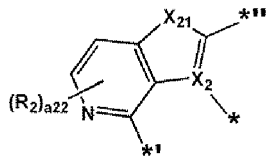
A2-3(12)

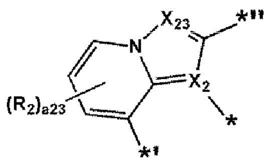
A2-3(13)

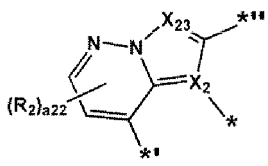
A2-3(14)

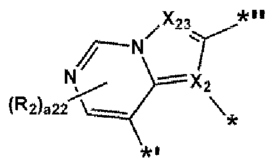
A2-3(15)

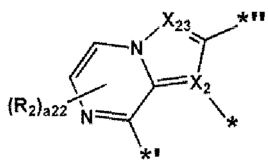
A2-3(16)

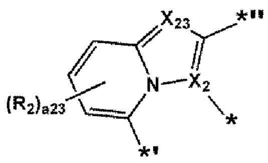
A2-3(17)

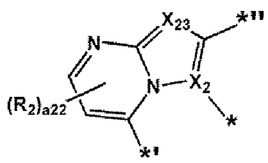
A2-3(18)

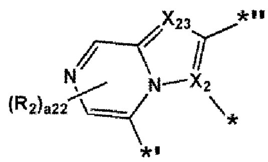
A2-3(19)

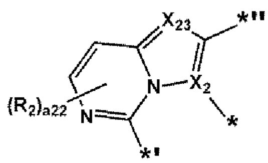
A2-3(20)

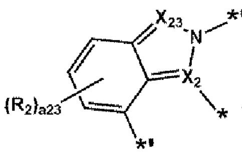
A2-3(21)

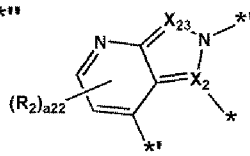
A2-3(22)

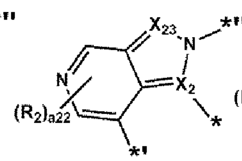
A2-3(23)

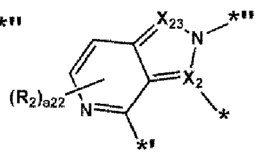
A2-3(24)

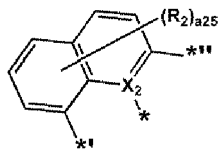
A2-3(25)

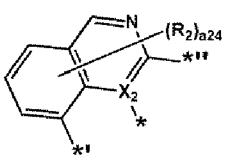
A2-3(26)

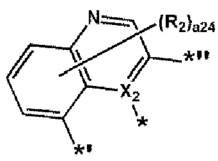
A2-3(27)

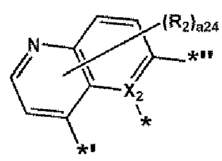
A2-3(28)

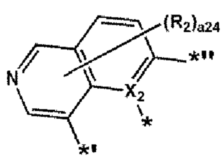
A2-3(29)

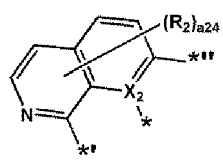
A2-3(30)

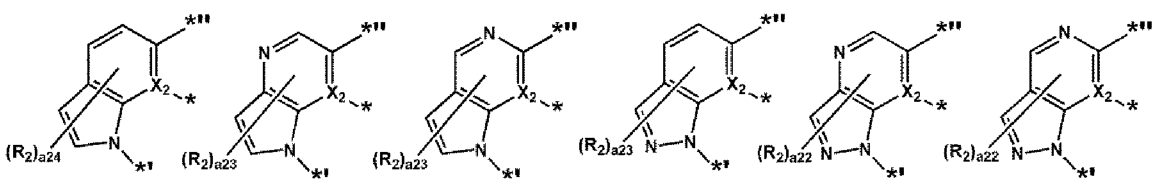
A2-3(31) A2-3(32) A2-3(33) A2-3(34) A2-3(35) A2-3(36)

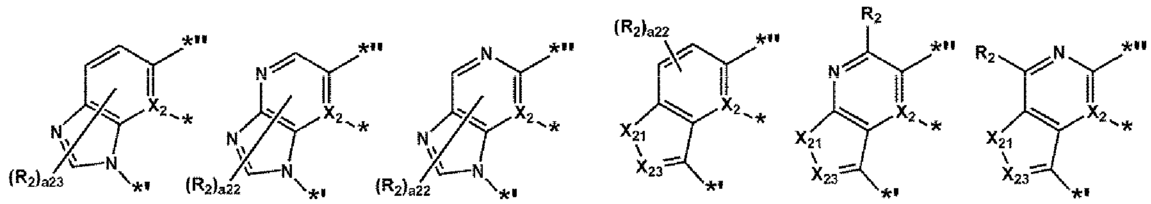

A2-3(37) A2-3(38) A2-3(39) A2-3(40) A2-3(41) A2-3(42)

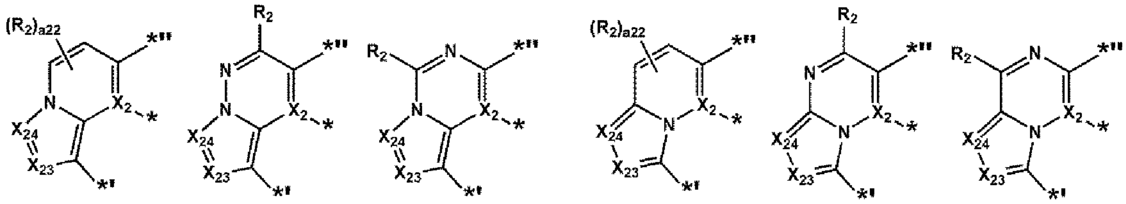

A2-3(43) A2-3(44) A2-3(45) A2-3(46) A2-3(47) A2-3(48)

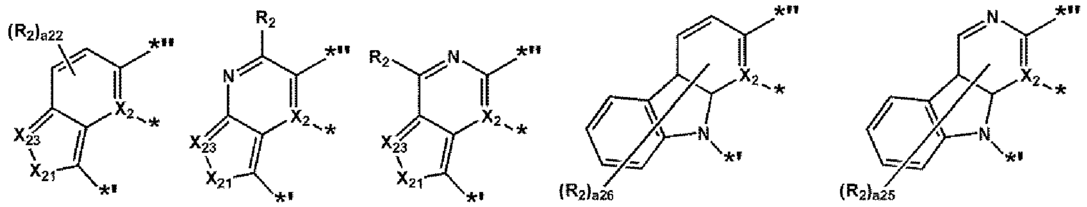

A2-3(49) A2-3(50) A2-3(51) A2-3(52) A2-3(53)

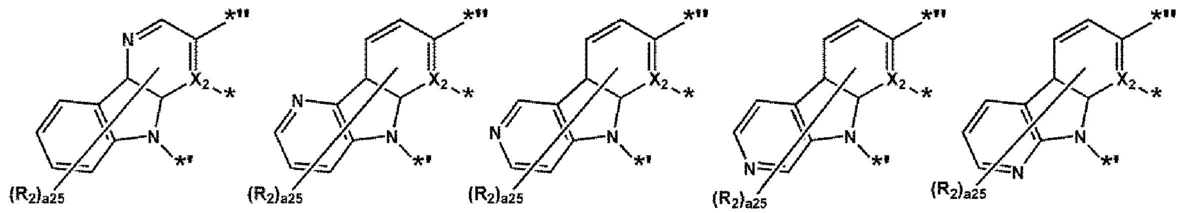

A2-3(54) A2-3(55) A2-3(56) A2-3(57) A2-3(58) ,

où, dans les Formules A2-1(1) à A2-1(21), A2-2(1) à A2-2(58), et A2-3(1) à A2-3(58),

$X_2$ et $R_2$ sont identiques à la description de la revendication 1,
$X_{21}$ est O, S, $N(R_{21})$, $C(R_{21})(R_{22})$, ou $Si(R_{21})(R_{22})$,
$X_{23}$ est N ou $C(R_{23})$,
$X_{24}$ est N ou $C(R_{24})$,
$R_{21}$ à $R_{28}$ sont identiques à la description en rapport avec $R_2$ dans la revendication 1,
a26 est un nombre entier de 0 à 6,
a25 est un nombre entier de 0 à 5,
a24 est un nombre entier de 0 à 4,
a23 est un nombre entier de 0 à 3,
a22 est un nombre entier de 0 to 2,
* indique un site de fixation à $X_5$ ou M dans la Formule 1,
*' indique un site de fixation à $T_1$ dans la Formule 1, et
*'' indique un site de fixation à $T_2$ dans la Formule 1.

**9.** Composé organométallique selon l'une quelconque des revendications 1-8, où un groupement représenté par

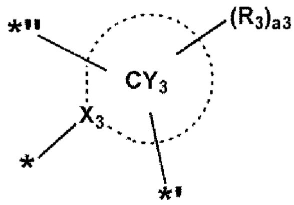

est sélectionné dans des groupes représentés par les Formules A3-1(1) à A3-1(21), A3-2(1) à A3-2(58), et A3-3(1) à A3-3(58) :

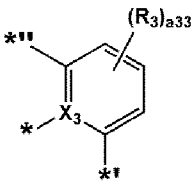
A3-1(1)

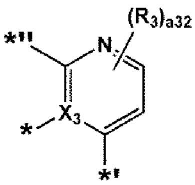
A3-1(2)

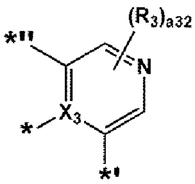
A3-1(3)

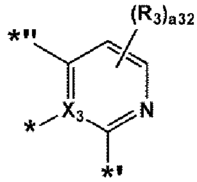
A3-1(4)

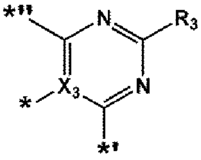
A3-1(5)

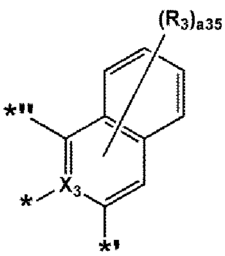
A3-1(6)

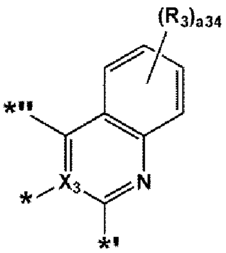
A3-1(7)

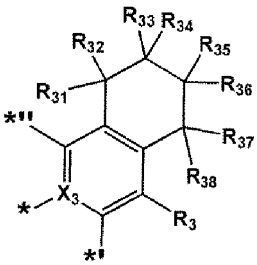
A3-1(8)

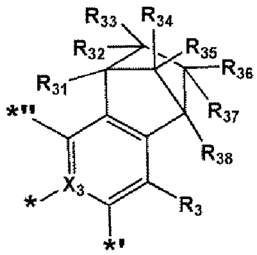
A3-1(9)

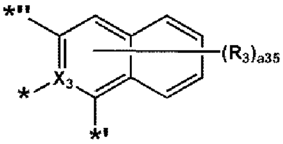
A3-1(10)

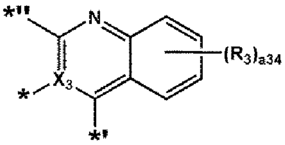
A3-1(11)

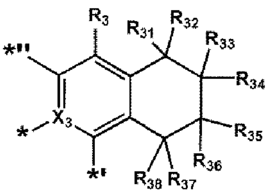
A3-1(12)

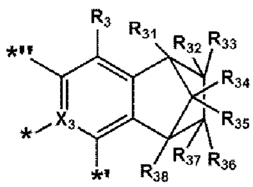
A3-1(13)

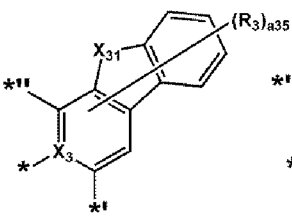
A3-1(14)

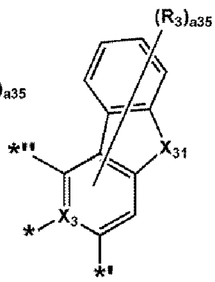
A3-1(15)

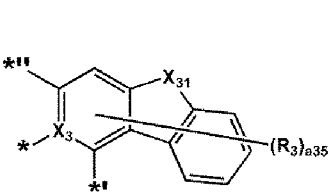
A3-1(16)

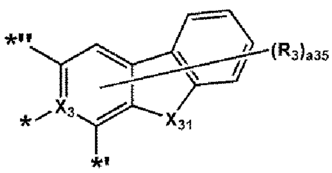
A3-1(17)

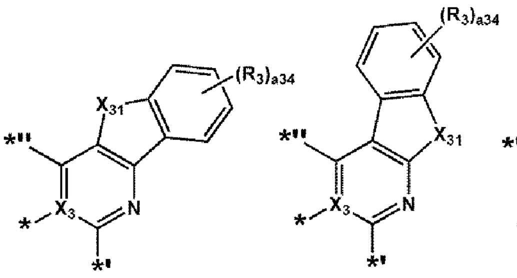

A3-1(18) A3-1(19)

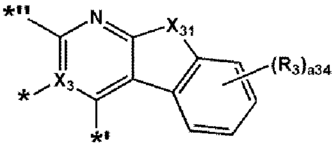

A3-1(20)

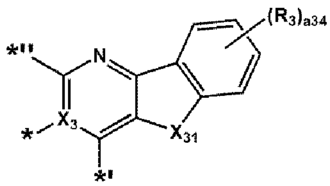

A3-1(21)

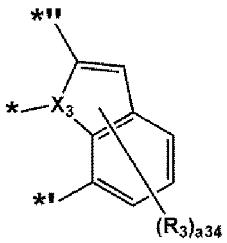

A3-2(1)

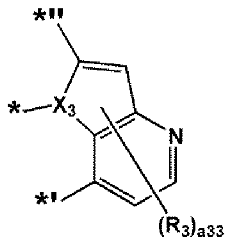

A3-2(2)

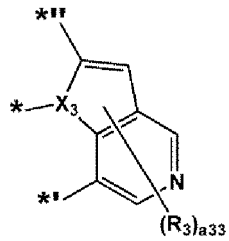

A3-2(3)

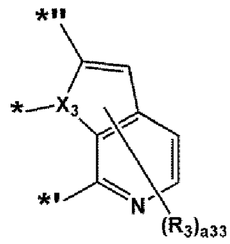

A3-2(4)

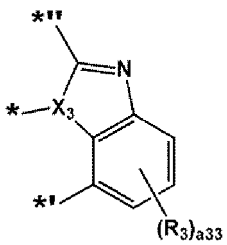

A3-2(5)

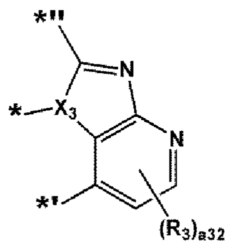

A3-2(6)

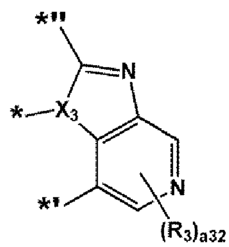

A3-2(7)

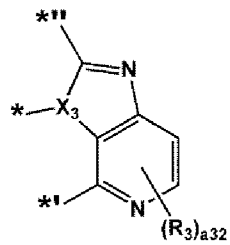

A3-2(8)

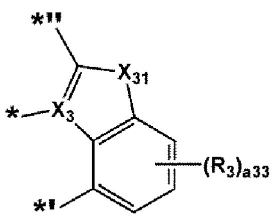

A3-2(9)

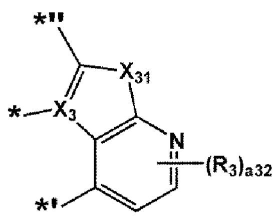

A3-2(10)

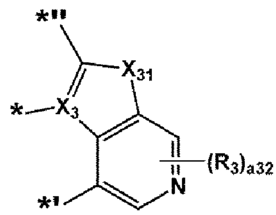

A3-2(11)

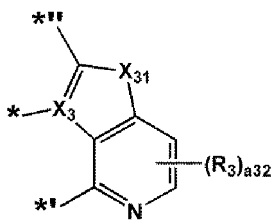

A3-2(12)

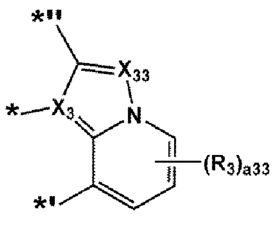

A3-2(13)

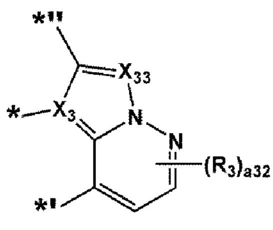

A3-2(14)

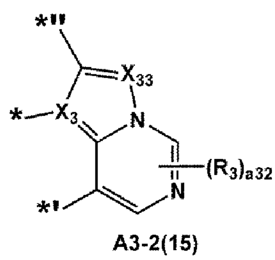

A3-2(15)

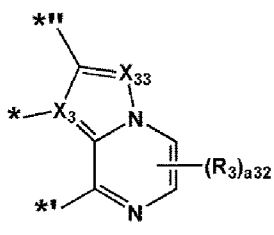

A3-2(16)

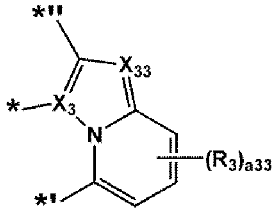
A3-2(17)

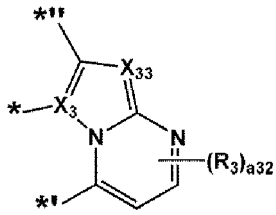
A3-2(18)

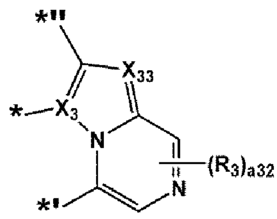
A3-2(19)

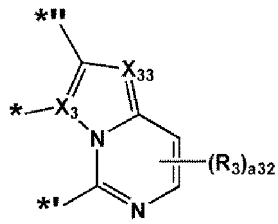
A3-2(20)

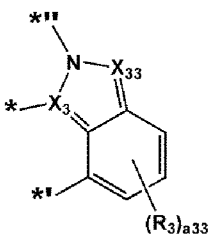
A3-2(21)

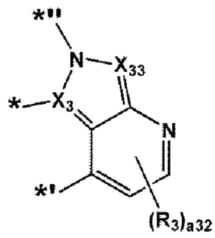
A3-2(22)

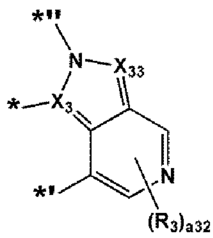
A3-2(23)

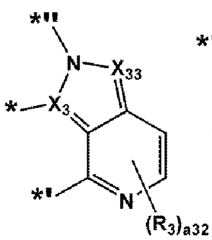
A3-2(24)

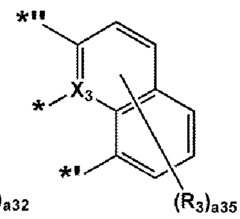
A3-2(25)

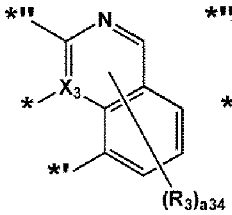
A3-2(26)

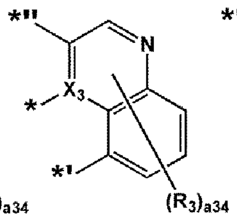
A3-2(27)

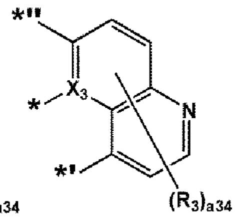
A3-2(28)

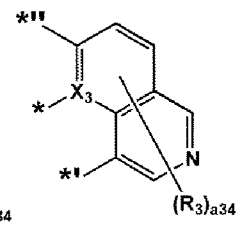
A3-2(29)

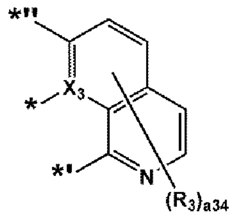
A3-2(30)

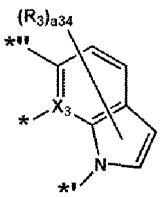
A3-2(31)

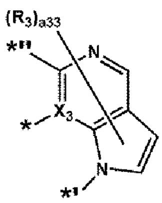
A3-2(32)

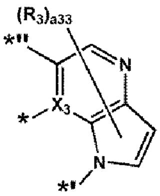
A3-2(33)

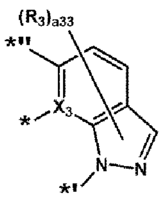
A3-2(34)

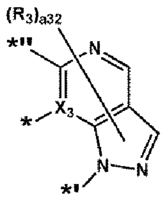
A3-2(35)

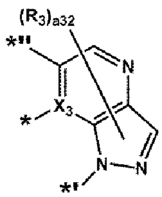
A3-2(36)

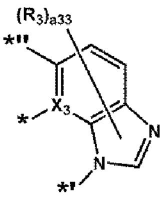
A3-2(37)

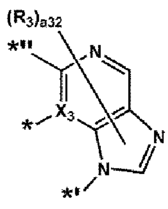
A3-2(38)

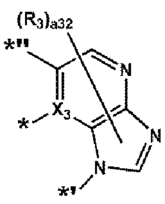
A3-2(39)

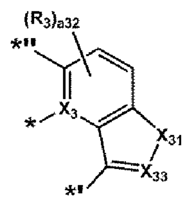
A3-2(40)

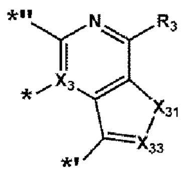
A3-2(41)

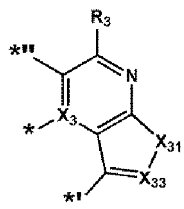
A3-2(42)

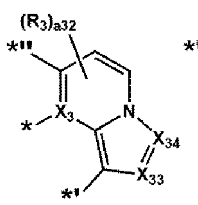
A3-2(43)

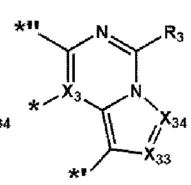
A3-2(44)

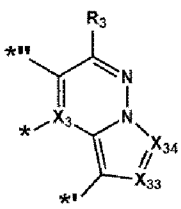
A3-2(45)

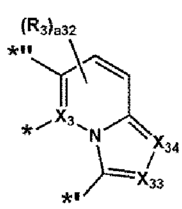
A3-2(46)

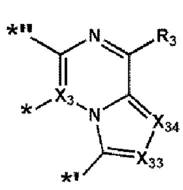
A3-2(47)

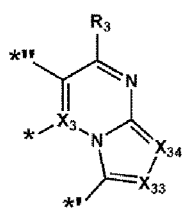
A3-2(48)

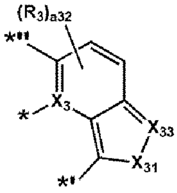
A3-2(49)

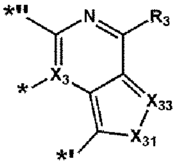
A3-2(50)

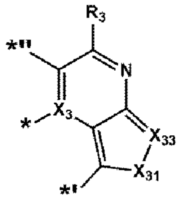
A3-2(51)

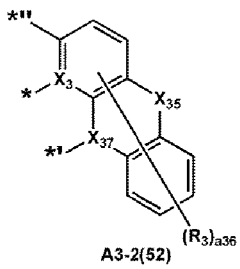
A3-2(52)

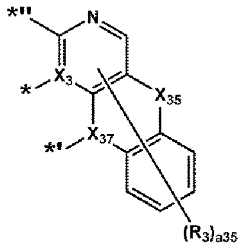
A3-2(53)

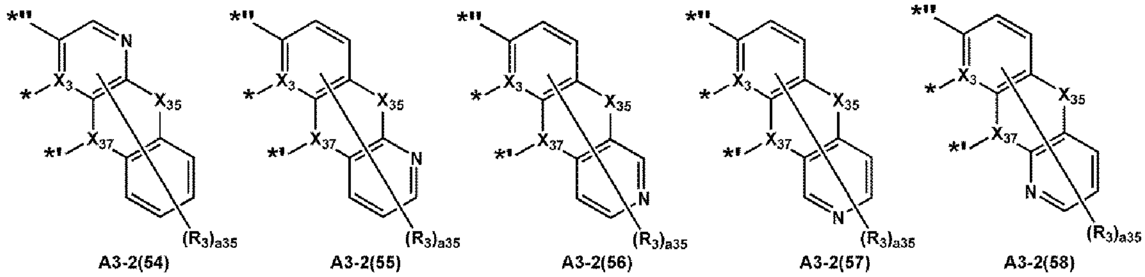
A3-2(54) A3-2(55) A3-2(56) A3-2(57) A3-2(58)

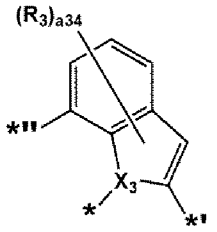
A3-3(1)

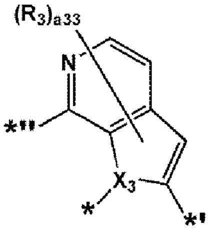
A3-3(2)

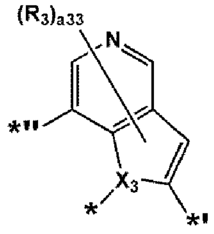
A3-3(3)

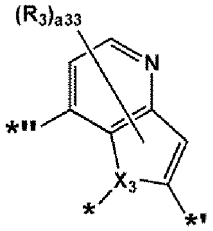
A3-3(4)

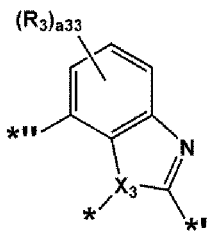
A3-3(5)

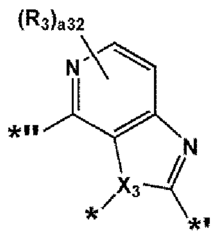
A3-3(6)

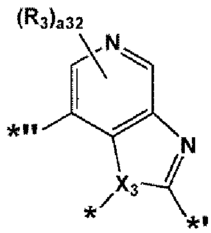
A3-3(7)

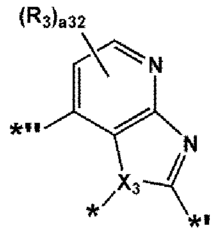
A3-3(8)

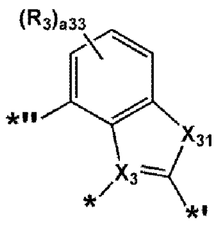
A3-3(9)

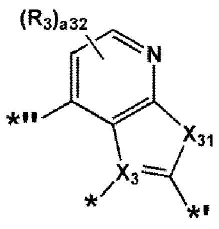
A3-3(10)

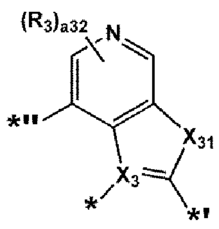
A3-3(11)

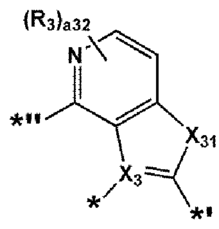
A3-3(12)

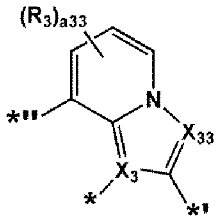
A3-3(13)

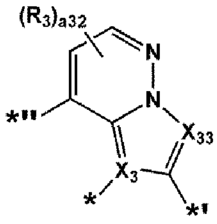
A3-3(14)

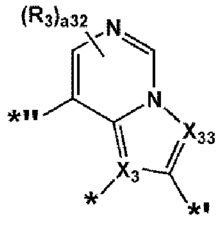
A3-3(15)

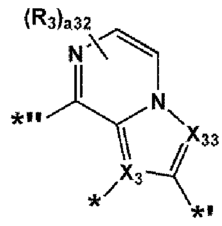
A3-3(16)

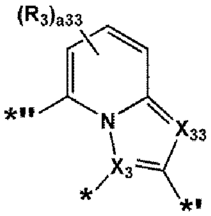
A3-3(17)

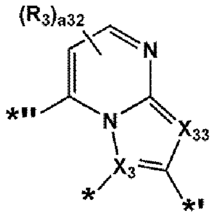
A3-3(18)

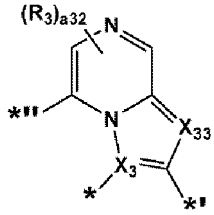
A3-3(19)

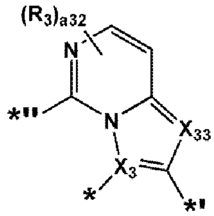
A3-3(20)

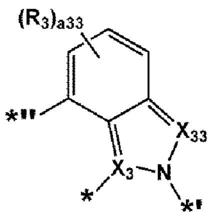
A3-3(21)

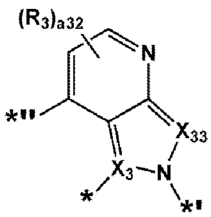
A3-3(22)

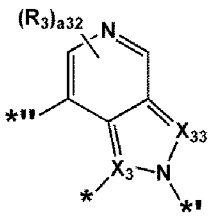
A3-3(23)

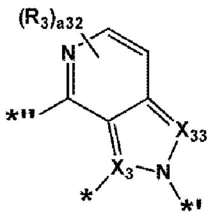
A3-3(24)

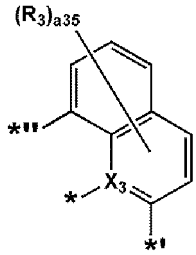
A3-3(25)

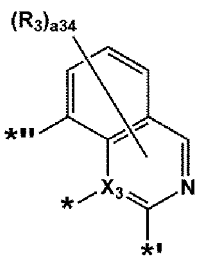
A3-3(26)

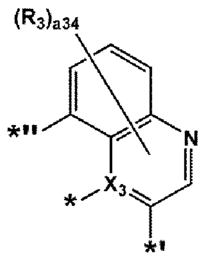
A3-3(27)

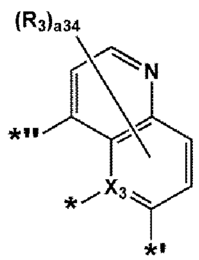
A3-3(28)

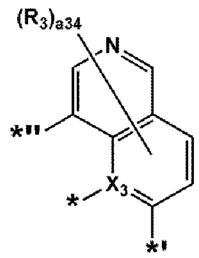
A3-3(29)

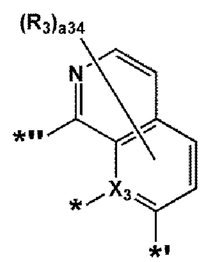
A3-3(30)

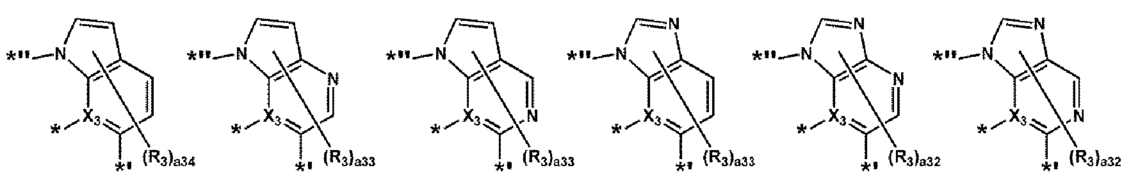
A3-3(31) A3-3(32) A3-3(33) A3-3(34) A3-3(35) A3-3(36)

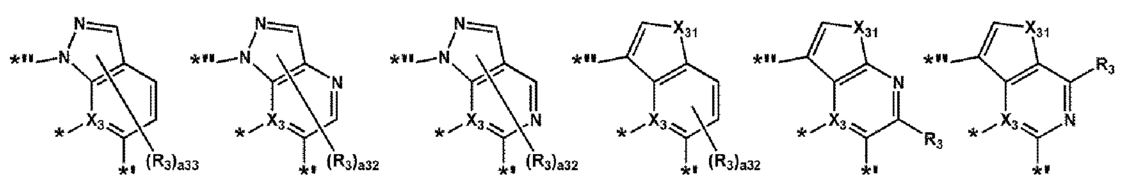
A3-3(37) A3-3(38) A3-3(39) A3-3(40) A3-3(41) A3-3(42)

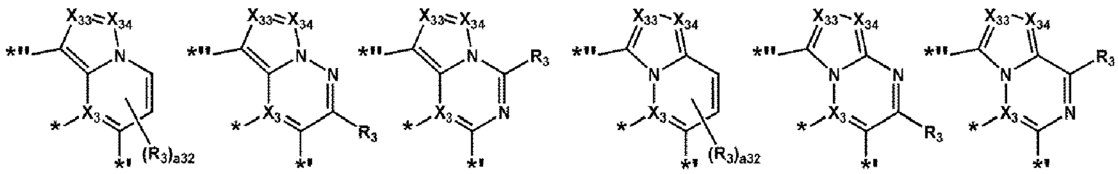

A3-3(43) A3-3(44) A3-3(45) A3-3(46) A3-3(47) A3-3(48)

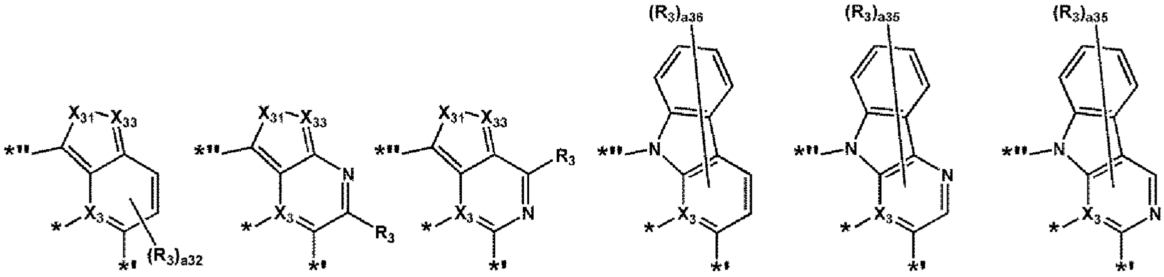

A3-3(49) A3-3(50) A3-3(51) A3-3(52) A3-3(53) A3-3(54)

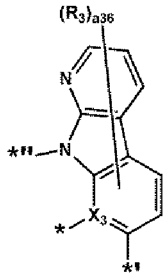

A3-3(55)

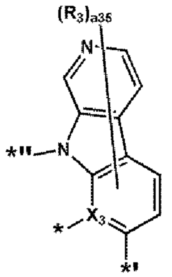

A3-3(56)

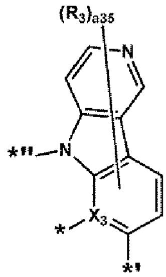

A3-3(57)

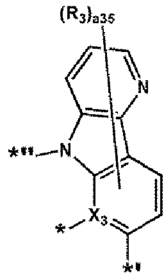

A3-3(58)

où, dans les Formules A3-1(1) à A3-1(21), A3-2(1) à A3-2(58), et A3-3(1) à A3-3(58),

$X_3$ et $R_3$ sont identiques à la description de la revendication 1,
$X_{31}$ est O, S, $N(R_{31})$, $C(R_{31})(R_{32})$, ou $Si(R_{31})(R_{32})$,
$X_{33}$ est N ou $C(R_{33})$,
$X_{34}$ est N ou $C(R_{34})$,
$X_{35}$ est O, S, $N(R_{35})$, $C(R_{35})(R_{36})$, ou $Si(R_{35})(R_{36})$,
$X_{37}$ est N ou $C(R_{37})$,
$R_{31}$ à $R_{38}$ sont identiques à la description en rapport avec $R_3$ dans la revendication 1,
a36 est un nombre entier de 0 à 6,
a35 est un nombre entier de 0 à 5,
a34 est un nombre entier de 0 à 4,
a33 est un nombre entier de 0 à 3,
a32 est un nombre entier de 0 à 2,
*'' indique un site de fixation à $T_2$ dans la Formule 1,
* indique un site de fixation à $X_6$ ou M dans la Formule 1, et
*' indique un site de fixation à $T_3$ dans la Formule 1.

**10.** Composé organométallique selon l'une quelconque des revendications1-9, dans lequel un groupement représenté par

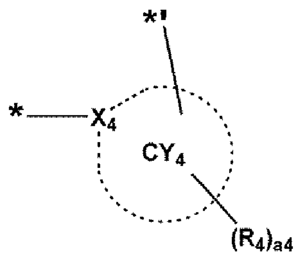

est sélectionné dans des groupes représentés par les Formules A4-1(1) à A4-1(51) et A4-2(1) à A4-2(71) :

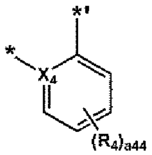
A4-1(1)

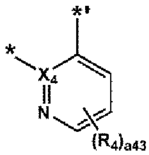
A4-1(2)

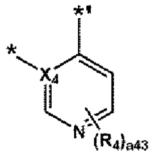
A4-1(3)

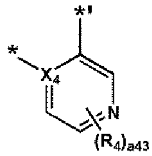
A4-1(4)

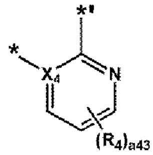
A4-1(5)

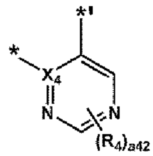
A4-1(6)

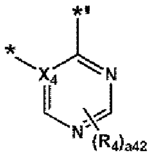
A4-1(7)

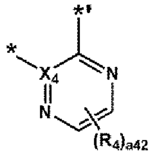
A4-1(8)

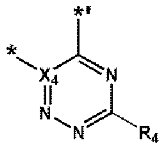
A4-1(9)

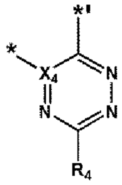
A4-1(10)

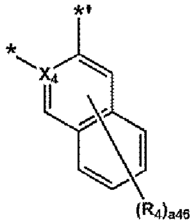
A4-1(11)

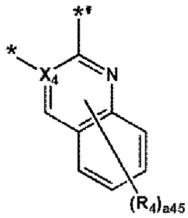
A4-1(12)

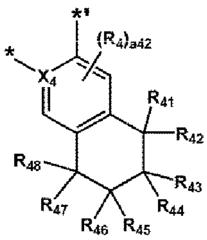
A4-1(13)

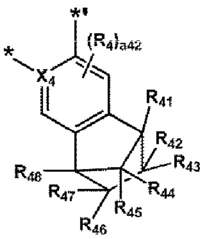
A4-1(14)

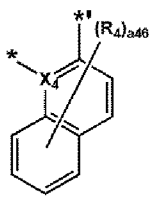
A4-1(15)

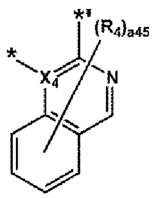
A4-1(16)

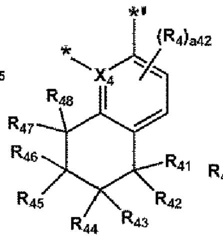
A4-1(17)

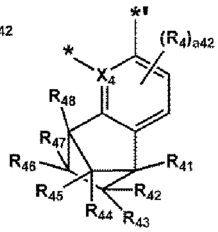
A4-1(18)

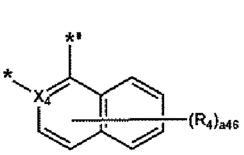
A4-1(19)

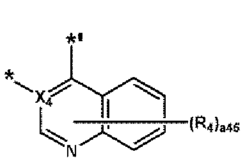
A4-1(20)

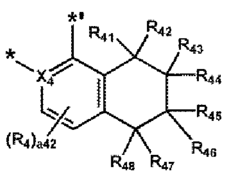
A4-1(21)

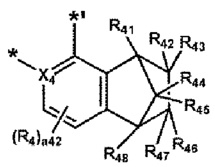
A4-1(22)

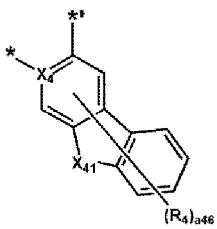
A4-1(23)

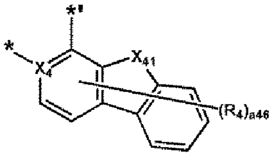
A4-1(24)

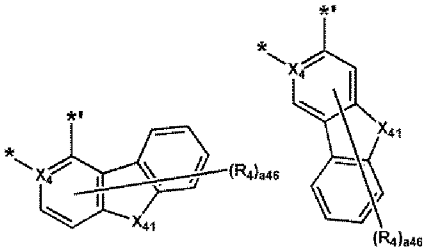
A4-1(25)

A4-1(26)

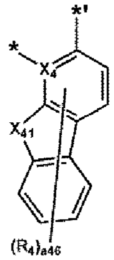
A4-1(27)

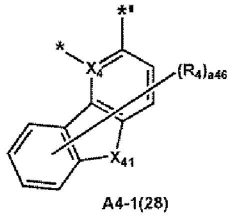
A4-1(28)

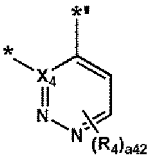
A4-1(29)

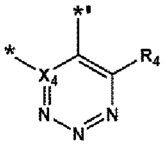
A4-1(30)

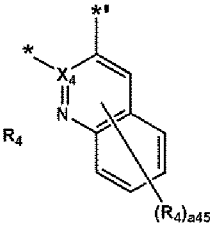
A4-1(31)

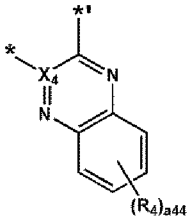
A4-1(32)

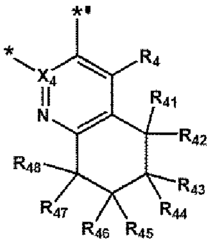
A4-1(33)

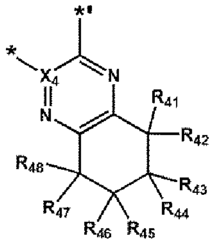
A4-1(34)

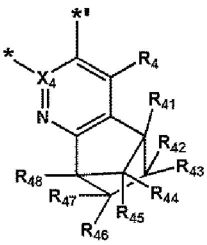
A4-1(35)

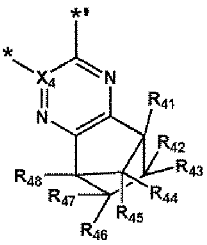
A4-1(36)

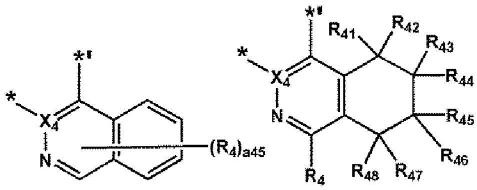
A4-1(37)

A4-1(38)

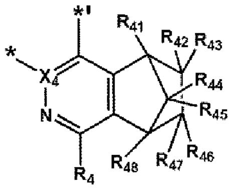
A4-1(39)

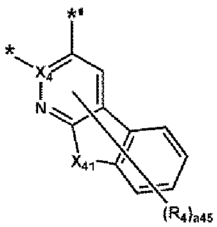
A4-1(40)

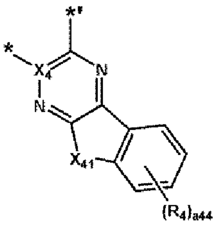
A4-1(41)

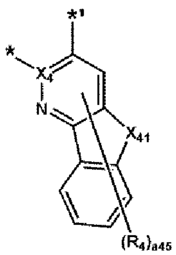
A4-1(42)

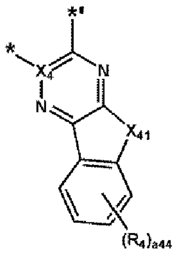
A4-1(43)

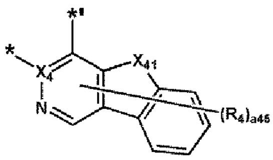
A4-1(44)

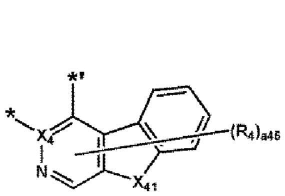
A4-1(45)

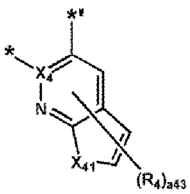
A4-1(46)

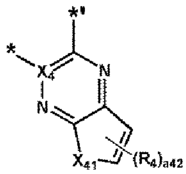
A4-1(47)

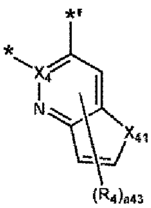
A4-1(48)

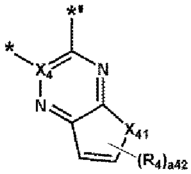
A4-1(49)

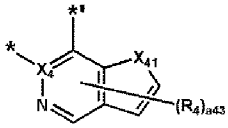
A4-1(50)

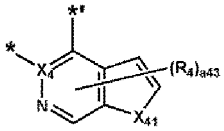
A4-1(51)

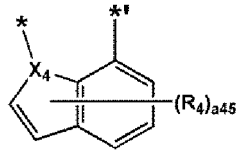
A4-2(1)

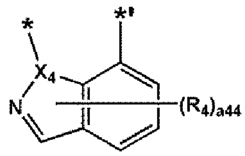
A4-2(2)

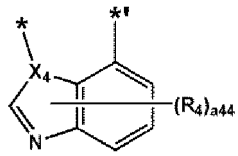
A4-2(3)

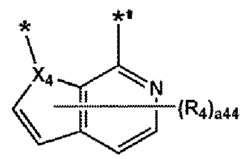
A4-2(4)

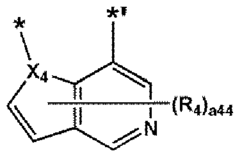
A4-2(5)

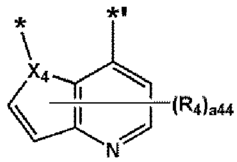
A4-2(6)

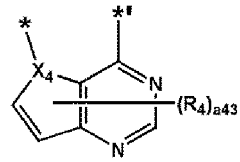
A4-2(7)

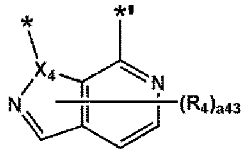
A4-2(8)

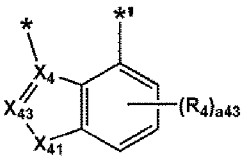
A4-2(9)

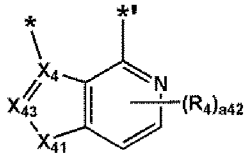
A4-2(10)

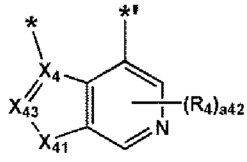
A4-2(11)

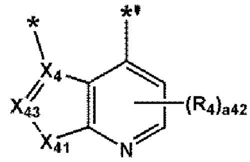
A4-2(12)

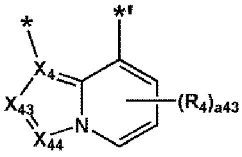
A4-2(13)

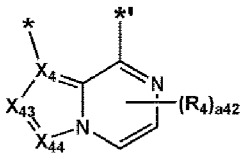
A4-2(14)

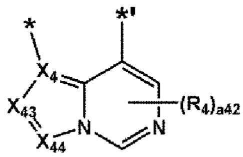
A4-2(15)

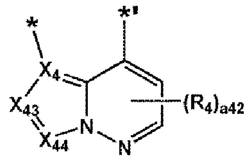
A4-2(16)

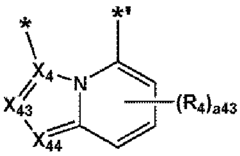
A4-2(17)

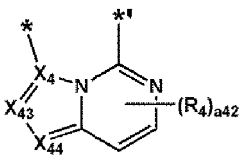
A4-2(18)

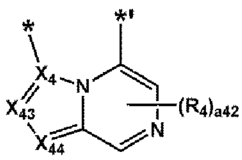
A4-2(19)

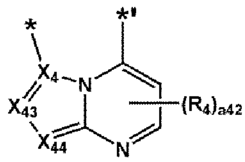
A4-2(20)

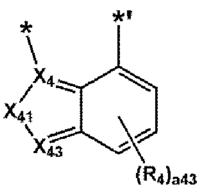
A4-2(21)

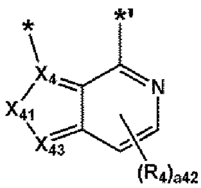
A4-2(22)

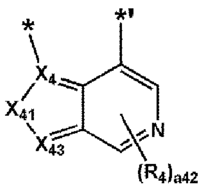
A4-2(23)

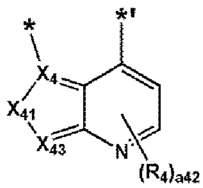
A4-2(24)

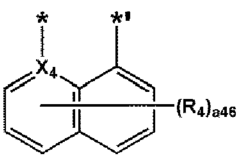
A4-2(25)

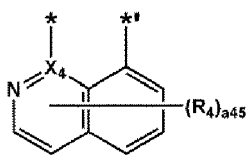
A4-2(26)

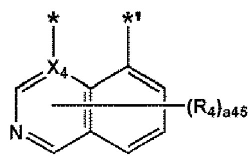
A4-2(27)

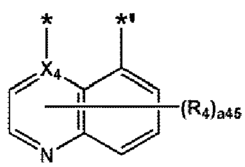
A4-2(28)

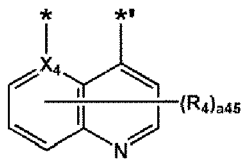
A4-2(29)

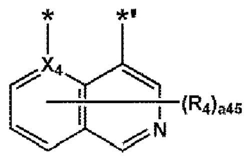
A4-2(30)

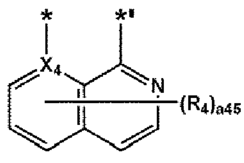
A4-2(31)

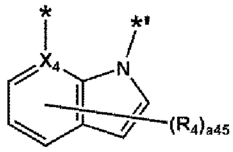
A4-2(32)

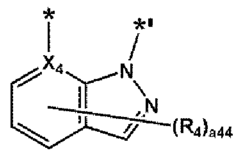
A4-2(33)

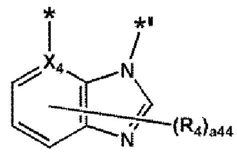
A4-2(34)

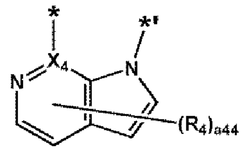
A4-2(35)

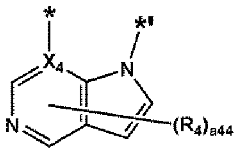
A4-2(36)

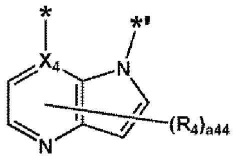
A4-2(37)

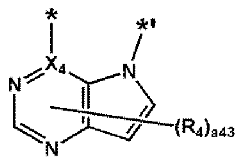
A4-2(38)

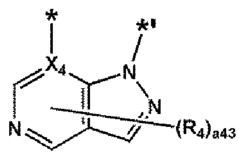
A4-2(39)

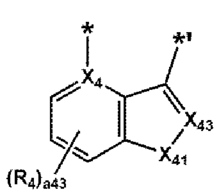
A4-2(40)

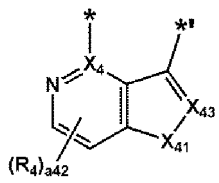
A4-2(41)

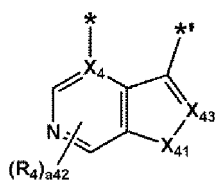
A4-2(42)

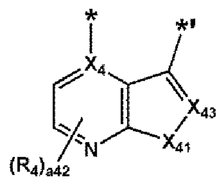
A4-2(43)

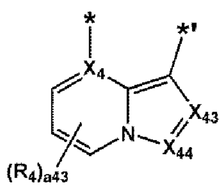
A4-2(44)

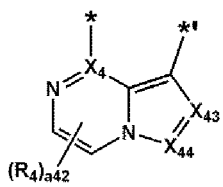
A4-2(45)

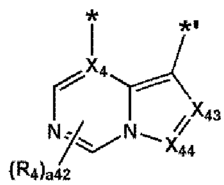
A4-2(46)

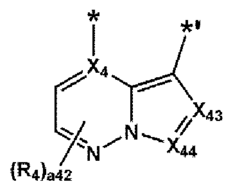
A4-2(47)

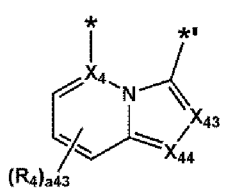
A4-2(48)

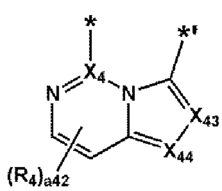
A4-2(49)

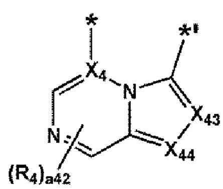
A4-2(50)

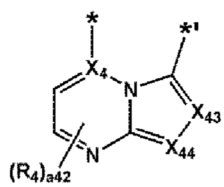
A4-2(51)

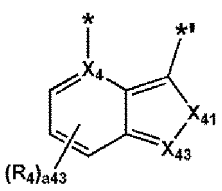
A4-2(52)

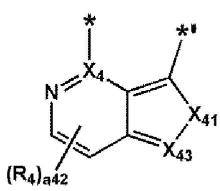
A4-2(53)

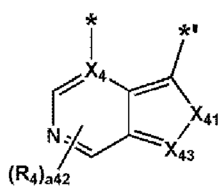
A4-2(54)

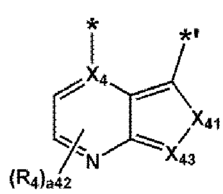
A4-2(55)

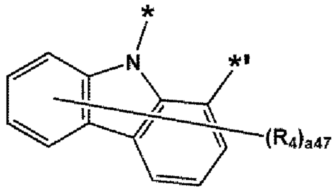

A4-2(56)

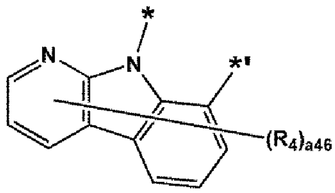

A4-2(57)

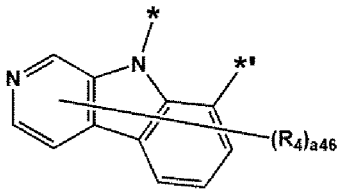

A4-2(58)

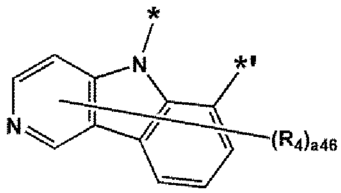

A4-2(59)

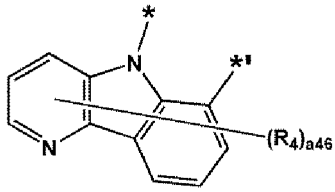

A4-2(60)

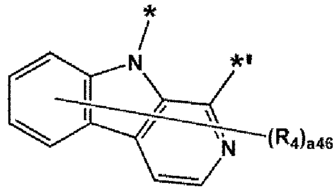

A4-2(61)

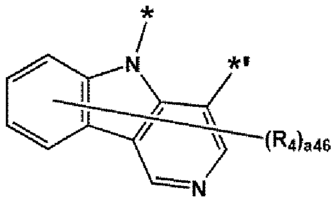

A4-2(62)

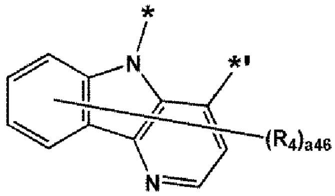

A4-2(63)

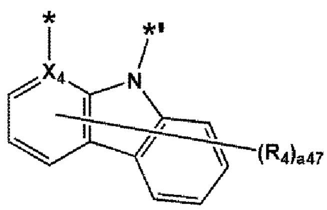

A4-2(64)

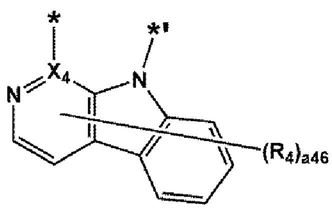

A4-2(65)

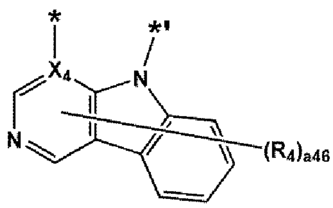

A4-2(66)

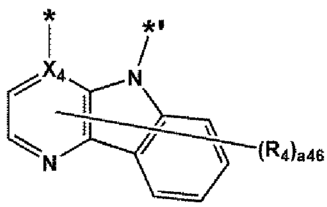

A4-2(67)

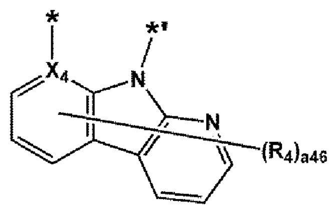

A4-2(68)

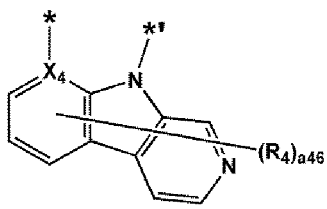

A4-2(69)

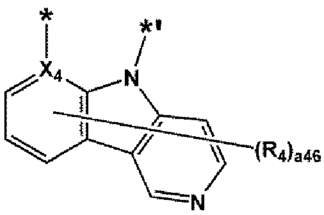

A4-2(70)

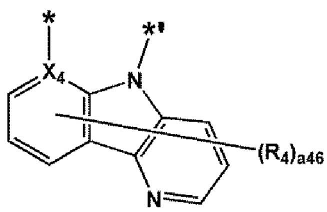

A4-2(71)

,

où, dans les Formules A4-1(1) à A4-1(51) et A4-2(1) à A4-2(71),

$X_4$ et $R_4$ sont identiques à la description de la revendication 1,
$X_{41}$ est O, S, $N(R_{41})$, $C(R_{41})(R_{42})$, ou $Si(R_{41})(R_{42})$,

$X_{43}$ est N ou $C(R_{43})$,
$X_{44}$ est N ou $C(R_{44})$,
$R_{41}$ à $R_{48}$ sont identiques à la description en rapport avec $R_4$ dans la revendication 1,
a47 est un nombre entier de 0 à 7,
a46 est un nombre entier de 0 à 6,
a45 est un nombre entier de 0 à 5,
a44 est un nombre entier de 0 à 4,
a43 est un nombre entier de 0 à 3,
a42 est un nombre entier de 0 à 2,
* indique un site de fixation à $X_7$ ou M dans la Formule 1, et
*' indique un site de fixation à $T_3$ dans la Formule 1.

**11.** Composé organométallique selon l'une quelconque des revendications 1-10, le composé organométallique ayant une structure linéairemenet symétrique par rapport à un axe de symétrie reliant M et $T_2$ dans la Formule 1 ; et/ou où,
le composé organométallique étant représenté par la Formule 1A :

Formule 1A

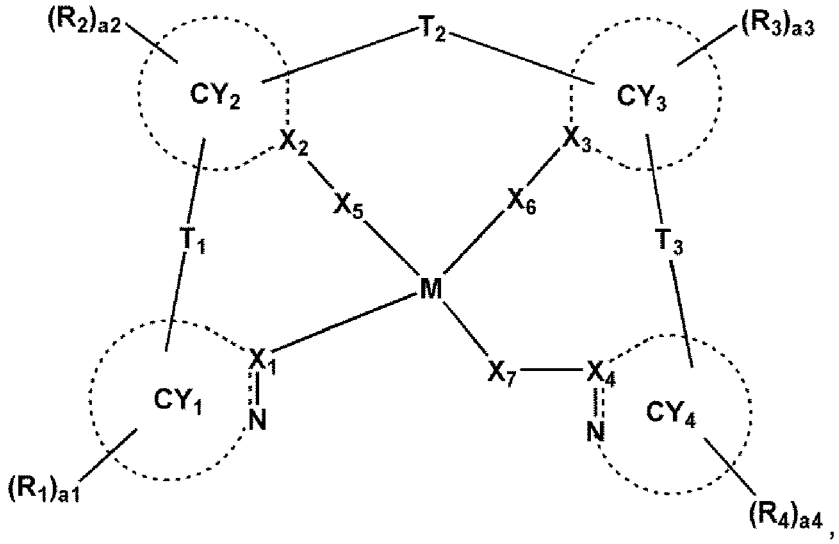

où, dans la Formule 1A, M, $X_1$ à $X_7$, l'anneau $CY_1$ à l'anneau $CY_3$, $T_1$ à $T_3$, $R_1$ à $R_4$, et a1 à a4 sont identiques à la description de la revendication 1, et l'anneau $CY_4$ est un groupe hétérocyclique $C_1$-$C_{30}$ ayant au moins un atome N comme atome de formation d'anneau ; et/ou
où
le composé organométallique est représenté par la Formule 1A(1) :

Formule 1A(1)

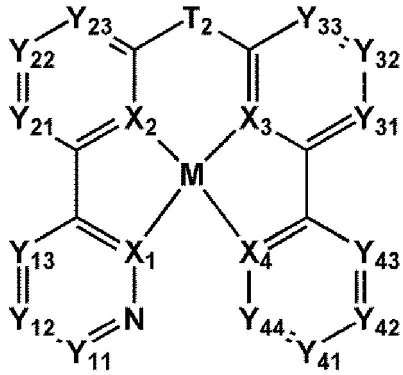

,

où, dans la Formule 1A(1),

M, $X_1$ à $X_4$, et $T_2$ sont identiques à la description de la revendication 1,
$Y_{11}$ est $C(Z_{11})$ ou N, $Y_{12}$ est $C(Z_{12})$ ou N, $Y_{13}$ est $C(Z_{13})$ ou N, $Y_{21}$ est $C(Z_{21})$ ou N, $Y_{22}$ est $C(Z_{22})$ ou N, $Y_{23}$ est $C(Z_{23})$ ou N, $Y_{31}$ est $C(Z_{31})$ ou N, $Y_{32}$ est $C(Z_{32})$ ou N, $Y_{33}$ est $C(Z_{33})$ ou N, $Y_{41}$ est $C(Z_{41})$ ou N, $Y_{42}$ est $C(Z_{42})$ ou N, $Y_{43}$ est $C(Z_{43})$ ou N, et $Y_{44}$ est $C(Z_{44})$ ou N,
$Z_{11}$ à $Z_{13}$ sont identiques à la description en rapport avec $R_1$ dans la revendication 1, et au moins deux de $Z_{11}$ à $Z_{13}$ sont optionnellement liés pour former un groupe carbocyclique $C_5$-$C_{30}$ qui est non substitué ou substitué avec au moins un $R_{10a}$ ou un groupe hétérocyclique $C_1$-$C_{30}$ qui est non substitué ou substitué avec au moins un $R_{10a}$,
$Z_{21}$ à $Z_{23}$ sont identiques à la description en rapport avec $R_2$ dans la revendication 1, et au moins deux de $Z_{21}$ à $Z_{23}$ sont optionnellement liés pour former un groupe carbocyclique $C_5$-$C_{30}$ qui est non substitué ou substitué avec au moins un $R_{10a}$ ou un groupe hétérocyclique $C_1$-$C_{30}$ qui est non substitué ou substitué avec au moins un $R_{10a}$,
$Z_{31}$ à $Z_{33}$ sont identiques à la description en rapport avec $R_3$ dans la revendication 1, et au moins deux de $Z_{31}$ à $Z_{33}$ sont optionnellement liés pour former un groupe carbocyclique $C_5$-$C_{30}$ qui est non substitué ou substitué avec au moins un $R_{10a}$ ou un groupe hétérocyclique $C_1$-$C_{30}$ qui est non substitué ou substitué avec au moins un $R_{10a}$,
$Z_{41}$ à $Z_{44}$ sont identiques à la description en rapport avec $R_4$ dans la revendication 1, et au moins deux de $Z_{41}$ à $Z_{44}$ sont optionnellement liés pour former un groupe carbocyclique $C_5$-$C_{30}$ qui est non substitué ou substitué avec au moins un $R_{10a}$ ou un groupe hétérocyclique $C_1$-$C_{30}$ qui est non substitué ou substitué avec au moins un $R_{10a}$, et
$R_{10a}$ est identique à la description en rapport avec $R_1$ dans la revendication 1.

12. Composé organométallique selon l'une quelconque des revendications 1-11, le composé organométallique étant un composé sélectionné parmi les composés 1 à 16 :

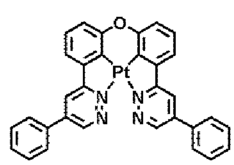

1

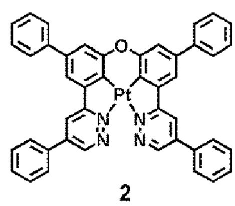

2

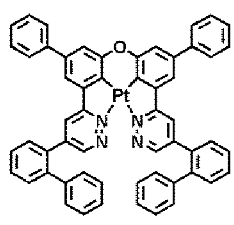

3

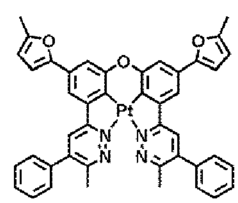

4

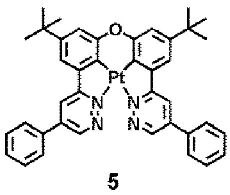
5

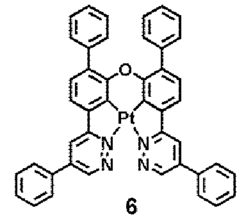
6

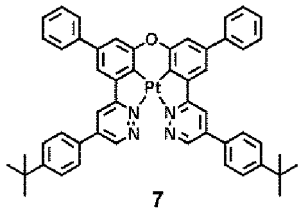
7

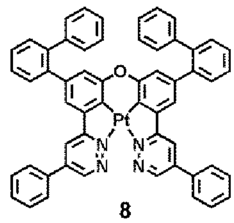
8

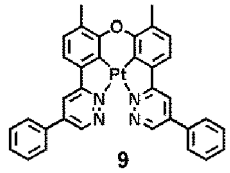
9

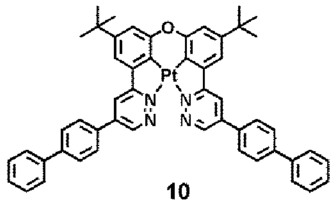
10

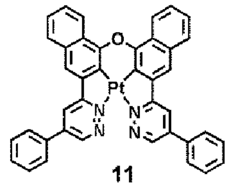
11

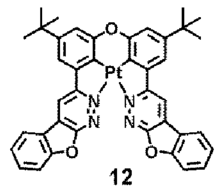
12

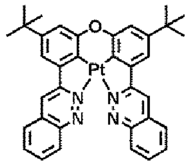
13

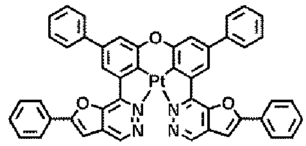
14

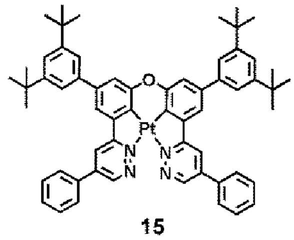
15

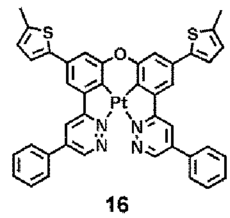
16

.

**13.** Dispositif électroluminescent organique comprenant :

une premièrec électrode ;
une deuxième électrode ; et
une couche organique disposée entre la première électrode et la deuxième électrode,
dans lequel la couche organique comprend une couche d'émission, et
dans lequel la couche organique comprend en outre au moins un composé organométallique selon l'une quelconque des revendications 1-12 ;
de préférence dans lequel
la première électrode est une anode,
la deuxième électrode est une cathode, et
la couche organique comprend en outre une zone de transport de trous disposée entre la première électrode et la couche d'émission et une zone de transport d'électrons disposée entre la couche d'émission et la deuxième électrode,
dans lequel la zone de transport de trous comprend une couche d'injection de trous, une couche de transport de trous, une couche de blocage d'électrons, une couche tampon ou toute combinaison de celles-ci, et
dans lequel la zone de transport d'électrons comprend une couche de blocage de trous, une couche de transport d'électrons une couche d'injection d'électrons ou toute combinaison de celles-ci.

**14.** Dispositif électroluminescent organique selon la revendication 13, dans lequel la couche d'émission comprend le composé organométallique ;

de préférence dans lequel
la couche d'émission comprend en outre un hôte, et
une quantité de l'hôte est plus grande qu'une quantité du composé organométallique.

**15.** Composition de diagnostic comprenant au moins l'un des composés organométalliques selon l'une quelconque des revendications 1-12.

# FIGURE

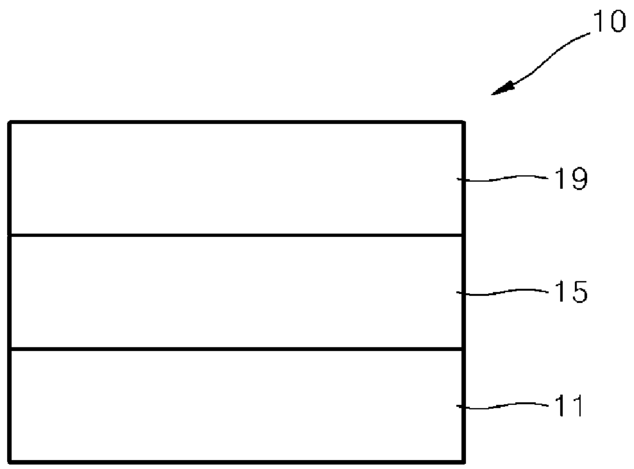

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- US 20170305881 A1